# EUROPEAN PATENT SPECIFICATION

(11) **EP 3 098 873 B1**
(45) Date of publication and mention of the grant of the patent: **26.06.2019**
(21) Application number: 16171798.8
(22) Date of filing: 27.05.2016
(51) Int. Cl.: H01L 51/54

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 27.05.2015 KR 20150073932; 27.01.2016 KR 20160010082
(43) Date of publication of application: 30.11.2016
(73) Proprietor: Samsung Display Co., Ltd., Gyeonggi-do (KR)
(72) Inventor: KIM, Seulong, Gyeonggi-do (KR); ITO, Naoyuki, Gyeonggi-do (KR); KIM, Younsun, Gyeonggi-do (KR); SHIN, Dongwoo, Gyeonggi-do (KR); LEE, Jungsub, Gyeonggi-do (KR)
(74) Representative: Mounteney, Simon James

(56) References cited:
- EP-A1- 3 144 302
- WO-A1-2015/174682
- WO-A2-2010/114243
- DE-A1-102009 005 289
- US-A1- 2014 246 657

## Description

### BACKGROUND

### 1. Field

One or more aspects of embodiments of the present disclosure relate to an organic light-emitting device.

### 2. Description of the Related Art

Organic light emitting devices are self-emission devices that have wide viewing angles, high contrast ratios, short response times, and excellent luminance, driving voltage, and response speed characteristics, and can produce full-color images.

An example of such organic light-emitting devices may include a first electrode disposed (e.g., positioned) on a substrate, and a hole transport region, an emission layer, an electron transport region, and a second electrode, which are sequentially disposed on the first electrode. Holes provided from the first electrode may move toward the emission layer through the hole transport region, and electrons provided from the second electrode may move toward the emission layer through the electron transport region. Carriers, such as holes and electrons, may then recombine in the emission layer to produce excitons. These excitons transition from an excited state to a ground state, thereby generating light.

WO 2010/114243 A2 relates to compounds for organic electronic materials and organic electronic devices including the same.

US 2014/246657 A1 relates to organic light-emitting compounds and organic light-emitting devices including the organic light-emitting compounds.

DE 10 2009 005289 A1 relates to indenofluorene derivatives.

WO 2015/174682 A1 and EP 3 144 302 A1 relates to heterocyclic compounds containing an aromatic amine group.

### SUMMARY

One or more aspects of embodiments of the present disclosure are directed toward an organic light-emitting device.

Additional aspects will be set forth in part in the description which follows and, in part, will be apparent from the description, or may be learned by practice of the presented embodiments.

According to one or more embodiments, an organic light-emitting device includes a first electrode, a second electrode, and an organic layer between the first electrode and the second electrode, the organic layer including an emission layer;

wherein the emission layer includes a first compound selected from Compounds H1 to H116 and a second compound represented by Formula 2:

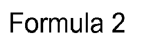

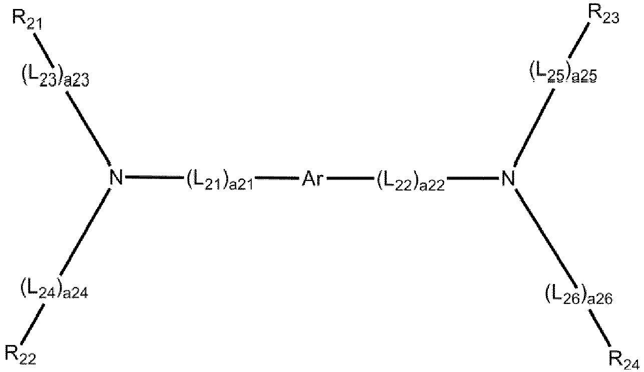

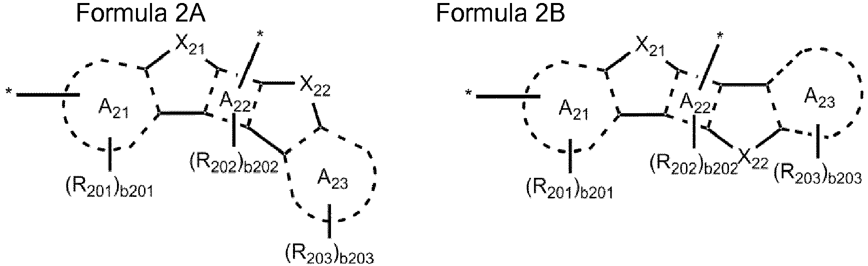

In Formulae 2, 2A, and 2B,
Ar is selected from a group represented by Formula 2A and a group represented by Formula 2B;
A₂₁ is selected from a C₅-C₂₀ carbocyclic group and a C₁-C₂₀ heterocyclic group;
A₂₂ is selected from a C₆-C₂₀ arene group and a C₁-C₂₀ heteroarene group;
A₂₃ is selected from a C₅-C₂₀ carbocyclic group and a C₁-C₂₀ heterocyclic group;
X₂₁ is selected from oxygen, sulfur, N(R₂₀₄), and C(R₂₀₄)(R₂₀₅);
X₂₂ is selected from oxygen, sulfur, N(R₂₀₆), and C(R₂₀₆)(R₂₀₇);
L₂₁ to L₂₆ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group;
a21 to a26 are each independently selected from 0, 1, 2, and 3;
R₂₁ to R₂₄ are each independently selected from a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group; R₂₁ and R₂₂ may optionally be linked to each other to form a saturated ring or an unsaturated ring, R₂₃ and R₂₄ may optionally be linked to each other to form a saturated ring or an unsaturated ring;
R₂₀₁ to R₂₀₇ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂); R₂₀₄ and R₂₀₅ are optionally linked to each other to form a saturated ring or an unsaturated ring, R₂₀₆ and R₂₀₇ are optionally linked to each other to form a saturated ring or an unsaturated ring;
b201 to b203 are each independently selected from 1, 2, 3, 4, 5, 6, 7, 8, 9, and 10;
Q₁ to Q₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group and a terphenyl group; and
* indicates a binding site to a neighboring atom, wherein the structures of Compounds H1 to H116 are shown in paragraph [0223].

At least some of the above and other features of the invention are set out in the claims.

### BRIEF DESCRIPTION OF THE DRAWINGS

These and/or other aspects will become apparent and more readily appreciated from the following description of the embodiments, taken in conjunction with the accompanying drawings in which:
FIG. 1 is a schematic cross-sectional view of an organic light-emitting device according to an embodiment;
FIG. 2 is a schematic cross-sectional view of an organic light-emitting device according to an embodiment;
FIG. 3 is a schematic cross-sectional view of an organic light-emitting device according to an embodiment; and
FIG. 4 is a schematic cross-sectional view of an organic light-emitting device according to an embodiment.

### DETAILED DESCRIPTION

The present disclosure will now be described more fully with reference to embodiments. The disclosure may, however, be embodied in many different forms and should not be construed as being limited to the embodiments set forth herein; rather, these embodiments are provided so that this disclosure will be thorough and complete, and will fully convey the concept of the disclosure to those skilled in the art. Advantages, features of the present invention, and how to achieve them, will become more apparent by reference to the embodiments that will be described later in more detail, together with the accompanying drawings. This invention may, however, be embodied in many different forms and should not be limited to the embodiments.

Hereinafter, embodiments are described in more detail by referring to the attached drawings, and in the drawings, like reference numerals denote like elements, and redundant explanations thereof will not be provided herein.

As used herein, the singular forms "a," "an" and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, region, or component is referred to as being "on" or "onto" another layer, region, or component, it may be directly or indirectly formed on the other layer, region, or component. That is, for example, intervening layers, regions, or components may be present.

Sizes of components in the drawings may be exaggerated for convenience of explanation. In other words, since sizes and thicknesses of components in the drawings are arbitrarily illustrated for convenience of explanation, the following embodiments are not limited thereto.

The expression "an (organic layer) includes a first compound" may refer to a case in which an (organic layer) includes one or more of the same first compound represented by Formula 1 and a case in which an (organic layer) includes two or more different first compounds represented by Formula 1.

The term "organic layer" used herein may refer to a single layer and/or a plurality of layers between a first electrode and a second electrode in an organic light-emitting device. A material included in the "organic layer" is not limited to an organic material.

Expressions such as "at least one of," "one of," and "selected from," when preceding a list of elements, modify the entire list of elements and do not modify the individual elements of the list. Further, the use of "may" when describing embodiments of the present invention refers to "one or more embodiments of the present invention."

According to one or more example embodiments, an organic light-emitting device includes a first electrode, a second electrode, and an organic layer between the first electrode and the second electrode,
wherein the emission layer comprises a first compound selected from Compounds H1 to H116 and a second compound represented by Formula 2: 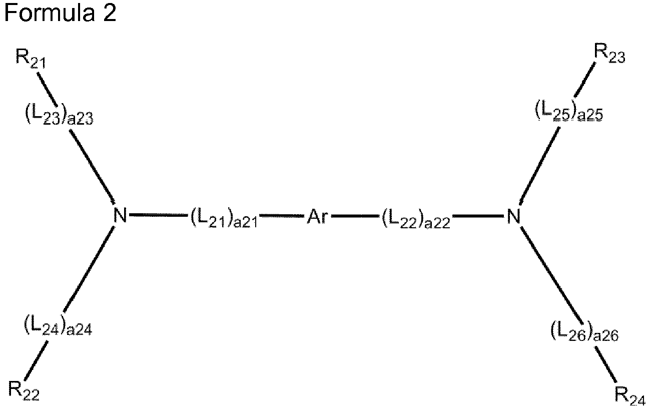 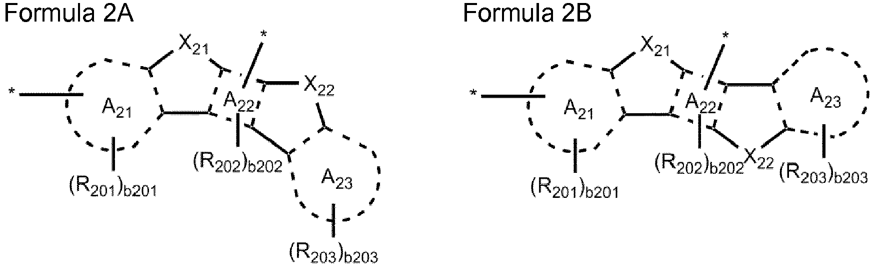
Ar in Formula 2 is selected from a group represented by Formula 2A and a group represented by Formula 2B.
X₂₁ in Formulae 2A and 2B is selected from oxygen, sulfur, N(R₂₀₄), and C(R₂₀₄)(R₂₀₅), and R₂₀₄ and R₂₀₅ are as described below.
X₂₂ in Formulae 2A and 2B is selected from oxygen, sulfur, N(R₂₀₆), and C(R₂₀₆)(R₂₀₇), and R₂₀₆ and R₂₀₇ are as described below.
A₂₁ in Formulae 2A and 2B is selected from a C₅-C₂₀ carbocyclic group and a C₁-C₂₀ heterocyclic group. For example, A₂₁ in Formulae 2A and 2B may be selected from a C₆-C₁₄ carbocyclic group and a C₄-C₁₃ heterocyclic group.
A₂₂ in Formulae 2A and 2B is selected from a C₆-C₂₀ arene group and a C₁-C₂₀ heteroarene group. For example, A₂₂ in Formulae 2A and 2B may be selected from a C₆-C₁₈ carbocyclic group and a C₃-C₁₃ heterocyclic group.
A₂₃ in Formulae 2A and 2B is selected from a C₅-C₂₀ carbocyclic group and a C₁-C₂₀ heterocyclic group. For example, A₂₃ in Formulae 2A and 2B may be selected from a C₆-C₁₄ carbocyclic group and a C₄-C₁₃ heterocyclic group.

In various embodiments, A₂₁ and A₂₃ in Formulae 2A and 2B may each independently be selected from a benzene group, a naphthalene group, a phenanthrene group, an anthracene group, a triphenylene group, a pyrene group, a chrysene group, a furan group, a thiophene group, a pyrrole group, a pyridine group, a pyrazine group, a pyrimidine group, a triazine group, a quinoline group, an isoquinoline group, a benzoquinoline group, a benzoisoquinoline group, a 2,6-naphthyridine group, a 1,8-naphthyridine group, a 1,5-naphthyridine group, a 1,6-naphthyridine group, a 1,7-naphthyridine group, a 2,7-naphthyridine group, a quinoxaline group, a quinazoline group, a phenanthridine group, a phenanthroline group, a benzofuran group, a benzothiophene group, an indene group, an indole group, furopyridine group, thienopyridine group, a cyclopentapyridine group, a pyrrolopyridine group, a dibenzofuran group, a dibenzothiophene group, a fluorene group, a carbazole group, a benzofuropyrrole group, a benzothienopyrrole group, an indenopyrrole group, an indolopyrrole group, a benzofurothiophene group, a benzothienothiophene group, an indenothiophene group, an indolothiophene group, a benzofurofuran group, a benzothienofuran group, an indenofuran group, an indolofuran group, a benzofurothiophene group, a benzothienothiophene group, an indenothiophene group, an indolothiophene group, a benzofuropyridine group, a benzothienopyridine group, an indenopyridine group, an indolopyridine group, a benzofuropyrimidine group, a benzothienopyrimidine group, an indenopyrimidine group, an indolopyrimidine group, a benzofuroindole group, a benzothienoindole group, an indenoindole group, an indoloindole group, a benzofurobenzofuran group, a benzothienobenzofuran group, an indenobenzofuran group, an indolobenzofuran group, a benzofurobenzothiophene group, a benzothienobenzothiophene group, an indenobenzothiophene group, an indolobenzothiophene group, a benzofuroquinoline group, a benzothienoquinoline group, an indenoquinoline group, an indoloquinoline group, a benzonaphthofuran group, a benzonaphthothiophene group, a benzofluorene group, a benzocarbazole group, a dinaphthofuran group, a dinaphthothiophene group, a dibenzofluorene group, a dibenzocarbazole group, a benzoxazole group, a benzothiazole group, a benzimidazole group, a naphthofuran, a naphthothiophene, a cyclopentanaphthalene group, a spiro-bifluorene group, and a spiro-fluorene-indene group, but are not limited thereto.

In various embodiments, A₂₁ and A₂₃ in Formulae 2A and 2B may each independently be selected from a benzene group, a naphthalene group, a phenanthrene group, a pyridine group, a pyrazine group, a pyrimidine group, a quinoline group, an isoquinoline group, a benzoquinoline group, a benzoisoquinoline group, a dibenzofuran group, a dibenzothiophene group, a fluorene group, a carbazole group, and an indolopyridine group, but are not limited thereto.

In various embodiments, A₂₁ and A₂₃ in Formulae 2A and 2B may each independently be selected from a benzene group, a naphthalene group, a phenanthrene group, a pyridine group, a quinoline group, an isoquinoline group, a benzoquinoline group, a benzoisoquinoline group, a dibenzofuran group, a dibenzothiophene group, a fluorene group, a carbazole group, and an indolopyridine group, but are not limited thereto.

In various embodiments, A₂₂ in Formulae 2A and 2B may be selected from a benzene group, a naphthalene group, a phenanthrene group, an anthracene group, a triphenylene group, a pyrene group, a chrysene group, a pyridine group, a pyrazine group, a pyrimidine group, a triazine group, a quinoline group, an isoquinoline group, a benzoquinoline group, a benzoisoquinoline group, a 2,6-naphthyridine group, a 1,8-naphthyridine group, a 1,5-naphthyridine group, a 1,6-naphthyridine group, a 1,7-naphthyridine group, a 2,7-naphthyridine group, a quinoxaline group, a quinazoline group, a phenanthridine group, and a phenanthroline group, but is not limited thereto.

In various embodiments, A₂₂ in Formulae 2A and 2B may be selected from a benzene group, a naphthalene group, a pyridine group, a quinoline group, and an isoquinoline group, but is not limited thereto.

In various embodiments, A₂₂ in Formulae 2A and 2B may be selected from a benzene group and a naphthalene group, but is not limited thereto.

L₂₁ to L₂₆ in Formula 2 are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group.

For example, L₂₁ to L₂₆ in Formula 2 may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₂₀ (*e.g.* C₆-C₁₈ or C₆-C₁₄) arylene group, a substituted or unsubstituted C₁-C₂₀ (*e.g.* C₃-C₁₆) heteroarylene group, a substituted or unsubstituted divalent non-aromatic condensed polycyclic group, and a substituted or unsubstituted divalent non-aromatic condensed heteropolycyclic group.

In various embodiments, L₂₁ to L₂₆ in Formula 2 may each independently be selected from the group consisting of:
a phenylene group, a naphthylene group, a fluorenylene group, a phenanthrenylene group, an anthracenylene group, a triphenylenylene group, a pyrrolylene group, a thiophenylene group, a furanylene group, a pyridinylene group, a pyrazinylene group, a pyrimidinylene group, an indolylene group, a quinolinylene group, an isoquinolinylene group, a benzoquinolinylene group, a benzoisoquinolinylene group, a naphthyridinylene group, a quinoxalinylene group, a quinazolinylene group, a cinnolinylene group, a phenanthridinylene group, a phenanthrolinylene group, a carbazolylene group, a benzimidazolylene group, a benzofuranylene group, a benzothiophenylene group, a triazinylene group, a dibenzofuranylene group, and a dibenzothiophenylene group; and
a phenylene group, a naphthylene group, a fluorenylene group, a phenanthrenylene group, an anthracenylene group, a triphenylenylene group, a pyrrolylene group, a thiophenylene group, a furanylene group, a pyridinylene group, a pyrazinylene group, a pyrimidinylene group, an indolylene group, a quinolinylene group, an isoquinolinylene group, a benzoquinolinylene group, a benzoisoquinolinylene group, a naphthyridinylene group, a quinoxalinylene group, a quinazolinylene group, a cinnolinylene group, a phenanthridinylene group, a phenanthrolinylene group, a carbazolylene group, a benzimidazolylene group, a benzofuranylene group, a benzothiophenylene group, a triazinylene group, a dibenzofuranylene group, and a dibenzothiophenylene group, each substituted with at least one selected from deuterium, -F, -Cl, -Br, -I, a cyano group, a C₁-C₂₀ alkyl group, a C₁-C₂₀ alkoxy group, a cyclopropyl group, a cyclobutyl group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂),
wherein Q₃₁ to Q₃₃ may each independently be selected from hydrogen, a C₁-C₂₀ alkyl group, a phenyl group, a naphthyl group, a biphenyl group, and a terphenyl group, but embodiments are not limited thereto.

In various embodiments, L₂₁ to L₂₆ in Formula 2 may each independently be selected from the group consisting of:
a phenylene group, a naphthylene group, a fluorenylene group, a phenanthrenylene group, a pyridinylene group, a pyrazinylene group, a pyrimidinylene group, a quinolinylene group, an isoquinolinylene group, a benzoquinolinylene group, a benzoisoquinolinylene group, a naphthyridinylene group, a quinoxalinylene group, a quinazolinylene group, a phenanthridinylene group, a phenanthrolinylene group, a carbazolylene group, a triazinylene group, a dibenzofuranylene group, and a dibenzothiophenylene group; and
a phenylene group, a naphthylene group, a fluorenylene group, a phenanthrenylene group, a pyridinylene group, a pyrazinylene group, a pyrimidinylene group, a quinolinylene group, an isoquinolinylene group, a benzoquinolinylene group, a benzoisoquinolinylene group, a naphthyridinylene group, a quinoxalinylene group, a quinazolinylene group, a phenanthridinylene group, a phenanthrolinylene group, a carbazolylene group, a triazinylene group, a dibenzofuranylene group, and a dibenzothiophenylene group, each substituted with at least one selected from deuterium, -F, -Cl, -Br, -I, a cyano group, a methyl group, an ethyl group, an n-propyl group, an iso-propyl group, a tert-butyl group, a methoxy group, an ethoxy group, an n-propoxy group, an iso-propoxy group, tert-butoxy group, a cyclopropyl group, a cyclobutyl group, a cyclopentyl group, a cyclohexyl group, a phenyl group, a biphenyl group, a terphenyl group, a naphthyl group, a pyridinyl group, a pyrazinyl group, a pyrimidinyl group, a pyridazinyl group, a quinolinyl group, an isoquinolinyl group, a triazinyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂),
wherein Q₃₁ to Q₃₃ may each independently be selected from hydrogen, a methyl group, an ethyl group, an n-propyl group, an iso-propyl group, a tert-butyl group, a phenyl group, a naphthyl group, a biphenyl group, and a terphenyl group, but embodiments are not limited thereto.

In various embodiments, L₂₁ to L₂₆ in Formula 2 may each independently be selected from groups represented by Formulae 3-1 to 3-179, but are not limited thereto: 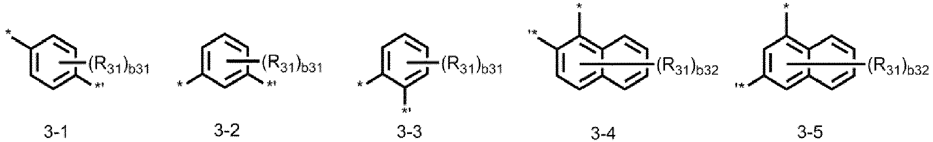 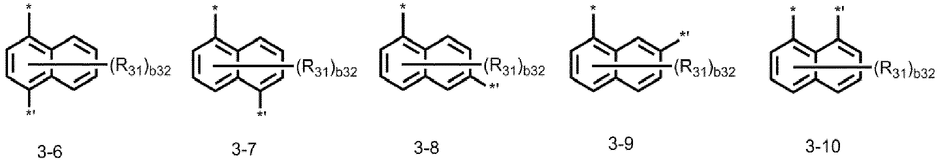 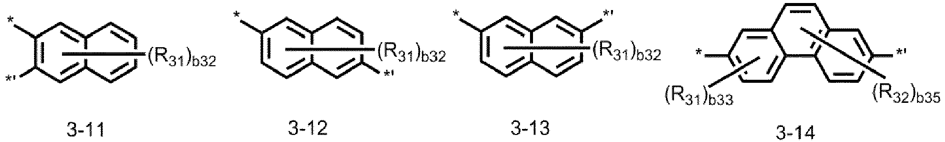 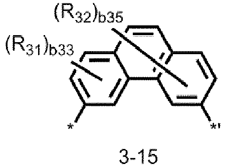 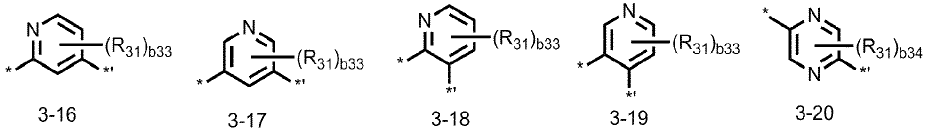 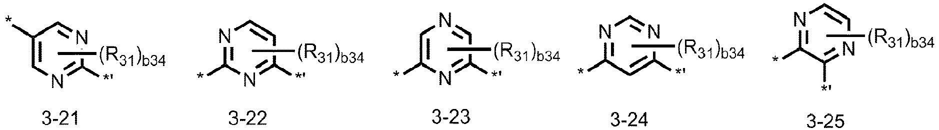 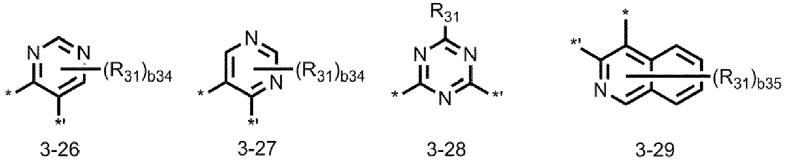 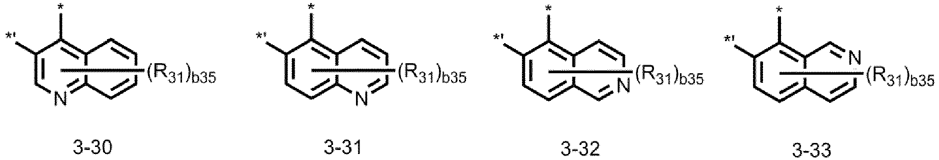 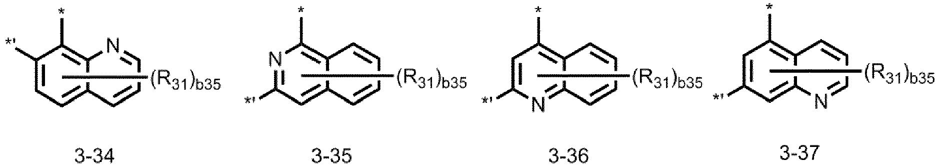 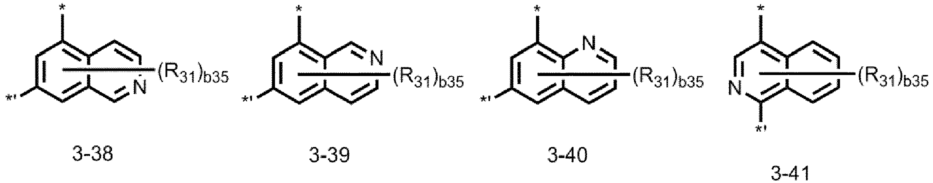 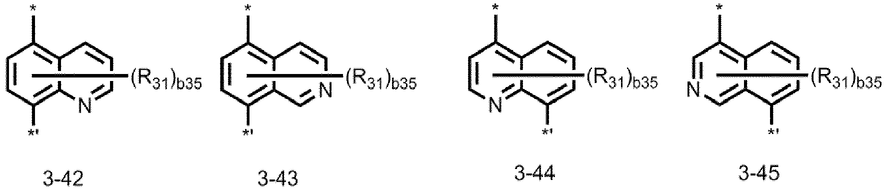 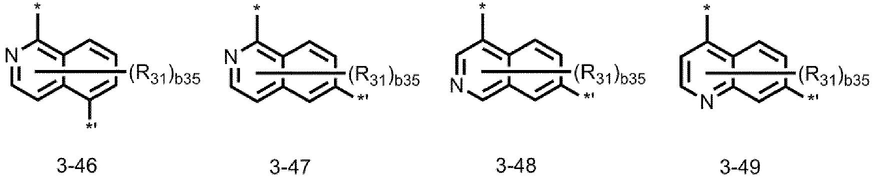 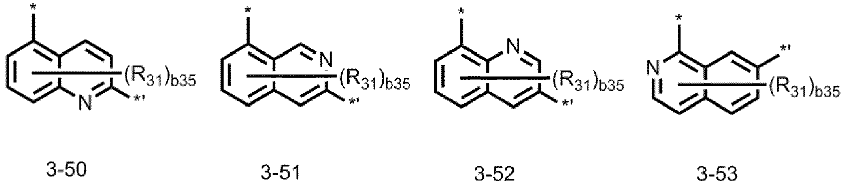 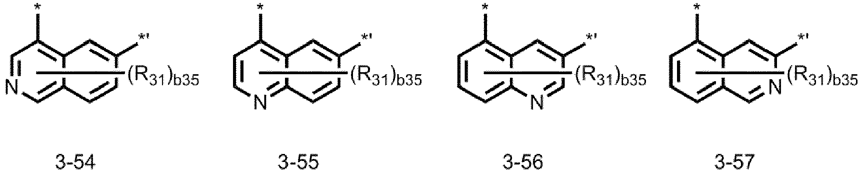 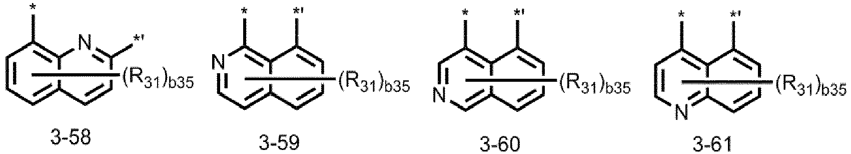 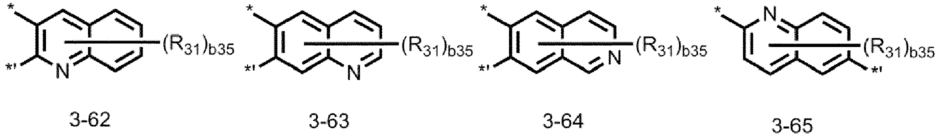 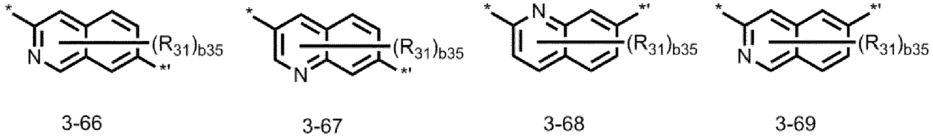 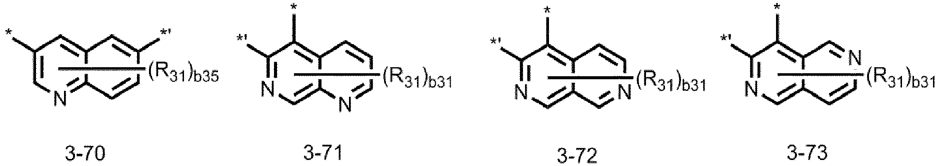 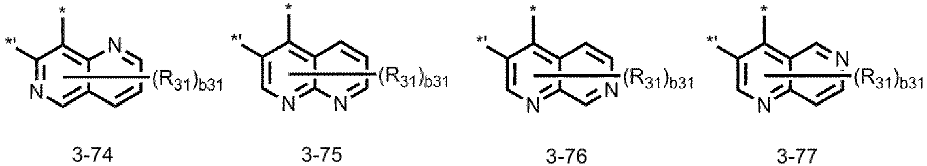 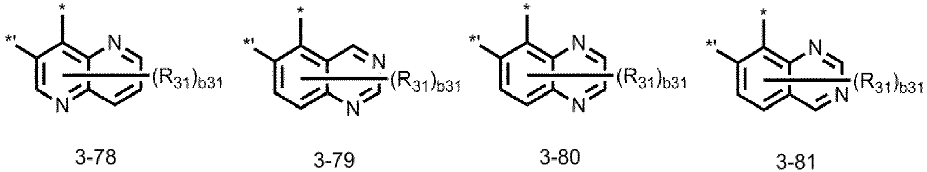 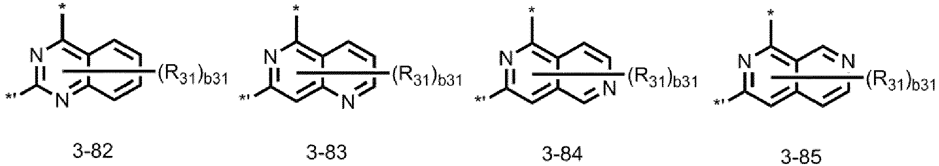 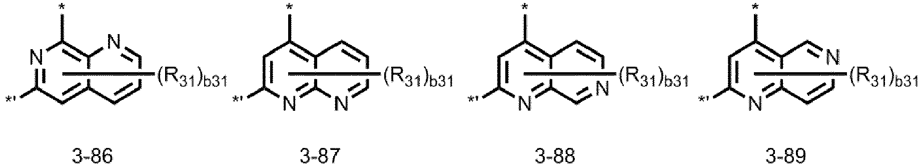 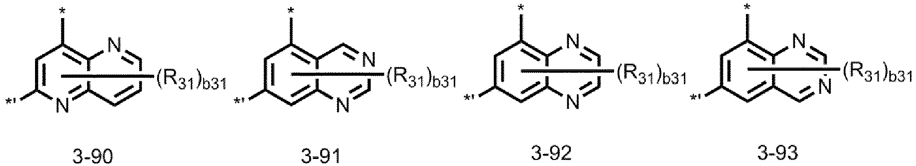 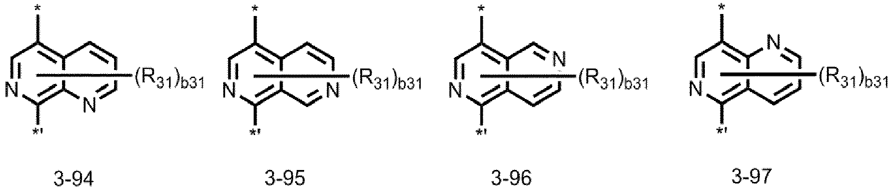 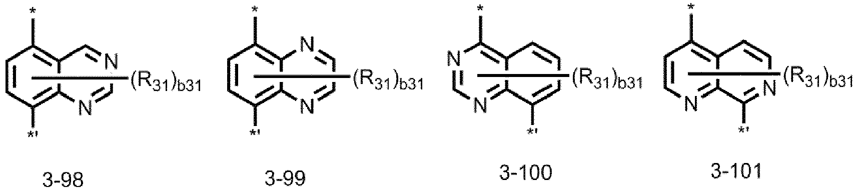 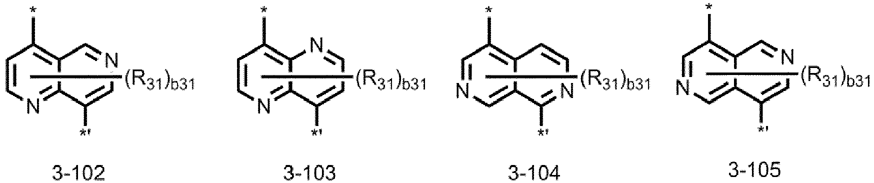 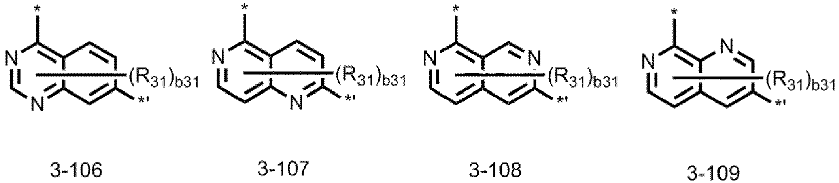 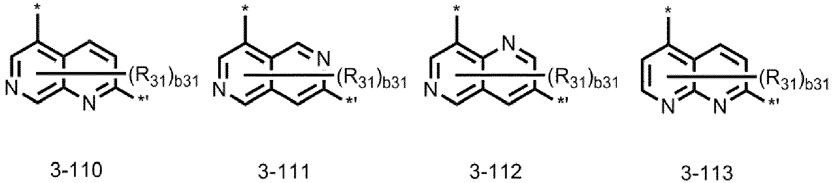 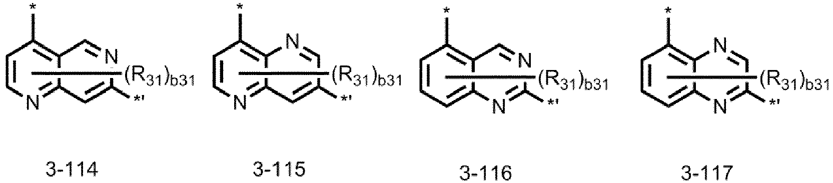 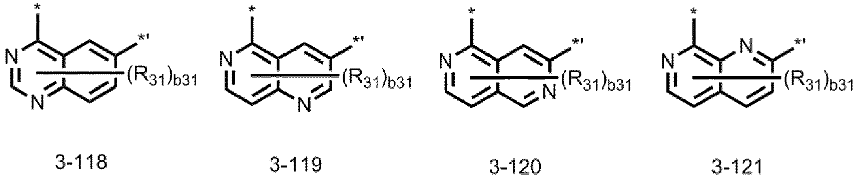 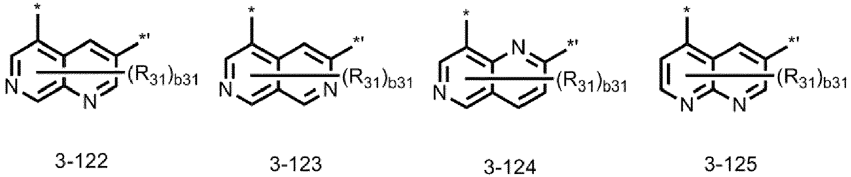 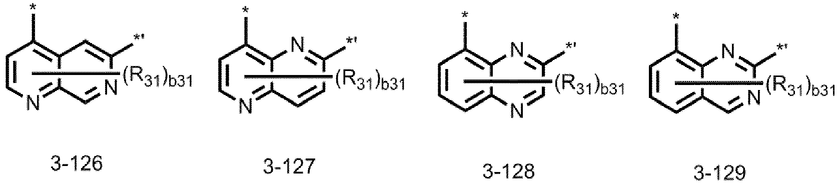 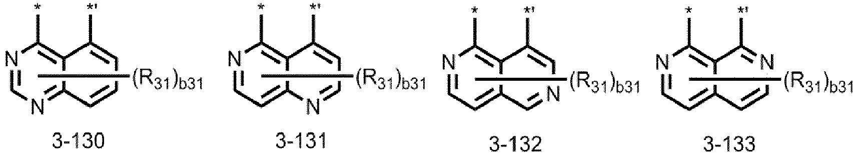 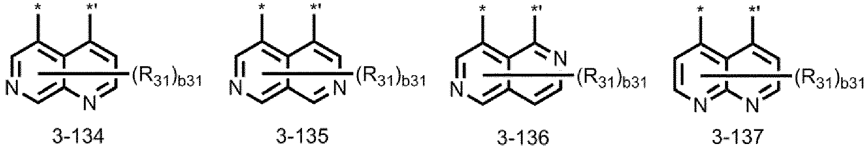 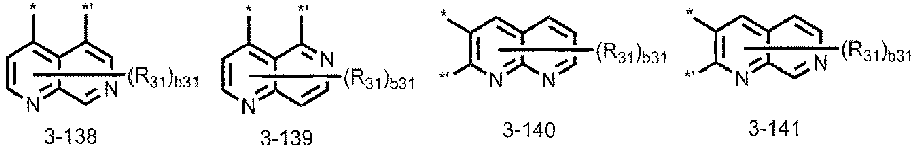 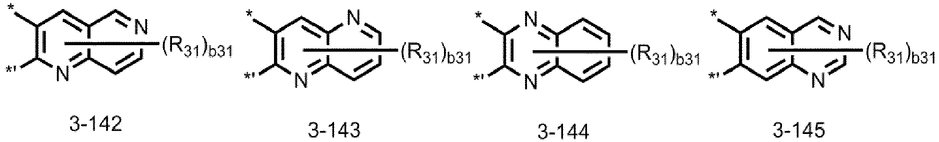 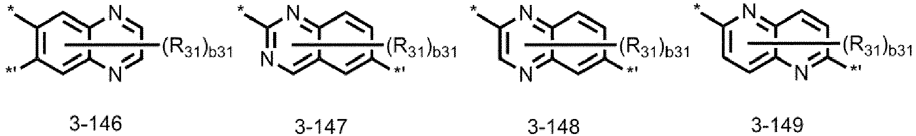 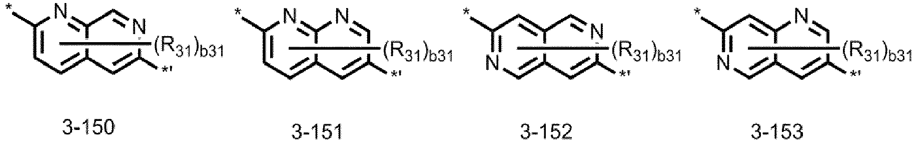 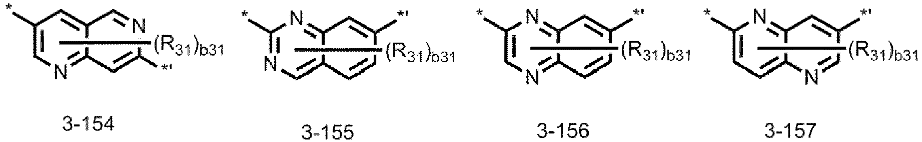 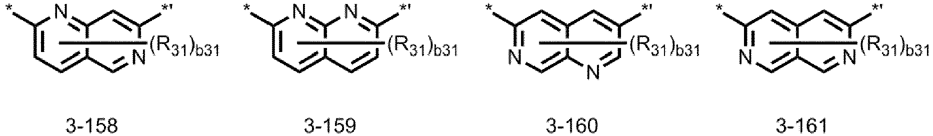 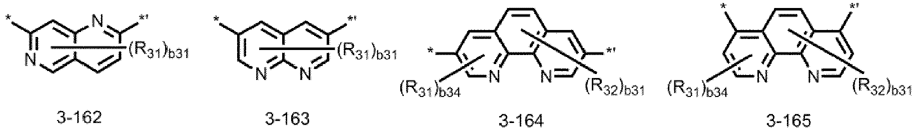 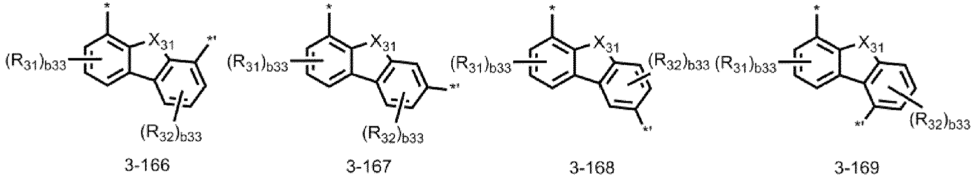 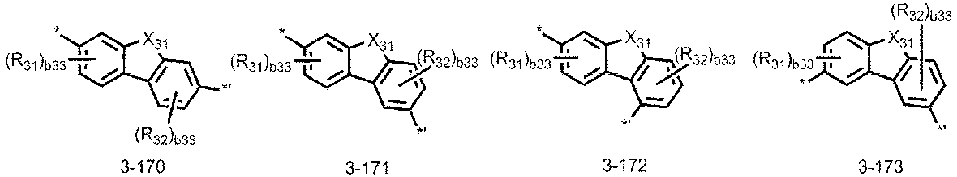 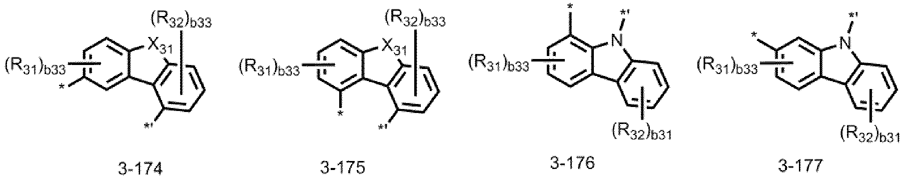 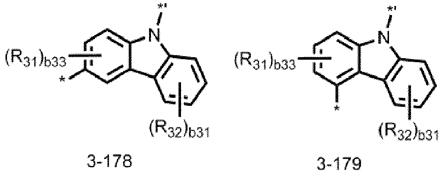 In Formulae 3-1 to 3-179,
X₃₁ may be selected from O, S, N(R₃₃), and C(R₃₃)(R₃₄);
R₃₁ to R₃₄ may each independently be selected from hydrogen, deuterium, - F, -Cl, -Br, -I, a cyano group, a methyl group, an ethyl group, an n-propyl group, an iso-propyl group, a tert-butyl group, a methoxy group, an ethoxy group, an n-propoxy group, an iso-propoxy group, tert-butoxy group, a cyclopropyl group, a cyclobutyl group, a cyclopentyl group, a cyclohexyl group, a phenyl group, a biphenyl group, a terphenyl group, a naphthyl group, a pyridinyl group, a pyrazinyl group, a pyrimidinyl group, a pyridazinyl group, a quinolinyl group, an isoquinolinyl group, a triazinyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂);
Q₃₁ to Q₃₃ may each independently be selected from hydrogen, a methyl group, an ethyl group, an n-propyl group, an iso-propyl group, a tert-butyl group, a phenyl group, a naphthyl group, a biphenyl group, and a terphenyl group;
b31 may be selected from 1, 2, 3 and 4;
b32 may be selected from 1, 2, 3, 4, 5 and 6;
b33 may be selected from 1, 2 and 3;
b34 may be selected from 1 and 2;
b35 may be selected from 1, 2, 3, 4 and 5; and
* and *' each indicate a binding site to a neighboring atom.
a21 in Formula 2 indicates the number of L₂₁(s), and a21 is selected from 0, 1, 2, and 3. When a21 is 0, (L₂₁)ₐ₂₁ may be a single bond. When a21 is two or more, a plurality of L₂₁(s) may be identical to or different from each other. Descriptions of a22 to a26 in Formula 2 may be each independently understood by referring to the description provided in connection with a21 and the structure of Formula 2. For example, a22 to a26 are independently selected from 0, 1, 2, and 3.

In various embodiments, a21 to a26 in Formula 2 may each independently be selected from 0 and 1, but are not limited thereto.

In various embodiments, L₂₃ to L₂₆ in Formula 2 may each independently be selected from groups represented by Formulae 3-1 to 3-15; and a23 to a26 may each independently be selected from 0 and 1, but embodiments are not limited thereto.

R₂₁ to R₂₄ in Formula 2 are each independently selected from a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group; R₂₁ and R₂₂ are optionally linked to each other to form a saturated ring or an unsaturated ring, and R₂₃ and R₂₄ are optionally linked to each other to form a saturated ring or an unsaturated ring.

For example, R₂₁ to R₂₄ in Formula 2 may each independently be selected from a substituted or unsubstituted C₁-C₂₀ alkyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₂ aryl group, a substituted or unsubstituted C₁-C₂₀ heteroaryl group, a substituted or unsubstituted monovalent non-aromatic condensed polycyclic group, and a substituted or unsubstituted monovalent non-aromatic condensed heteropolycyclic group; R₂₁ and R₂₂ may optionally be linked to each other to form a saturated ring or an unsaturated ring, and R₂₃ and R₂₄ may optionally be linked to each other to form a saturated ring or an unsaturated ring.

In various embodiments, R₂₁ to R₂₄ in Formula 2 may each independently be selected from the group consisting of:
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a spiro-benzofluorene-fluorenyl group, a spiro-cyclopentane-fluorenyl group, a spiro-cyclohexane-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a carbazolyl group, a benzocarbazolyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a benzonaphthofuranyl group, a dibenzothiophenyl group, a benzonaphthothiophenyl group, a benzocarbazolyl group, a dibenzocarbazolyl group, a thiadiazolyl group, an imidazopyridinyl group, an imidazopyrimidinyl group, a benzofuropyridinyl group, a benzofuropyrimidinyl group, a benzothienopyridinyl group, a benzothienopyrimidinyl group, an indenopyridinyl group, an indenopyrimidinyl group, an indolopyridinyl group, an indolopyrimidinyl group, and a diazafluorenyl group;
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a spiro-benzofluorene-fluorenyl group, a spiro-cyclopentane-fluorenyl group, a spiro-cyclohexane-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a carbazolyl group, a benzocarbazolyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a benzonaphthofuranyl group, a dibenzothiophenyl group, a benzonaphthothiophenyl group, a benzocarbazolyl group, a dibenzocarbazolyl group, a thiadiazolyl group, an imidazopyridinyl group, an imidazopyrimidinyl group, a benzofuropyridinyl group, a benzofuropyrimidinyl group, a benzothienopyridinyl group, a benzothienopyrimidinyl group, an indenopyridinyl group, an indenopyrimidinyl group, an indolopyridinyl group, an indolopyrimidinyl group, and a diazafluorenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkyl group substituted with deuterium, a C₁-C₂₀ alkyl group substituted with - F, a C₁-C₂₀ alkoxy group, a C₃-C₁₀ cycloalkyl group, a phenyl group, a phenyl group substituted with deuterium, a phenyl group substituted with a methyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a spiro-benzofluorene-fluorenyl group, a spiro-cyclopentane-fluorenyl group, a spiro-cyclohexane-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyridinyl group substituted with deuterium, a pyridinyl group substituted with a methyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a carbazolyl group, a benzocarbazolyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a benzonaphthofuranyl group, a dibenzothiophenyl group, a benzonaphthothiophenyl group, a benzocarbazolyl group, a dibenzocarbazolyl group, a thiadiazolyl group, an imidazopyridinyl group, an imidazopyrimidinyl group, a benzofuropyridinyl group, a benzofuropyrimidinyl group, a benzothienopyridinyl group, a benzothienopyrimidinyl group, an indenopyridinyl group, an indenopyrimidinyl group, an indolopyridinyl group, an indolopyrimidinyl group, a diazafluorenyl group, - N(Q₃₁)(Q₃₂), and -Si(Q₃₁)(Q₃₂)(Q₃₃); and
-N(Q₁)(Q₂) and -Si(Q₁)(Q₂)(Q₃),
wherein Q₁ to Q₃ and Q₃₁ to Q₃₃ may each independently be selected from a C₁-C₆₀ (*e.g.* C₁-C₂₀) alkyl group, a C₆-C₆₀ (*e.g.* C₆-C₃₂) aryl group, a C₁-C₆₀ (*e.g.* C₁-C₂₀) heteroaryl group, a monovalent non-aromatic condensed polycyclic group, a monovalent non-aromatic condensed heteropolycyclic group, a biphenyl group, and a terphenyl group, but embodiments are not limited thereto.

In various embodiments, R₂₁ to R₂₄ in Formula 2 may each independently be selected from the group consisting of:
a phenyl group, a biphenyl group, a terphenyl group, a naphthyl group, a fluorenyl group, a spiro-bifluorenyl group, a spiro-benzofluorene-fluorenyl group, a spiro-cyclopentane-fluorenyl group, a spiro-cyclohexane-fluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a pyrrolyl group, a thiophenyl group, a furanyl group, a pyridinyl group, a pyrazinyl group, a pyrimidinyl group, a quinolinyl group, an isoquinolinyl group, a benzoquinolinyl group, a benzoisoquinolinyl group, a carbazolyl group, a benzocarbazolyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a triazinyl group, a dibenzofuranyl group, a benzonaphthofuranyl group, a dibenzothiophenyl group, a benzonaphthothiophenyl group, a benzofuropyridinyl group, a benzofuropyrimidinyl group, a benzothienopyridinyl group, a benzothienopyrimidinyl group, an indenopyridinyl group, an indenopyrimidinyl group, an indolopyridinyl group, an indolopyrimidinyl group, and a diazafluorenyl group;
a phenyl group, a biphenyl group, a terphenyl group, a naphthyl group, a fluorenyl group, a spiro-bifluorenyl group, a spiro-benzofluorene-fluorenyl group, a spiro-cyclopentane-fluorenyl group, a spiro-cyclohexane-fluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a pyrrolyl group, a thiophenyl group, a furanyl group, a pyridinyl group, a pyrazinyl group, a pyrimidinyl group, a quinolinyl group, an isoquinolinyl group, a benzoquinolinyl group, a benzoisoquinolinyl group, a carbazolyl group, a benzocarbazolyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a triazinyl group, a dibenzofuranyl group, a benzonaphthofuranyl group, a dibenzothiophenyl group, a benzonaphthothiophenyl group, a benzofuropyridinyl group, a benzofuropyrimidinyl group, a benzothienopyridinyl group, a benzothienopyrimidinyl group, an indenopyridinyl group, an indenopyrimidinyl group, an indolopyridinyl group, an indolopyrimidinyl group, and a diazafluorenyl group, each substituted with at least one selected from deuterium, -F, - CI, -Br, -I, a hydroxyl group, a cyano group, a nitro group, an amidino group, a hydrazino group, a hydrazono group, a C₁-C₂₀ alkyl group, a C₁-C₂₀ alkyl group substituted with deuterium, a C₁-C₂₀ alkyl group substituted with -F, a C₁-C₂₀ alkoxy group, a C₃-C₁₀ cycloalkyl group, a phenyl group, a phenyl group substituted with deuterium, a phenyl group substituted with a methyl group, a biphenyl group, a terphenyl group, a naphthyl group, a fluorenyl group, a spiro-bifluorenyl group, a spiro-benzofluorene-fluorenyl group, a spiro-cyclopentane-fluorenyl group, a spiro-cyclohexane-fluorenyl group, a benzofluorenyl group, a dibenzofluorenyl group, a phenanthrenyl group, an anthracenyl group, a triphenylenyl group, a pyrenyl group, a tetraphenyl group, a chrysenyl group, a pyrrolyl group, a thiophenyl group, a furanyl group, a pyridinyl group, a pyridinyl group substituted with deuterium, a pyridinyl group substituted with a methyl group, a pyrazinyl group, a pyrimidinyl group, a quinolinyl group, an isoquinolinyl group, a benzoquinolinyl group, a benzoisoquinolinyl group, a carbazolyl group, a carbolinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a triazinyl group, a dibenzofuranyl group, a dibenzothiophenyl group, a benzofuropyridinyl group, a benzofuropyrimidinyl group, a benzothienopyridinyl group, a benzothienopyrimidinyl group, an indenopyridinyl group, an indenopyrimidinyl group, an indolopyridinyl group, an indolopyrimidinyl group, a diazafluorenyl group, -N(Q₃₁)(Q₃₂), and -Si(Q₃₁)(Q₃₂)(Q₃₃); and
-N(Q₁)(Q₂) and -Si(Q₁)(Q₂)(Q₃), and
wherein Q₁ to Q₃ and Q₃₁ to Q₃₃ may each independently be selected from a C₁-C₂₀ alkyl group, a C₆-C₆₀ (*e.g*. C₆-C₃₂) aryl group, a biphenyl group, and a terphenyl group, but embodiments are not limited thereto.

In various embodiments, R₂₁ to R₂₄ in Formula 2 may each independently be selected from the group consisting of:
a phenyl group, a biphenyl group, a terphenyl group, a naphthyl group, a fluorenyl group, a spiro-bifluorenyl group, a spiro-benzofluorene-fluorenyl group, a spiro-cyclopentane-fluorenyl group, a spiro-cyclohexane-fluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a pyridinyl group, a pyrimidinyl group, a quinolinyl group, an isoquinolinyl group, a benzoquinolinyl group, a benzoisoquinolinyl group, a carbazolyl group, a benzocarbazolyl group, a naphthyridinyl group, a quinoxalinyl group, a quinazolinyl group, a phenanthridinyl group, a phenanthrolinyl group, a benzimidazolyl group, a triazinyl group, a dibenzofuranyl group, a benzonaphthofuranyl group, a dibenzothiophenyl group, a benzonaphthothiophenyl group, a benzofuropyridinyl group, a benzofuropyrimidinyl group, a benzothienopyridinyl group, a benzothienopyrimidinyl group, an indenopyridinyl group, an indenopyrimidinyl group, an indolopyridinyl group, an indolopyrimidinyl group, and a diazafluorenyl group;
a phenyl group, a biphenyl group, a terphenyl group, a naphthyl group, a fluorenyl group, a spiro-bifluorenyl group, a spiro-benzofluorene-fluorenyl group, a spiro-cyclopentane-fluorenyl group, a spiro-cyclohexane-fluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a pyridinyl group, a pyrimidinyl group, a quinolinyl group, an isoquinolinyl group, a benzoquinolinyl group, a benzoisoquinolinyl group, a carbazolyl group, a benzocarbazolyl group, a naphthyridinyl group, a quinoxalinyl group, a quinazolinyl group, a phenanthridinyl group, a phenanthrolinyl group, a benzimidazolyl group, a triazinyl group, a dibenzofuranyl group, a benzonaphthofuranyl group, a dibenzothiophenyl group, a benzonaphthothiophenyl group, a benzofuropyridinyl group, a benzofuropyrimidinyl group, a benzothienopyridinyl group, a benzothienopyrimidinyl group, an indenopyridinyl group, an indenopyrimidinyl group, an indolopyridinyl group, an indolopyrimidinyl group, and a diazafluorenyl group, each substituted with at least one selected from deuterium, -F, -Cl, -Br, -I, a hydroxyl group, a cyano group, a nitro group, an amidino group, a hydrazino group, a hydrazono group, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a neo-pentyl group, -CDH₂, - CD₂H, -CD₃, -CFH₂, -CF₂H, -CF₃, a methoxy group, an ethoxy group, an n-propoxy group, an iso-propoxy group, an n-butoxy group, an iso-butoxy group, a sec-butoxy group, a tert-butoxy group, an n-pentoxy group, an iso-pentoxy group, a sec-pentoxy group, a tert-pentoxy group, a neo-pentoxy group, a cyclopropyl group, a cyclobutyl group, a cyclopentyl group, a cyclohexyl group, a phenyl group, D₅-Ph, 2-Me-Ph, 3-Me-Ph, 4-Me-Ph, a biphenyl group, a terphenyl group, a naphthyl group, a fluorenyl group, a spiro-bifluorenyl group, a spiro-benzofluorene-fluorenyl group, a spiro-cyclopentane-fluorenyl group, a spiro-cyclohexane-fluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a pyridinyl group, D₅-Py, 2-Me-1-Py, 3-Me-1-Py, 4-Me-1-Py, 5-Me-1-Py, 1-Me-2-Py, 3-Me-2-Py, 4-Me-2-Py, 5-Me-2-Py, 1-Me-3-Py, 2-Me-3-Py, 4-Me-3-Py, 5-Me-3-Py, a pyrimidinyl group, a quinolinyl group, an isoquinolinyl group, a benzoquinolinyl group, a benzoisoquinolinyl group, a carbazolyl group, a benzocarbazolyl group, a naphthyridinyl group, a quinoxalinyl group, a quinazolinyl group, a phenanthridinyl group, a phenanthrolinyl group, a benzimidazolyl group, a triazinyl group, a dibenzofuranyl group, a benzonaphthofuranyl group, a dibenzothiophenyl group, a benzonaphthothiophenyl group, a benzofuropyridinyl group, a benzofuropyrimidinyl group, a benzothienopyridinyl group, a benzothienopyrimidinyl group, an indenopyridinyl group, an indenopyrimidinyl group, an indolopyridinyl group, an indolopyrimidinyl group, a diazafluorenyl group, -N(Q₃₁)(Q₃₂), and -Si(Q₃₁)(Q₃₂)(Q₃₃); and
-N(Q₁)(Q₂) and -Si(Q₁)(Q₂)(Q₃),
wherein Q₁ to Q₃ and Q₃₁ to Q₃₃ may each independently be selected from a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a neo-pentyl group, a phenyl group, a biphenyl group, a terphenyl group and a naphthyl group, but embodiments are not limited thereto.

In various embodiments, R₂₁ to R₂₄ in Formula 2 may each independently be selected from groups represented by Formulae 5-1 to 5-128, but are not limited thereto.

R₂₀₁ to R₂₀₇ in Formulae 2A and 2B are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), - C(=O)(Q₁), -S(=O)₂(Q₁), and -P(=O)(Q₁)(Q₂); and R₂₀₄ and R₂₀₅ may optionally be linked to each other to form a saturated ring or an unsaturated ring, and R₂₀₆ and R₂₀₇ may optionally be linked to each other to form a saturated ring or an unsaturated ring,
wherein Q₁ to Q₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

For example, R₂₀₁ to R₂₀₇ in Formulae 2A and 2B may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₂-C₂₀ alkenyl group, a substituted or unsubstituted C₂-C₂₀ alkynyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂); and R₂₀₄ and R₂₀₅ may optionally be linked to each other to form a saturated ring or an unsaturated ring, and R₂₀₆ and R₂₀₇ may optionally be linked to each other to form a saturated ring or an unsaturated ring,
wherein Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₂-C₂₀ alkenyl group, a C₂-C₂₀ alkynyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₃₀ aryl group, a C₁-C₂₀ heteroaryl group, a monovalent non-aromatic condensed polycyclic group, a monovalent non-aromatic condensed heteropolycyclic group, a biphenyl group, and a terphenyl group.

In various embodiments, R₂₀₁ to R₂₀₇ in Formulae 2A and 2B may each independently be selected from hydrogen, deuterium, -F, -Cl, -Br, -I, a cyano group, a substituted or unsubstituted C₁-C₆₀ (e.g. C₁-C₂₀) alkyl group, a substituted or unsubstituted C₆-C₆₀ (*e.g*. C₆-C₃₀) aryl group, a substituted or unsubstituted C₁-C₆₀ (*e.g*. C₁-C₂₀) heteroaryl group, a substituted or unsubstituted monovalent non-aromatic condensed polycyclic group, a substituted or unsubstituted monovalent non-aromatic condensed heteropolycyclic group, -N(Q₁)(Q₂), and -Si(Q₁)(Q₂)(Q₃);
Q₁ to Q₃ may each independently be selected from a C₁-C₆₀ (*e.g*. C₁-C₂₀) alkyl group, a C₆-C₆₀ *(e.g.* C₆-C₃₀) aryl group, a C₁-C₆₀ (*e.g.* C₁-C₂₀) heteroaryl group, a monovalent non-aromatic condensed polycyclic group, a monovalent non-aromatic condensed heteropolycyclic group, a biphenyl group, and a terphenyl group; and
R₂₀₄ and R₂₀₅ may optionally be linked to each other to form a saturated ring or an unsaturated ring, and R₂₀₆ and R₂₀₇ may optionally be linked to each other to form a saturated ring or an unsaturated ring, but are not limited thereto.

In various embodiments, R₂₀₁ to R₂₀₇ in Formulae 2A and 2B may each independently be selected from the group consisting of:
hydrogen, deuterium, -F, -Cl, -Br, -I, a cyano group, a C₁-C₆₀ (*e.g*. C₁-C₂₀) alkyl group, a C₆-C₆₀ (*e.g.* C₆-C₃₀) aryl group, a C₁-C₆₀ (*e.g.* C₁-C₂₀) heteroaryl group, a monovalent non-aromatic condensed polycyclic group, a monovalent non-aromatic condensed heteropolycyclic group, -N(Q₁)(Q₂), and -Si(Q₁)(Q₂)(Q₃); and
a C₆-C₆₀ (*e.g.* C₆-C₃₀) aryl group, a C₁-C₆₀ (*e.g.* C₁-C₂₀) heteroaryl group, a monovalent non-aromatic condensed polycyclic group, and a monovalent non-aromatic condensed heteropolycyclic group, each substituted with at least one selected from a C₁-C₂₀ alkyl group, a phenyl group, a biphenyl group, a terphenyl group, a naphthyl group, a pyridinyl group, a pyrimidinyl group, a pyridazinyl group, and a triazinyl group;
where Q₁ to Q₃ may each independently be selected from a C₁-C₆₀ (*e.g*. C₁-C₂₀) alkyl group, a C₆-C₆₀ (*e.g.* C₆-C₃₀) aryl group, a biphenyl group, and a terphenyl group; and
R₂₀₄ and R₂₀₅ may optionally be linked to each other to form a saturated ring or an unsaturated ring, and R₂₀₆ and R₂₀₇ may optionally be linked to each other to form a saturated ring or an unsaturated ring, but are not limited thereto.

In various embodiments, R₂₀₁ to R₂₀₇ in Formulae 2A and 2B may each independently be selected from the group consisting of:
hydrogen, deuterium, -F, -Cl, -Br, -I, a cyano group, a methyl group, an ethyl group, an n-propyl group, an iso-propyl group, an n-butyl group, a sec-butyl group, an iso-butyl group, a tert-butyl group, a phenyl group, a biphenyl group, a terphenyl group, a naphthyl group, a pyridinyl group, -N(Q₁)(Q₂), and -Si(Q₁)(Q₂)(Q₃); and
a phenyl group, a biphenyl group, a terphenyl group, a naphthyl group, and a pyridinyl group, each substituted with at least one selected from a methyl group, an ethyl group, an n-propyl group, an iso-propyl group, an n-butyl group, a sec-butyl group, an iso-butyl group, a tert-butyl group, a phenyl group, a biphenyl group, a terphenyl group, a naphthyl group, and a pyridinyl group;
where Q₁ to Q₃ may each independently be selected from a methyl group, an ethyl group, an n-propyl group, an iso-propyl group, and a phenyl group; and
R₂₀₄ and R₂₀₅ may optionally be linked to each other to form a saturated ring or an unsaturated ring, and R₂₀₆ and R₂₀₇ may optionally be linked to each other to form a saturated ring or an unsaturated ring, but are not limited thereto.

In various embodiments, in Formulae 2A and 2B, when X₂₁ is C(R₂₀₄)(R₂₀₅), R₂₀₄ and R₂₀₅ may be optionally linked to each other to form a group represented by one of Formulae 9-1 and 9-2; and
when X₂₂ is C(R₂₀₆)(R₂₀₇), R₂₀₆ and R₂₀₇ may optionally be linked to each other to form a group represented by one of Formulae 9-1 and 9-2, but they are not limited thereto: 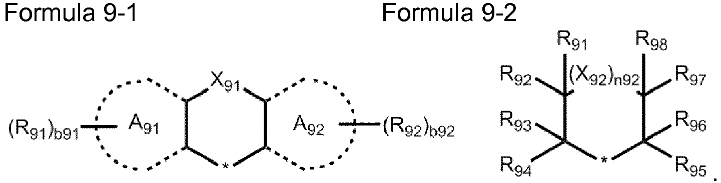 In Formulae 9-1 and 9-2,
X₉₁ may be selected from a single bond, O, S, Se, C(R₉₃)(R₉₄), Si(R₉₃)(R₉₄), and Ge(R₉₃)(R₉₄);
X₉₂ may be C(R₉₉)(R₁₀₀);
n92 may be selected from 0, 1, and 2;
A₉₁ and A₉₂ may each independently be selected from a C₆-C₂₀ arene group and a C₁-C₂₀ heteroarene group; and
R₉₁ to R₁₀₀ may each independently be selected from hydrogen, deuterium, - F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂),
wherein Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group;
b91 and b92 may each independently be selected from 1, 2, 3, 4, 5, 6, 7, 8, 9, and 10; and
* indicates a carbon atom in Formulae 2-1 and 2-2 (e.g., the carbon atom in C(R₂₀₆)(R₂₀₇)).

In various embodiments, n92 in Formulae 9-1 and 9-2 may be selected from 0 and 1, but is not limited thereto. When n92 is 0, (X₉₂)ₙ₉₂ indicates a single bond.

In various embodiments, A₉₁ and A₉₂ may each independently be selected from a C₆-C₁₀ arene group and a C₅-C₉ heteroarene group.

In various embodiments, A₉₁ and A₉₂ in Formulae 9-1 and 9-2 may each independently be selected from a benzene group, a naphthalene group, a pyridine group, a quinoline group, and an isoquinoline group, but are not limited thereto.

In various embodiments, A₉₁ and A₉₂ in Formulae 9-1 and 9-2 may each independently be selected from a benzene group, a naphthalene group, and a pyridine group, but are not limited thereto.

In various embodiments R₉₁ to R₁₀₀ may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₂-C₂₀ alkenyl group, a substituted or unsubstituted C₂-C₂₀ alkynyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), - C(=O)(Q₁), -S(=O)₂(Q₁), and -P(=O)(Q₁)(Q₂),
wherein Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₂-C₂₀ alkenyl group, a C₂-C₂₀ alkynyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₃₀ aryl group, a C₁-C₂₀ heteroaryl group, a monovalent non-aromatic condensed polycyclic group, a monovalent non-aromatic condensed heteropolycyclic group, a biphenyl group, and a terphenyl group.

In various embodiments, R₉₁ to R₁₀₀ in Formulae 9-1 and 9-2 may each independently be selected from hydrogen, deuterium, -F, -Cl, -Br, -I, a cyano group, a substituted or unsubstituted C₁-C₆₀ (*e.g*. C₁-C₂₀) alkyl group, a substituted or unsubstituted C₆-C₆₀ (*e.g*. C₆-C₃₀) aryl group, a substituted or unsubstituted C₁-C₆₀ (*e.g*. C₁-C₂₀) heteroaryl group, a substituted or unsubstituted monovalent non-aromatic condensed polycyclic group, a substituted or unsubstituted monovalent non-aromatic condensed heteropolycyclic group, -N(Q₁)(Q₂), and -Si(Q₁)(Q₂)(Q₃),
wherein Q₁ to Q₃ may each independently be selected from a C₁-C₆₀ (*e.g*. C₁-C₂₀) alkyl group, a C₆-C₆₀ (*e.g.* C₆-C₃₀) aryl group, a C₁-C₆₀ (*e.g.* C₁-C₂₀) heteroaryl group, a monovalent non-aromatic condensed polycyclic group, a monovalent non-aromatic condensed heteropolycyclic group, a biphenyl group, and a terphenyl group, but are not limited thereto.

In various embodiments, R₉₁ to R₁₀₀ in Formulae 9-1 and 9-2 may each independently be selected from the group consisting of:
hydrogen, deuterium, -F, -Cl, -Br, -I, a cyano group, a C₁-C₆₀ (*e.g*. C₁-C₂₀) alkyl group, a C₆-C₆₀ (*e.g.* C₆-C₃₀) aryl group, a C₁-C₆₀ (*e.g.* C₁-C₂₀) heteroaryl group, a monovalent non-aromatic condensed polycyclic group, a monovalent non-aromatic condensed heteropolycyclic group, -N(Q₁)(Q₂), and -Si(Q₁)(Q₂)(Q₃); and
a C₆-C₆₀ (*e.g.* C₆-C₃₀) aryl group, a C₁-C₆₀ (*e.g.* C₁-C₂₀) heteroaryl group, a monovalent non-aromatic condensed polycyclic group, and a monovalent non-aromatic condensed heteropolycyclic group, each substituted with at least one selected from a C₁-C₂₀ alkyl group, a phenyl group, a biphenyl group, a terphenyl group, a naphthyl group, a pyridinyl group, a pyrimidinyl group, a pyridazinyl group, and a triazinyl group,
wherein Q₁ to Q₃ may each independently be selected from a C₁-C₆₀ (*e.g*. C₁-C₂₀) alkyl group, a C₆-C₆₀ (*e.g*. C₆-C₃₀) aryl group, a biphenyl group, and a terphenyl group, but are not limited thereto.

In various embodiments, R₉₁ to R₁₀₀ in Formulae 9-1 and 9-2 may each independently be selected from the group consisting of:
hydrogen, deuterium, -F, -Cl, -Br, -I, a cyano group, a methyl group, an ethyl group, an n-propyl group, an iso-propyl group, an n-butyl group, a sec-butyl group, an iso-butyl group, a tert-butyl group, a phenyl group, a biphenyl group, a terphenyl group, a naphthyl group, a pyridinyl group, -N(Q₁)(Q₂), and -Si(Q₁)(Q₂)(Q₃); and
a phenyl group, a biphenyl group, a terphenyl group, a naphthyl group, and a pyridinyl group, each substituted with at least one selected from a methyl group, an ethyl group, an n-propyl group, an iso-propyl group, an n-butyl group, a sec-butyl group, an iso-butyl group, a tert-butyl group, a phenyl group, a biphenyl group, a terphenyl group, a naphthyl group, and a pyridinyl group,
wherein Q₁ to Q₃ may each independently be selected from a methyl group, an ethyl group, an n-propyl group, an iso-propyl group, and a phenyl group, but are not limited thereto.

b201 in Formulae 2A and 2B indicates the number of R₂₀₁(s), and b201 is selected from 1, 2, 3, 4, 5, 6, 7, 8, 9, and 10. When b201 is 2 or more, a plurality of R₂₀₁(S) may be identical to or different from each other. Descriptions of b202 and b203 in Formulae 2A and 2B are each independently understood by referring to the description of b201 and the corresponding structures of Formulae 2A and 2B, for example, b202 and b203 are each independently selected from 1, 2, 3, 4, 5, 6, 7, 8, 9, and 10.

In various embodiments, the group represented by Formula 2A may be represented by one of Formulae 2A-1 to 2A-5, and the group represented by Formula 2B may be represented by one of Formulae 2B-1 to 2B-3, but these groups are not limited thereto: 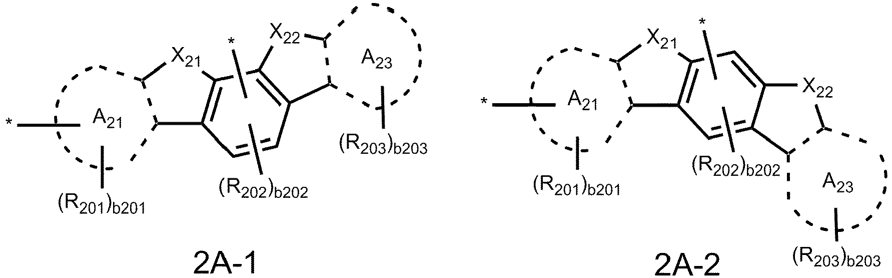 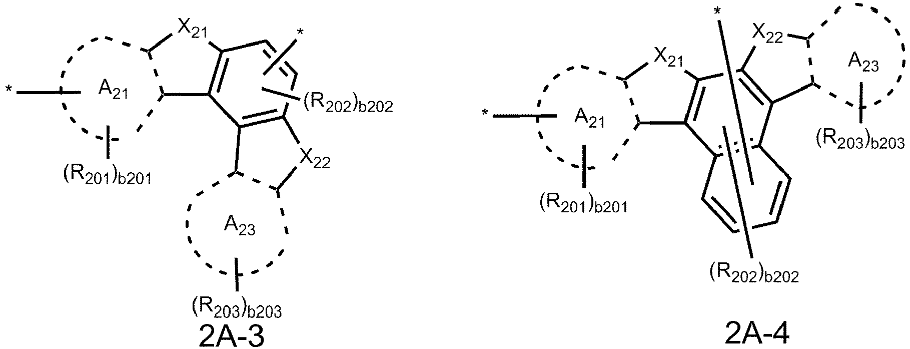 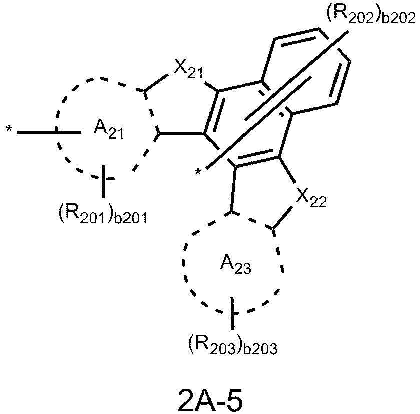 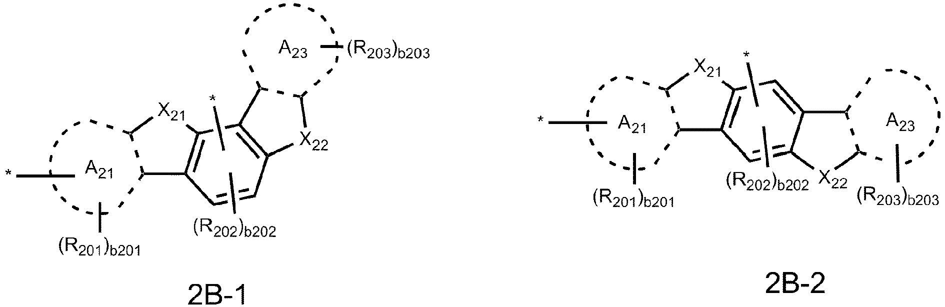 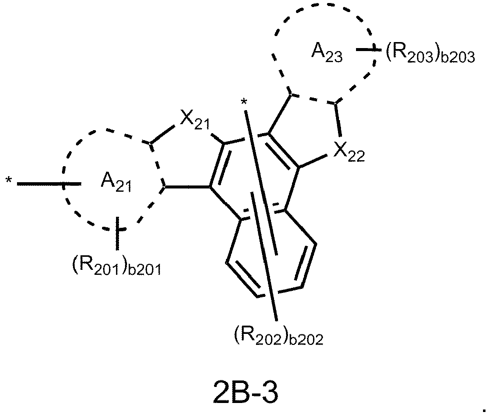 In Formulae 2A-1 to 2A-5 and 2B-1 to 2B-3,
X₂₁, X₂₂, A₂₁, A₂₃, R₂₀₁ to R₂₀₃ and b201 to b203 may be understood by referring to the descriptions thereof provided in connection with Formulae 2A and 2B; and
* indicates a binding site to a neighboring atom.

In the present invention the first compound is selected from Compounds H1 to H116:

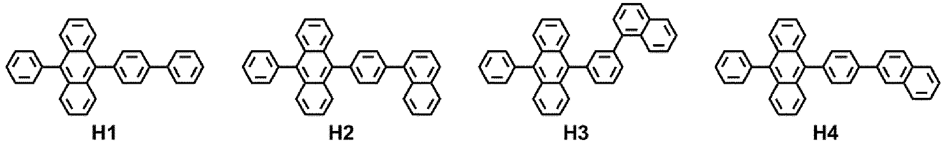

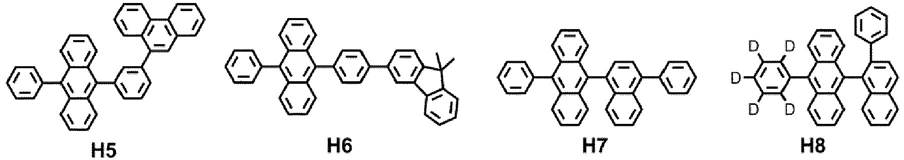

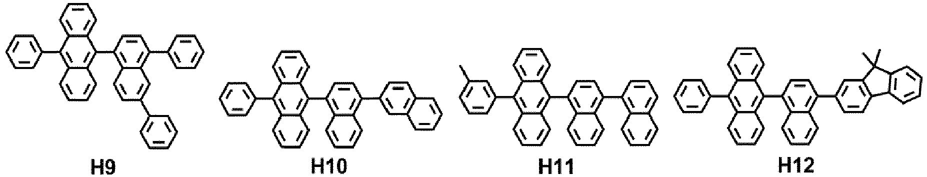

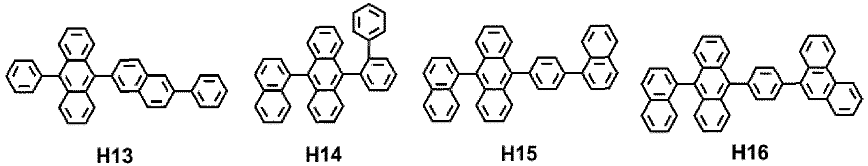

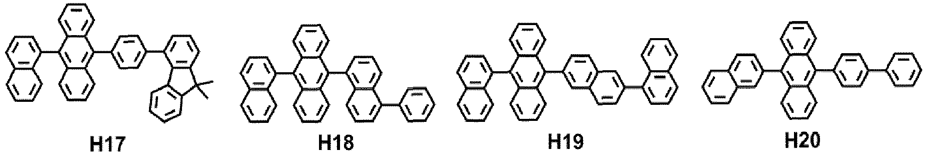

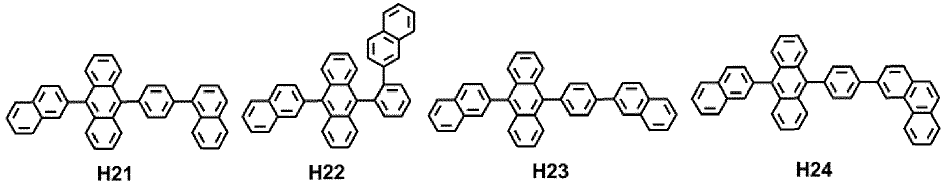

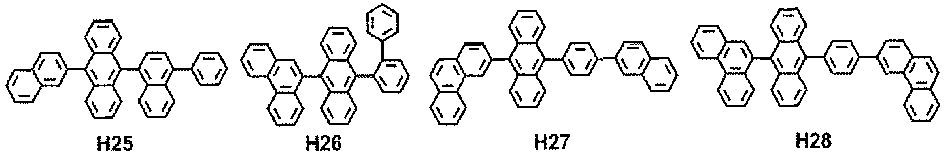

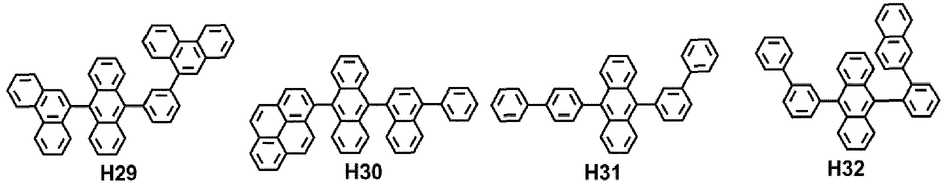

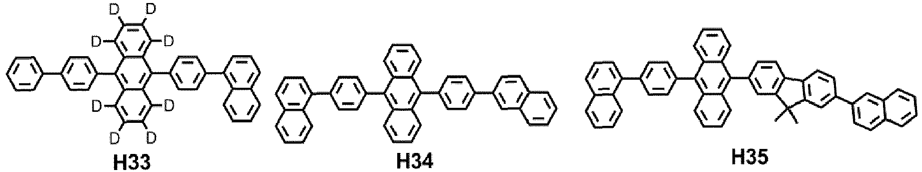

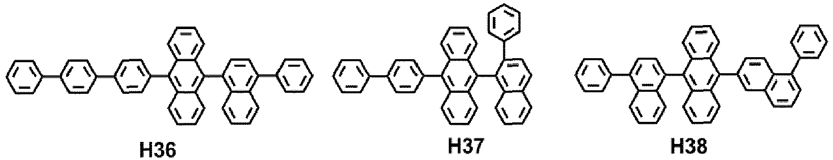

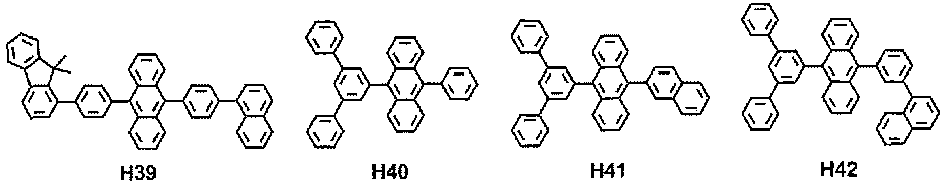

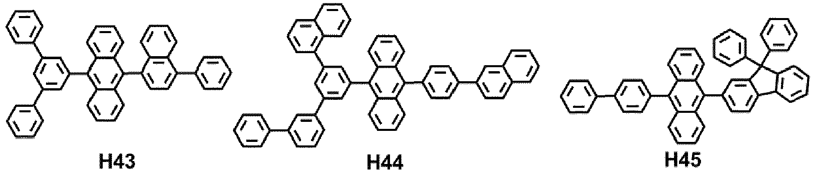

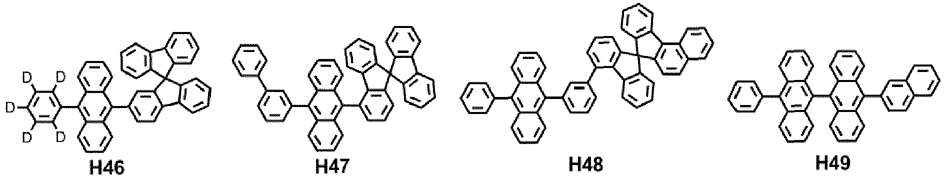

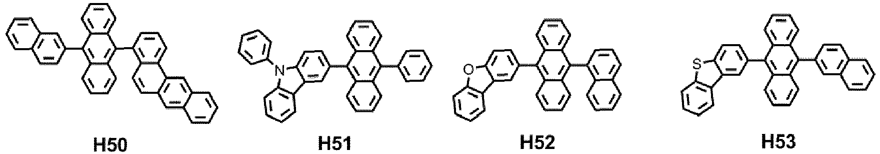

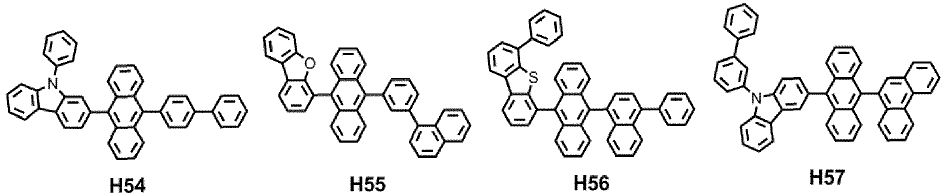

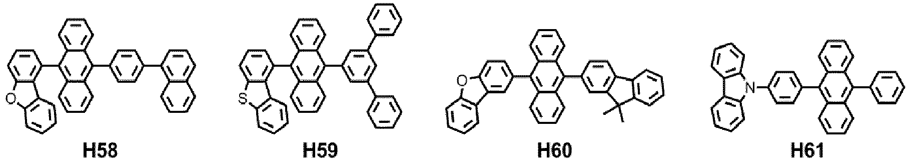

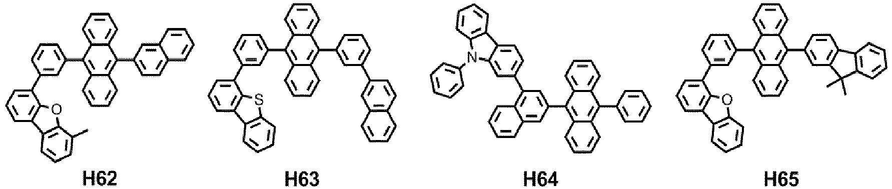

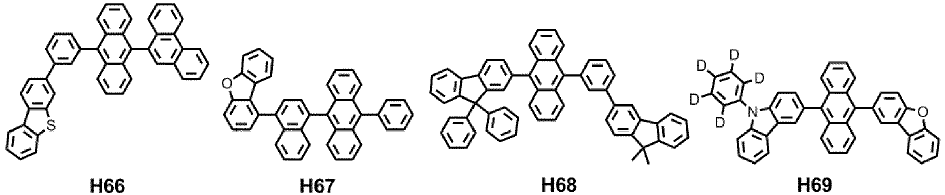

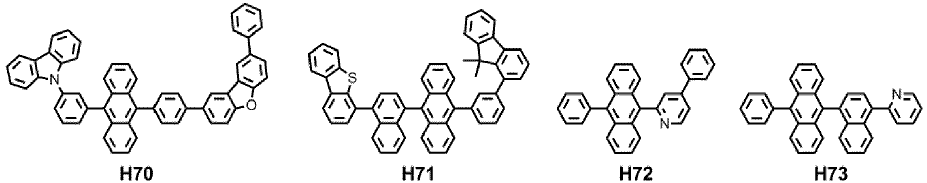

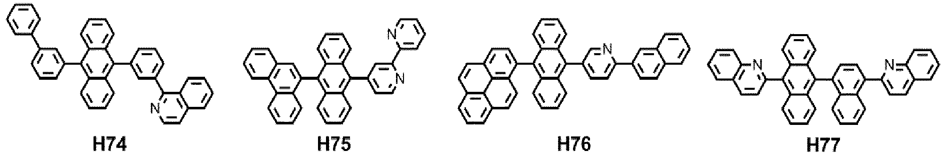

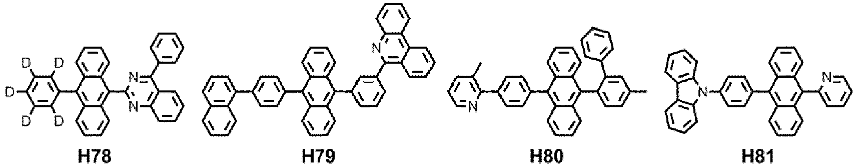

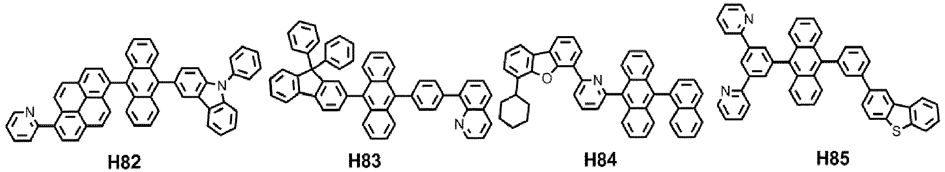

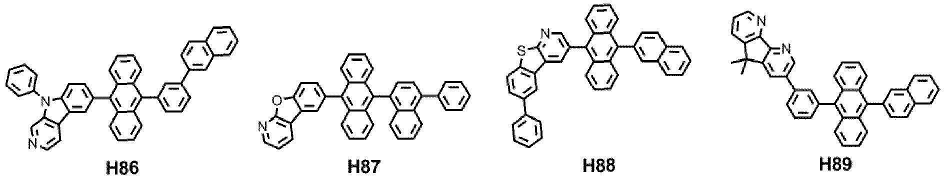

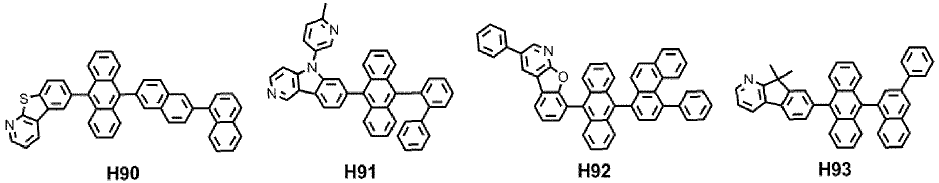

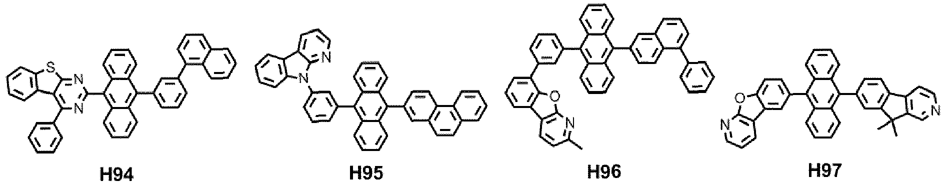

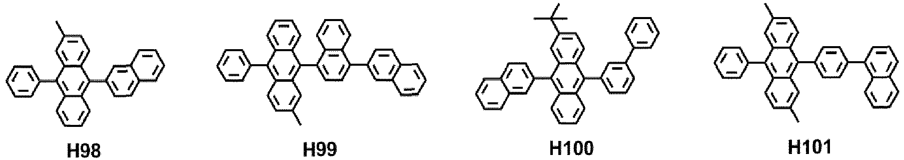

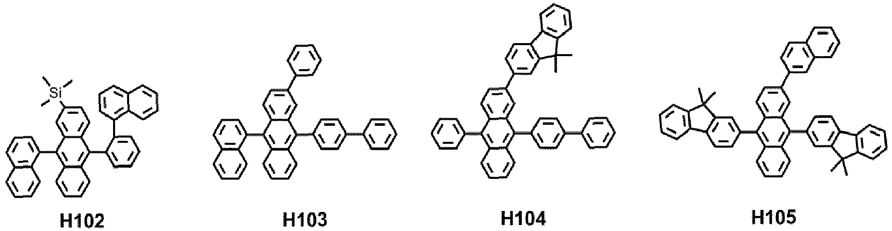

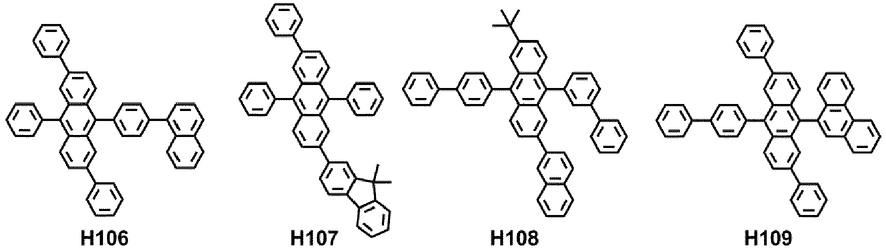

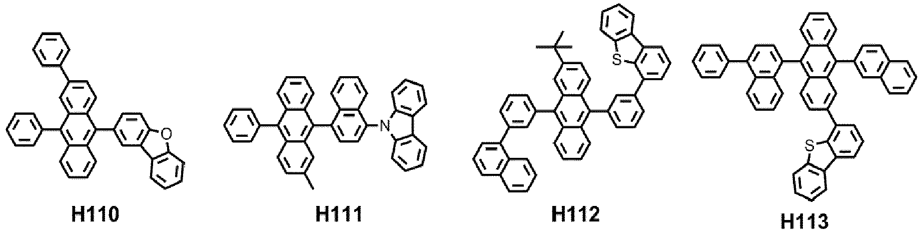

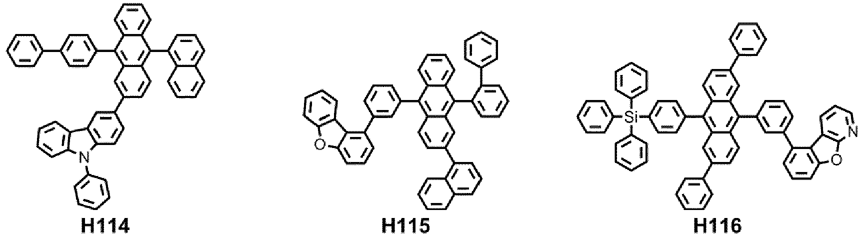

In one embodiment, the second compound represented by Formula 2 is selected from Compounds D1 to D212, but is not limited thereto:

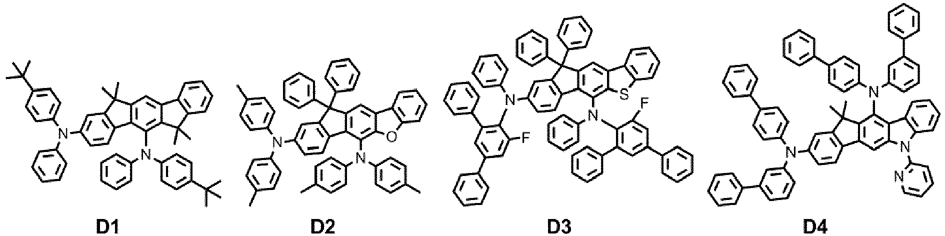

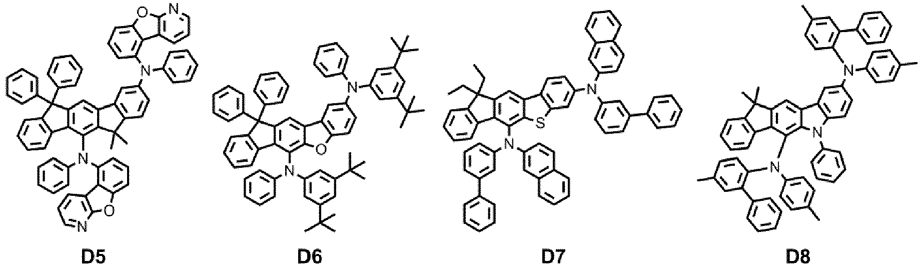

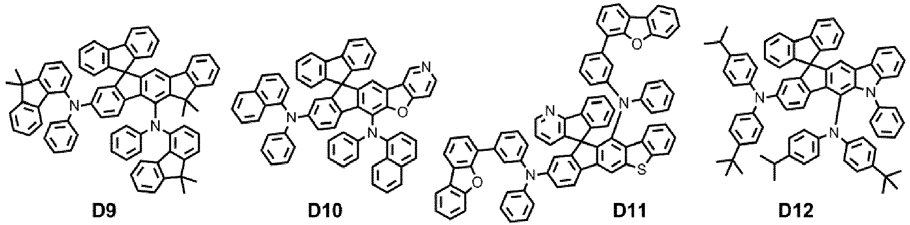

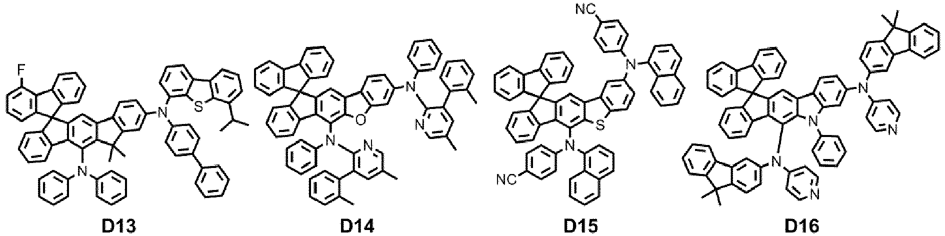

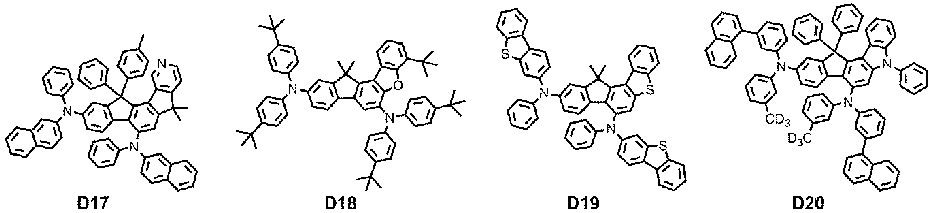

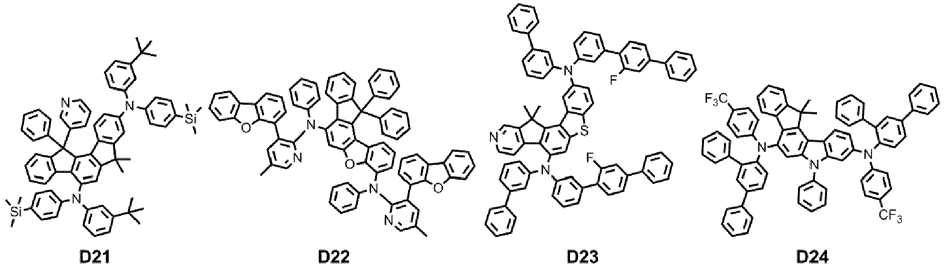

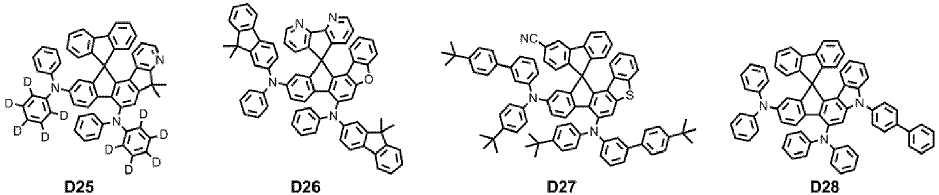

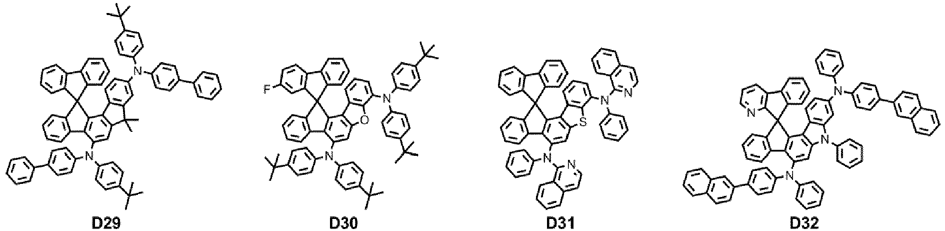

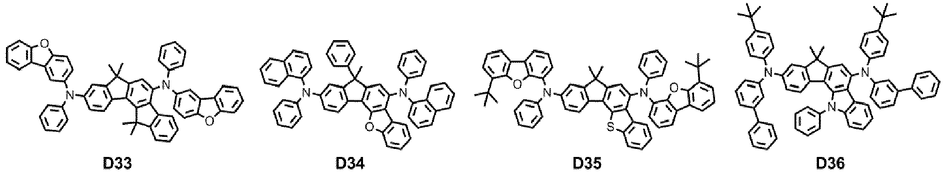

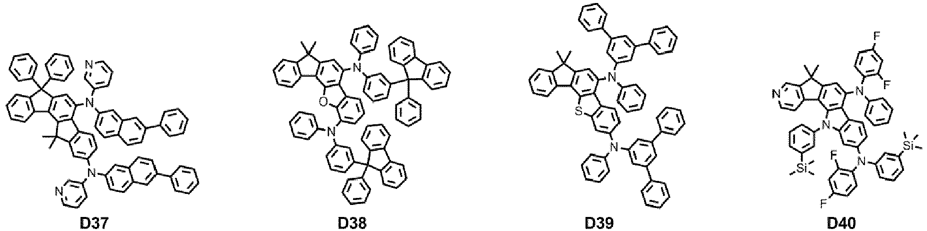

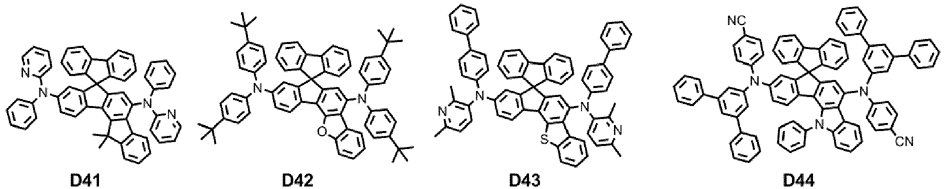

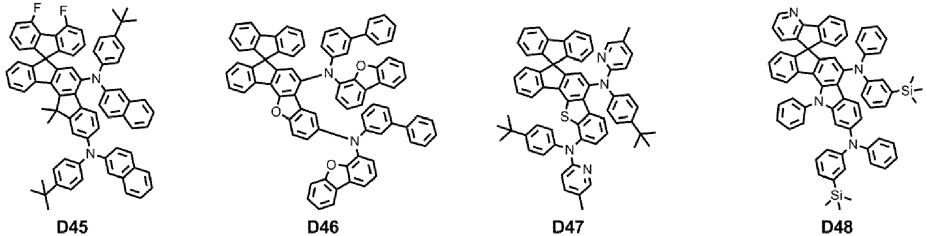

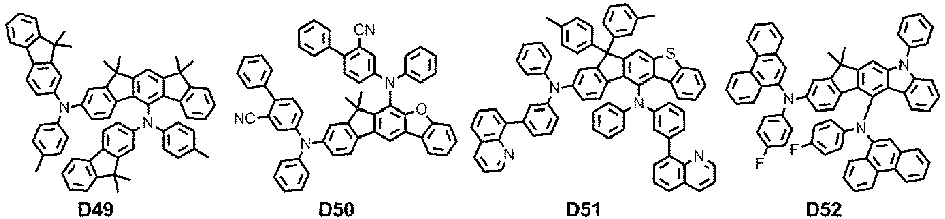

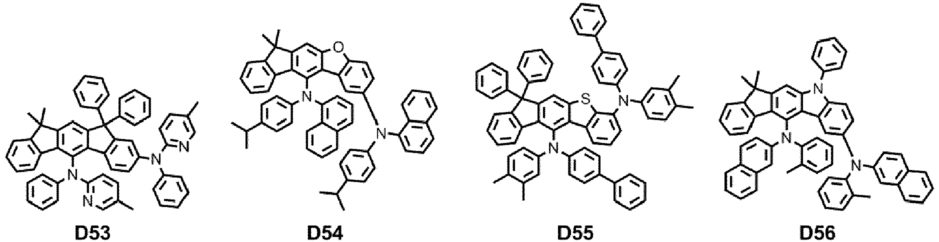

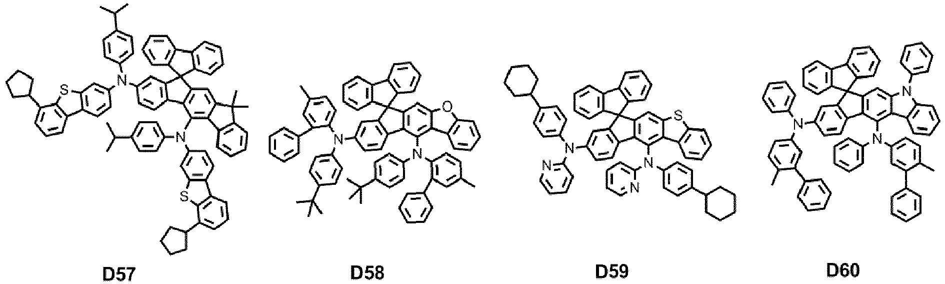

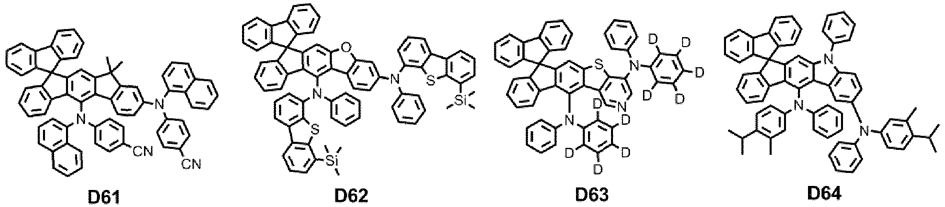

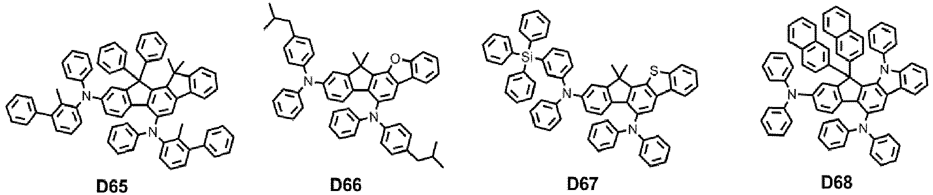

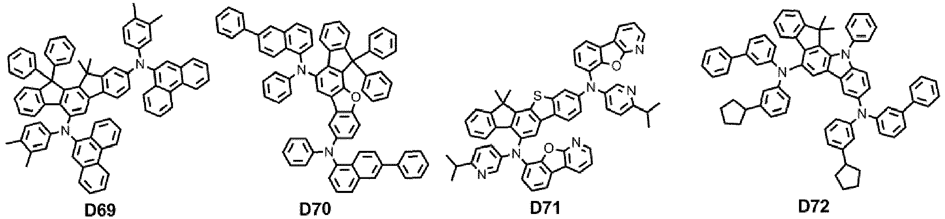

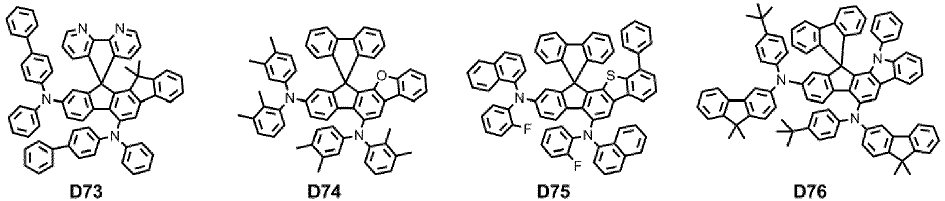

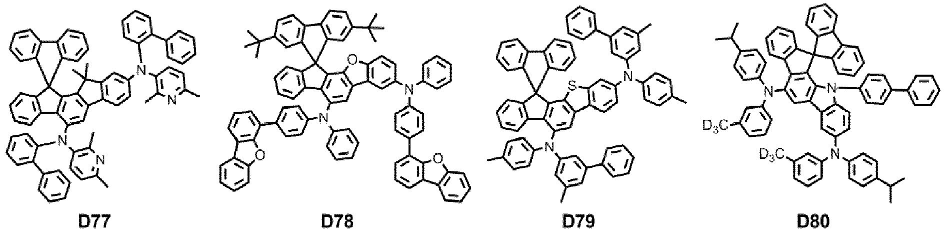

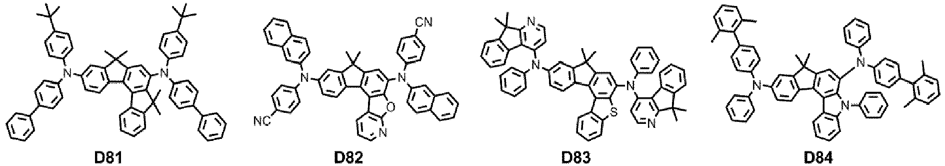

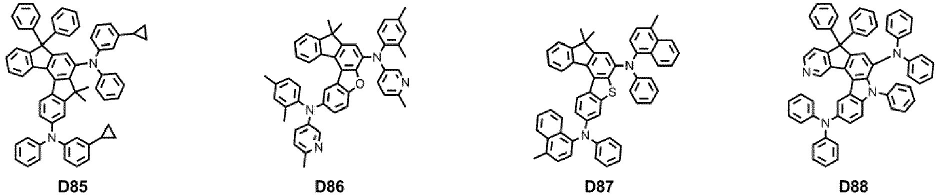

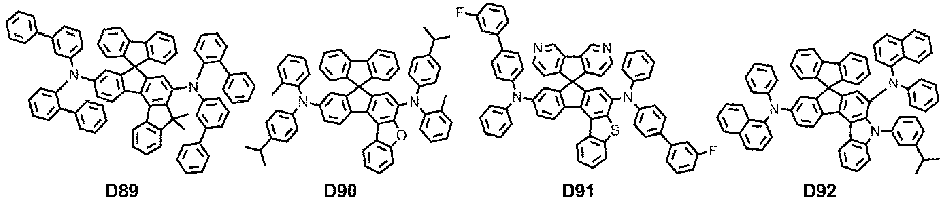

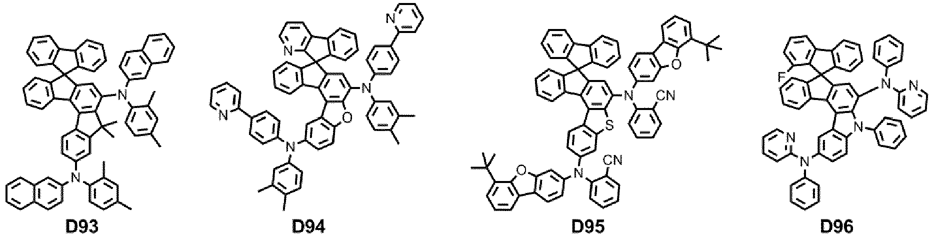

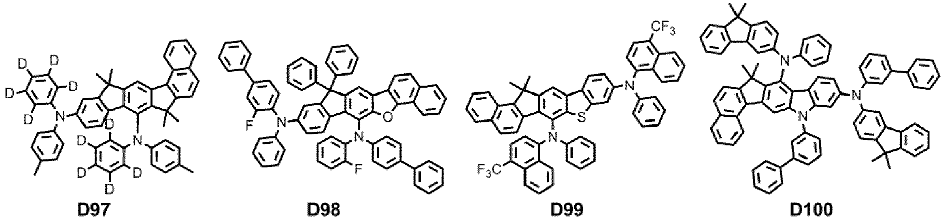

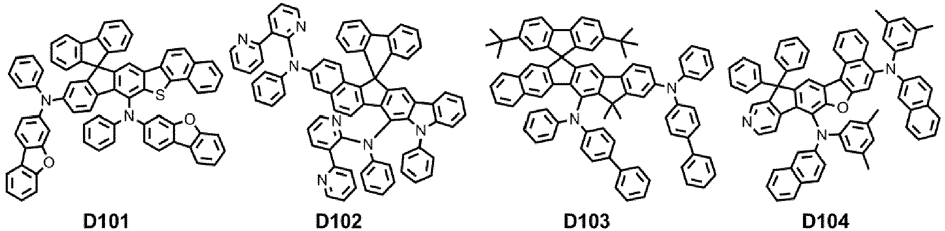

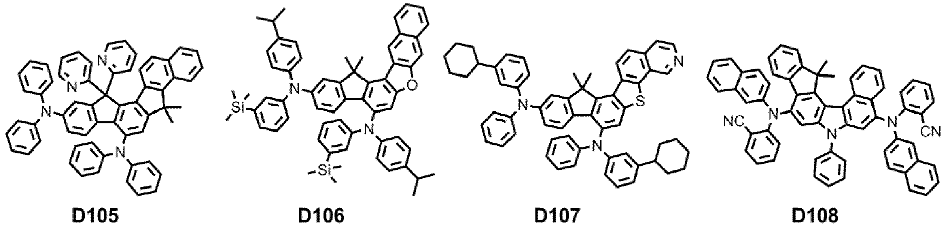

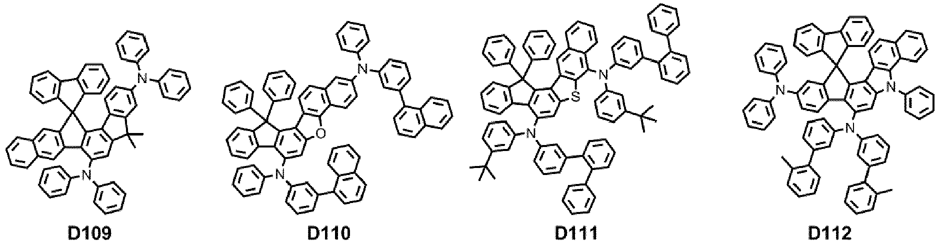

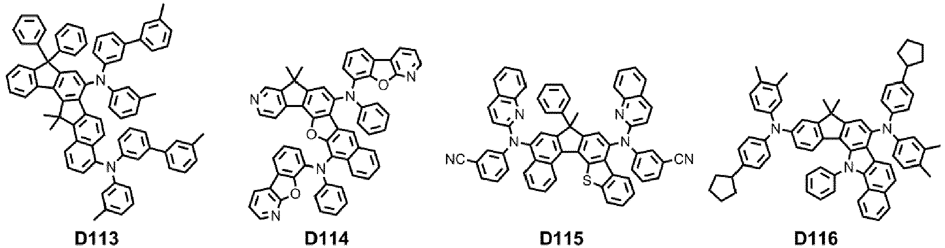

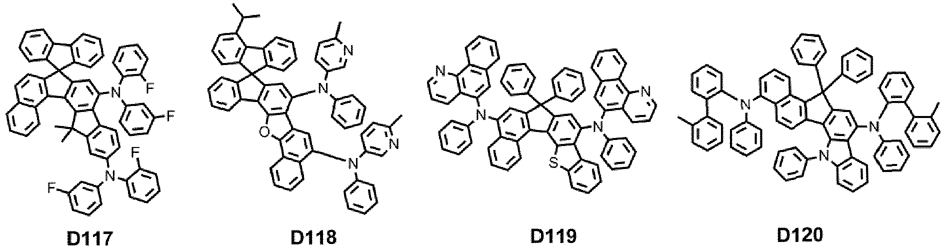

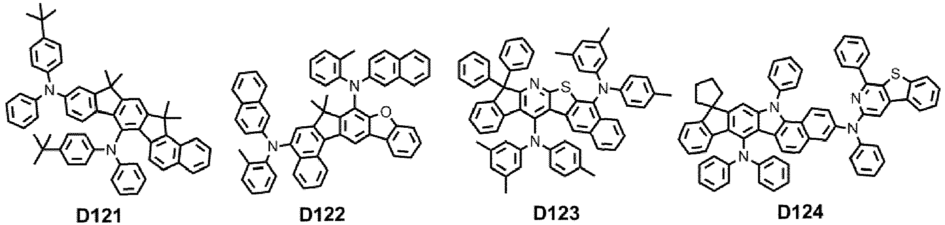

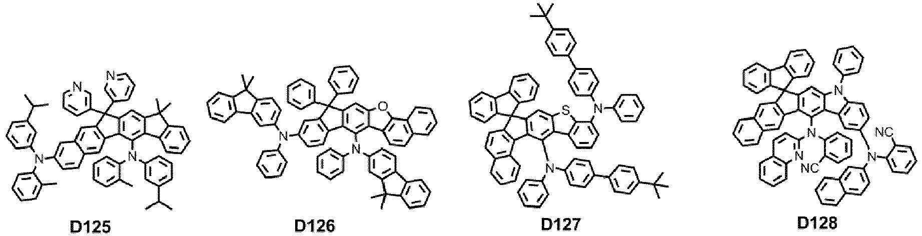

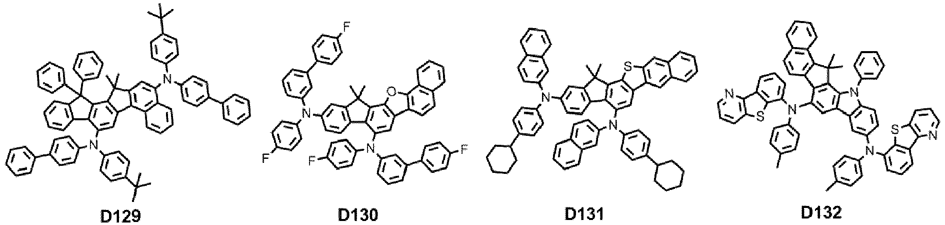

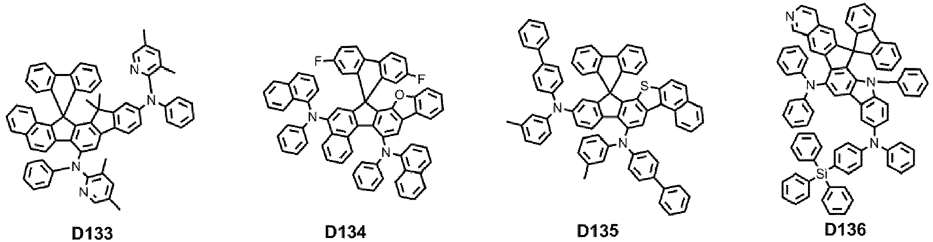

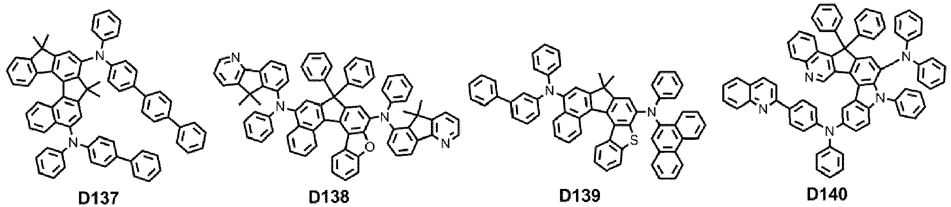

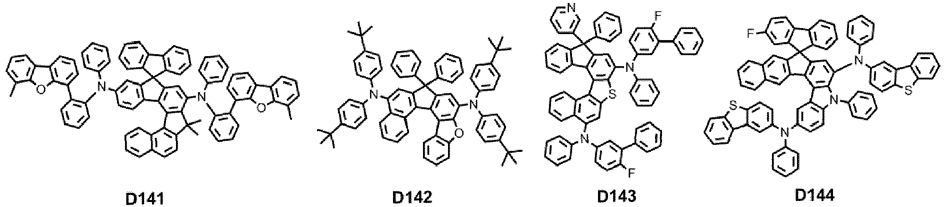

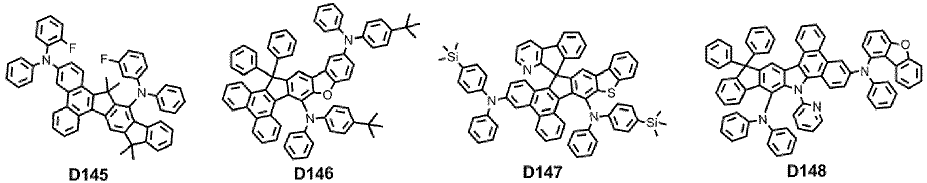

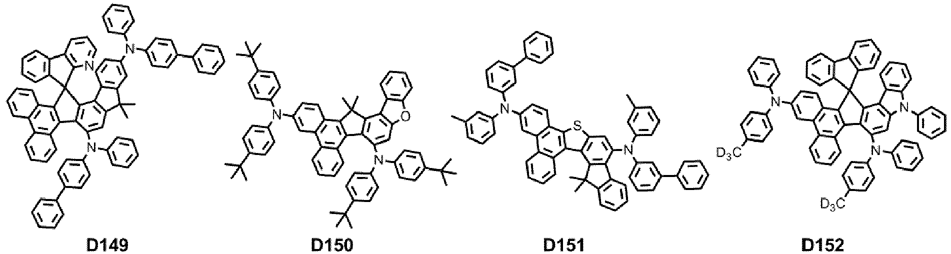

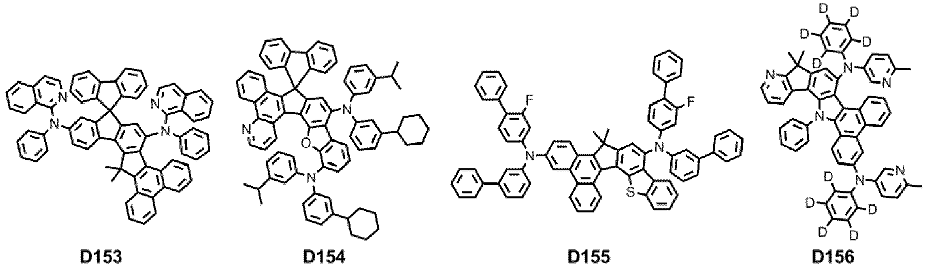

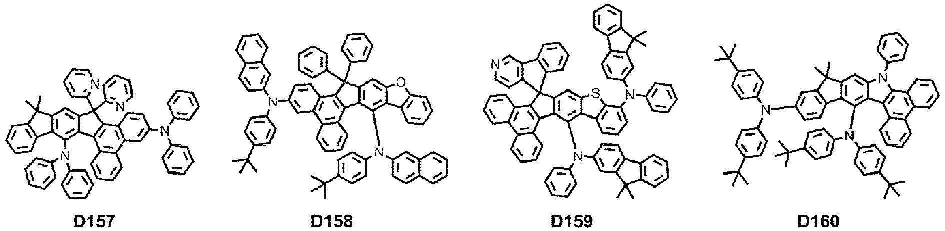

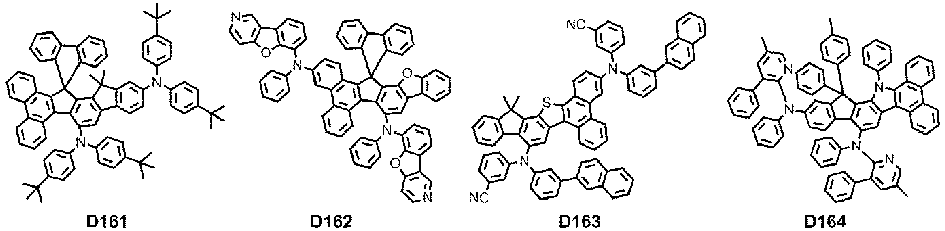

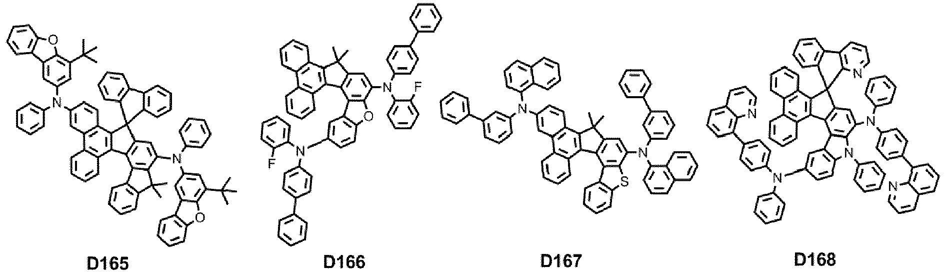

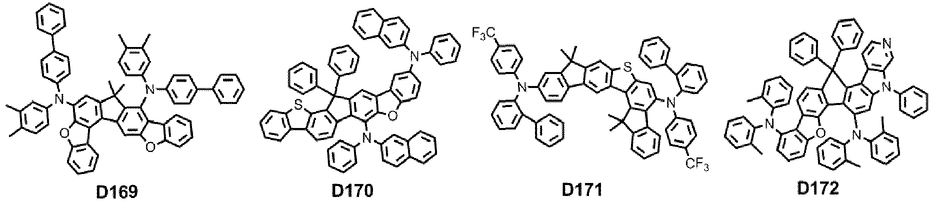

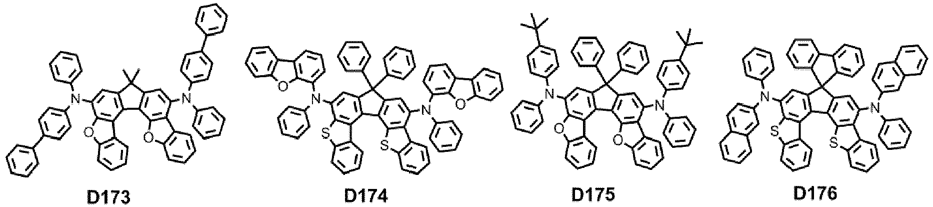

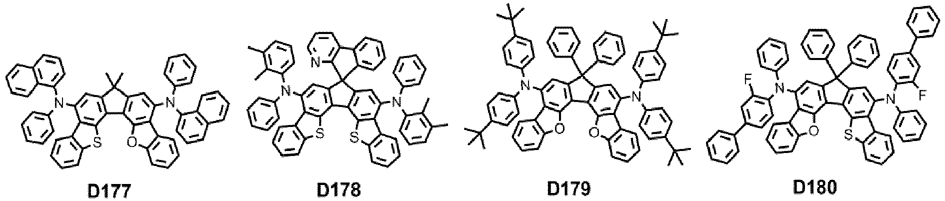

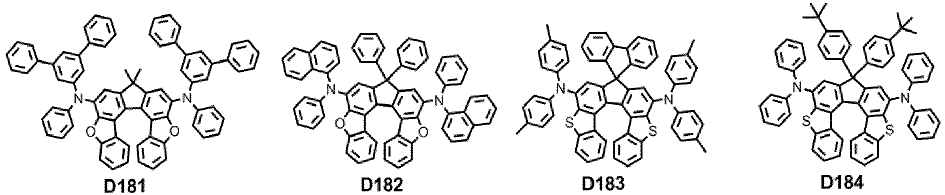

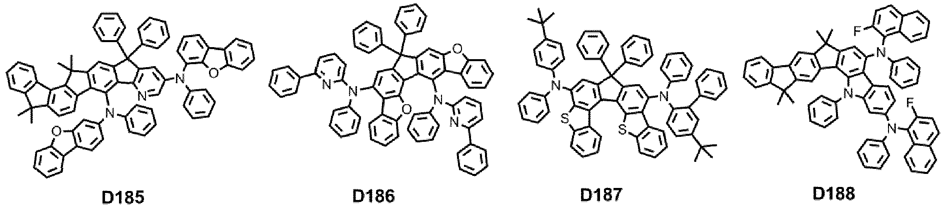

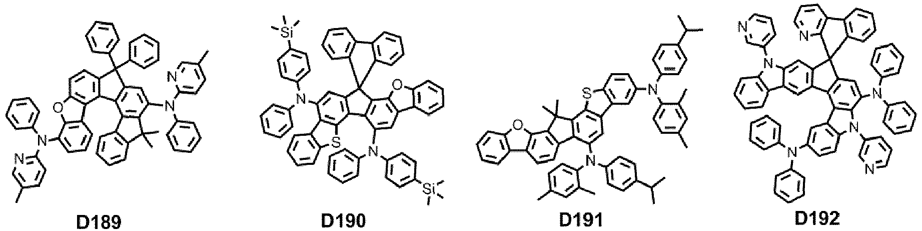

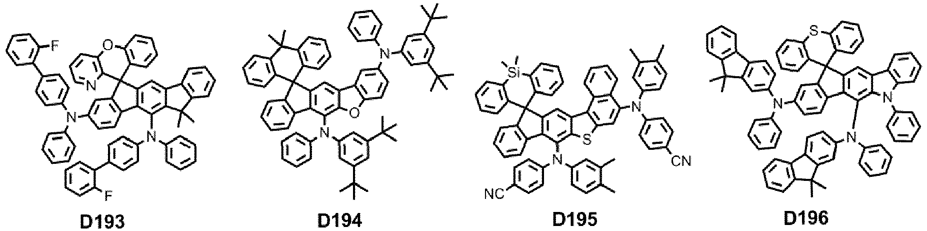

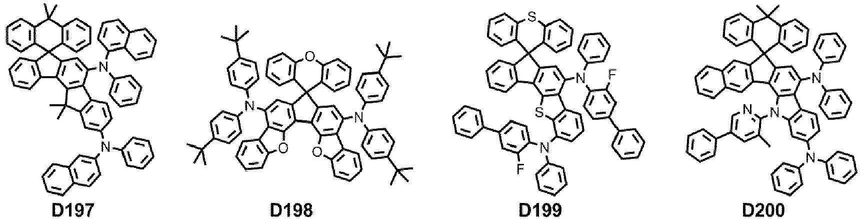

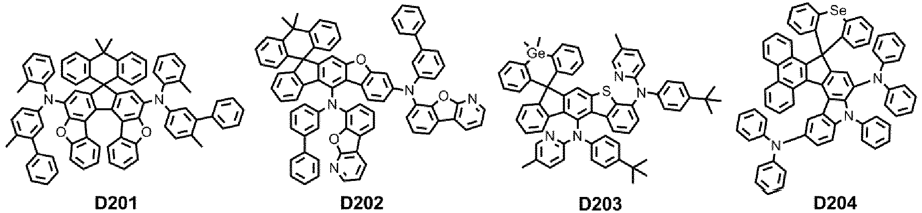

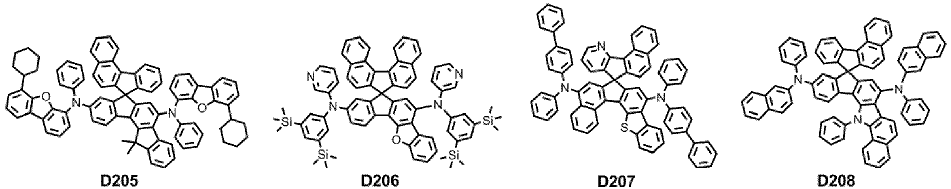

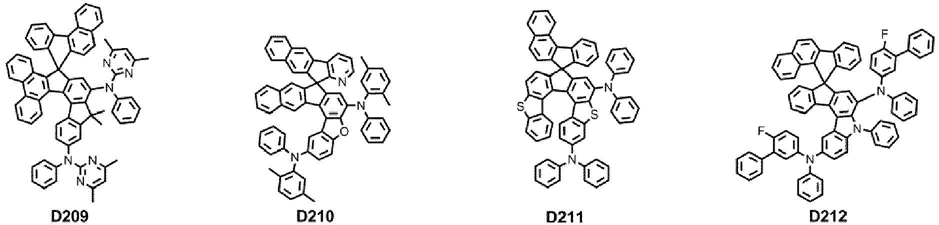

A compound that has an anthracene moiety as a core and a symmetric structure is known to have poor film-forming properties. However, since Compounds H1 to H116 have an asymmetric structure, they may be suitable for forming a film therefrom.

The second compound represented by Formula 2 has a condensed cyclic moiety as a core, as shown in Formula 2-1' and 2-2'. Since the second compound represented by Formula 2 has the condensed cyclic moiety as a core, an organic light-emitting device manufactured using the second compound may have a long lifespan and high efficiency.

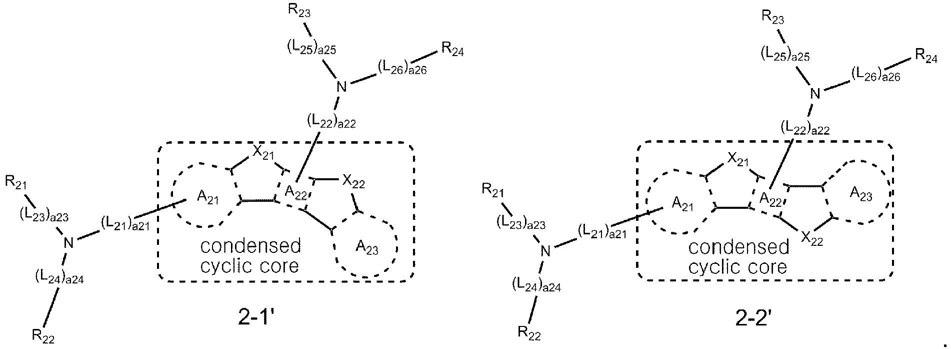

The second compound represented by Formula 2 may have amine groups respectively coupled to A₂₁ and A₂₂ of Formulae 2A and 2B, as shown in Formulae 2-1" and 2-2". Due to the inclusion of amine groups in a certain position of the second compound represented by Formula 2, an organic light-emitting device including the second compound may have improved efficiency and lifespan characteristics. When an organic light-emitting device comprises an emission layer that includes the second compound and an anthracene-based compound selected from H1 to H116 (e.g., the first compound), molecular association may be less likely to occur between the anthracene compound and the second compound, thus contributing to higher interior quantum efficiency.

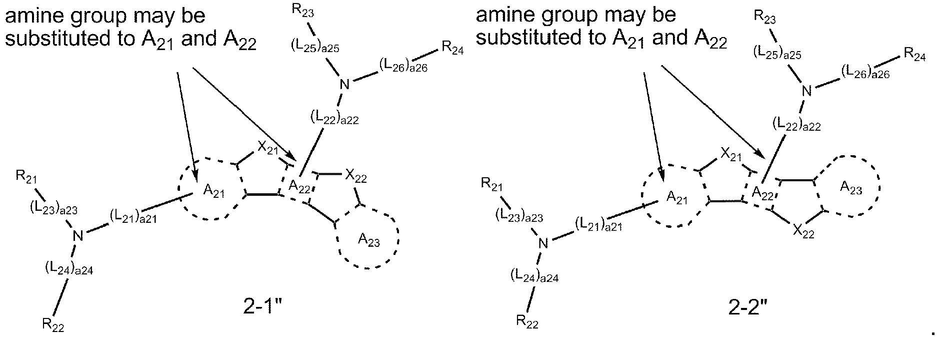

In the second compound, a distance between amine groups is short. Accordingly, an organic light-emitting device including the second compound may have high efficiency.

Thus, an organic light-emitting device comprising an emission layer including the second compound represented by Formula 2 may have high efficiency and a long lifespan.

The first compound selected from H1 to H116 and the second compound represented by Formula 2 may be synthesized by using any suitable organic synthetic methods.

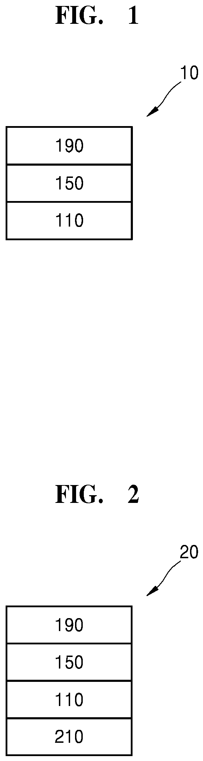

### [Description of FIG. 1]

FIG. 1 is a schematic view of an organic light-emitting device 10 according to an embodiment. The organic light-emitting device 10 includes a first electrode 110, an organic layer 150, and a second electrode 190.

Hereinafter, the structure of the organic light-emitting device 10 according to an embodiment and a method of manufacturing the organic light-emitting device 10 will be described in connection with FIG. 1.

### [First electrode 110]

In FIG. 1, a substrate may be additionally disposed (e.g., positioned) under the first electrode 110 or above the second electrode 190. The substrate may be a glass substrate or a plastic substrate, each having excellent mechanical strength, thermal stability, transparency, surface smoothness, ease of handling, and/or water-resistance.

The first electrode 110 may be formed by depositing or sputtering a material for forming the first electrode 110 on the substrate. When the first electrode 110 is an anode, the material for forming the first electrode may be selected from materials with a high work function to facilitate hole injection.

The first electrode 110 may be a reflective electrode, a semi-transmissive electrode, or a transmissive electrode. When the first electrode 110 is a transmissive electrode, a material for forming the first electrode may be selected from indium tin oxide (ITO), indium zinc oxide (IZO), tin oxide (SnO₂), zinc oxide (ZnO), and any combinations thereof, but is not limited thereto. In various embodiments, when the first electrode 110 is a semi-transmissive electrode or a reflective electrode, a material for forming the first electrode may be selected from magnesium (Mg), silver (Ag), aluminium (Al), aluminium-lithium (Al-Li), calcium (Ca), magnesium-indium (Mg-In), magnesium-silver (Mg-Ag), and any combinations thereof, but is not limited thereto.

The first electrode 110 may have a single-layered structure, or a multi-layered structure including two or more layers. For example, the first electrode 110 may have a three-layered structure of ITO/Ag/ITO, but the structure of the first electrode 110 is not limited thereto.

### [Organic layer 150]

The organic layer 150 may be disposed on the first electrode 110. The organic layer 150 may include an emission layer.

The organic layer 150 may further include a hole transport region between the first electrode 110 and the emission layer, and an electron transport region between the emission layer and the second electrode 190.

### [Hole transport region in the organic layer 150]

The hole transport region may have i) a single-layered structure including a single layer including a single material, ii) a single-layered structure including a single layer including a plurality of different materials, or iii) a multi-layered structure having a plurality of layers including a plurality of different materials.

The hole transport region may include at least one layer selected from a hole injection layer (HIL), a hole transport layer (HTL), an emission auxiliary layer, and an electron blocking layer (EBL).

For example, the hole transport region may have a single-layer structure including a single layer including a plurality of different materials, or a multi-layer structure having a structure of hole injection layer/hole transport layer, hole injection layer/hole transport layer/emission auxiliary layer, hole injection layer/emission auxiliary layer, hole transport layer/emission auxiliary layer or hole injection layer/hole transport layer/electron blocking layer, wherein for each structure, constituting layers are sequentially stacked from the first electrode 110 in this stated order, but the structure of the hole transport region is not limited thereto.

The hole transport region may include at least one selected from m-MTDATA, TDATA, 2-TNATA, NPB (also referred to as NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), polyaniline/poly(4-styrenesulfonate) (PANI/PSS), a compound represented by Formula 201, and a compound represented by Formula 202: 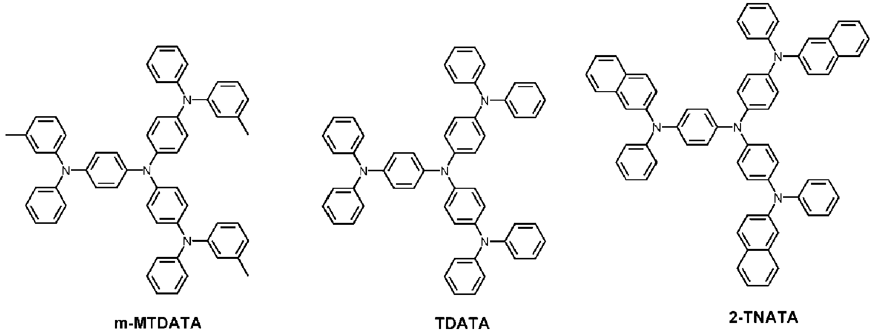 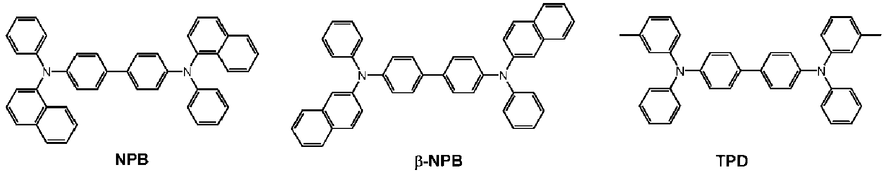 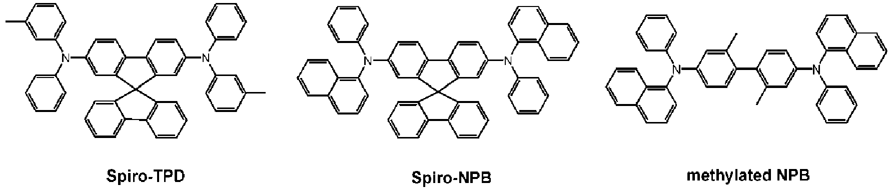 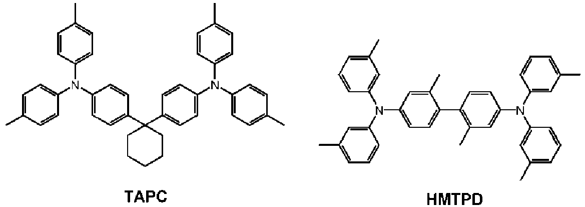 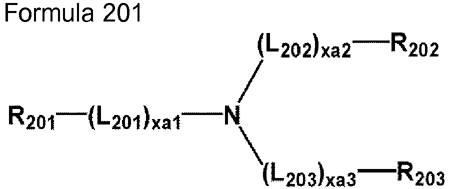 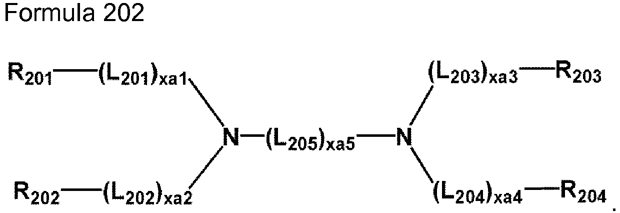 In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₂) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₂) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group,
xa1 to xa4 may each independently be an integer selected from 0 to 3,
xa5 may be an integer selected from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₂) aryl group, a substituted or unsubstituted C₆-C₆₀ (*e.g.* C₆-C₃₂) aryloxy group, a substituted or unsubstituted C₆-C₆₀ (*e.g.* C₆-C₃₂) arylthio group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group.

In various embodiments, R₂₀₁ and R₂₀₂ in Formula 202 may optionally be linked to each other via a single bond, a dimethyl-methylene group, or a diphenyl-methylene group; and R₂₀₃ and R₂₀₄ may optionally be linked to each other via a single bond, a dimethyl-methylene group, or a diphenyl-methylene group.

In one embodiment, in Formulae 201 and 202,
L₂₀₁ to L₂₀₅ may each independently be selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In various embodiments, xa1 to xa4 may each independently be 0, 1, or 2.

In various embodiments, xa5 may be 1, 2, 3, or 4.

In various embodiments, R₂₀₁ to R₂₀₄ and Q₂₀₁ may each independently be selected from a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂), and
Q₃₁ to Q₃₃ are the same as described above.

In various embodiments, at least one selected from R₂₀₁ to R₂₀₃ in Formula 201 may each independently be selected from the group consisting of:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments are not limited thereto.

In various embodiments, in Formula 202, i) R₂₀₁ and R₂₀₂ may be linked to each other via a single bond, and/or ii) R₂₀₃ and R₂₀₄ may be linked to each other via a single bond.

In various embodiments, at least one selected from R₂₀₁ to R₂₀₄ in Formula 202 may be selected from the group consisting of:
a carbazolyl group; and
a carbazolyl group substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but are not limited thereto.

The compound represented by Formula 201 may be represented by Formula 201A:

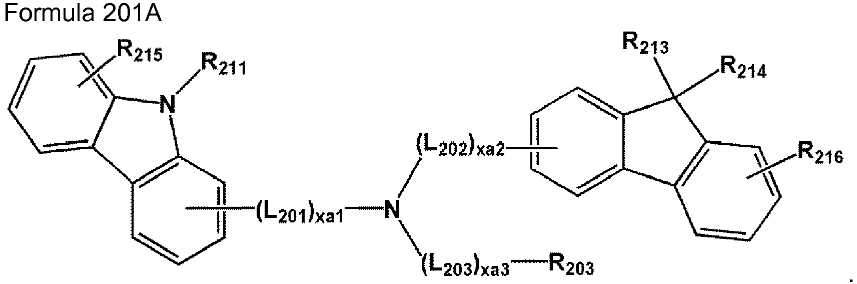

In various embodiments, the compound represented by Formula 201 may be represented by Formula 201A(1), but is not limited thereto:

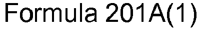

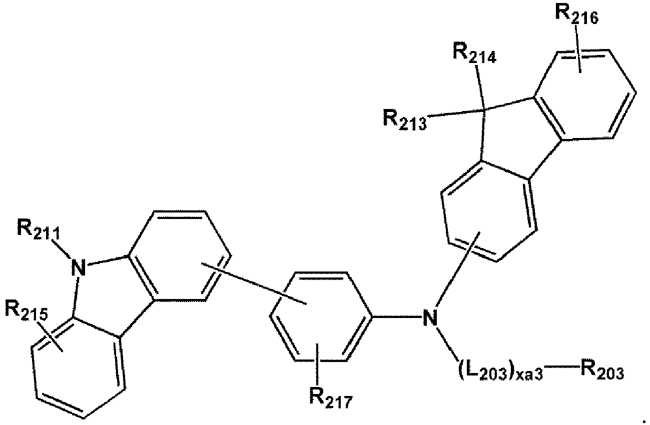

In various embodiments, the compound represented by Formula 201 may be represented by Formula 201A-1, but is not limited thereto:

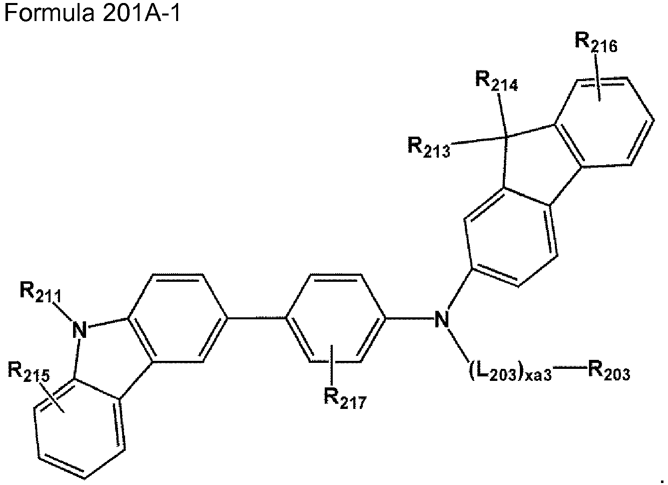

The compound represented by Formula 202 may be represented by Formula 202A:

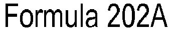

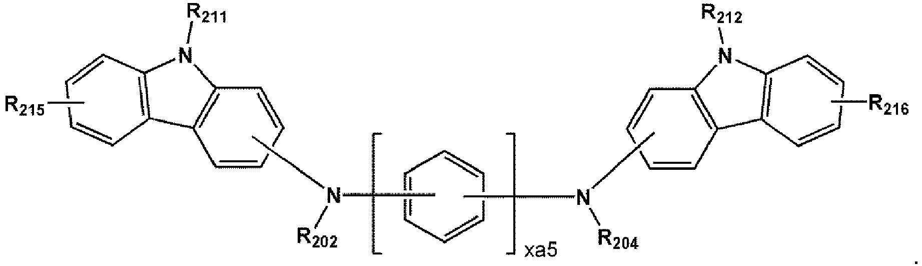

In various embodiments, the compound represented by Formula 202 may be represented by Formula 202A-1: 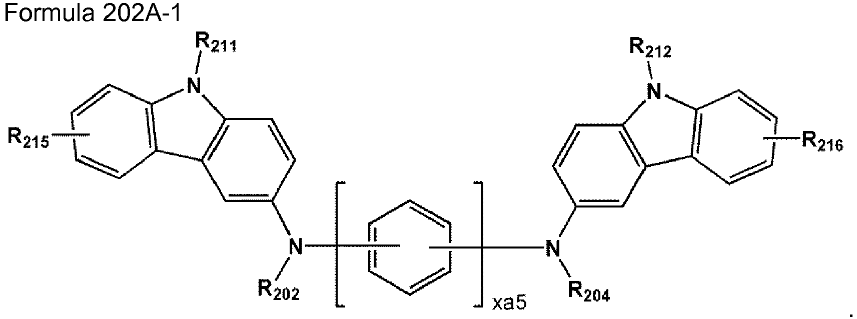 In Formulae 201A, 201A(1), 201A-1, 202A, and 202A-1,
L₂₀₁ to L₂₀₃, xa1 to xa3, xa5, and R₂₀₂ to R₂₀₄ are the same as described above,
descriptions of R₂₁₁ and R₂₁₂ may each independently be the same as the description provided in connection with R₂₀₃, and
R₂₁₃ to R₂₁₇ may each independently be selected from hydrogen, deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from Compounds HT1 to HT39, but a material to be included in the hole transport region is not limited thereto:

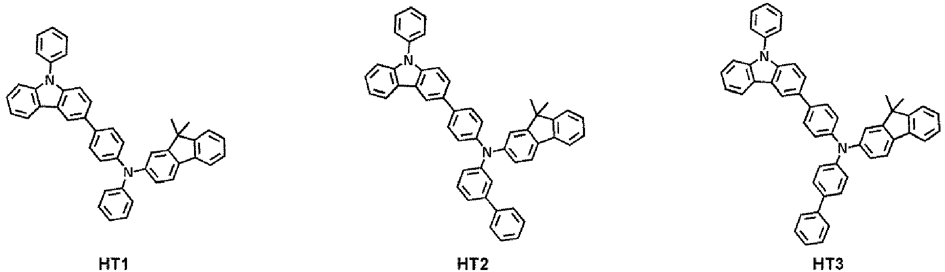

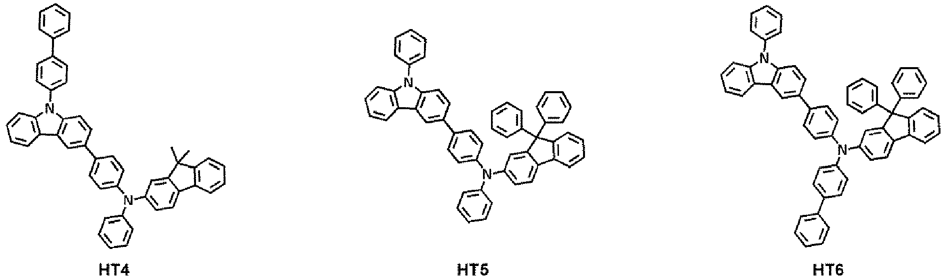

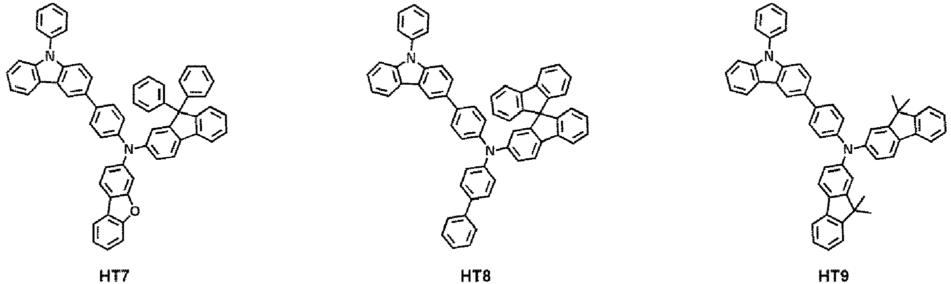

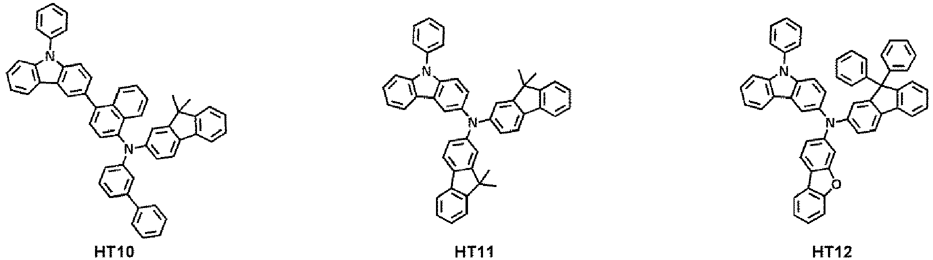

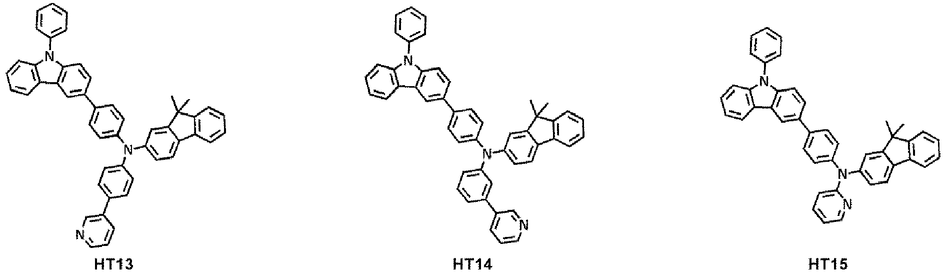

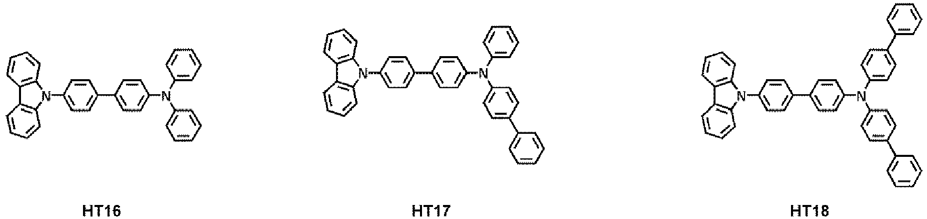

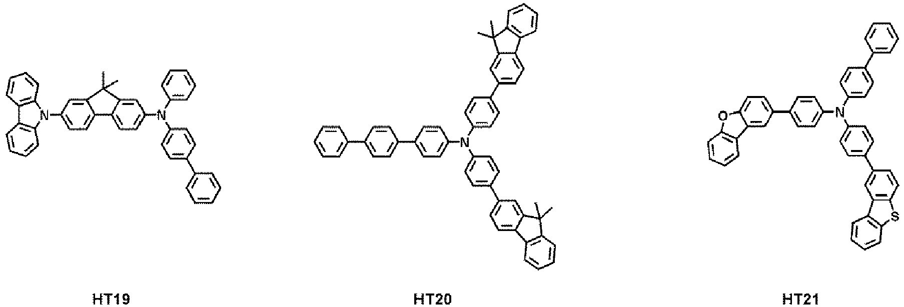

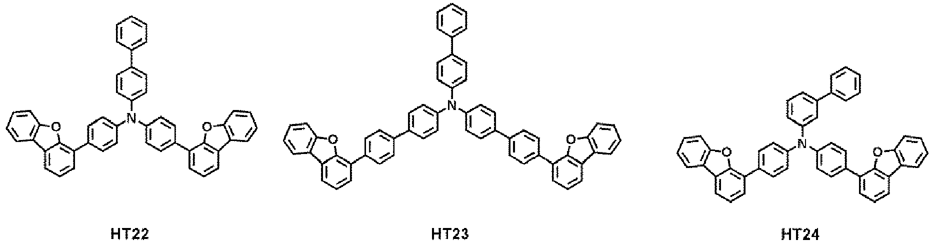

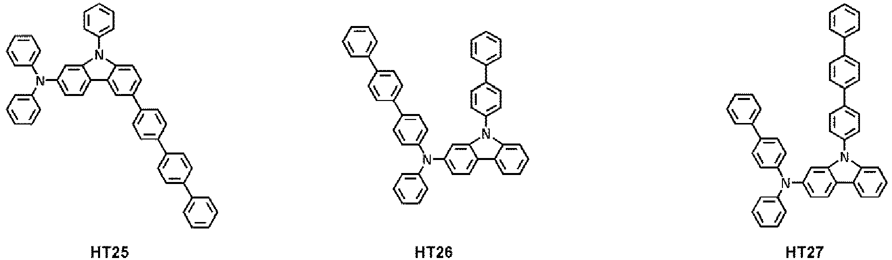

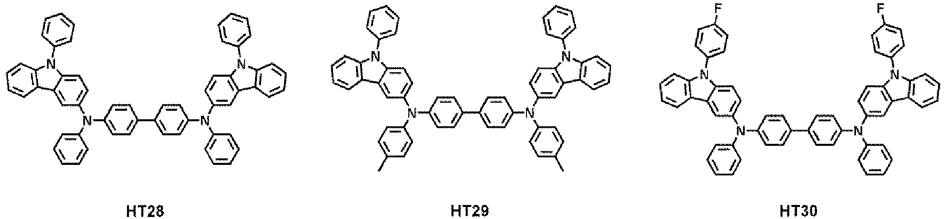

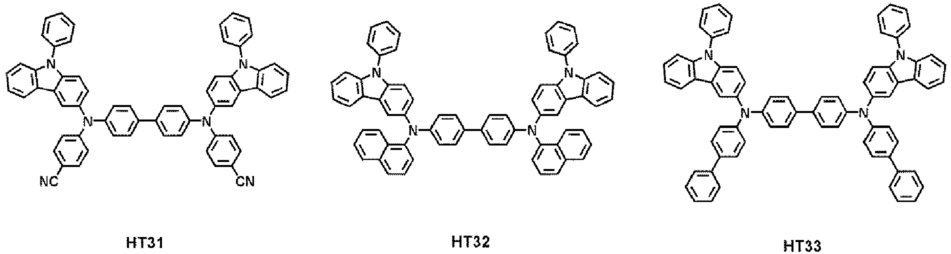

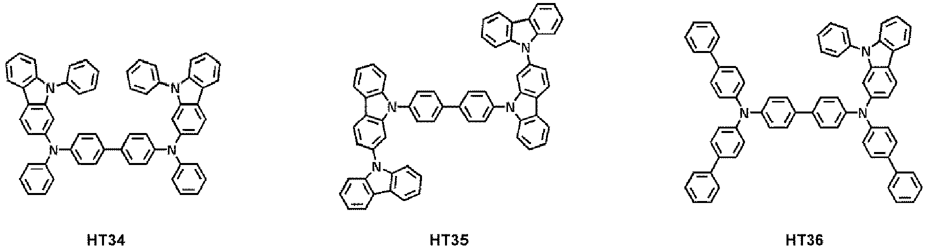

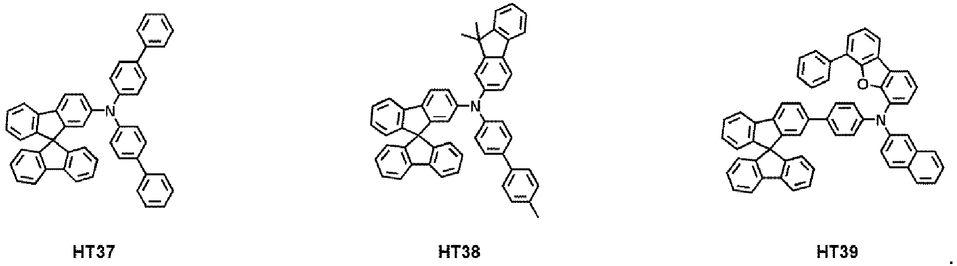

A thickness of the hole transport region may be in a range of about 100 Å to about 10,000 Å, for example, about 100 Å to about 7000 Å, about 100 Å to about 5000 Å, about 100 Å to about 3000 Å or about 100 Å to about 1,000 Å. When the hole transport region includes at least one selected from a hole injection layer and a hole transport layer, a thickness of the hole injection layer may be in a range of about 100 Å to about 9,000 Å, for example, about 100 Å to about 9,000 Å, about 100 Å to about 7,000 Å, about 100 Å to about 5,000 Å, about 100 Å to about 3,000 Å or about 100 Å to about 1,000 Å (e.g. about 100 Å to about 300 Å), and a thickness of the hole transport layer may be in a range of about 50 Å to about 2,000 Å, for example about 100 Å to about 1,500 Å (e.g. about 100 Å to about 1,000 Å, about 200 Å to about 800 Å, about 300 Å to about 700 Å or about 400 Å to about 600 Å). When the thicknesses of the hole transport region, the hole injection layer, and the hole transport layer are within any of these ranges, satisfactory (or suitable) hole transporting characteristics may be obtained without a substantial increase in driving voltage.

The emission auxiliary layer may increase light-emission efficiency by compensating for an optical resonance distance according to the wavelength of light emitted by an emission layer; and the electron blocking layer may block or reduce the flow of electrons from an electron transport region. The emission auxiliary layer and the electron blocking layer may each independently include any of the materials described above (e.g., any of the materials included in the hole transport region).

### [p-dopant]

The hole transport region may further include, in addition to the materials described above, a charge-generation material for the improvement of conductive properties. The charge-generation material may be homogeneously or non-homogeneously dispersed in the hole transport region.

The charge-generation material may be, for example, a p-dopant.

According to one embodiment, a lowest unoccupied molecular orbital (LUMO) energy level of the p-dopant may be -3.5 eV or less, but embodiments are not limited thereto.

The p-dopant may include at least one selected from a quinone derivative, a metal oxide, and a cyano group-containing compound, but embodiments are not limited thereto.

For example, the p-dopant may include at least one selected from the group consisting of:
a quinone derivative, such as tetracyanoquinodimethane (TCNQ) and/or 2,3,5,6-tetrafluoro-7,7,8,8-tetracyanoquinodimethane (F4-TCNQ);
a metal oxide, such as tungsten oxide and/or molybdenum oxide;
1,4,5,8,9,11-hexaazatriphenylene-hexacarbonitrile (HAT-CN); and
a compound represented by Formula 221 below:
   but is not limited thereto: 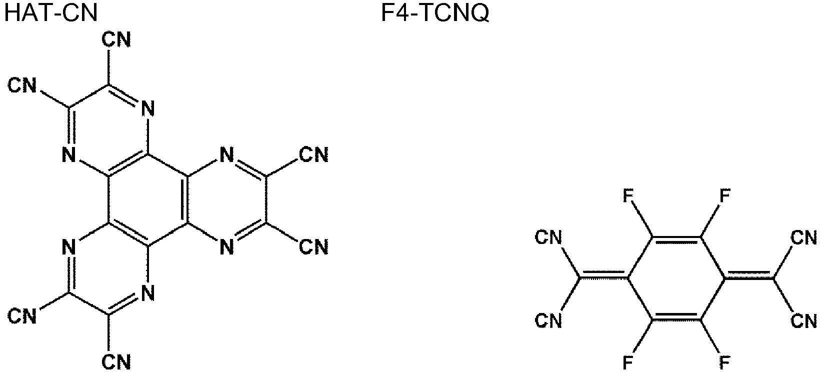 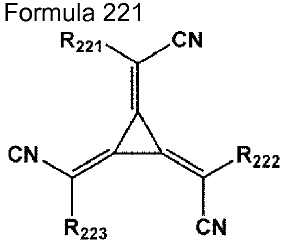 In Formula 221,
   R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (e.g. C₆-C₃₀) aryl group, a substituted or unsubstituted C₁-C₆₀ (e.g. C₁-C₂₀) heteroaryl group, a substituted or unsubstituted monovalent non-aromatic condensed polycyclic group and a substituted or unsubstituted monovalent non-aromatic condensed heteropolycyclic group, provided that at least one selected from R₂₂₁ to R₂₂₃ may have a substituent selected from a cyano group, -F, -CI, -Br, -I, a C₁-C₂₀ alkyl group substituted with -F, a C₁-C₂₀ alkyl group substituted with -CI, a C₁-C₂₀ alkyl group substituted with -Br, and a C₁-C₂₀ alkyl group substituted with -I.

### [Emission layer in the organic layer 150]

When the organic light-emitting device 10 is a full color organic light-emitting device, the emission layer may be patterned into a red emission layer, a green emission layer, and/or a blue emission layer, according to a sub pixel. In various embodiments, the emission layer may have a stacked structure of two or more layers selected from a red emission layer, a green emission layer, and a blue emission layer, in which the two or more layers contact each other or are separated from each other. In various embodiments, the emission layer may include two or more materials selected from a red-light emission material, a green-light emission material, and a blue-light emission material, in which the two or more materials are mixed with each other in a single layer to emit white light.

In one embodiment, the emission layer of the organic light-emitting device 10 may be a first-color-light emitting-emission layer;
the organic layer may further include at least one second-color-light emitting-emission layer;
where the first-color light and the second-color light may be identical to or different from each other; and
the first-color light and the second-color light may be emitted in a mixed-color light.

Herein, when the first-color light and the second-color light are different from each other, a maximum emission wavelength of the first-color light is different from a maximum emission wavelength of the second-color light.

In various embodiments, the mixed-color light may be white light, but is not limited thereto.

In one embodiment, the emission layer of the organic light-emitting device 10 may be a first-color-light emitting-emission layer;
the organic layer may further include at least one second-color-light emitting-emission layer and at least one third-color-light emitting-emission layer;
the first-color light, the second-color light, and the third-color light may be identical to or different from each other;
the first-color light, the second-color light, and the third-color light may be emitted in a mixed-color light.

Herein, when the first-color light, the second-color light, and the third-color light are different from each other, a maximum emission wavelength of the first-color light, a maximum emission wavelength of the second-color light, and a maximum emission wavelength of the third-color light are different from each other.

In various embodiments, the mixed-color light may be white light, but is not limited thereto.

The emission layer may include a host and a dopant. The dopant may be at least one selected from a phosphorescent dopant and a fluorescent dopant.

An amount of the dopant in the emission layer may be, for example, in a range of about 0.01 to about 15 parts by weight based on 100 parts by weight of the host, but is not limited thereto.

A thickness of the emission layer may be in a range of about 100 A to about 1,000 Å, for example, about 200 Å to about 600 Å or about 200 Å to about 400 Å (*e.g.* about 300 Å). When the thickness of the emission layer is within any of these ranges, excellent (or suitable) light-emission characteristics may be obtained without a substantial increase in driving voltage.

### [Host in the emission layer]

The host includes the first compound selected from Compounds H1 to H116.

### [Fluorescent dopant in the emission layer]

The fluorescent dopant includes the second compound represented by Formula 2.

### [Electron transport region in the organic layer 150]

The electron transport region may have i) a single-layered structure including a single layer including a single material, ii) a single-layered structure including a single layer including a plurality of different materials, or iii) a multi-layered structure having a plurality of layers including a plurality of different materials.

The electron transport region may include at least one selected from a buffer layer, a hole blocking layer, an electron control layer, an electron transport layer (ETL), and an electron injection layer, but is not limited thereto.

For example, the electron transport region may have a structure of electron transport layer/electron injection layer, a structure of hole blocking layer/electron transport layer/electron injection layer, a structure of electron control layer/electron transport layer/electron injection layer, or a structure of buffer layer/electron transport layer/electron injection layer, wherein in each of these structures, constituting layers are sequentially stacked in this stated order from an emission layer. However, the structure of the electron transport layer is not limited thereto.

The electron transport region (e.g., a buffer layer, a hole blocking layer, an electron control layer, or an electron transport layer in the electron transport region) may include a metal-free compound containing at least one π electron-depleted nitrogen-containing ring.

The "π electron-depleted nitrogen-containing ring" may refer to a C₁-C₆₀ (e.g. C₁-C₂₀) heterocyclic group having at least one *-N=*' moiety as a ring-forming moiety.

For example, the "π electron-depleted nitrogen-containing ring" may be i) a 5-membered to 7-membered heteromonocyclic group having at least one *-N=*' moiety, ii) a heteropolycyclic group in which two or more 5-membered to 7-membered heteromonocyclic groups each having at least one *-N=*' moiety are condensed with each other, or iii) a heteropolycyclic group in which at least one of 5-membered to 7-membered heteromonocyclic groups, each having at least one *-N=*' moiety, is condensed with at least one C₅-C₆₀ (*e.g*. C₅-C₃₀) carbocyclic group.

Examples of the π electron-depleted nitrogen-containing ring include an imidazole, a pyrazole, a thiazole, an isothiazole, an oxazole, an isoxazole, a pyridine, a pyrazine, a pyrimidine, a pyridazine, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzoimidazole, an isobenzothiazole, a benzoxazole, an isobenzoxazole, a triazole, a tetrazole, an oxadiazole, a triazine, thiadiazole, an imidazopyridine, an imidazopyrimidine, and an azacarbazole, but are not limited thereto.

For example, the electron transport region may include a compound represented by Formula 601:

<Formula 601> [Ar₆₀₁]ₓₑ₁₁-(L₆₀₁)ₓₑ₁-R₆₀₁]ₓₑ₂₁.

In Formula 601,
Ar₆₀₁ may be a substituted or unsubstituted C₅-C₆₀ (e.g. C₅-C₃₀) carbocyclic group or a substituted or unsubstituted C₁-C₆₀ (*e.g*. C₁-C₂₀) heterocyclic group,
xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₀) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group;
xe1 may be an integer selected from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₀) aryl group, a substituted or unsubstituted C₆-C₆₀ (*e.g*. C₆-C₃₀) aryloxy group, a substituted or unsubstituted C₆-C₆₀ (*e.g*. C₆-C₃₀) arylthio group, a substituted or unsubstituted C₁-C₆₀ (e.g. C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₆₀₁)(Q₆₀₂)(Q₆₀₃), -C(=O)(Q₆₀₁),-S(=O)₂(Q₆₀₁), and -P(=O)(Q₆₀₁)(Q₆₀₂),
Q₆₀₁ to Q₆₀₃ may each independently be selected from a C₁-C₁₀ alkyl group, a C₁-C₁₀ alkoxy group, a phenyl group, a biphenyl group, a terphenyl group, and a naphthyl group, and
xe21 may be an integer selected from 1 to 5.

In one embodiment, at least one selected from Ar₆₀₁(s) (where the number of Ar₆₀₁(s) equals to xe11) and/or at least one selected from R₆₀₁(s) (where the number of R₆₀₁(s) equals to xe21) may include the π electron-depleted nitrogen-containing ring as described above.

In one embodiment, ring Ar₆₀₁ in Formula 601 may be selected from the group consisting of:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, thiadiazol group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, thiadiazol group, an imidazopyridine group, an imidazopyrimidine group, and an azacarbazole group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is two or more, two or more Ar₆₀₁(s) may be linked to each other via a single bond.

In various embodiments, Ar₆₀₁ in Formula 601 may be an anthracene group.

In various embodiments, a compound represented by Formula 601 may be represented by Formula 601-1: 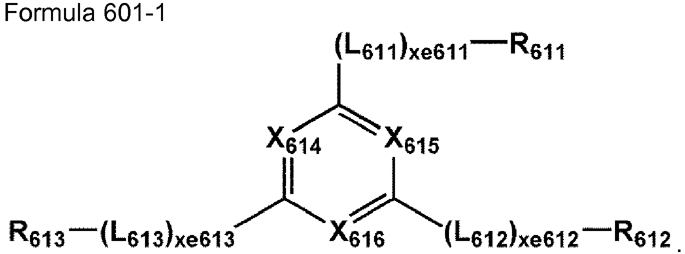 In Formula 601-1,
X₆₁₄ may be N or C(R₆₁₄), X₆₁₅ may be N or C(R₆₁₅), X₆₁₆ may be N or C(R₆₁₆), at least one selected from X₆₁₄ to X₆₁₆ may be N,
descriptions of L₆₁₁ to L₆₁₃ may each independently be understood by referring to the description provided above in connection with L₆₀₁,
descriptions of xe611 to xe613 may each independently be understood by referring to the description provided above in connection with xe1,
descriptions of R₆₁₁ to R₆₁₃ may each independently be understood by referring to the description provided above in connection with R₆₀₁, and
R₆₁₄ to R₆₁₆ may each independently be selected from hydrogen, deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one embodiment, L₆₀₁ and L₆₁₁ to L₆₁₃ in Formulae 601 and 601-1 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, but are not limited thereto.

In various embodiments, xe1 and xe611 to xe613 in Formulae 601 and 601-1 may each independently be 0, 1, or 2.

In various embodiments, R₆₀₁ and R₆₁₁ to R₆₁₃ in Formulae 601 and 601-1 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂),
wherein Q₆₀₁ and Q₆₀₂ may be the same as described above.

The electron transport region may include at least one compound selected from Compounds ET1 to ET36, but a material to be included in the electron transport region is not limited thereto:

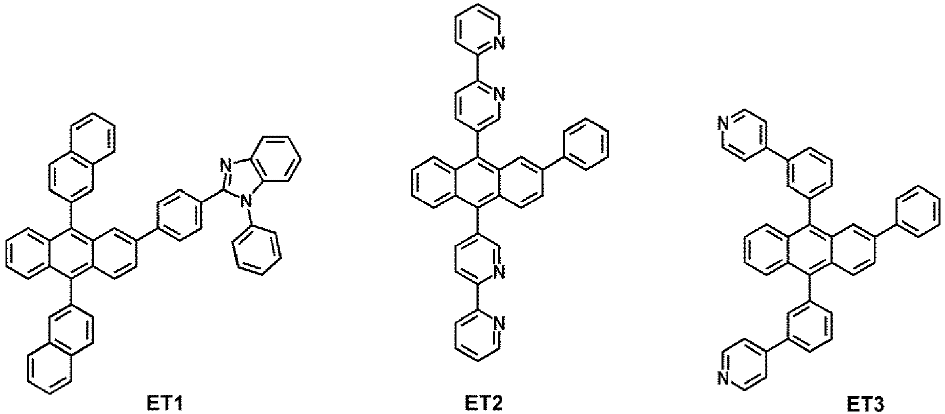

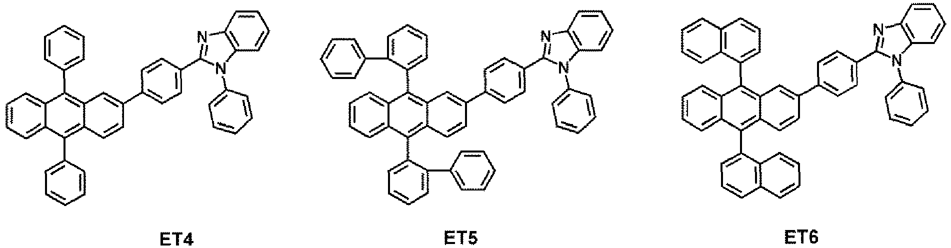

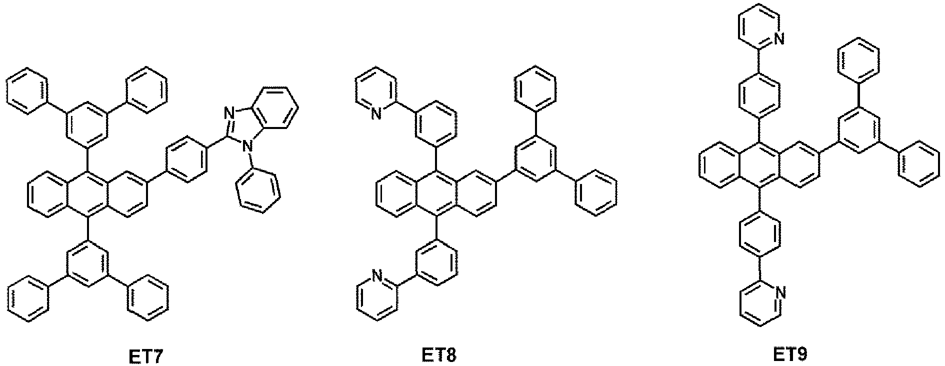

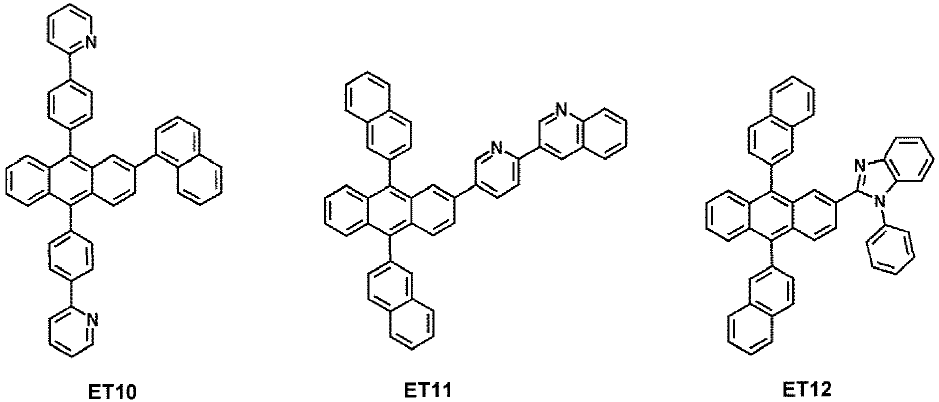

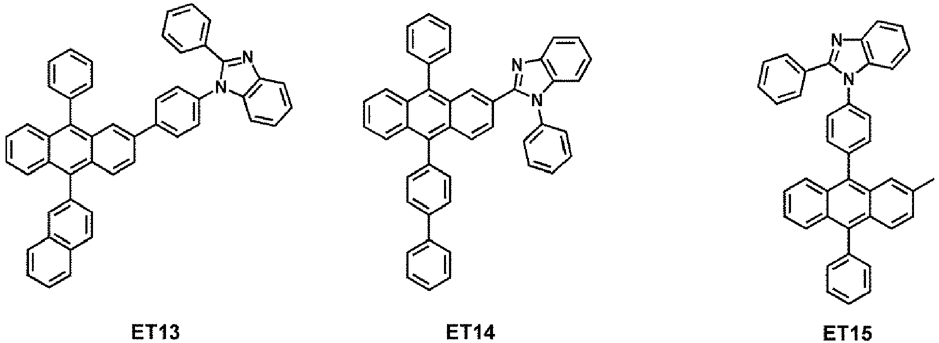

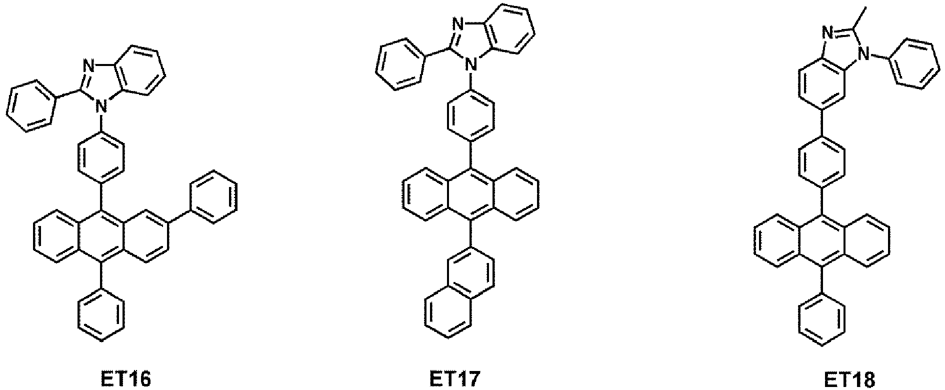

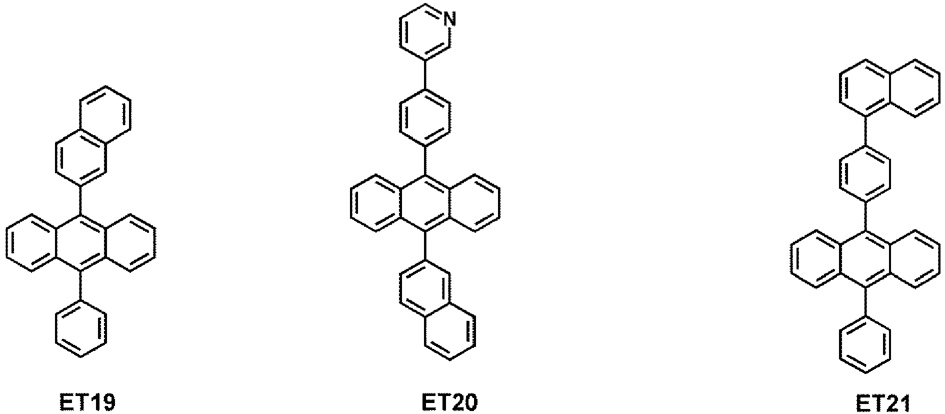

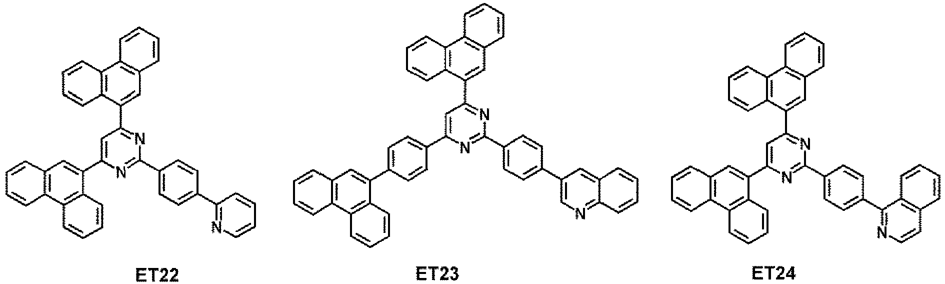

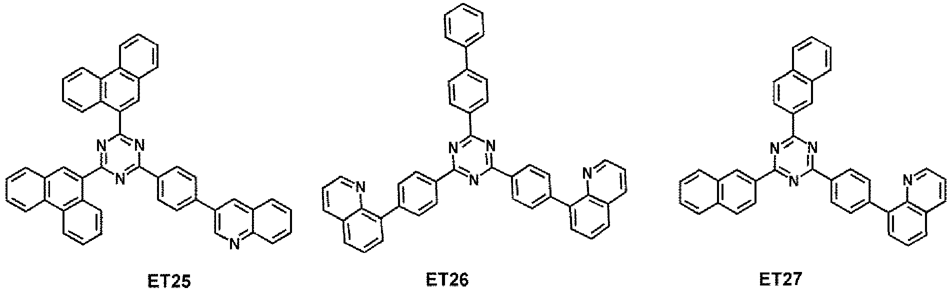

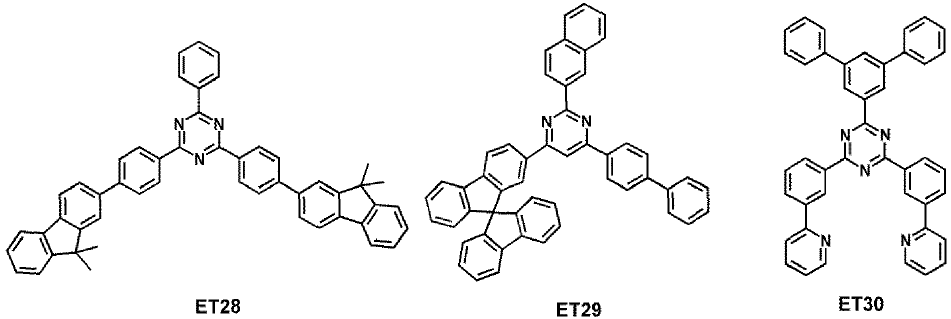

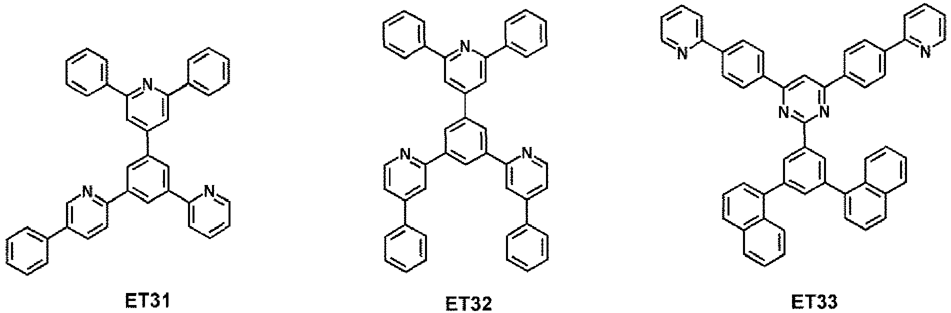

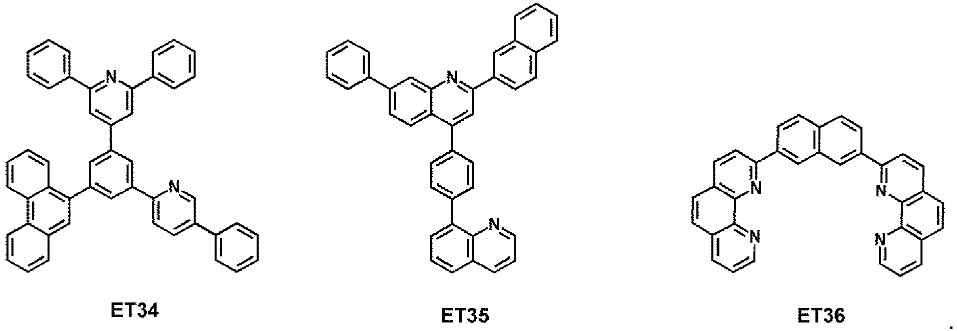

In various embodiments, the electron transport region may include at least one compound selected from BCP (2,9-Dimethyl-4,7-diphenyl-1,10-phenanthroline), Bphen (4,7-Diphenyl-1,10-phenanthroline), Alq₃, Balq, TAZ (3-(Biphenyl-4-yl)-5-(4-*tert-*butylphenyl)-4-phenyl-4*H*-1,2,4-triazole), and NTAZ.

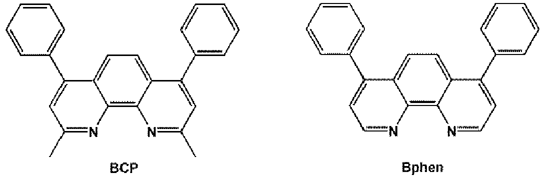

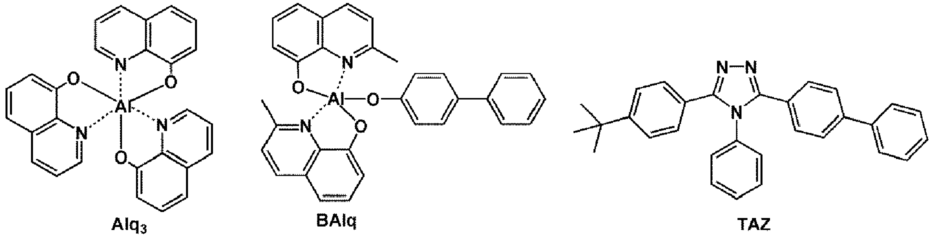

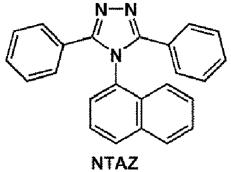

A thickness of the buffer layer, the hole blocking layer, and the electron control layer may be each independently in a range of about 20 **Å** to about 1,000 **Å**, for example, about 30 **Å** to about 300 **Å.** When the thicknesses of the buffer layer, the hole blocking layer, and the electron control layer are within any of these ranges, the electron transport region may have excellent hole blocking characteristics or electron control characteristics without a substantial increase in driving voltage.

A thickness of the electron transport layer may be in a range of about 100 **Å** to about 1,000 **Å,** for example, about 150 **Å** to about 500 **Å** or about 200 **Å** to about 400 **Å** (e.g. about 300 **Å**). When the thickness of the electron transport layer is within any of the ranges described above, the electron transport layer may have satisfactory (or suitable) electron transport characteristics without a substantial increase in driving voltage.

The electron transport region (e.g., the electron transport layer in the electron transport region) may further include, in addition to the materials described above, metal-containing materials.

The metal-containing materials may include alkaline metals, alkaline earth metals, rare-earth-metals, alkaline metal compounds, alkaline earth-metal compounds, rare-earth metal compounds, alkaline metal complexes, alkaline earth-metal complexes, rare-earth metal complexes, or any combinations thereof.

The alkaline metal may be selected from Li, Na, K, Rb, and Cs. In one embodiment, the alkaline metal may be Li, Na, or Cs. In various embodiments, the alkaline metal may be Li or Cs, but is not limited thereto.

The alkaline earth metal may be selected from Mg, Ca, Sr, and Ba.

The rare-earth metal may be selected from Sc, Y, Ce, Tb, Yb, Gd, and Tb.

The alkaline metal compounds, the alkaline earth-metal compounds, and the rare-earth metal compounds may be selected from oxides and halides (e.g., fluorides, chlorides, bromides, and/or iodides) of the alkaline metals, the alkaline earth-metals, and rare-earth metals, respectively.

The alkaline metal compound may be selected from alkaline metal oxides (such as Li₂O, Cs₂O, and/or K₂O) and alkaline metal halides (such as LiF, NaF, CsF, KF, Lil, Nal, Csl, and/or KI). In one embodiment, the alkaline metal compound may be selected from LiF, Li₂O, NaF, Lil, Nal, Csl, and KI, but is not limited thereto.

The alkaline earth-metal compound may be selected from BaO, SrO, CaO, BaₓSr₁₋ₓO(0<x<1), and BaₓCa₁₋ₓO(0<x<1). In one embodiment, the alkaline earth-metal compound may be selected from BaO, SrO, and CaO, but is not limited thereto.

The rare-earth metal compound may be selected from YbF₃, ScF₃, ScO₃, Y₂O₃, Ce₂O₃, GdF₃, and TbF₃. In one embodiment, the rare-earth metal compound may be selected from YbF₃, ScF₃, TbF₃, YbI₃, ScI₃, and TbI₃, but is not limited thereto.

The alkaline metal complex may include a metal ion selected from a Li ion, a Na ion, a K ion, a Rb ion, and a Cs ion; and the alkaline earth-metal complex may include a metal ion selected from a Be ion, a Mg ion, a Ca ion, a Sr ion, and a Ba ion. Ligands coordinated with the metal ion of the alkaline metal complex or the alkaline earth-metal complex may each independently be selected from a hydroxy quinoline, a hydroxy isoquinoline, a hydroxy benzoquinoline, a hydroxy acridine, a hydroxy phenanthridine, a hydroxy phenyl oxazole, a hydroxy phenylthiazole, a hydroxy diphenyl oxadiazole, a hydroxy diphenylthiadiazole, a hydroxy phenylpyridine, a hydroxy phenylbenzoimidazole, a hydroxy phenylbenzothiazole, a bipyridine, a phenanthroline, and a cyclopentadiene, but are not limited thereto.

For example, the metal-containing material may include a Li complex. The Li complex may include, for example, Compound ET-D1 (lithium quinolate, LiQ) and/or Compound ET-D2.

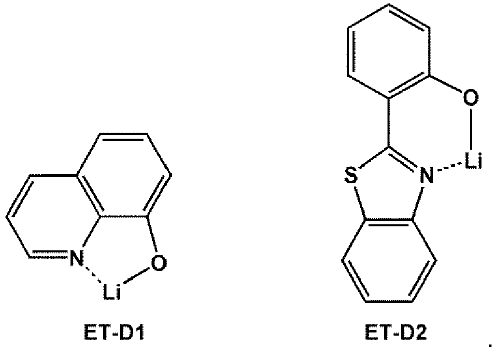

The electron transport region may include an electron injection layer that facilitates injection of electrons from the second electrode 190. The electron injection layer may directly contact the second electrode 190.

The electron injection layer may have i) a single-layered structure including a single layer including a single material, ii) a single-layered structure including a single layer including a plurality of different materials, or iii) a multi-layered structure having a plurality of layers including a plurality of different materials.

The electron injection layer may include a reducing dopant.

The reducing dopant may include at least one selected from alkaline metals, alkaline earth-metals, rare-earth metals, alkaline metal compounds, alkaline earth-metal compounds, rare-earth metal compounds, alkaline metal complexes, alkaline earth metal complexes, and rare-earth metal complexes.

The alkaline metals, the alkaline earth metals, and the rare-earth metals may be respectively the same as the alkaline metals, alkaline earth metals, and rare-earth metals described above, but they are not limited thereto.

The alkaline metal compounds, the alkaline earth metal compounds, and the rare-earth metal compounds may be respectively the same as the alkaline metal compounds, alkaline earth metal compounds, and rare-earth metal compounds described above, but they are not limited thereto.

The alkaline metal complexes, the alkaline earth-metal complexes, and the rare-earth metal complexes may each independently include a metal ion selected from alkaline metals, alkaline earth-metals, and rare-earth metals as described above; and ligands coordinated with the metal ion selected from the alkaline metal complexes, the alkaline earth-metal complexes, and the rare-earth metal complexes may each independently be selected from hydroxy quinoline, hydroxy isoquinoline, hydroxy benzoquinoline, hydroxy acridine, hydroxy phenanthridine, hydroxy phenyl oxazole, hydroxy phenylthiazole, hydroxy diphenyl oxadiazole, hydroxy diphenylthiadiazole, hydroxy phenylpyridine, hydroxy phenylbenzoimidazole, hydroxy phenylbenzothiazole, bipyridine, a phenanthroline, and cyclopentadiene, but are not limited thereto.

The electron injection layer may include only the reducing dopant described above, or may include the reducing dopant and an organic material. When the electron injection layer includes the reducing dopant and an organic material, the reducing dopant may be homogeneously or non-homogeneously dispersed in a matrix consisting of the organic material.

A thickness of the electron injection layer may be in a range of about 1 **Å** to about 100 **Å**, for example, about 1 Å to about 95 Å or about 2 Å to about 95 Å or about 3 **Å** to about 90 **Å** (*e.g*. about 3 Å to about 50 Å, about 3 Å to about 20 Å, about 5 Å to about 20 Å or about 5 Å to about 15 Å, such as about 5 Å or about 10 Å). When the thickness of the electron injection layer is within any of the ranges described above, the electron injection layer may have satisfactory (or suitable) electron injection characteristics without a substantial increase in driving voltage.

### [Second electrode 190]

The second electrode 190 may be disposed (e.g., positioned) on the organic layer 150 having the structure according to embodiments of the present disclosure. The second electrode 190 may be a cathode (which is an electron injection electrode), and in this regard, a material for forming the second electrode 190 may be selected from a metal, an alloy, an electrically conductive compound, and a mixture thereof, which have a relatively low work function.

The second electrode 190 may include at least one selected from lithium (Li), silver(Ag), magnesium (Mg), aluminium (Al), aluminium-lithium (Al-Li), calcium (Ca), magnesium-indium (Mg-In), magnesium-silver (Mg-Ag), ITO, and IZO, but is not limited thereto. The second electrode 190 may be a transmissive electrode, a semi-transmissive electrode, or a reflective electrode.

The second electrode 190 may have a single-layer structure, or a multi-layer structure including two or more layers.

### [Description of FIGS. 2 to 4]

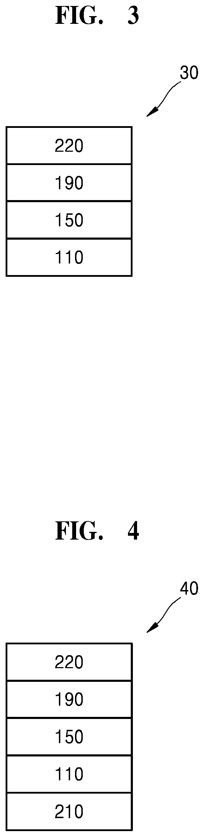

An organic light-emitting device 20 of FIG. 2 includes a first capping layer 210, a first electrode 110, an organic layer 150, and a second electrode 190, which are sequentially stacked in this stated order; an organic light-emitting device 30 of FIG. 3 includes a first electrode 110, an organic layer 150, a second electrode 190, and a second capping layer 220, which are sequentially stacked in this stated order; and an organic light-emitting device 40 of FIG. 4 includes a first capping layer 210, a first electrode 110, an organic layer 150, a second electrode 190, and a second capping layer 220, which are sequentially stacked in this stated order.

Regarding FIGS. 2 to 4, descriptions of the first electrode 110, the organic layer 150, and the second electrode 190 may each independently be understood by referring to the descriptions thereof presented in connection with FIG. 1.

In the organic layer 150 of each of the organic light-emitting devices 20 and 40, light generated in an emission layer may pass through the first electrode 110 (which may be a semi-transmissive electrode or a transmissive electrode) and the first capping layer 210 toward the outside; and in the organic layer 150 of each of the organic light-emitting devices 30 and 40, light generated in an emission layer may pass through the second electrode 190 (which may be a semi-transmissive electrode or a transmissive electrode) and the second capping layer 220 toward the outside.

The first capping layer 210 and the second capping layer 220 may increase external luminescent efficiency according to the principle of constructive interference.

The first capping layer 210 and the second capping layer 220 may each independently be a capping layer including an organic material, an inorganic capping layer including an inorganic material, or a composite capping layer including an organic material and an inorganic material.

At least one selected from the first capping layer 210 and the second capping layer 220 may each independently include at least one material selected from carbocyclic compounds, heterocyclic compounds, amine-based compounds, porphine derivatives, phthalocyanine derivatives, naphthalocyanine derivatives, alkaline metal complexes, and alkaline earth-based complexes. The carbocyclic compound, the heterocyclic compound, and the amine-based compound may be optionally substituted with a substituent containing at least one element selected from O, N, S, Se, Si, F, CI, Br, and I. In one embodiment, at least one selected from the first capping layer 210 and the second capping layer 220 may each independently include an amine-based compound.

In one embodiment, at least one selected from the first capping layer 210 and the second capping layer 220 may each independently include the compound represented by Formula 201 or the compound represented by Formula 202.

In various embodiments, at least one selected from the first capping layer 210 and the second capping layer 220 may each independently include a compound selected from Compounds HT28 to HT33 and Compounds CP1 to CP5, but is not limited thereto.

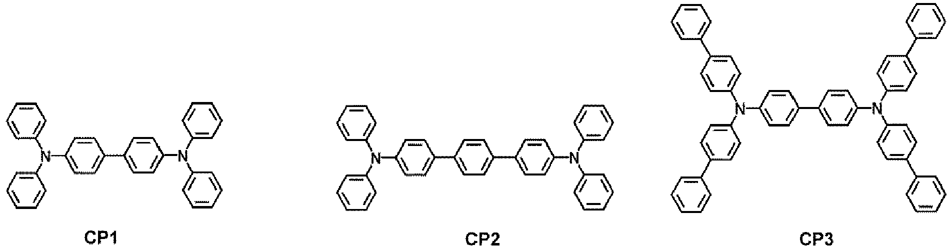

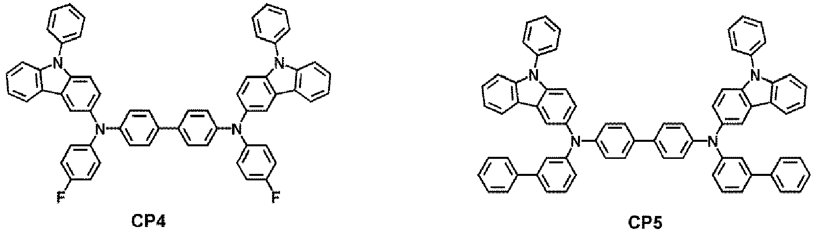

Hereinbefore, the organic light-emitting device according to one or more embodiments of the present disclosure has been described in connection with FIGS. 1-4. However, embodiments of the present disclosure are not limited thereto.

Layers constituting the hole transport region, the emission layer, and the electron transport region may be each independently be formed by using one or more suitable methods such as vacuum deposition, spin coating, casting, a Langmuir-Blodgett (LB) method, ink-jet printing, laser-printing, and/or laser-induced thermal imaging.

When a layer included in any of the hole transport region, the emission layer, and the electron transport region is formed by vacuum deposition, for example, the vacuum deposition may be performed at a deposition temperature of about 100 to about 500°C, at a vacuum degree of about 10⁻⁸ to about 10⁻³ torr, and at a deposition rate of about 0.01 to about 100 **Å**/sec, by taking into account a compound to be included in a to-be-formed layer, and the structure of the to-be-formed layer.

When a layer included in any of the hole transport region, the emission layer, and the electron transport region is formed by spin coating, for example, the spin coating may be performed at a coating speed (or rate) of about 2000 rpm to about 5000 rpm, and at a heat treatment temperature of about 80°C to 200°C, by taking into account a compound to be included in a to-be-formed layer, and the structure of the to-be-formed layer.

### [General definition of substituents]

The term "C₁-C₆₀ alkyl group," as used herein, may refer to a linear or branched aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an iso-amyl group, and a hexyl group. The term "C₁-C₆₀ alkylene group," as used herein, may refer to a divalent group having the same structure as the C₁-C₆₀ alkyl group. Corresponding definitions apply to other ranges given for the number of carbon atoms in an alkyl/alkylene group.

The term "C₂-C₆₀ alkenyl group," as used herein, may refer to a hydrocarbon group having at least one carbon double bond at one or more positions along the hydrocarbon chain of the C₂-C₆₀ alkyl group (e.g., in the middle and/or at either terminus of the C₂-C₆₀ alkyl group), and non-limiting examples thereof include an ethenyl group, a propenyl group, and a butenyl group. The term "C₂-C₆₀ alkenylene group," as used herein, may refer to a divalent group having the same structure as the C₂-C₆₀ alkenyl group. Corresponding definitions apply to other ranges given for the number of carbon atoms in an alkenyl group.

The term "C₂-C₆₀ alkynyl group," as used herein, may refer to a hydrocarbon group having at least one carbon triple bond at one or more positions along the hydrocarbon chain of the C₂-C₆₀ alkyl group (e.g., in the middle and/or at either terminus of the C₂-C₆₀ alkyl group), and non-limiting examples thereof include an ethynyl group and a propynyl group. The term "C₂-C₆₀ alkynylene group," as used herein, may refer to a divalent group having the same structure as the C₂-C₆₀ alkynyl group. Corresponding definitions apply to other ranges given for the number of carbon atoms in an alkynyl group.

The term "C₁-C₆₀ alkoxy group," as used herein, may refer to a monovalent group represented by -OA₁₀₁ (wherein A₁₀₁ is the C₁-C₆₀ alkyl group), and non-limiting examples thereof include a methoxy group, an ethoxy group, and an isopropoxy group.

The term "C₃-C₁₀ cycloalkyl group," as used herein, may refer to a monovalent hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "C₃-C₁₀ cycloalkylene group," as used herein, may refer to a divalent group having the same structure as the C₃-C₁₀ cycloalkyl group.

The term "C₁-C₁₀ heterocycloalkyl group," as used herein, may refer to a monovalent monocyclic group having at least one heteroatom selected from N, O, Si, P, and S as a ring-forming atom and 1 to 10 carbon atoms, and non-limiting examples thereof include a 1,2,3,4-oxatriazolidinyl group, a tetrahydrofuranyl group, and a tetrahydrothiophenyl group. The term "C₁-C₁₀ heterocycloalkylene group," used herein, may refer to a divalent group having the same structure as the C₁-C₁₀ heterocycloalkyl group.

The term "C₃-C₁₀ cycloalkenyl group," as used herein, may refer to a monovalent monocyclic group that has 3 to 10 carbon atoms and at least one double bond in the ring thereof and does not have aromaticity, and non-limiting examples thereof are a cyclopentenyl group, a cyclohexenyl group, and a cycloheptenyl group. The term "C₃-C₁₀ cycloalkenylene group," used herein, may refer to a divalent group having the same structure as the C₃-C₁₀ cycloalkenyl group.

The term "C₁-C₁₀ heterocycloalkenyl group," as used herein, may refer to a monovalent monocyclic group that has at least one heteroatom selected from N, O, Si, P, and S as a ring-forming atom, 1 to 10 carbon atoms, and at least one double bond in its ring. Non-limiting examples of the C₁-C₁₀ heterocycloalkenyl group include a 4,5-dihydro-1,2,3,4-oxatriazolyl group, a 2,3-hydrofuranyl group and a 2,3-hydrothiophenyl group. The term "C₁-C₁₀ heterocycloalkenylene group," used herein, may refer to a divalent group having the same structure as the C₁-C₁₀ heterocycloalkenyl group.

The term "C₆-C₆₀ aryl group," as used herein, may refer to a monovalent group having a carbocyclic aromatic system having 6 to 60 carbon atoms, and a C₆-C₆₀ arylene group," as used herein, may refer to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each independently include two or more rings, the respective rings may be fused to each other. Corresponding definitions apply to other ranges given for the number of carbon atoms in an aryl/arylene group.

The term "C₁-C₆₀ heteroaryl group," as used herein, may refer to a monovalent group having a carbocyclic aromatic system that has at least one heteroatom selected from N, O, Si, P, and S as a ring-forming atom, and 1 to 60 carbon atoms. The term "C₁-C₆₀ heteroarylene group," as used herein, may refer to a divalent group having a carbocyclic aromatic system that has at least one heteroatom selected from N, O, Si, P, and S as a ring-forming atom, and 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each independently include two or more rings, the respective rings may be fused to each other. Corresponding definitions apply to other ranges given for the number of carbon atoms in a heteroaryl/heteroarylene group.

The term "C₆-C₆₀ aryloxy group," used herein, may refer to a monovalent group represented by -OA₁₀₂ (wherein A₁₀₂ is the C₆-C₆₀ aryl group), and a C₆-C₆₀ arylthio group may refer to a monovalent group represented by -SA₁₀₃ (wherein A₁₀₃ is the C₆-C₆₀ aryl group). Corresponding definitions apply to other ranges given for the number of carbon atoms in aryloxy and arylthio groups.

The term "monovalent non-aromatic condensed polycyclic group," as used herein, may refer to a monovalent group that has two or more rings condensed (e.g., fused) with each other, only carbon atoms as ring-forming atoms (e.g., 8 to 60 carbon atoms), and non-aromaticity in the entire molecular structure (e.g., does not have overall aromaticity). Non-limiting example of the monovalent non-aromatic condensed polycyclic group is a fluorenyl group. The term "divalent non-aromatic condensed polycyclic group," used herein, may refer to a divalent group having the same structure as the monovalent non-aromatic condensed polycyclic group.

The term "monovalent non-aromatic condensed heteropolycyclic group," as used herein, may refer to a monovalent group that has two or more rings condensed (e.g., fused) to each other, has at least one heteroatom selected from N, O, Si, P, and S, other than carbon atoms (e.g., 1 to 60 carbon atoms), as ring-forming atoms, and has non-aromaticity in the entire molecular structure (e.g., does not have overall aromaticity). An example of the monovalent non-aromatic condensed heteropolycyclic group is a carbazolyl group. The term "divalent non-aromatic condensed heteropolycyclic group," used herein, may refer to a divalent group having the same structure as the monovalent non-aromatic condensed heteropolycyclic group.

The term "C₅-C₆₀ carbocyclic group," as used herein, may refer to a monocyclic or polycyclic group having 5 to 60 carbon atoms, in which ring-forming atoms include carbon atoms only. The C₅-C₆₀ carbocyclic group may be an aromatic carbocyclic group or a non-aromatic carbocyclic group. The C₅-C₆₀ carbocyclic group may be a ring (such as a benzene), a monovalent group (such as a phenyl group), or a divalent group (such as a phenylene group). In various embodiments, depending on the number of substituents connected to the C₅-C₆₀ carbocyclic group, the C₅-C₆₀ carbocyclic group may be a trivalent group or a quadrivalent group.

The term "C₁-C₆₀ heterocyclic group," as used herein, may refer to a group having substantially the same structure as the C₅-C₆₀ carbocyclic group, except that at least one heteroatom selected from N, O, Si, P, and S is used as a ring-forming atom, in addition to carbon atoms (e.g., the number of carbon atoms may be in a range of 1 to 60).

The term "C₆-C₂₀ arene group," as used herein, may refer to a monocarbocyclic aromatic group or a polycarbocyclic aromatic group, having 6 to 20 carbon atoms, in which ring-forming atoms include carbon atoms only. The C₆-C₂₀ arene group may be a ring (such as a benzene), a monovalent group (such as a phenyl group), or a divalent group (such as a phenylene group). In various embodiments, depending on the number of substituents connected to the C₆-C₂₀ arene group, the C₆-C₂₀ arene group may be a trivalent group or a quadrivalent group.

The term "C₁-C₂₀ heteroarene group," as used herein, may refer to a group having substantially the same structure as the C₆-C₂₀ arene group, except that at least one heteroatom selected from N, O, Si, P, and S is used as a ring-forming atom, in addition to carbon atoms (e.g., the number of carbon atoms may be in a range of 1 to 20).

At least one substituent of the substituted C₅-C₆₀ carbocyclic group, substituted C₁-C₆₀ heterocyclic group, substituted C₆-C₂₀ arene group, substituted C₁-C₂₀ heteroarene group, substituted C₃-C₁₀ cycloalkylene group, substituted C₁-C₁₀ heterocycloalkylene group, substituted C₃-C₁₀ cycloalkenylene group, substituted C₁-C₁₀ heterocycloalkenylene group, substituted C₆-C₆₀ arylene group, substituted C₁-C₆₀ heteroarylene group, substituted a divalent non-aromatic condensed polycyclic group, substituted a divalent non-aromatic condensed heteropolycyclic group, substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group, and substituted monovalent non-aromatic condensed heteropolycyclic group may be selected from the group consisting of:
deuterium (-D), -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F,-CI, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃),-N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃),-N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₁₁ to Q₁₃, Q₂₁ to Q₂₃, and Q₃₁ to Q₃₃ may each independently be selected from hydrogen, deuterium, -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

The term "Ph" used herein may refer to a phenyl group, the term "Me" used herein may refer to a methyl group, the term "Et" used herein may refer to an ethyl group, the term "ter-Bu" or "Bu^{t}" used herein may refer to a tert-butyl group, the term "OMe" used herein may refer to a methoxy group, and "D" may refer to deuterium. The term "D₅-Ph," as used herein, may refer to a group having the following structure:

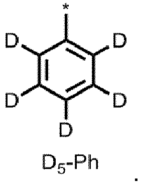

The "biphenyl group" used therein may refer to "a phenyl group substituted with a phenyl group." For example, the "biphenyl group" may be referred to as "a substituted phenyl group" having "a C₆-C₆₀ aryl group" as a substituent. The terms "2-biPh, 3-biPh, and 4-biPh," as used herein, respectively refer to the following structures:

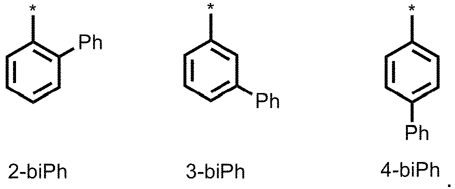

The "terphenyl group" used herein may refer to "a phenyl group substituted with a biphenyl group." For example, the "terphenyl group" may be referred to as "a substituted phenyl group" having "a C₆-C₆₀ aryl group substituted with a C₆-C₆₀ aryl group" as a substituent.

The terms "2-Me-1-Py, 3-Me-1-Py, 4-Me-1-Py, 5-Me-1-Py, 1-Me-2-Py, 3-Me-2-Py, 4-Me-2-Py, 5-Me-2-Py, 1-Me-3-Py, 2-Me-3-Py, 4-Me-3-Py, and 5-Me-3-Py," as used herein, respectively refer to the following structures:

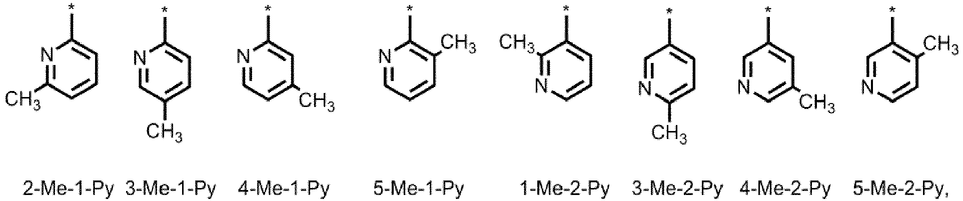

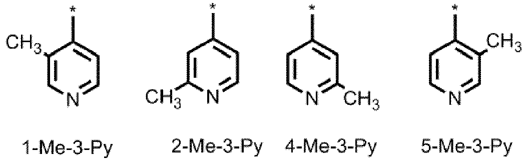

Symbols * and *' used herein, unless defined otherwise, refer to a binding site to a neighboring atom in a corresponding formula.

Hereinafter, a compound according to one or more embodiments of the present disclosure and an organic light-emitting device according to embodiments will be described in more detail with reference to Examples. However, these examples are provided for illustrative purposes only, and should not in any sense be interpreted as limiting the scope of the present disclosure.

### Examples

### Example 1-1

An anode was manufactured by cutting a 15 Ωcm² (1200 Å) ITO glass substrate (by Corning Inc.) to a size of 50 mm×50 mm×0.7 mm, ultrasonically cleaning the glass substrate by using isopropyl alcohol and pure water, for 5 minutes each, and then irradiating UV light for 30 minutes thereto and being exposed to ozone to clean. Then, the resulting ITO anode was loaded into a vacuum deposition apparatus.

HT28 was deposited on the anode to form a hole injection layer having a thickness of 300 Å, and then, HT3 was deposited on the hole injection layer to form a hole transport layer having a thickness of 400 Å, and Compounds H1 (as a host) and D1 (as a dopant) were co-deposited on the hole transport layer at a weight ratio of 95:5 to form an emission layer having a thickness of 300 Å.

ET1 was deposited on the emission layer to form an electron transport layer having a thickness of 300 Å, and then, LiF was deposited on the electron transport layer to form an electron injection layer having a thickness of 5 Å, and then, Al was deposited on the electron injection layer to form a cathode having a thickness of 2,000Å, thereby completing the manufacture of an organic light-emitting device.

### Examples 1-2 to 1-20 and Comparative Examples 1-1 and 1-5

Organic light-emitting devices were manufactured in the same (or substantially the same) manner as in Example 1-1, except that in forming an emission layer, compounds as shown in Table 1 were used as hosts and dopants.

**[Table 1]**

| | Host | Dopant |
|---|---|---|
| Example 1-1 | H1 | D1 |
| Example 1-2 | H7 | D1 |
| Example 1-3 | H7 | D6 |
| Example 1-4 | H7 | D35 |
| Example 1-5 | H7 | D61 |
| Example 1-6 | H7 | D86 |
| Example 1-7 | H7 | D108 |
| Example 1-8 | H7 | D110 |
| Example 1-9 | H7 | D179 |
| Example 1-10 | H7 | D190 |
| Example 1-11 | H1 | D182 |
| Example 1-12 | H6 | D182 |
| Example 1-13 | H7 | D182 |
| Example 1-14 | H16 | D182 |
| Example 1-15 | H23 | D182 |
| Example 1-16 | H52 | D182 |
| Example 1-17 | H60 | D182 |
| Example 1-18 | H61 | D182 |
| Example 1-19 | H67 | D182 |
| Example 1-20 | H87 | D182 |
| Comparative Example 1-1 | ADN | BD1 |
| Comparative Example 1-2 | ADN | D1 |
| Comparative Example 1-3 | H1 | BD1 |
| Comparative Example 1-4 | H1 | BD2 |
| Comparative Example 1-5 | ADN | BD3 |

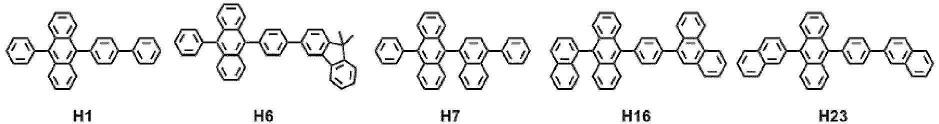

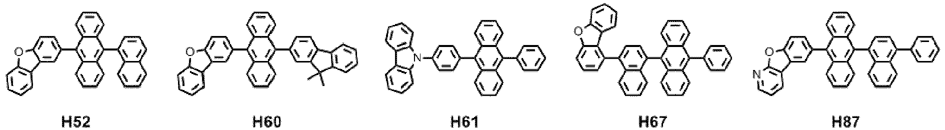

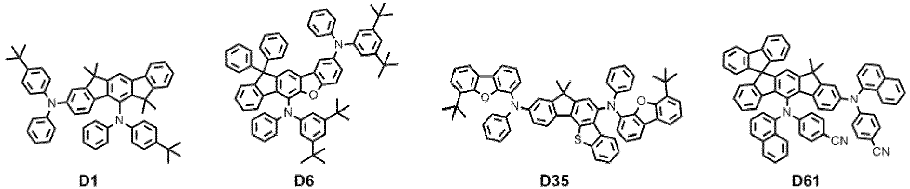

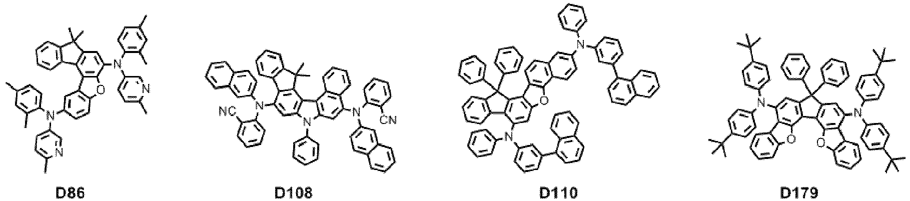

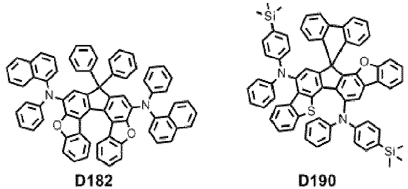

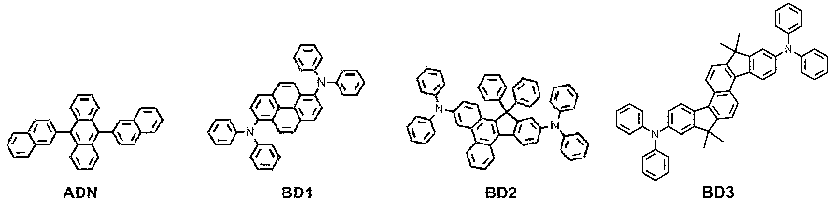

### Example 2-1

An anode was manufactured by cutting a 15 Ωcm² (1,200 Å) ITO glass substrate (by Corning Inc.) to a size of 50 mm×50 mm×0.7 mm, ultrasonically cleaning the glass substrate by using isopropyl alcohol and pure water, for 5 minutes each, and then irradiating UV light for 30 minutes thereto and being exposed to ozone to clean. Then, the resulting ITO anode was loaded into a vacuum deposition apparatus.

Compound HT3 and Compound F4-TCNQ were co-deposited on the glass substrate at a weight ratio of 95:5 to form a hole injection layer having a thickness of 100 Å, and then, Compound HT3 was deposited on the hole injection layer to form a hole transport layer having a thickness of 600 Å.

Subsequently, Compounds H1 (as a host) and D1 (as a dopant) were co-deposited at a weight ratio of 95:5 to form an emission layer having a thickness of 300 Å.

Then, Compound ET1 and Liq were co-deposited on the emission layer at a weight ratio of 50:50 to form an electron transport layer having a thickness of 300 Å, and then, LiF was deposited on the electron transport layer to form an electron injection layer having a thickness of 10 Å, thereby completing the formation of an electron transport region. Then, Al was vacuum deposited to form a cathode having a thickness of 2,000 Å, thereby completing the manufacture of an organic light-emitting device.

### Examples 2-2 to 2-10 and Comparative Examples 2-1 and 2-5

Organic light-emitting devices were manufactured in the same (or substantially the same) manner as in Example 2-1, except that in forming an emission layer, compounds as shown in Table 2 were used as hosts and dopants.

**[Table 2]**

| | Host | Dopant |
|---|---|---|
| Example 2-1 | H1 | D1 |
| Example 2-2 | H7 | D1 |
| Example 2-3 | H7 | D6 |
| Example 2-4 | H7 | D35 |
| Example 2-5 | H7 | D61 |
| Example 2-6 | H7 | D86 |
| Example 2-7 | H7 | D108 |
| Example 2-8 | H7 | D110 |
| Example 2-9 | H7 | D179 |
| Example 2-10 | H7 | D190 |
| Comparative Example 2-1 | ADN | BD1 |
| Comparative Example 2-2 | ADN | D1 |
| Comparative Example 2-3 | H1 | BD1 |
| Comparative Example 2-4 | H1 | BD2 |
| Comparative Example 2-5 | ADN | BD3 |

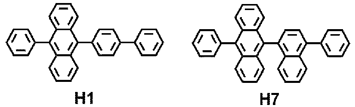

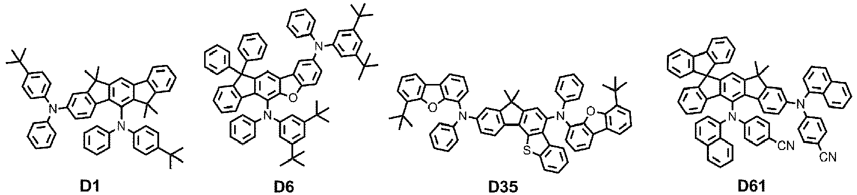

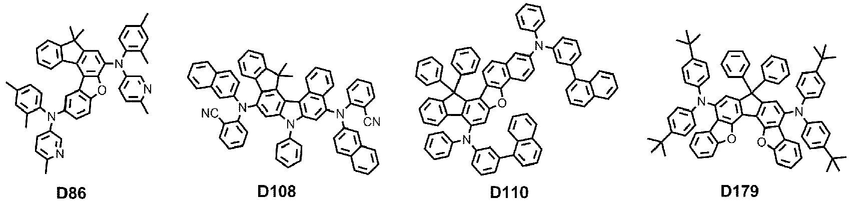

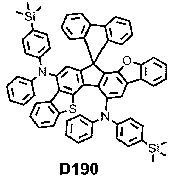

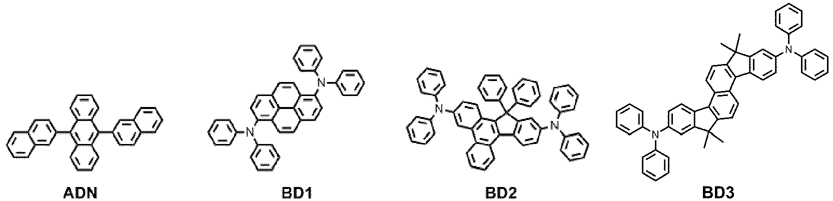

### Evaluation Example

Efficiency (current density at 10 mA/cm²) and lifespan (T₉₀) (current density at 10 mA/cm²) of the organic light-emitting devices manufactured according to Examples 1-1 to 1-20, Examples 2-1 to 2-10, Comparative Examples 1-1 to 1-5, and Comparative Examples 2-1 to 2-5 were evaluated by using Keithley 2400 and Minolta CS-1000A. The lifespan (T₉₀) refers to an amount of time that lapsed when 100% of the initial luminance was decreased to 90% (e.g., 90% of the initial luminance). Evaluation results are shown in Tables 3 and 4.

**[Table 3]**

| | Host | Dopant | Efficiency (cd/A) | Lifespan (Hours) |
|---|---|---|---|---|
| Example 1-1 | H1 | D1 | 5.2 | 120 |
| Example 1-2 | H7 | D1 | 5.3 | 140 |
| Example 1-3 | H7 | D6 | 5.2 | 110 |
| Example 1-4 | H7 | D35 | 5.4 | 125 |
| Example 1-5 | H7 | D61 | 5.4 | 130 |
| Example 1-6 | H7 | D86 | 5.3 | 120 |
| Example 1-7 | H7 | D108 | 5.4 | 120 |
| Example 1-8 | H7 | D110 | 5.4 | 110 |
| Example 1-9 | H7 | D179 | 5.5 | 125 |
| Example 1-10 | H7 | D190 | 5.4 | 130 |
| Example 1-11 | H1 | D182 | 5.3 | 120 |
| Example 1-12 | H6 | D182 | 5.2 | 115 |
| Example 1-13 | H7 | D182 | 5.5 | 130 |
| Example 1-14 | H16 | D182 | 5.4 | 120 |
| Example 1-15 | H23 | D182 | 5.3 | 120 |
| Example 1-16 | H52 | D182 | 5.4 | 110 |
| Example 1-17 | H60 | D182 | 5.5 | 130 |
| Example 1-18 | H61 | D182 | 5.3 | 120 |
| Example 1-19 | H67 | D182 | 5.3 | 120 |
| Example 1-20 | H87 | D182 | 5.4 | 125 |
| Comparative Example 1-1 | ADN | BD1 | 4.5 | 35 |
| Comparative Example 1-2 | ADN | D1 | 4.7 | 60 |
| Comparative Example 1-3 | H1 | BD1 | 4.6 | 80 |
| Comparative Example 1-4 | H1 | BD2 | 4.8 | 60 |
| Comparative Example 1-5 | ADN | BD3 | 4.8 | 70 |

**[Table 4]**

| | Host | Dopant | Efficiency (cd/A) | Lifespan (Hours) |
|---|---|---|---|---|
| Example 2-1 | H1 | D1 | 5.4 | 130 |
| Example 2-2 | H7 | D1 | 5.5 | 140 |
| Example 2-3 | H7 | D6 | 5.4 | 120 |
| Example 2-4 | H7 | D35 | 5.6 | 140 |
| Example 2-5 | H7 | D61 | 5.5 | 135 |
| Example 2-6 | H7 | D86 | 5.5 | 140 |
| Example 2-7 | H7 | D108 | 5.6 | 120 |
| Example 2-8 | H7 | D110 | 5.5 | 120 |
| Example 2-9 | H7 | D179 | 5.7 | 130 |
| Example 2-10 | H7 | D190 | 5.5 | 150 |
| Comparative Example 2-1 | ADN | BD1 | 4.6 | 50 |
| Comparative Example 2-2 | ADN | D1 | 4.8 | 80 |
| Comparative Example 2-3 | H1 | BD1 | 4.8 | 100 |
| Comparative Example 2-4 | H1 | BD2 | 4.9 | 90 |
| Comparative Example 2-5 | ADN | BD3 | 4.8 | 90 |

From the results shown in Table 3, it can be seen that the organic light-emitting devices of Examples 1-1 to 1-20 had better efficiency and lifespan characteristics than the organic light-emitting devices of Comparative Examples 1-1 to 1-5.

From the results shown in Table 4, it can be seen that the organic light-emitting devices of Examples 2-1 to 2-10 had better efficiency and characteristics than the organic light-emitting devices of Comparative Examples 2-1 to 2-5.

An organic light-emitting device according to embodiments of the present disclosure may have improved efficiency and lifespan characteristics.

As used herein, the terms "use," "using," and "used" may be considered synonymous with the terms "utilize," "utilizing," and "utilized," respectively.

In addition, the terms "substantially," "about," and similar terms are used as terms of approximation and not as terms of degree, and are intended to account for the inherent deviations in measured or calculated values that would be recognized by those of ordinary skill in the art.

It will be understood that when an element such as a layer, film, region, or substrate is referred to as being "on" or "over" another element, it can be directly on the other element or intervening elements may also be present. In contrast, when an element is referred to as being "directly on" or "directly contacting" another element, there are no intervening elements present.

Also, any numerical range recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

It should be understood that embodiments described herein should be considered in a descriptive sense only and not for purposes of limitation. Descriptions of features or aspects within each embodiment should typically be considered as available for other similar features or aspects in other embodiments.

## Claims

1. An organic light-emitting device comprising:
a first electrode;
a second electrode; and
an organic layer between the first electrode and the second electrode, the organic layer comprising an emission layer,
wherein the emission layer comprises a first compound selected from Compounds H1 to H116 and a second compound represented by Formula 2: 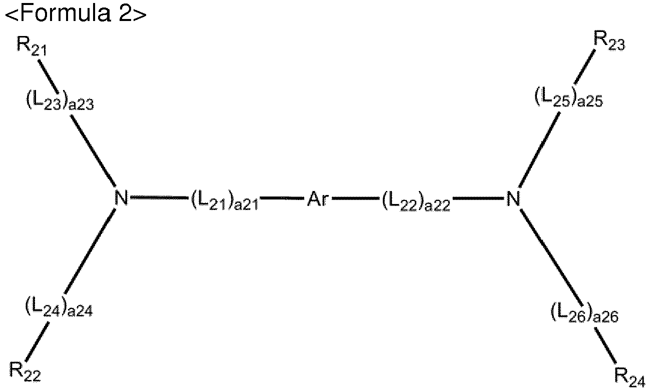 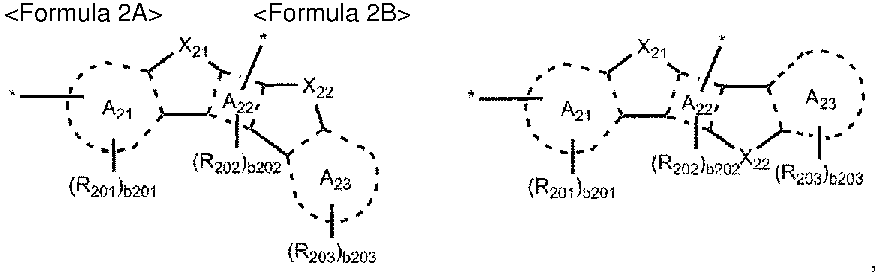 wherein, in Formulae 2, 2A and 2B,
Ar is selected from a group represented by Formula 2A and a group represented by Formula 2B;
X21 is selected from oxygen, sulfur, N(R₂₀₄), and C(R₂₀₄)(R₂₀₅);
X22 is selected from oxygen, sulfur, N(R₂₀₆), and C(R₂₀₆)(R₂₀₇);
A21 is selected from a C₅-C₂₀ carbocyclic group and a C₁-C₂₀ heterocyclic group;
A22 is selected from a C₆-C₂₀ arene group and a C₁-C₂₀ heteroarene group;
A23 is selected from a C₅-C₂₀ carbocyclic group and a C₁-C₂₀ heterocyclic group;
L₂₁ to L₂₆ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group;
a21 to a26 are each independently selected from 0, 1, 2, and 3;
R₂₁ to R₂₄ are each independently selected from a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group and a substituted or unsubstituted monovalent non-aromatic condensed heteropolycyclic group; wherein R₂₁ and R₂₂ are optionally linked to each other to form a saturated ring or an unsaturated ring, and R₂₃ and R₂₄ are optionally linked to each other to form a saturated ring or an unsaturated ring;
R₂₀₁ to R₂₀₇ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁),-S(=O)₂(Q₁) and -P(=O)(Q₁)(Q₂); wherein R₂₀₄ and R₂₀₅ are optionally linked to each other to form a saturated ring or an unsaturated ring, and R₂₀₆ and R₂₀₇ are optionally linked to each other to form a saturated ring or an unsaturated ring;
b201 to b203 are each independently selected from 1, 2, 3, 4, 5, 6, 7, 8, 9, and 10;
Q₁ to Q₃ are each independently selected from hydrogen, deuterium, -F, -CI, - Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group; and
* indicates a binding site to a neighboring atom

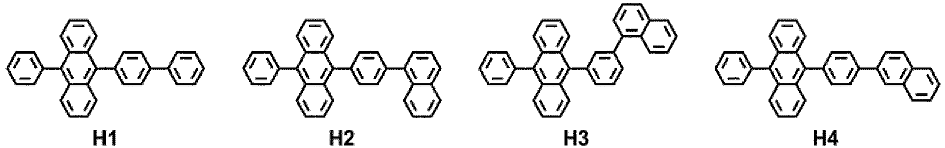

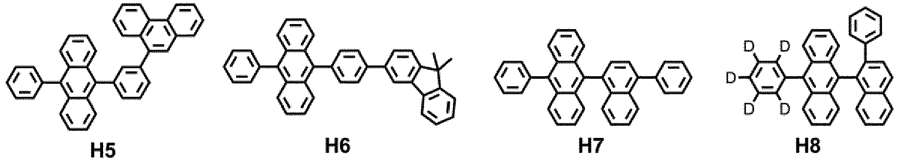

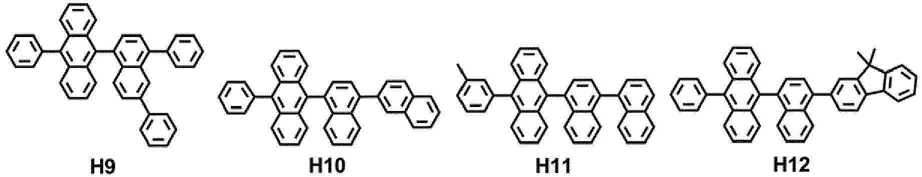

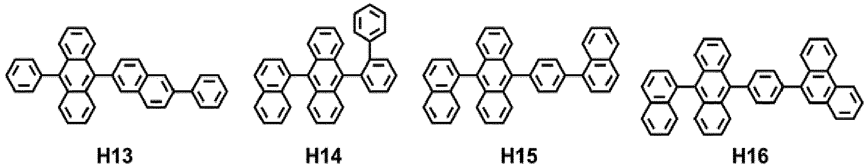

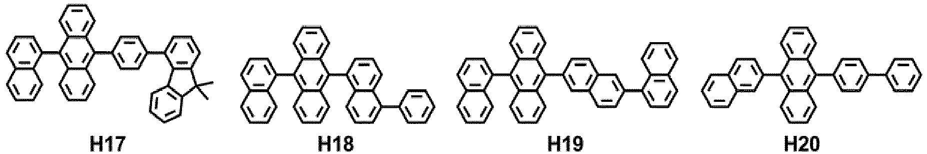

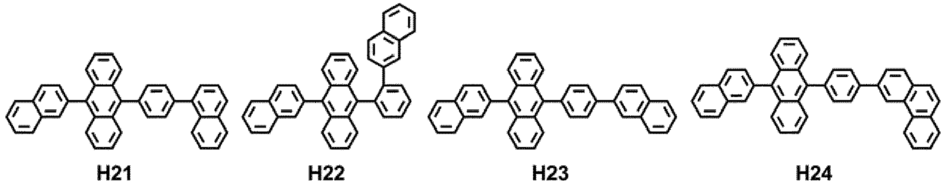

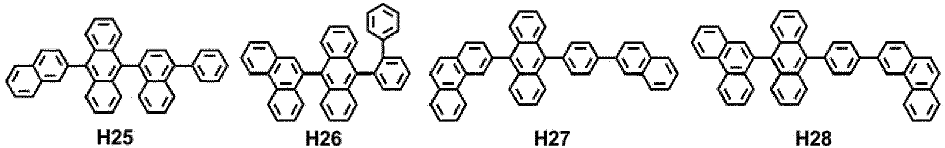

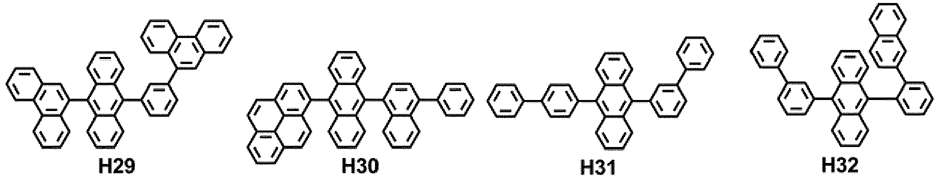

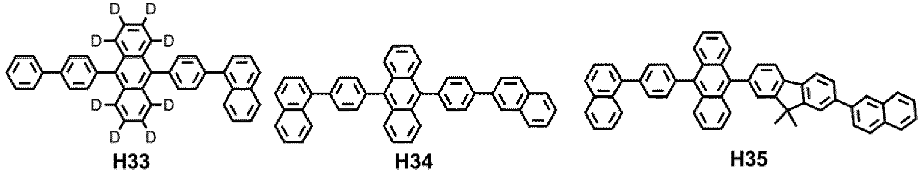

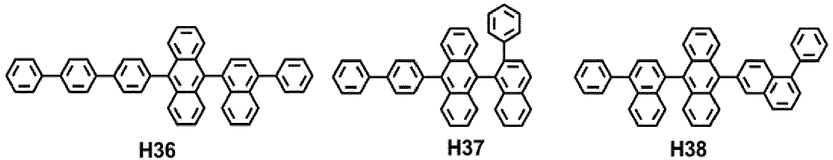

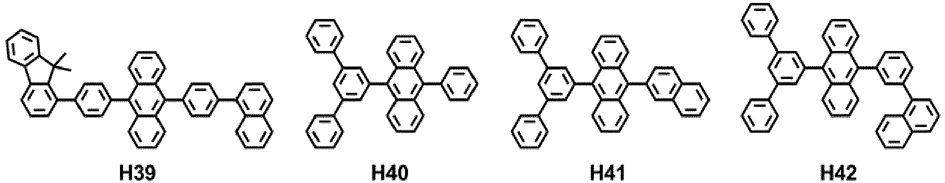

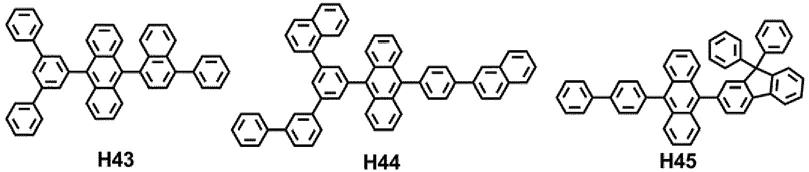

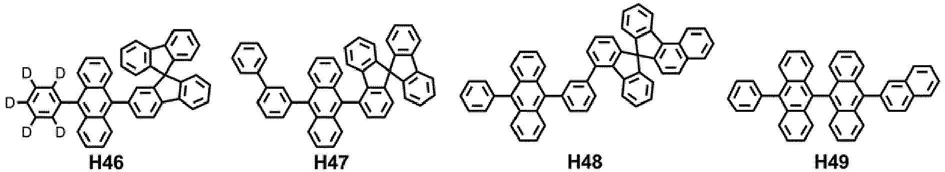

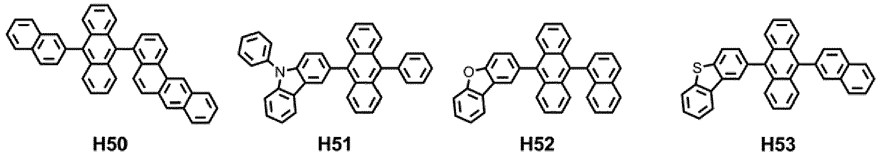

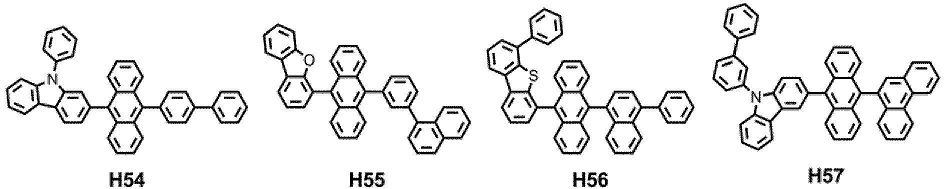

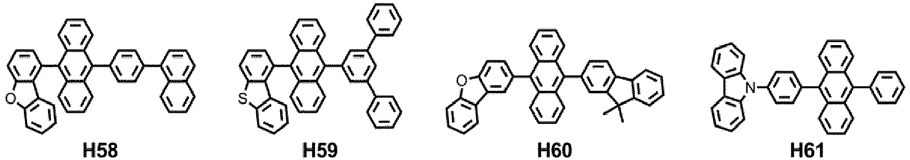

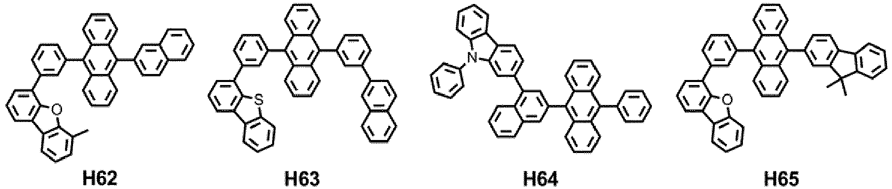

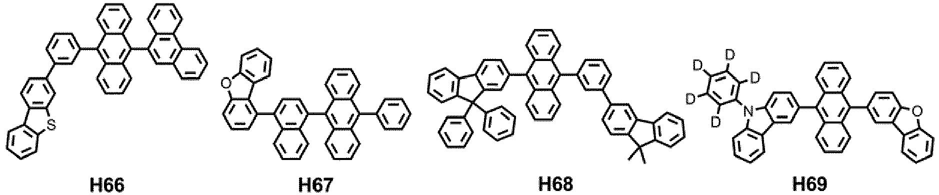

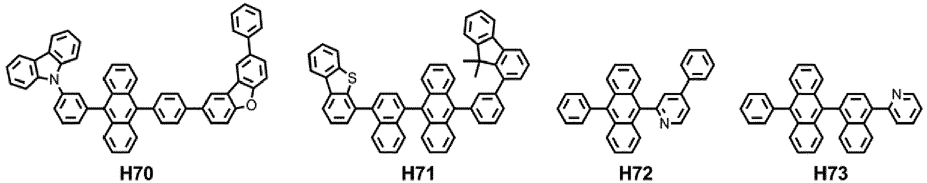

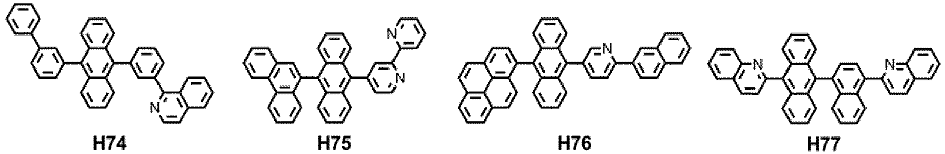

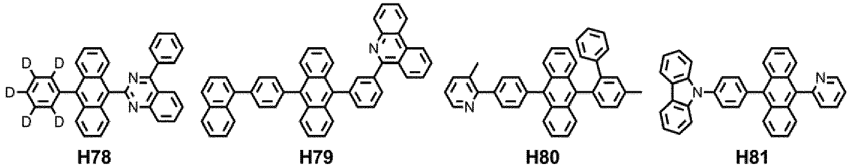

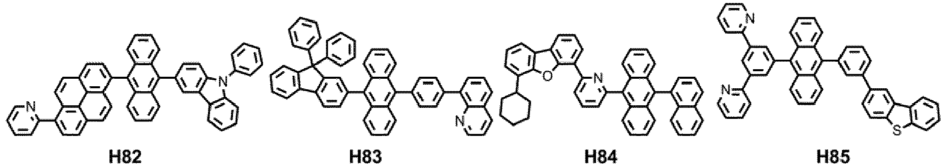

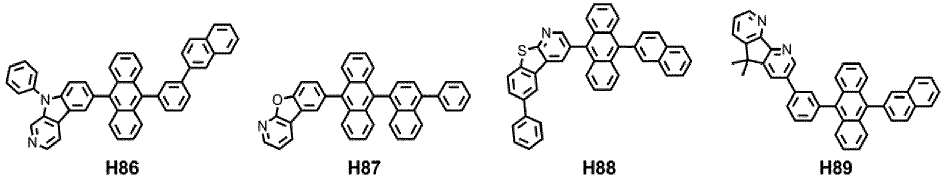

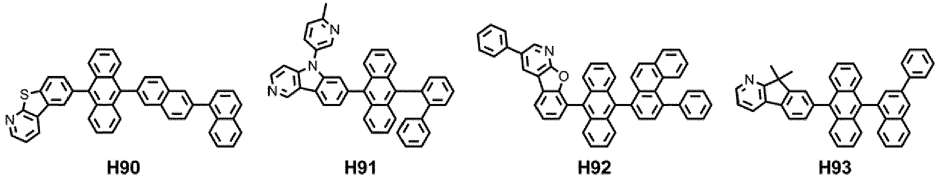

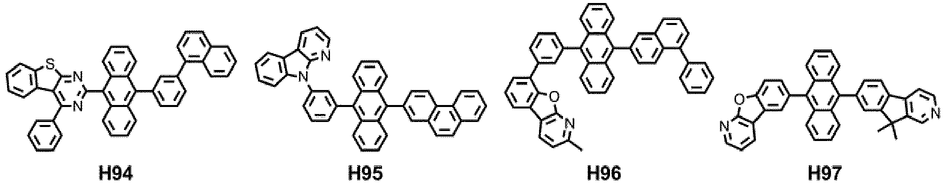

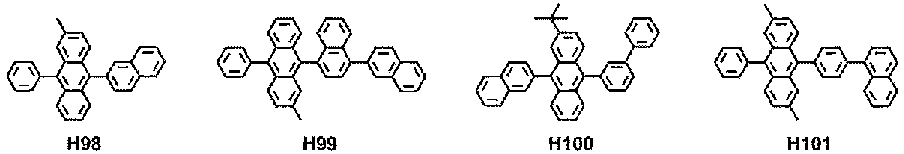

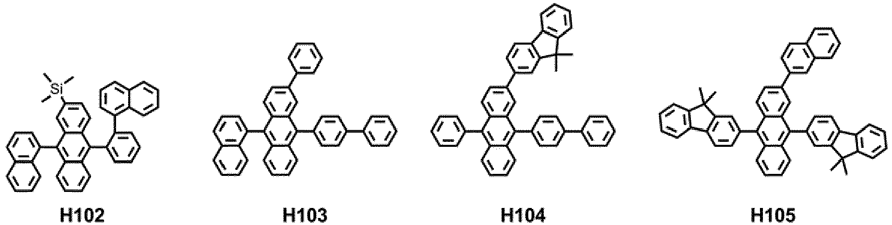

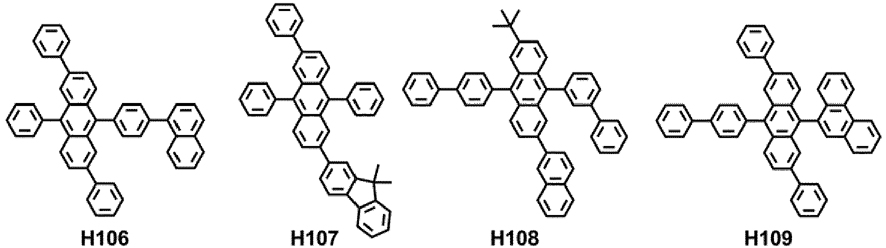

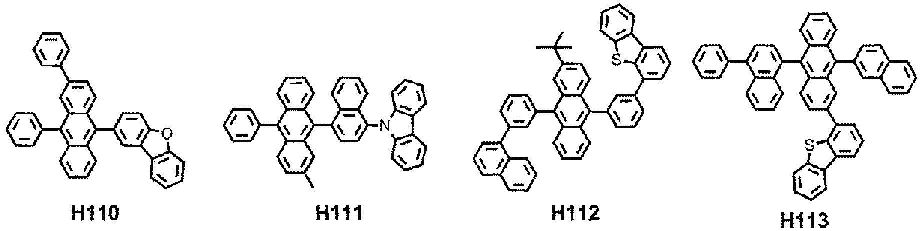

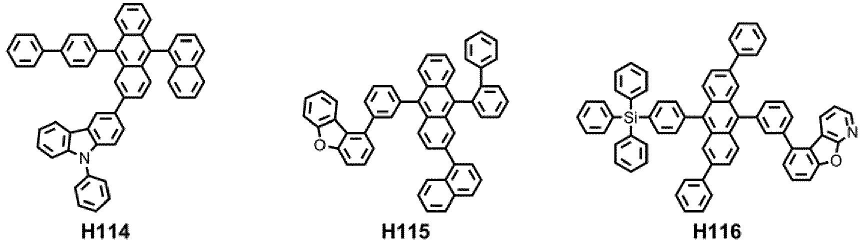

2. An organic light-emitting device according to claim 1, wherein
A₂₁ and A₂₃ are each independently selected from a benzene group, a naphthalene group, a phenanthrene group, an anthracene group, a triphenylene group, a pyrene group, a chrysene group, a furan group, a thiophene group, a pyrrole group, a pyridine group, a pyrazine group, a pyrimidine group, a triazine group, a quinoline group, an isoquinoline group, a benzoquinoline group, a benzoisoquinoline group, a 2,6-naphthyridine group, a 1,8-naphthyridine group, a 1,5-naphthyridine group, a 1,6-naphthyridine group, a 1,7-naphthyridine group, a 2,7-naphthyridine group, a quinoxaline group, a quinazoline group, a phenanthridine group, a phenanthroline group, a benzofuran group, a benzothiophene group, an indene group, an indole group, furopyridine group, thienopyridine group, a cyclopentapyridine group, a pyrrolopyridine group, a dibenzofuran group, a dibenzothiophene group, a fluorene group, a carbazole group, a benzofuropyrrole group, a benzothienopyrrole group, an indenopyrrole group, an indolopyrrole group, a benzofurothiophene group, a benzothienothiophene group, an indenothiophene group, an indolothiophene group, a benzofurofuran group, a benzothienofuran group, an indenofuran group, an indolofuran group, a benzofurothiophene group, a benzothienothiophene group, an indenothiophene group, an indolothiophene group, a benzofuropyridine group, a benzothienopyridine group, an indenopyridine group, an indolopyridine group, a benzofuropyrimidine group, a benzothienopyrimidine group, an indenopyrimidine group, an indolopyrimidine group, a benzofuroindole group, a benzothienoindole group, an indenoindole group, an indoloindole group, a benzofurobenzofuran group, a benzothienobenzofuran group, an indenobenzofuran group, an indolobenzofuran group, a benzofurobenzothiophene group, a benzothienobenzothiophene group, an indenobenzothiophene group, an indolobenzothiophene group, a benzofuroquinoline group, a benzothienoquinoline group, an indenoquinoline group, an indoloquinoline group, a benzonaphthofuran group, a benzonaphthothiophene group, a benzofluorene group, a benzocarbazole group, a dinaphthofuran group, a dinaphthothiophene group, a dibenzofluorene group, a dibenzocarbazole group, a benzoxazole group, a benzothiazole group, a benzimidazole group, a naphthofuran, a naphthothiophene, a cyclopentanaphthalene group, a spiro-bifluorene group, and a spiro-fluorene-indene group.

3. An organic light-emitting device according to claim 1 or 2, wherein
A₂₁ and A₂₃ are each independently selected from a benzene group, a naphthalene group, a phenanthrene group, a pyridine group, a quinoline group, an isoquinoline group, a benzoquinoline group, a benzoisoquinoline group, a dibenzofuran group, a dibenzothiophene group, a fluorene group, a carbazole group, and an indolopyridine group.

4. An organic light-emitting device according to any one of claims 1 to 3, wherein
A₂₂ is selected from a benzene group, a naphthalene group, a phenanthrene group, an anthracene group, a triphenylene group, a pyrene group, a chrysene group, a pyridine group, a pyrazine group, a pyrimidine group, a triazine group, a quinoline group, an isoquinoline group, a benzoquinoline group, a benzoisoquinoline group, a 2,6-naphthyridine group, a 1,8-naphthyridine group, a 1,5-naphthyridine group, a 1,6-naphthyridine group, a 1,7-naphthyridine group, a 2,7-naphthyridine group, a quinoxaline group, a quinazoline group, a phenanthridine group, and a phenanthroline group.

5. An organic light-emitting device according to any one of claims 1 to 4, wherein
A₂₂ is selected from a benzene group and a naphthalene group.

6. An organic light-emitting device according to any one of claims 1 to 5, wherein
L₂₁ to L₂₆ are each independently selected from the group consisting of:
a phenylene group, a naphthylene group, a fluorenylene group, a phenanthrenylene group, an anthracenylene group, a triphenylenylene group, a pyrrolylene group, a thiophenylene group, a furanylene group, a pyridinylene group, a pyrazinylene group, a pyrimidinylene group, an indolylene group, a quinolinylene group, an isoquinolinylene group, a benzoquinolinylene group, a benzoisoquinolinylene group, a naphthyridinylene group, a quinoxalinylene group, a quinazolinylene group, a cinnolinylene group, a phenanthridinylene group, a phenanthrolinylene group, a carbazolylene group, a benzimidazolylene group, a benzofuranylene group, a benzothiophenylene group, a triazinylene group, a dibenzofuranylene group, and a dibenzothiophenylene group; and
a phenylene group, a naphthylene group, a fluorenylene group, a phenanthrenylene group, an anthracenylene group, a triphenylenylene group, a pyrrolylene group, a thiophenylene group, a furanylene group, a pyridinylene group, a pyrazinylene group, a pyrimidinylene group, an indolylene group, a quinolinylene group, an isoquinolinylene group, a benzoquinolinylene group, a benzoisoquinolinylene group, a naphthyridinylene group, a quinoxalinylene group, a quinazolinylene group, a cinnolinylene group, a phenanthridinylene group, a phenanthrolinylene group, a carbazolylene group, a benzimidazolylene group, a benzofuranylene group, a benzothiophenylene group, a triazinylene group, a dibenzofuranylene group, and a dibenzothiophenylene group, each substituted with at least one selected from deuterium, -F, -CI, -Br, -I, a cyano group, a C₁-C₂₀ alkyl group, a C₁-C₂₀ alkoxy group, a cyclopropyl group, a cyclobutyl group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, -Si(Q₃₁)(Q₃₂)(Q₃₃), -N(Q₃₁)(Q₃₂), -B(Q₃₁)(Q₃₂), -C(=O)(Q₃₁),-S(=O)₂(Q₃₁), and -P(=O)(Q₃₁)(Q₃₂),
wherein Q₃₁ to Q₃₃ are each independently selected from hydrogen, a C₁-C₂₀ alkyl group, a phenyl group, a naphthyl group, a biphenyl group, and a terphenyl group.

7. An organic light-emitting device according to any one of claims 1 to 6, wherein
R₂₁ to R₂₄ are each independently selected from the group consisting of:
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a spiro-benzofluorene-fluorenyl group, a spiro-cyclopentane-fluorenyl group, a spiro-cyclohexane-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a carbazolyl group, a benzocarbazolyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a benzonaphthofuranyl group, a dibenzothiophenyl group, a benzonaphthothiophenyl group, a benzocarbazolyl group, a dibenzocarbazolyl group, a thiadiazolyl group, an imidazopyridinyl group, an imidazopyrimidinyl group, a benzofuropyridinyl group, a benzofuropyrimidinyl group, a benzothienopyridinyl group, a benzothienopyrimidinyl group, an indenopyridinyl group, an indenopyrimidinyl group, an indolopyridinyl group, an indolopyrimidinyl group, and a diazafluorenyl group;
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a spiro-benzofluorene-fluorenyl group, a spiro-cyclopentane-fluorenyl group, a spiro-cyclohexane-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a carbazolyl group, a benzocarbazolyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a benzonaphthofuranyl group, a dibenzothiophenyl group, a benzonaphthothiophenyl group, a benzocarbazolyl group, a dibenzocarbazolyl group, a thiadiazolyl group, an imidazopyridinyl group, an imidazopyrimidinyl group, a benzofuropyridinyl group, a benzofuropyrimidinyl group, a benzothienopyridinyl group, a benzothienopyrimidinyl group, an indenopyridinyl group, an indenopyrimidinyl group, an indolopyridinyl group, an indolopyrimidinyl group, and a diazafluorenyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkyl group substituted with deuterium, a C₁-C₂₀ alkyl group substituted with - F, a C₁-C₂₀ alkoxy group, a C₃-C₁₀ cycloalkyl group, a phenyl group, a phenyl group substituted with deuterium, a phenyl group substituted with a methyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a spiro-benzofluorene-fluorenyl group, a spiro-cyclopentane-fluorenyl group, a spiro-cyclohexane-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyridinyl group substituted with deuterium, a pyridinyl group substituted with a methyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a carbazolyl group, a benzocarbazolyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a benzonaphthofuranyl group, a dibenzothiophenyl group, a benzonaphthothiophenyl group, a benzocarbazolyl group, a dibenzocarbazolyl group, a thiadiazolyl group, an imidazopyridinyl group, an imidazopyrimidinyl group, a benzofuropyridinyl group, a benzofuropyrimidinyl group, a benzothienopyridinyl group, a benzothienopyrimidinyl group, an indenopyridinyl group, an indenopyrimidinyl group, an indolopyridinyl group, an indolopyrimidinyl group, a diazafluorenyl group, - N(Q₃₁)(Q₃₂), and -Si(Q₃₁)(Q₃₂)(Q₃₃); and
-N(Q₁)(Q₂) and -Si(Q₁)(Q₂)(Q₃),
wherein Q₁ to Q₃ and Q₃₁ to Q₃₃ are each independently selected from a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

8. An organic light-emitting device according to any one of claims 1 to 7, wherein
R₂₁ to R₂₄ are each independently selected from groups represented by Formulae 5-1 to 5-128: 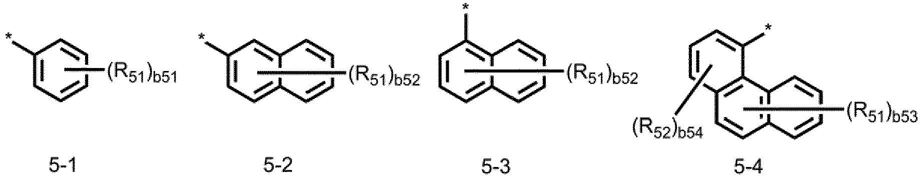 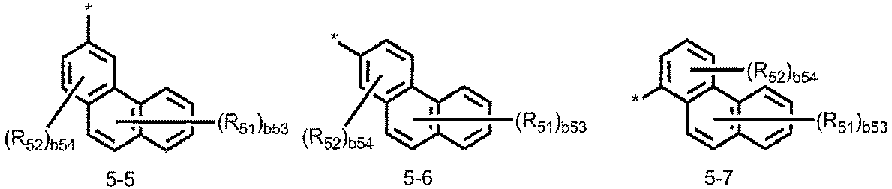 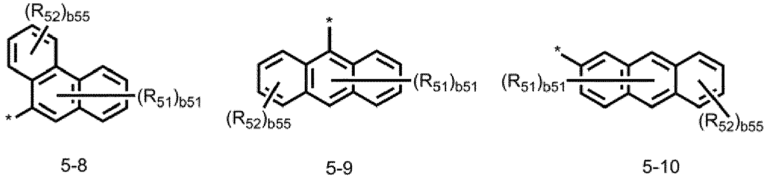 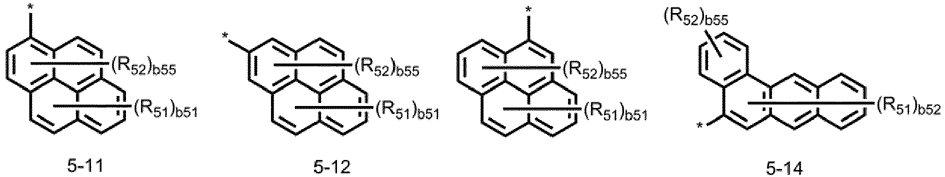 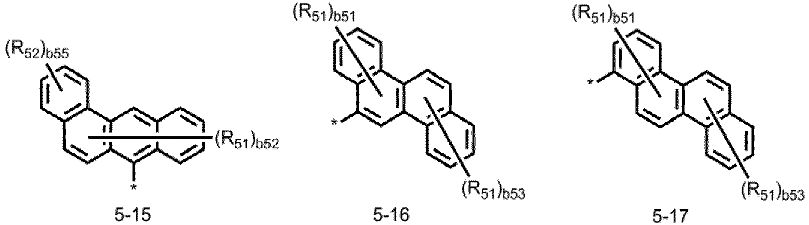 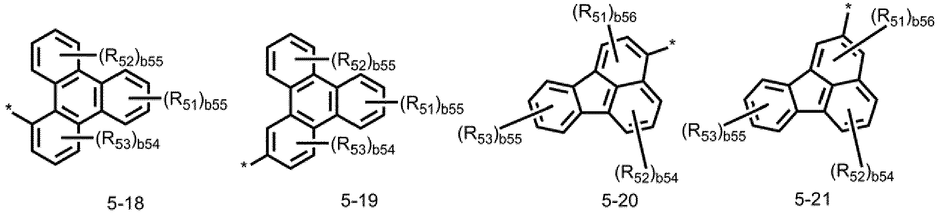 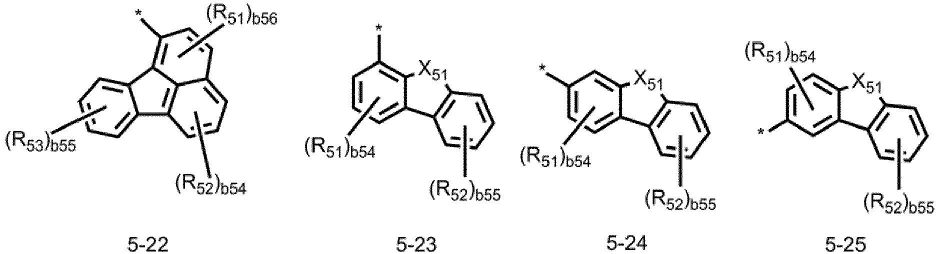 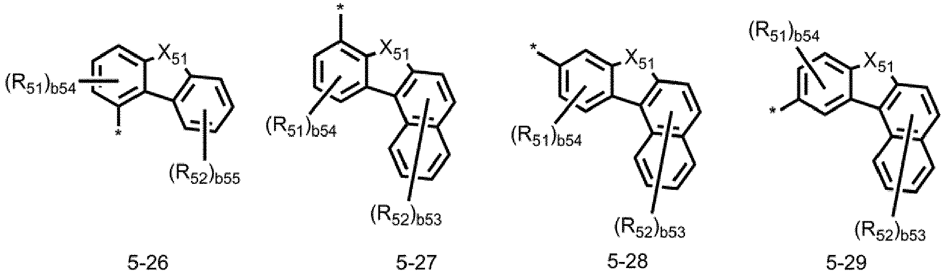 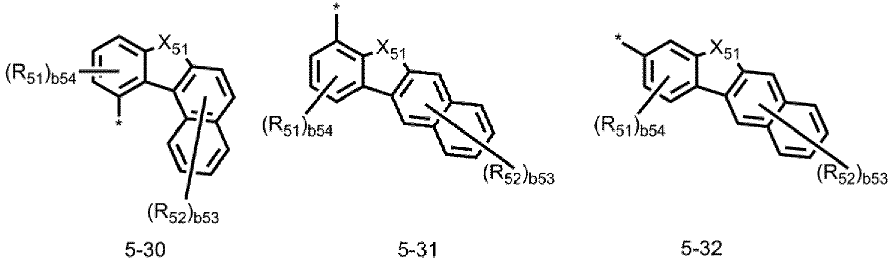 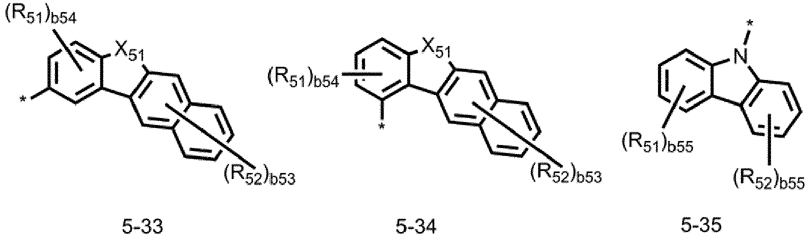 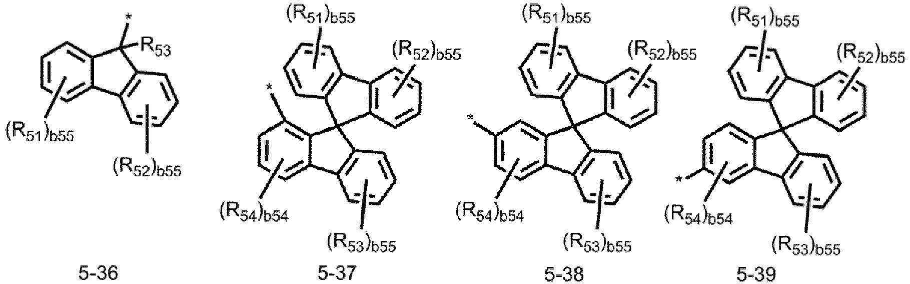 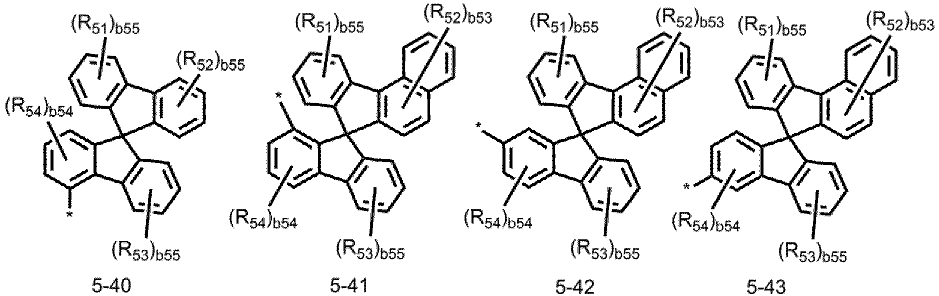 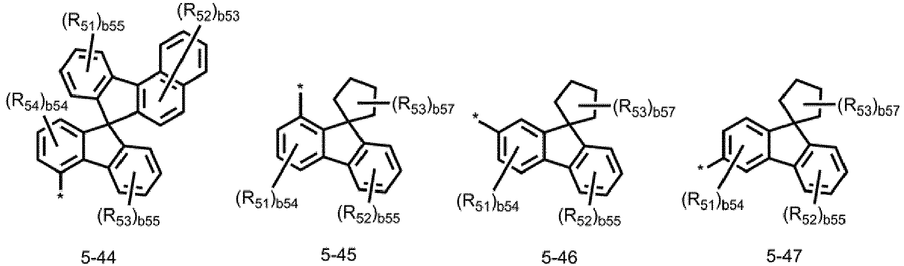 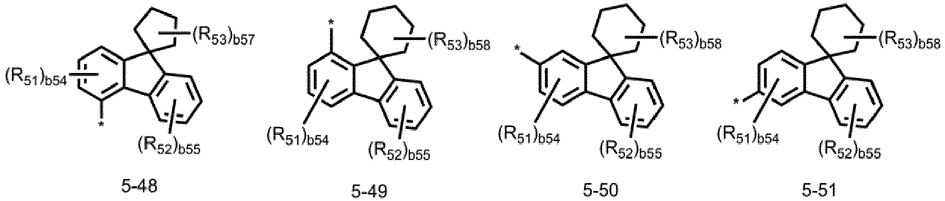 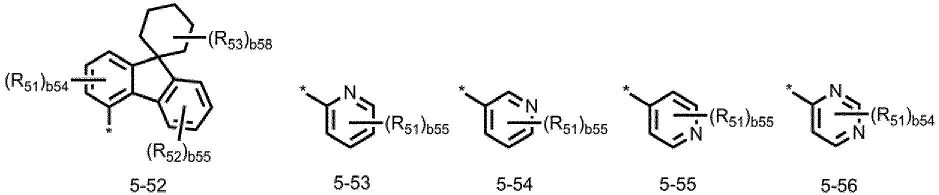 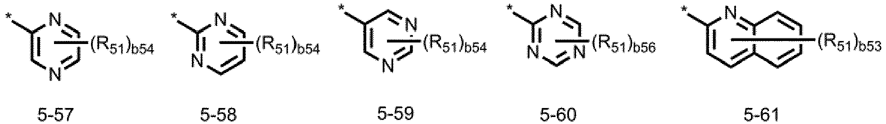 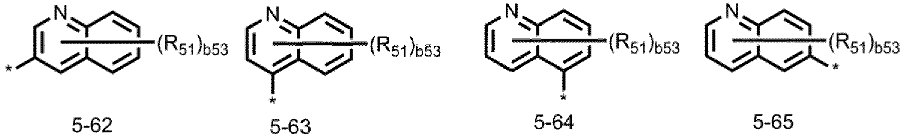 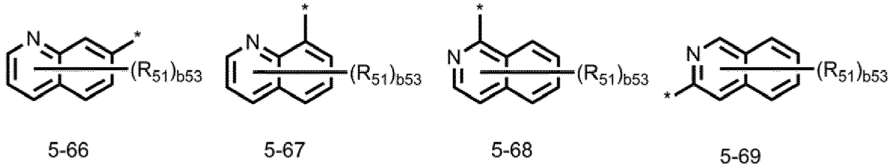 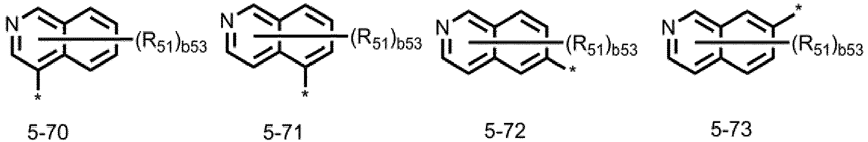 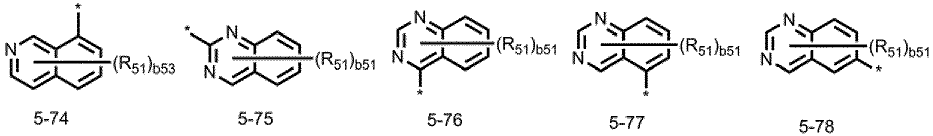 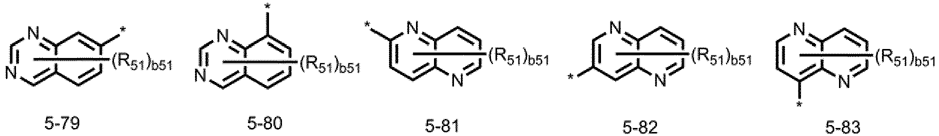 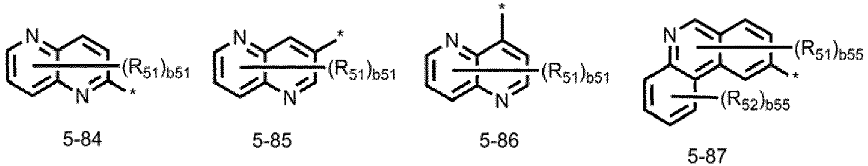 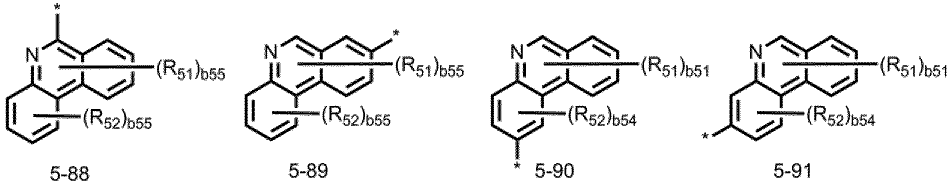 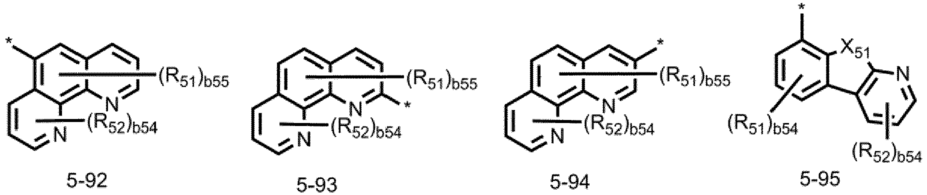 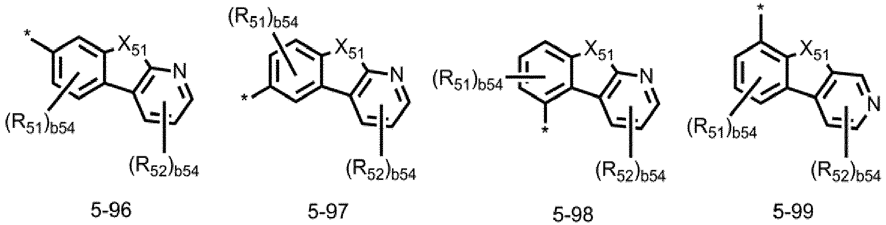 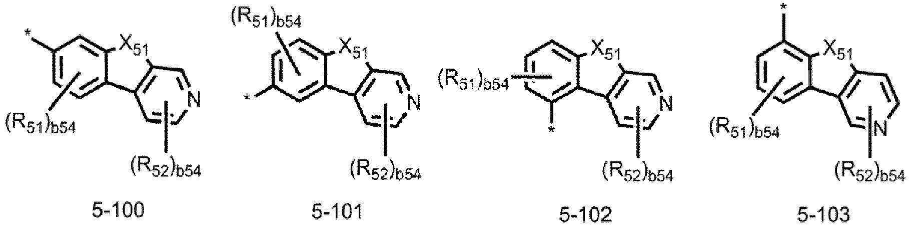 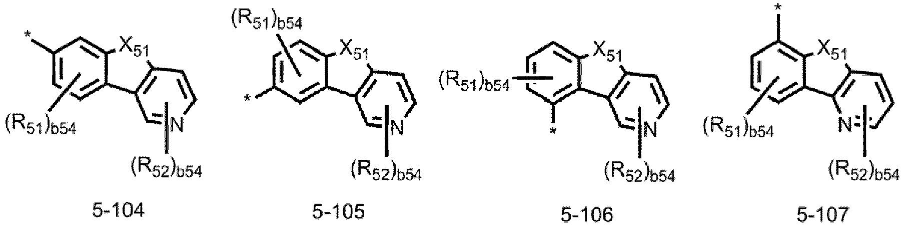 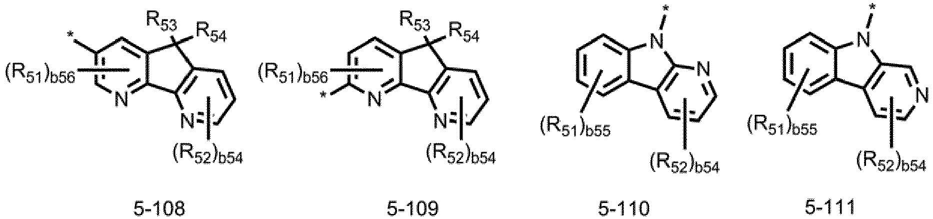 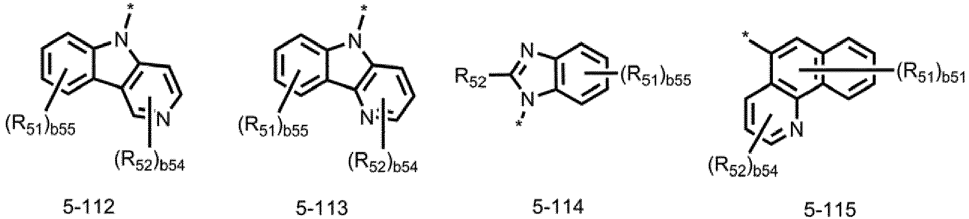 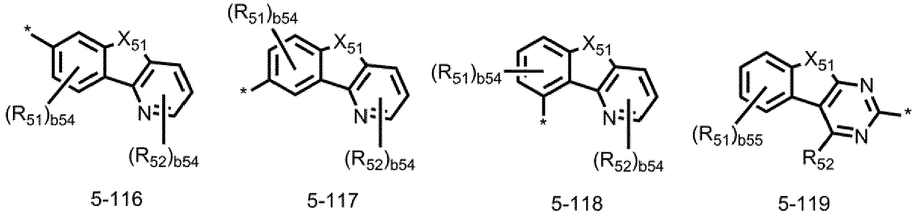 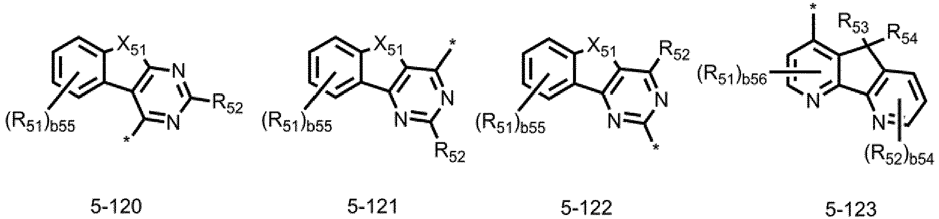 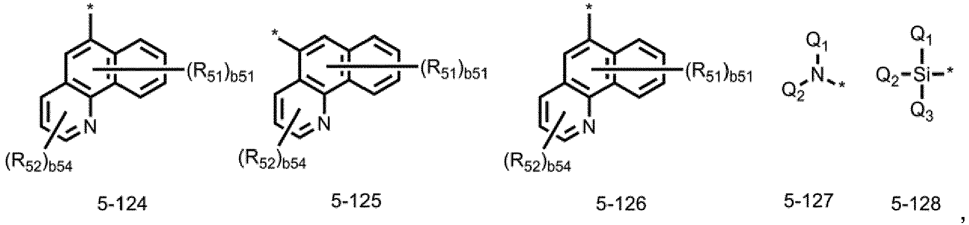 wherein, in Formulae 5-1 to 5-128,
X₅₁ is selected from O, S, N(R₅₃), and C(R₅₃)(R₅₄);
R₅₁ to R₅₄ are each independently selected from hydrogen, deuterium, -F, -Cl, - Br, -I, a hydroxyl group, a cyano group, a nitro group, an amidino group, a hydrazino group, a hydrazono group, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a neo-pentyl group, -CDH₂, -CD₂H, -CD₃, -CFH₂, -CF₂H, -CF₃, a methoxy group, an ethoxy group, an n-propoxy group, an iso-propoxy group, an n-butoxy group, an iso-butoxy group, a sec-butoxy group, a tert-butoxy group, an n-pentoxy group, an iso-pentoxy group, a sec-pentoxy group, a tert-pentoxy group, a neo-pentoxy group, a cyclopropyl group, a cyclobutyl group, a cyclopentyl group, a cyclohexyl group, a phenyl group, D₅-Ph, 2-Me-Ph, 3-Me-Ph, 4-Me-Ph, a biphenyl group, a terphenyl group, a naphthyl group, a fluorenyl group, a spiro-bifluorenyl group, a spiro-benzofluorene-fluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a pyridinyl group, D₅-Py, 2-Me-1-Py, 3-Me-1-Py, 4-Me-1-Py, 5-Me-1-Py, 1-Me-2-Py, 3-Me-2-Py, 4-Me-2-Py, 5-Me-2-Py, 1-Me-3-Py, 2-Me-3-Py, 4-Me-3-Py, 5-Me-3-Py, a pyrimidinyl group, a quinolinyl group, an isoquinolinyl group, a benzoquinolinyl group, a benzoisoquinolinyl group, a carbazolyl group, a benzocarbazolyl group, a naphthyridinyl group, a quinoxalinyl group, a quinazolinyl group, a phenanthridinyl group, a phenanthrolinyl group, a benzimidazolyl group, a triazinyl group, a dibenzofuranyl group, a benzonaphthofuranyl group, a dibenzothiophenyl group, a benzonaphthothiophenyl group, a benzofuropyridinyl group, a benzofuropyrimidinyl group, a benzothienopyridinyl group, a benzothienopyrimidinyl group, an indenopyridinyl group, an indenopyrimidinyl group, an indolopyridinyl group, an indolopyrimidinyl group, a diazafluorenyl group, - N(Q₃₁)(Q₃₂), and -Si(Q₃₁)(Q₃₂)(Q₃₃);
Q₁ to Q₃ and Q₃₁ to Q₃₃ are each independently selected from a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a neo-pentyl group, a phenyl group, a biphenyl group, a terphenyl group, and a naphthyl group;
b51 is selected from 1, 2, 3, 4, and 5;
b52 is selected from 1, 2, 3, 4, 5, 6, and 7;
b53 is selected from 1, 2, 3, 4, 5, and 6;
b54 is selected from 1, 2, and 3;
b55 is selected from 1, 2, 3, and 4;
b56 is selected from 1 and 2;
b57 is selected from 1, 2, 3, 4, 5, 6, 7, and 8;
b58 is selected from 1, 2, 3, 4, 5, 6, 7, 8, 9, and 10; and
* indicates a binding site to a neighboring atom.

9. An organic light-emitting device according to any one of claims 1 to 8, wherein
R201 to R207 are each independently selected from hydrogen, deuterium, -F, -CI, -Br, -I, a cyano group, a substituted or unsubstituted C₁-C₆₀ alkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), and -Si(Q₁)(Q₂)(Q₃);
Q₁ to Q₃ are each independently selected from a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group;
R₂₀₄ and R₂₀₅ are optionally linked to each other to form a saturated ring or an unsaturated ring; and
R₂₀₆ and R₂₀₇ are optionally linked to each other to form a saturated ring or an unsaturated ring.

10. An organic light-emitting device according to any one of claims 1 to 9, wherein
R₂₀₁ to R₂₀₇ are each independently selected from the group consisting of:
hydrogen, deuterium, -F, -CI, -Br, -I, a cyano group, a methyl group, an ethyl group, an n-propyl group, an iso-propyl group, an n-butyl group, a sec-butyl group, an iso-butyl group, a tert-butyl group, a phenyl group, a biphenyl group, a terphenyl group, a naphthyl group, a pyridinyl group, -N(Q₁)(Q₂), and -Si(Q₁)(Q₂)(Q₃); and
a phenyl group, a biphenyl group, a terphenyl group, a naphthyl group, and a pyridinyl group, each substituted with at least one selected from a methyl group, an ethyl group, an n-propyl group, an iso-propyl group, an n-butyl group, a sec-butyl group, an iso-butyl group, a tert-butyl group, a phenyl group, a biphenyl group, a terphenyl group, a naphthyl group, and a pyridinyl group;
Q₁ to Q₃ are each independently selected from a methyl group, an ethyl group, an n-propyl group, an iso-propyl group, and a phenyl group;
R₂₀₄ and R₂₀₅ are optionally linked to each other to form a saturated ring or an unsaturated ring; and
R₂₀₆ and R₂₀₇ are optionally linked to each other to form a saturated ring or an unsaturated ring.

11. An organic light-emitting device according to any one of claims 1 to 10, wherein
the second compound represented by Formula 2 is selected from Compounds D1 to D212:

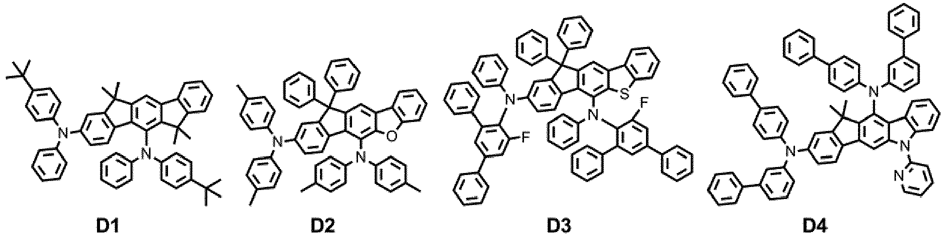

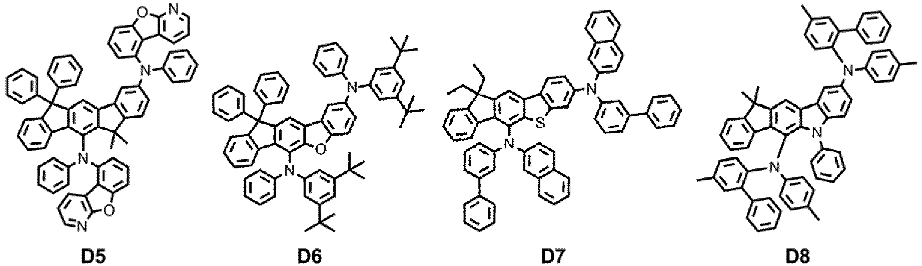

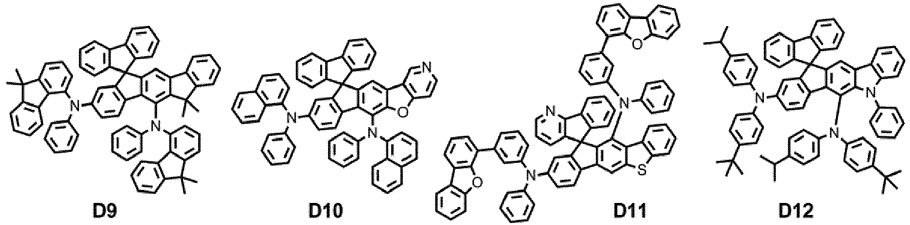

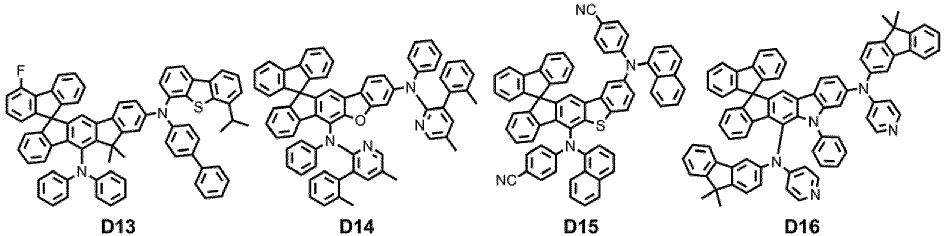

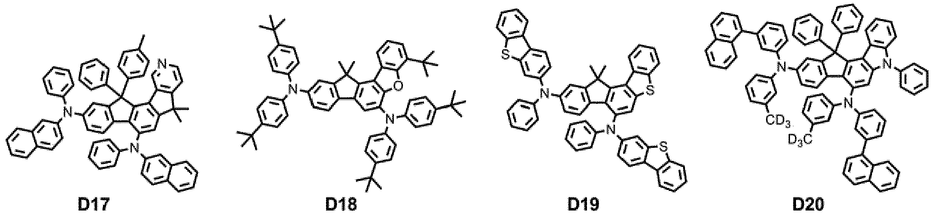

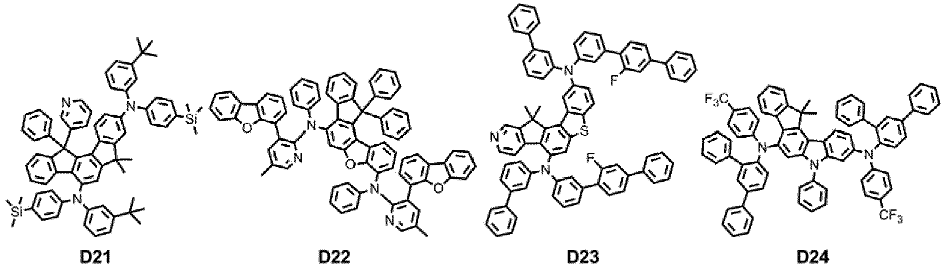

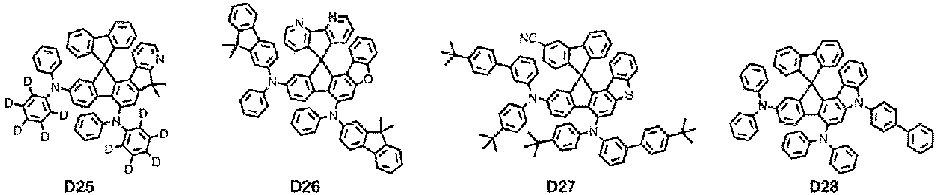

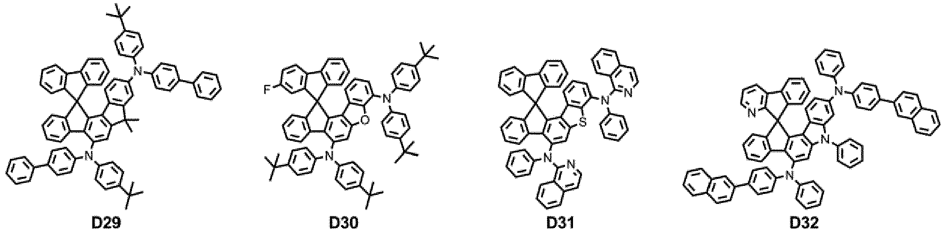

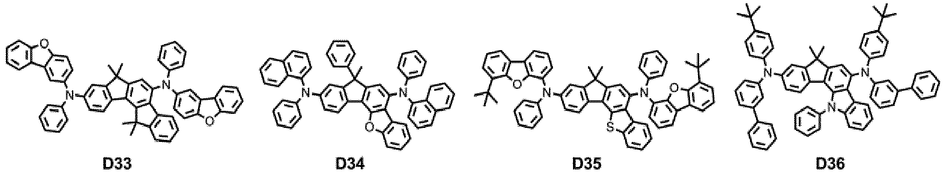

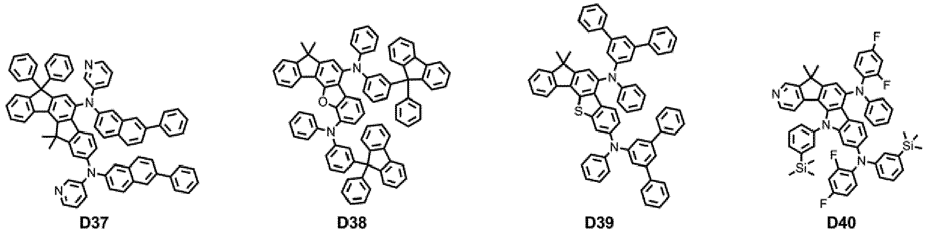

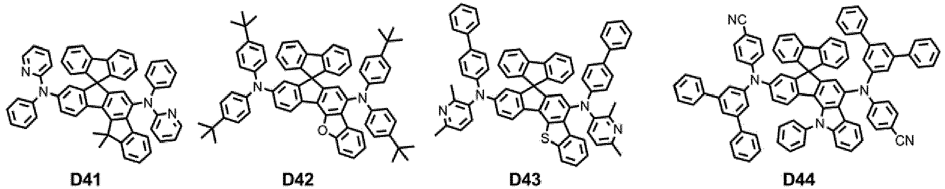

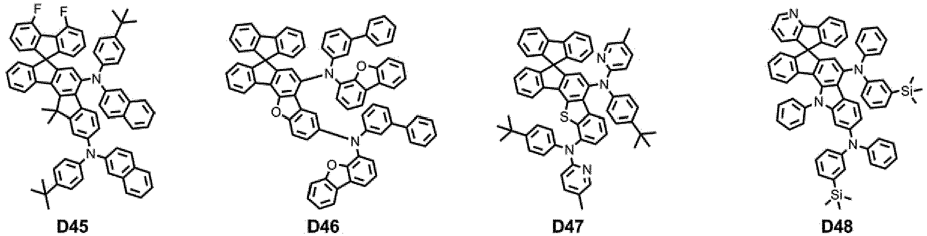

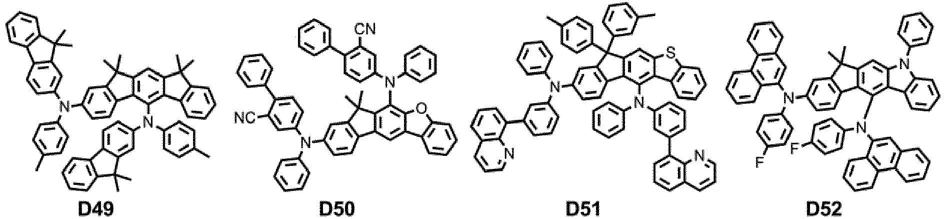

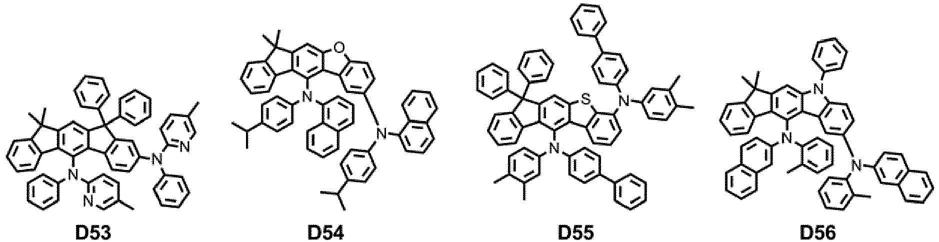

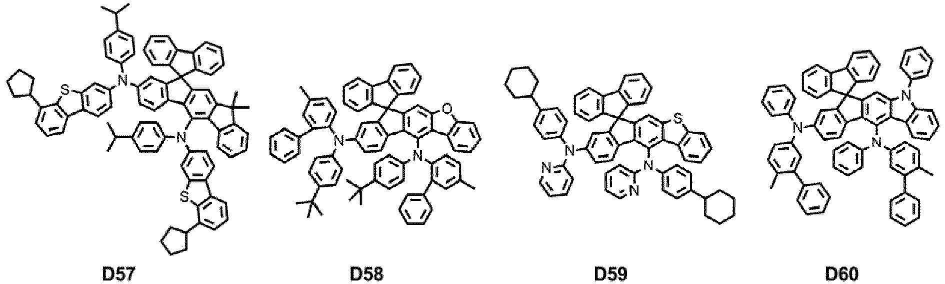

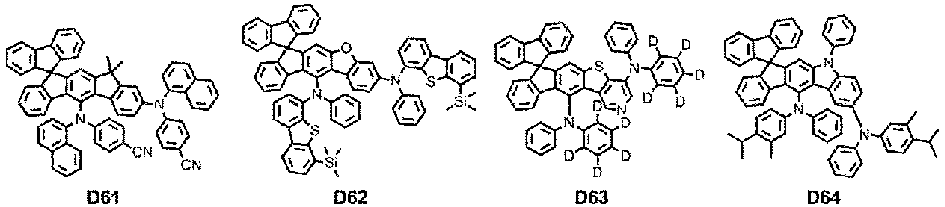

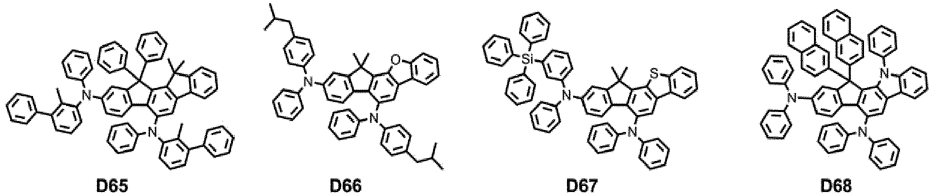

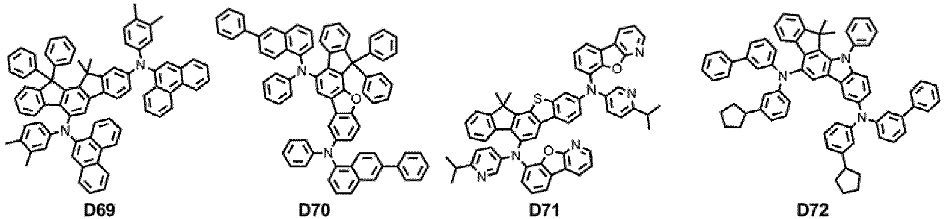

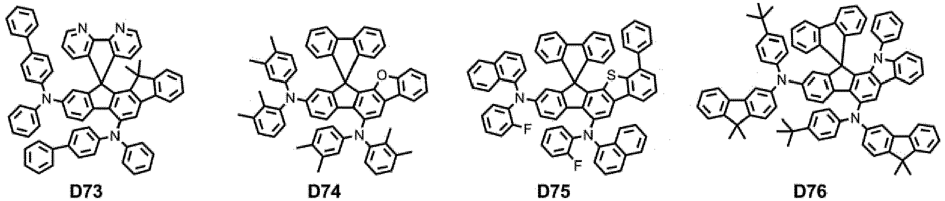

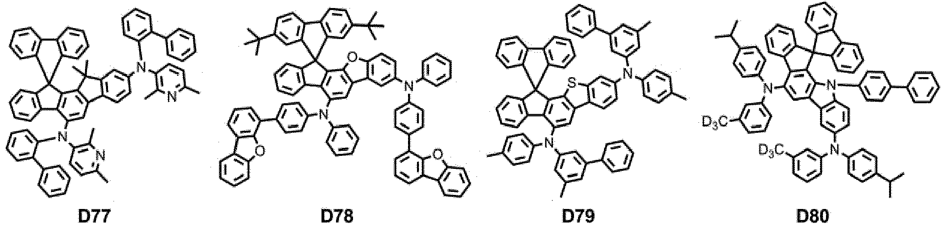

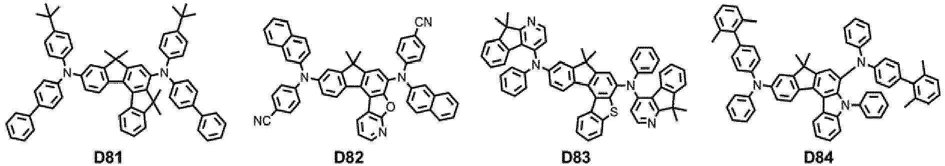

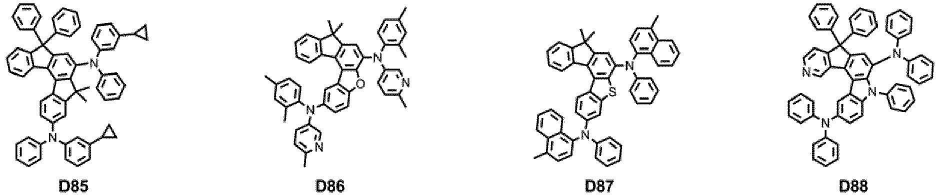

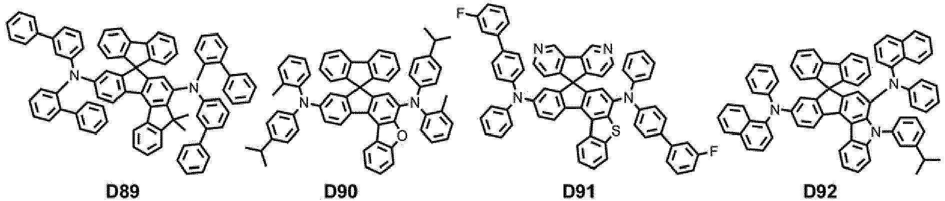

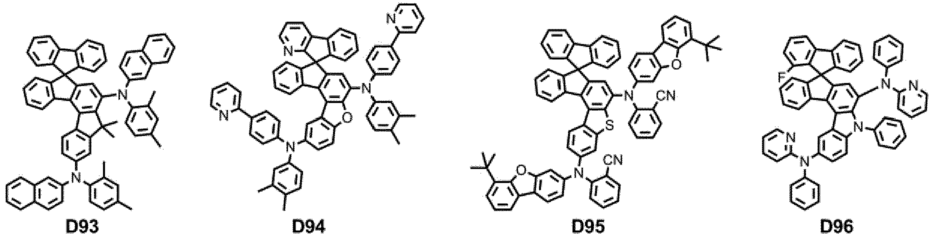

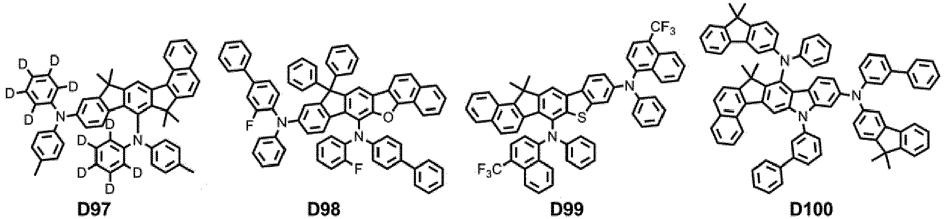

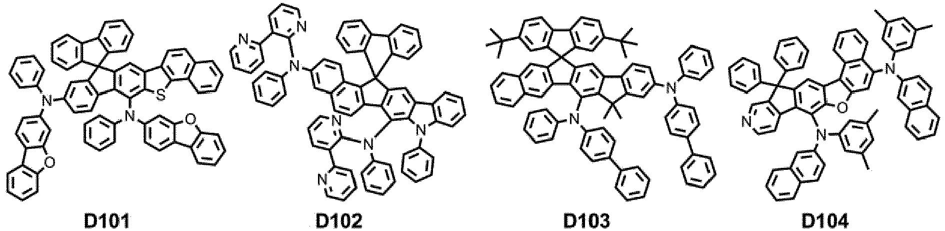

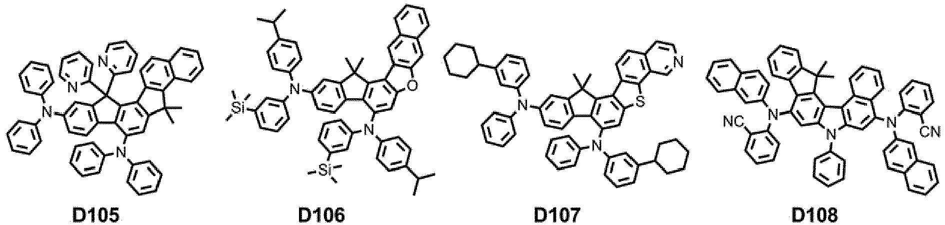

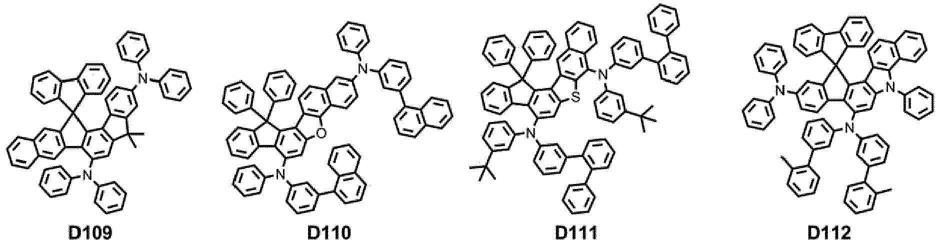

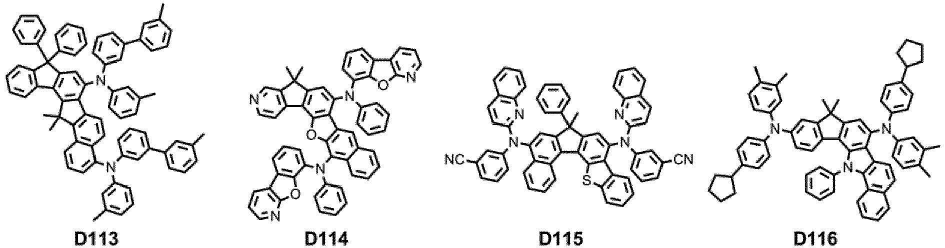

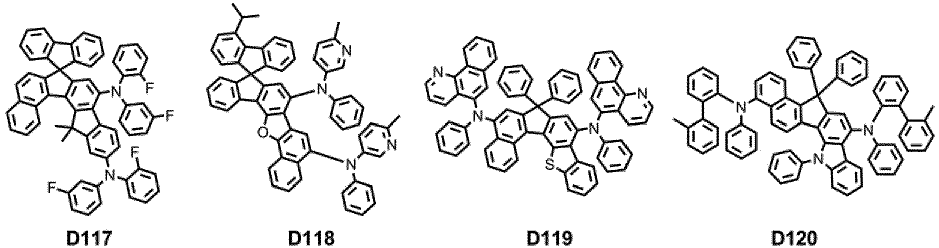

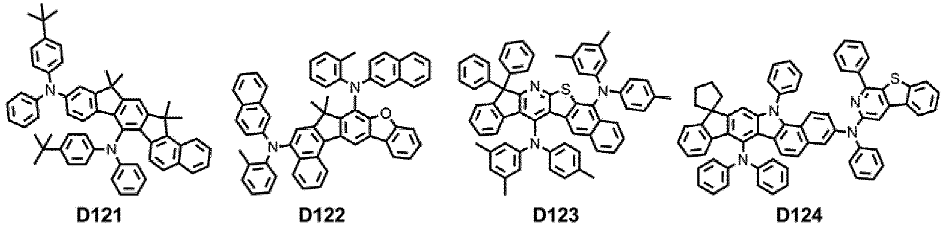

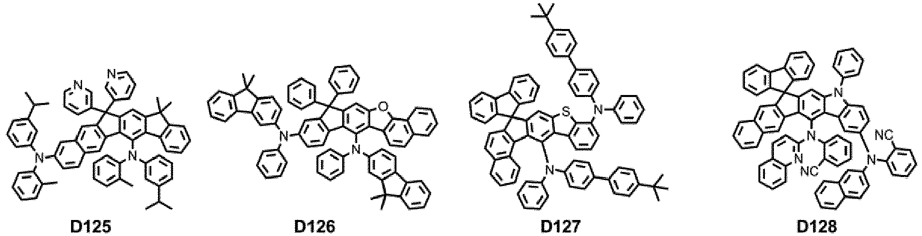

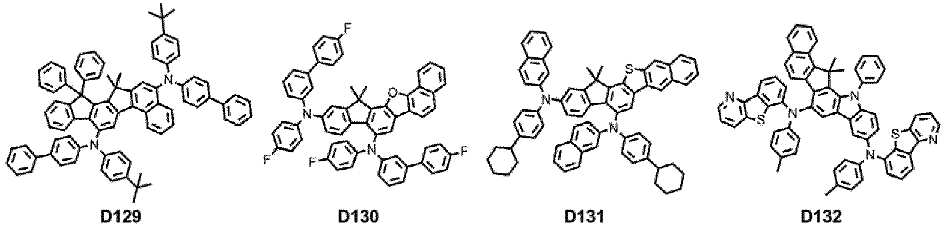

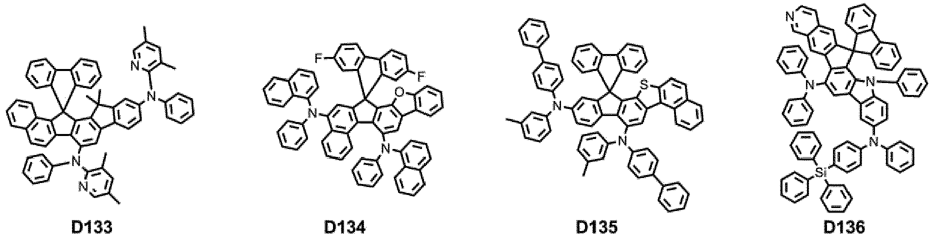

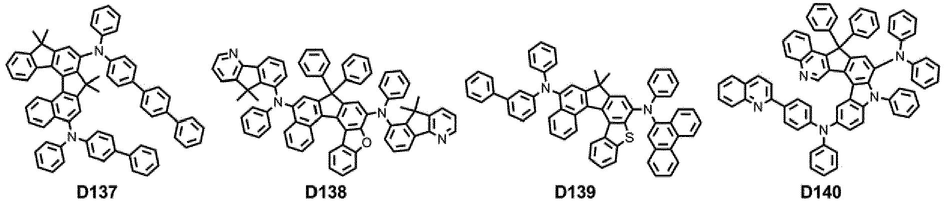

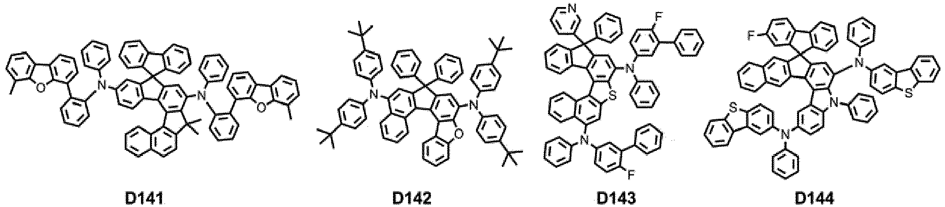

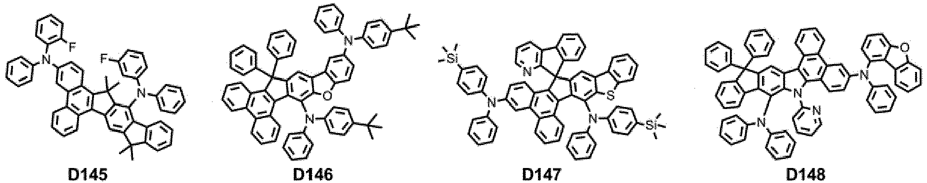

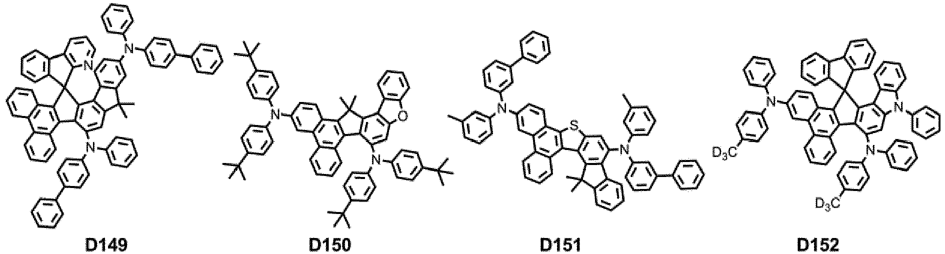

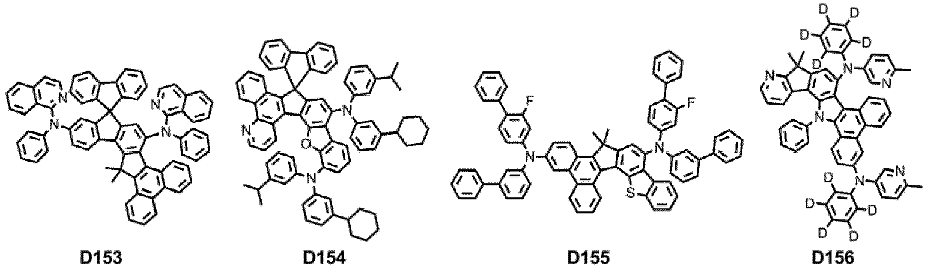

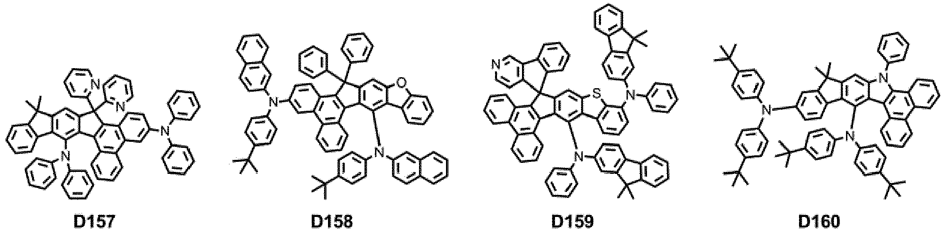

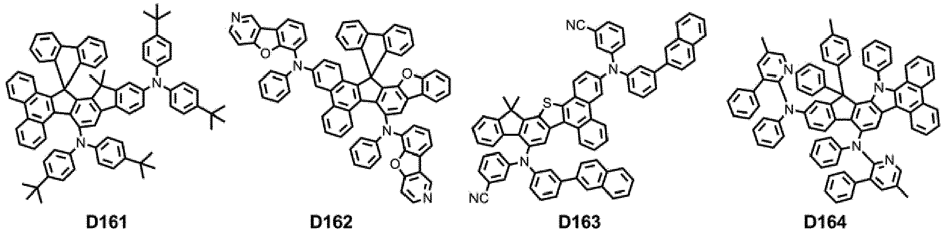

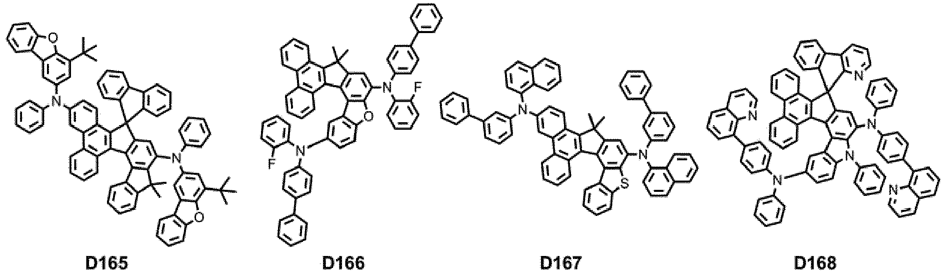

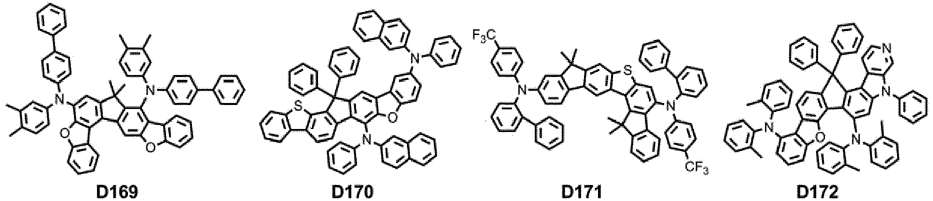

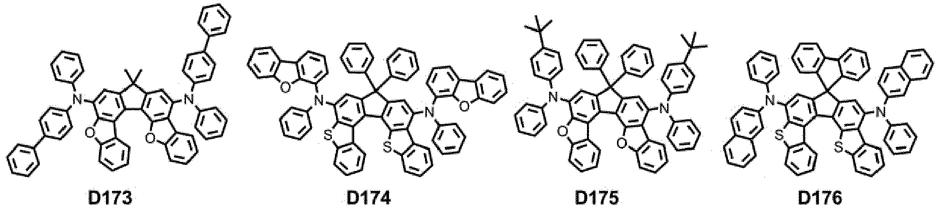

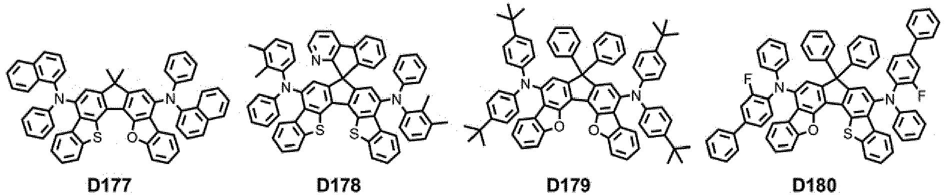

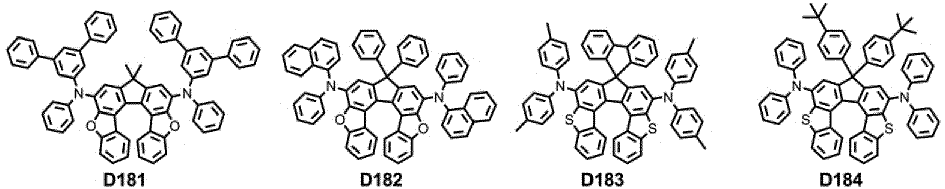

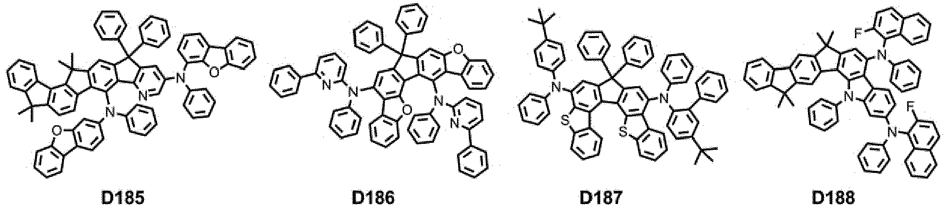

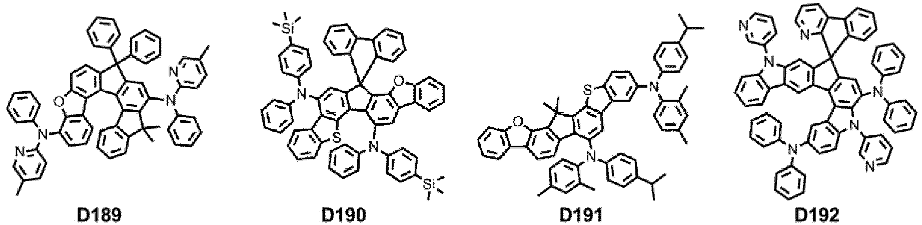

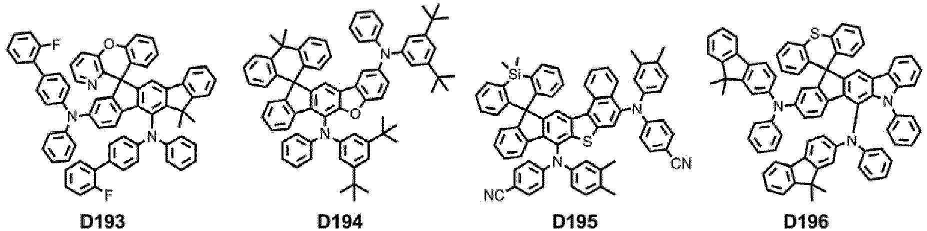

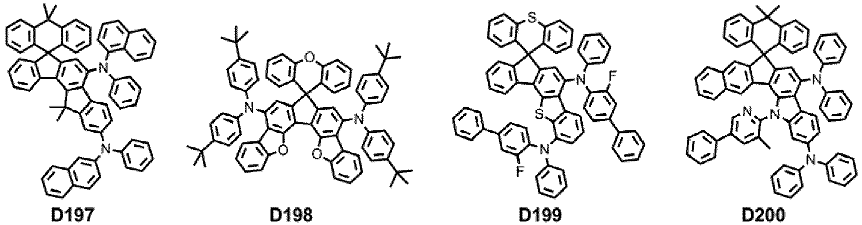

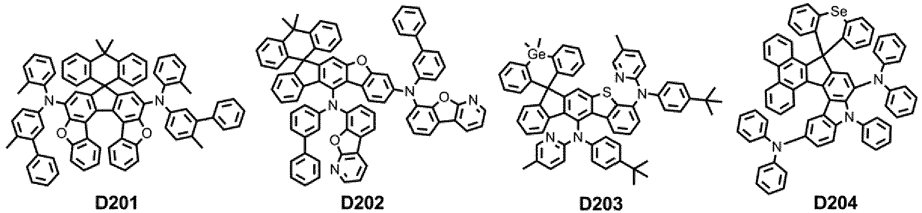

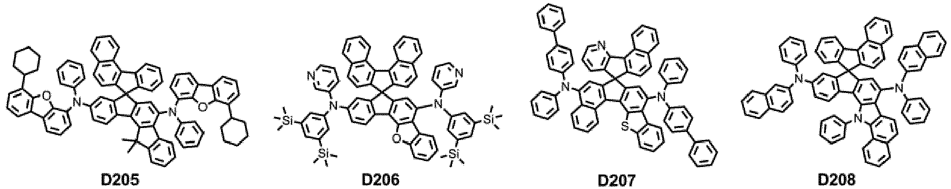

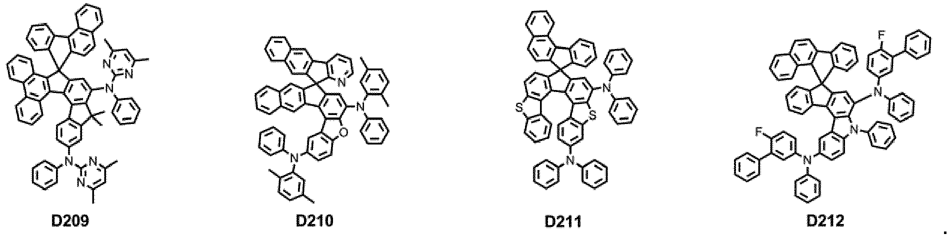

12. An organic light-emitting device according to any one of claims 1 to 11, wherein
the organic layer further comprises an electron transport region between the emission layer and the second electrode,
the electron transport region comprising an alkaline metal, an alkaline earth metal, a rare-earth metal, an alkaline metal compound, an alkaline earth metal compound, a rare-earth metal compound, an alkaline metal complex, an alkaline earth metal complex, a rare-earth metal complex, or any combination thereof.

13. An organic light-emitting device according to claim 12,
wherein the electron transport region comprises an electron transport layer and an electron injection layer; and
at least one selected from the electron transport layer and the electron injection layer comprises an alkaline metal, an alkaline earth metal, a rare-earth metal, an alkaline metal compound, an alkaline earth metal compound, a rare-earth metal compound, an alkaline metal complex, an alkaline earth metal complex, a rare-earth metal complex, or any combination thereof.

14. An organic light-emitting device according to any one of claims 1 to 13, wherein
the organic layer further comprises a hole transport region between the emission layer and the first electrode,
the hole transport region comprising a p-dopant, and
a lowest unoccupied molecular orbital (LUMO) energy level of the p-dopant is - 3.5 eV or less.

15. An organic light-emitting device according to claim 14, wherein the p-dopant comprises a cyano group-containing compound.

16. An organic light-emitting device according to any one of claims 1 to 15, wherein
the emission layer is a first-color-light emitting-emission layer;
the organic layer further comprises: i) at least one second-color-light emitting-emission layer, or ii) at least one second-color-light emitting-emission layer and at least one third-color-light emitting-emission layer;
wherein a first-color light of the first-color-light emitting-emission layer and a second-color light of the second-color-light emitting-emission layer are identical to or different from each other; or the first-color light, the second-color light, and a third-color light of the third-color-light emitting-emission layer are identical to or different from each other; and
the first-color light and the second-color light are emitted in a mixed-color light; or the first color light, the second-color light, and the third-color light are emitted in a mixed-color light.

## Patentansprüche

1. Organische lichtemittierende Vorrichtung, umfassend:
eine erste Elektrode;
eine zweite Elektrode; und
eine organische Schicht zwischen der ersten Elektrode und der zweiten Elektrode, wobei die organische Schicht eine Emissionsschicht umfasst,
wobei die Emissionsschicht eine erste Verbindung, ausgewählt aus Verbindungen H1 bis H116, und eine zweite Verbindung, dargestellt durch Formel 2, umfasst: 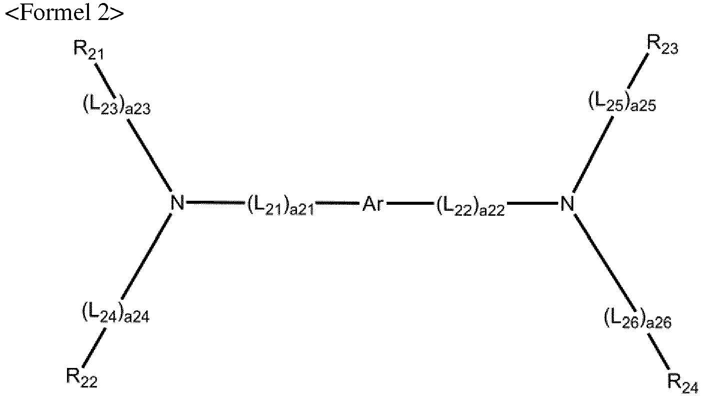 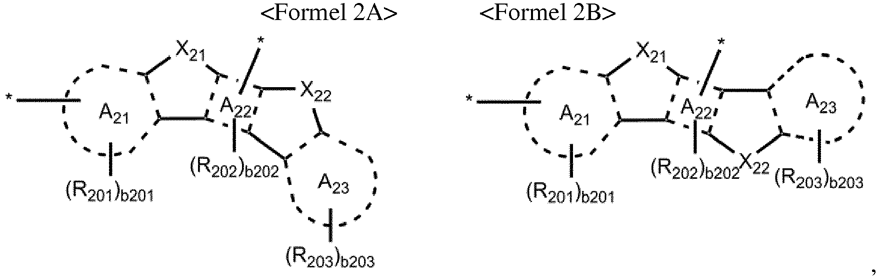
wobei, in Formeln 2, 2A und 2B,
Ar ausgewählt ist aus einer durch Formel 2A dargestellten Gruppe und einer durch Formel 2B dargestellten Gruppe;
X₂₁ ausgewählt ist aus Sauerstoff, Schwefel, N(R₂₀₄) und C(R₂₀₄)(R₂₀₅);
X₂₂ ausgewählt ist aus Sauerstoff, Schwefel, N(R₂₀₆) und C(R₂₀₆)(R₂₀₇);
A₂₁ ausgewählt ist aus einer carbocyclischen C₅-C₂₀-Gruppe und einer heterocyclischen C₁-C₂₀-Gruppe;
A₂₂ ausgewählt ist aus einer C₆-C₂₀-Arengruppe und einer C₁-C₂₀-Heteroarengruppe;
A₂₃ ausgewählt ist aus einer carbocyclischen C₅-C₂₀-Gruppe und einer heterocyclischen C₁-C₂₀-Gruppe;
L₂₁ bis L₂₆ jeweils unabhängig ausgewählt sind aus einer substituierten oder unsubstituierten C₃-C₁₀-Cycloalkylengruppe, einer substituierten oder unsubstituierten C₁-C₁₀-Heterocycloalkylengruppe, einer substituierten oder unsubstituierten C₃-C₁₀-Cycloalkenylengruppe, einer substituierten oder unsubstituierten C₁-C₁₀-Heterocycloalkenylengruppe, einer substituierten oder unsubstituierten C₆-C₆₀-Arylengruppe, einer substituierten oder unsubstituierten C₁-C₆₀-Heteroarylengruppe, einer substituierten oder unsubstituierten zweiwertigen nichtaromatischen kondensierten polycyclischen Gruppe und einer substituierten oder unsubstituierten zweiwertigen nichtaromatischen kondensierten heteropolycyclischen Gruppe;
a21 bis a26 jeweils unabhängig ausgewählt sind aus 0, 1, 2 und 3;
R₂₁ bis R₂₄ jeweils unabhängig ausgewählt sind aus einer substituierten oder unsubstituierten C₁-C₆₀-Alkylgruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₁-C₆₀-Heteroarylgruppe, einer substituierten oder unsubstituierten einwertigen nichtaromatischen kondensierten polycyclischen Gruppe und einer substituierten oder unsubstituierten einwertigen nichtaromatischen kondensierten heteropolycyclischen Gruppe; wobei R₂₁ und R₂₂ gegebenenfalls miteinander verknüpft sind, um einen gesättigten Ring oder einen ungesättigten Ring zu bilden, und R₂₃ und R₂₄ gegebenenfalls miteinander verknüpft sind, um einen gesättigten Ring oder einen ungesättigten Ring zu bilden;
R₂₀₁ bis R₂₀₇ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nichtaromatischen kondensierten polycyclischen Gruppe, einer substituierten oder unsubstituierten einwertigen nichtaromatischen kondensierten heteropolycyclischen Gruppe, -Si(Q₁)(Q₂)(Q₃), -N(Q₁)(Q₂), -B(Q₁)(Q₂), -C(=O)(Q₁), -S(=O)₂(Q₁) und-P(=O)(Q₁)(Q₂); wobei R₂₀₄ und R₂₀₅ gegebenenfalls miteinander verknüpft sind, um einen gesättigten Ring oder einen ungesättigten Ring zu bilden, und R₂₀₆ und R₂₀₇ gegebenenfalls miteinander verknüpft sind, um einen gesättigten Ring oder einen ungesättigten Ring zu bilden;
b201 bis b203 jeweils unabhängig ausgewählt sind aus 1, 2, 3, 4, 5, 6, 7, 8, 9 und 10;
Q₁ bis Q₃ jeweils unabhängig ausgewählt sind aus Wasserstoff, Deuterium, -F, - Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, einer Biphenylgruppe und einer Terphenylgruppe; und
* eine Bindungsstelle an ein Nachbaratom anzeigt,

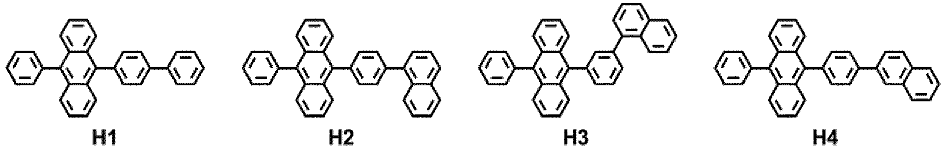

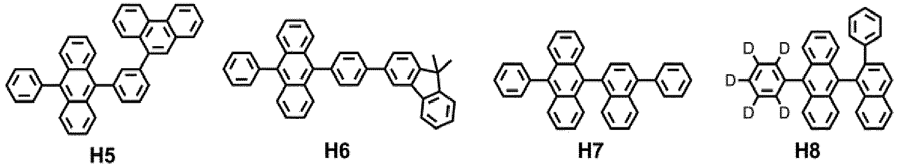

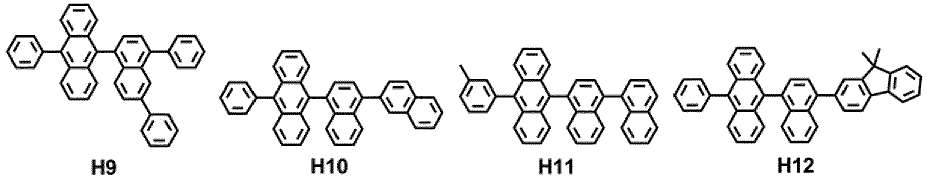

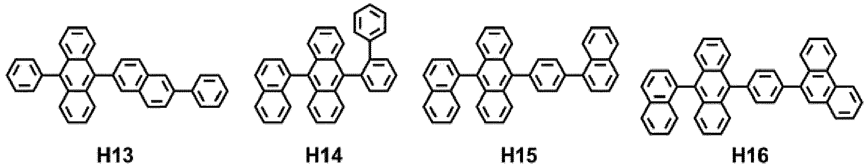

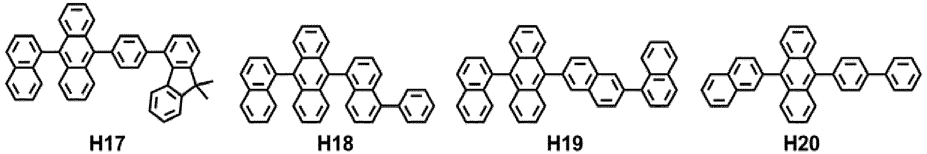

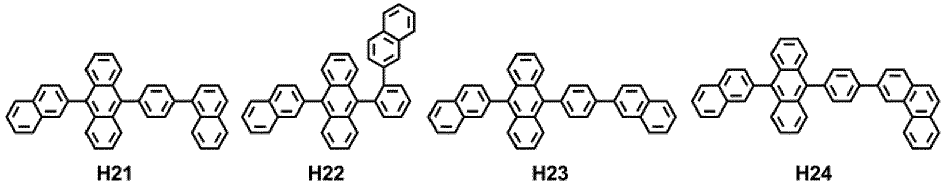

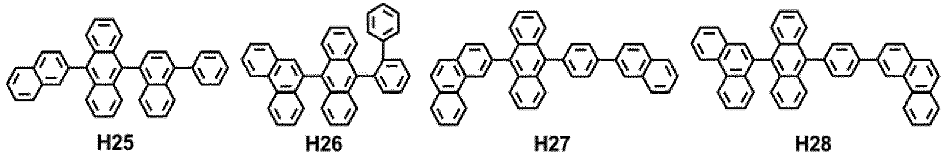

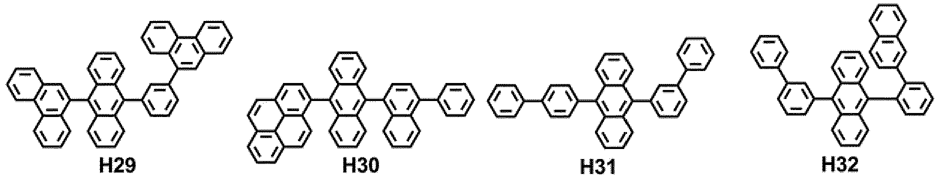

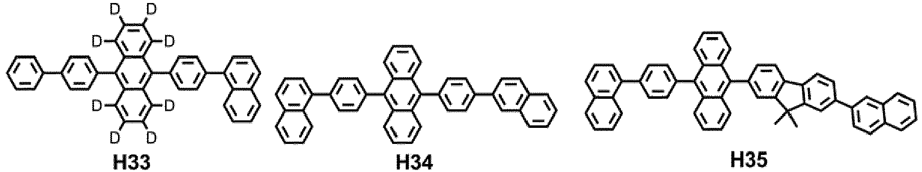

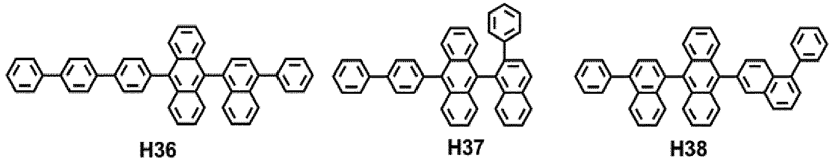

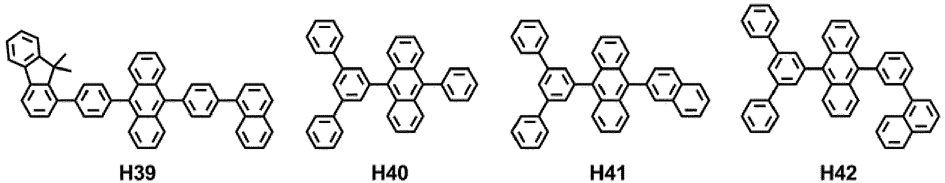

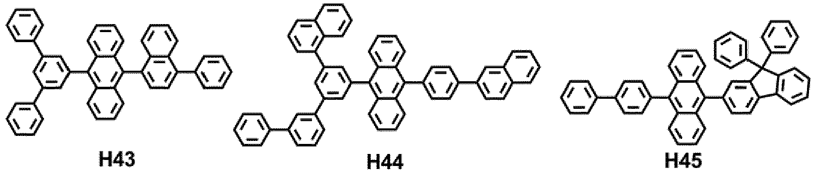

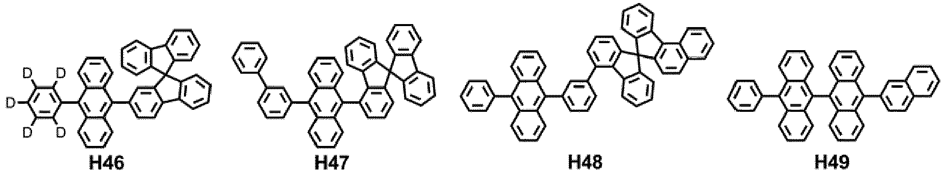

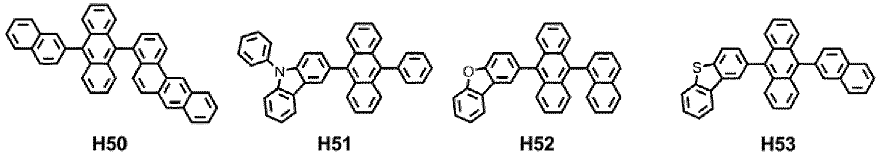

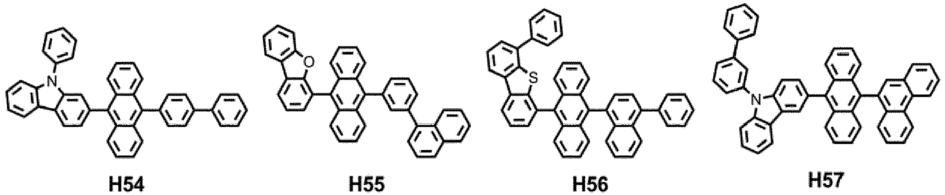

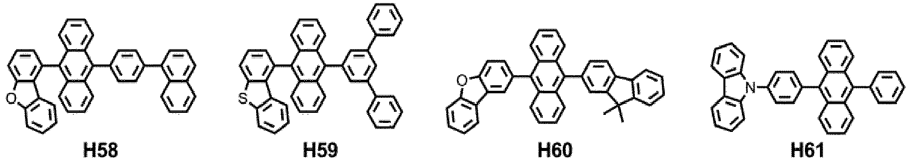

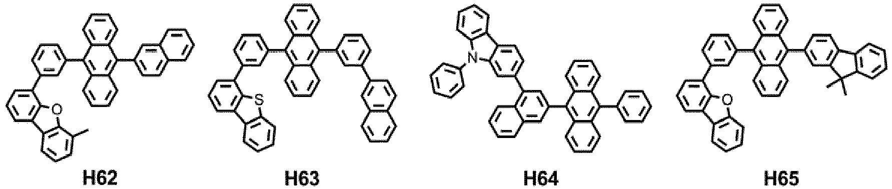

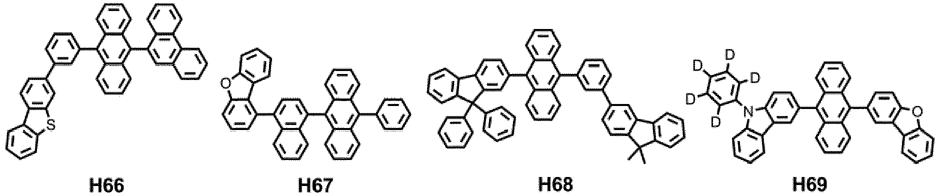

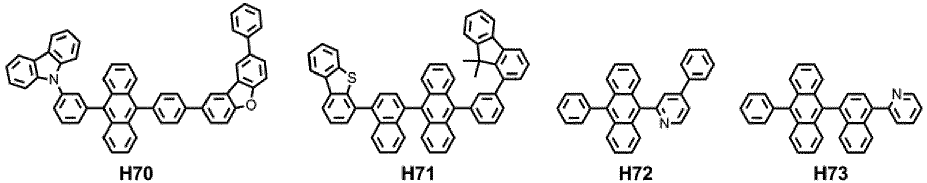

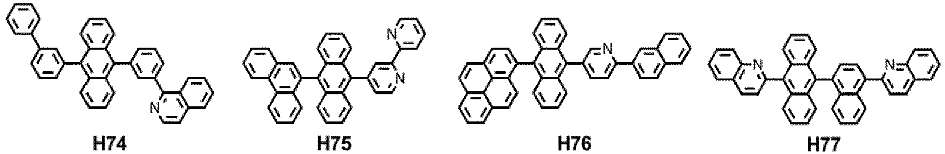

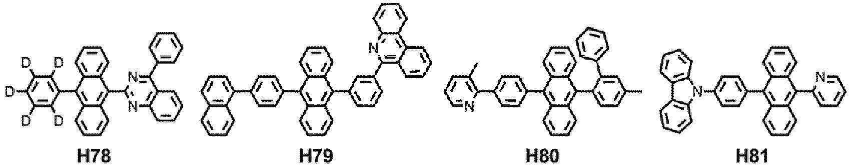

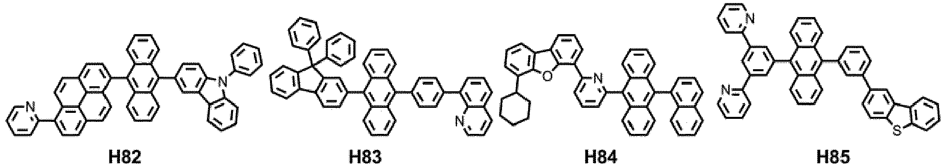

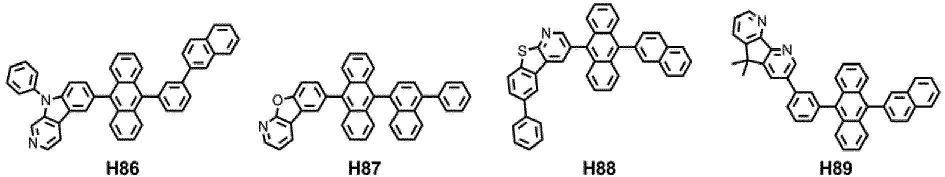

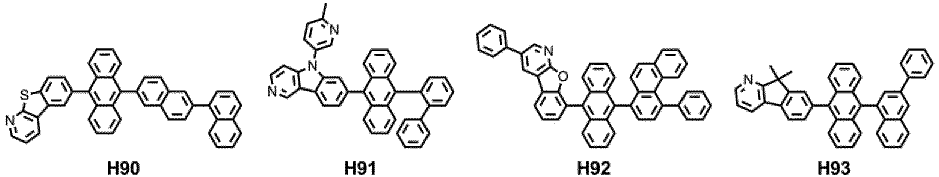

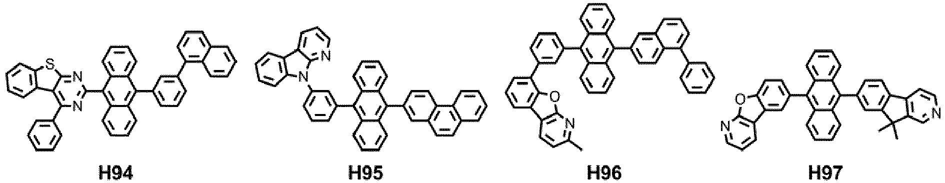

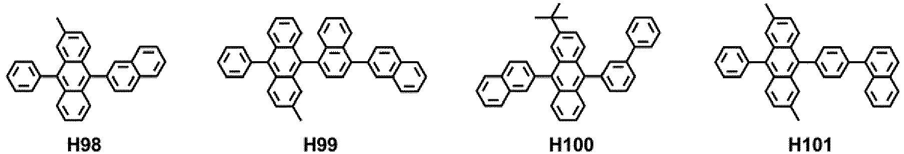

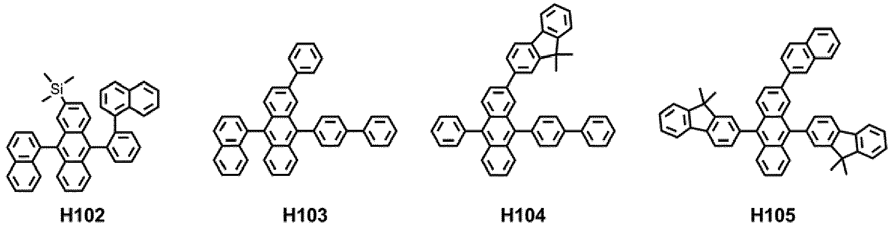

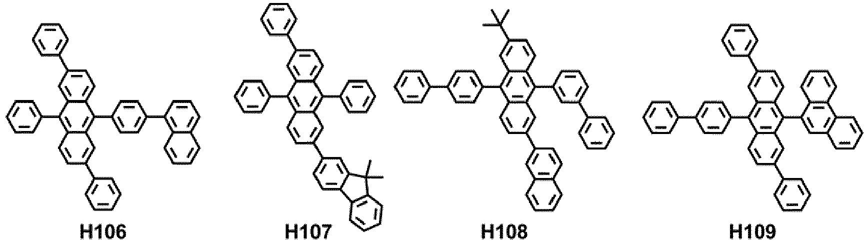

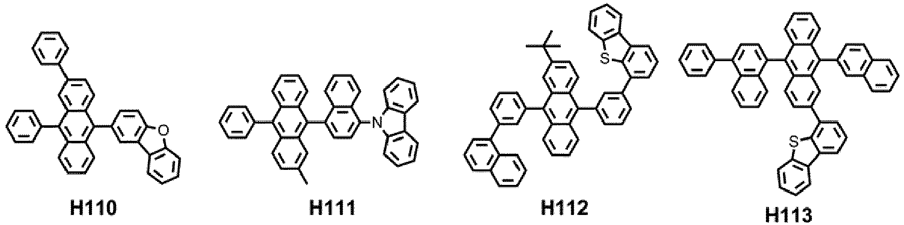

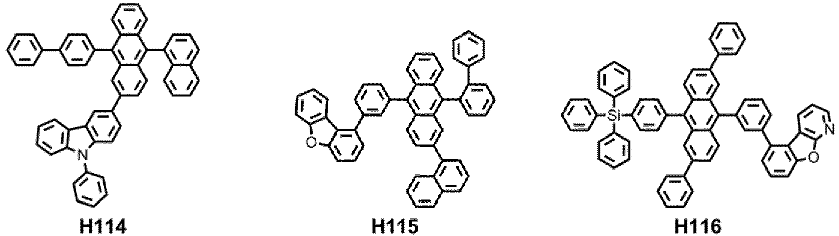

2. Organische lichtemittierende Vorrichtung nach Anspruch 1, wobei
A₂₁ und A₂₃ jeweils unabhängig ausgewählt sind aus einer Benzolgruppe, einer Naphthalingruppe, einer Phenanthrengruppe, einer Anthracengruppe, einer Triphenylengruppe, einer Pyrengruppe, einer Chrysengruppe, einer Furangruppe, einer Thiophengruppe, einer Pyrrolgruppe, einer Pyridingruppe, einer Pyrazingruppe, einer Pyrimidingruppe, einer Triazingruppe, einer Chinolingruppe, einer Isochinolingruppe, einer Benzochinolingruppe, einer Benzoisochinolingruppe, einer 2,6-Naphthyridingruppe, einer 1,8-Naphthyridingruppe, einer 1,5-Naphthyridingruppe, einer 1,6-Naphthyridingruppe, einer 1,7-Naphthyridingruppe, einer 2,7-Naphthyridingruppe, einer Chinoxalingruppe, einer Chinazolingruppe, einer Phenanthridingruppe, einer Phenanthrolingruppe, einer Benzofurangruppe, einer Benzothiophengruppe, einer Indengruppe, einer Indolgruppe, Furopyridingruppe, Thienopyridingruppe, einer Cyclopentapyridingruppe, einer Pyrrolopyridingruppe, einer Dibenzofurangruppe, einer Dibenzothiophengruppe, einer Fluorengruppe, einer Carbazolgruppe, einer Benzofuropyrrolgruppe, einer Benzothienopyrrolgruppe, einer Indenopyrrolgruppe, einer Indolopyrrolgruppe, einer Benzofurothiophengruppe, einer Benzothienothiophengruppe, einer Indenothiophengruppe, einer Indolothiophengruppe, einer Benzofurofurangruppe, einer Benzothienofurangruppe, einer Indenofurangruppe, einer Indolofurangruppe, einer Benzofurothiophengruppe, einer Benzothienothiophengruppe, einer Indenothiophengruppe, einer Indolothiophengruppe, einer Benzofuropyridingruppe, einer Benzothienopyridingruppe, einer Indenopyridingruppe, einer Indolopyridingruppe, einer Benzofuropyrimidingruppe, einer Benzothienopyrimidingruppe, einer Indenopyrimidingruppe, einer Indolopyrimidingruppe, einer Benzofuroindolgruppe, einer Benzothienoindolgruppe, einer Indenoindolgruppe, einer Indoloindolgruppe, einer Benzofurobenzofurangruppe, einer Benzothienobenzofurangruppe, einer Indenobenzofurangruppe, einer Indolobenzofurangruppe, einer Benzofurobenzothiophengruppe, einer Benzothienobenzothiophengruppe, einer Indenobenzothiophengruppe, einer Indolobenzothiophengruppe, einer Benzofurochinolingruppe, einer Benzothienochinolingruppe, einer Indenochinolingruppe, einer Indolochinolingruppe, einer Benzonaphthofurangruppe, einer Benzonaphthothiophengruppe, einer Benzofluorengruppe, einer Benzocarbazolgruppe, einer Dinaphthofurangruppe, einer Dinaphthothiophengruppe, einer Dibenzofluorengruppe, einer Dibenzocarbazolgruppe, einer Benzoxazolgruppe, einer Benzothiazolgruppe, einer Benzimidazolgruppe, einem Naphthofuran, einem Naphthothiophen, einer Cyclopentanaphthalingruppe, einer Spiro-bifluoren-Gruppe und einer Spiro-fluoren-inden-Gruppe.

3. Organische lichtemittierende Vorrichtung nach Anspruch 1 oder 2, wobei
A₂₁ und A₂₃ jeweils unabhängig ausgewählt sind aus einer Benzolgruppe, einer Naphthalingruppe, einer Phenanthrengruppe, einer Pyridingruppe, einer Chinolingruppe, einer Isochinolingruppe, einer Benzochinolingruppe, einer Benzoisochinolingruppe, einer Dibenzofurangruppe, einer Dibenzothiophengruppe, einer Fluorengruppe, einer Carbazolgruppe und einer Indolopyridingruppe.

4. Organische lichtemittierende Vorrichtung nach einem der Ansprüche 1 bis 3, wobei
A₂₂ ausgewählt ist aus einer Benzolgruppe, einer Naphthalingruppe, einer Phenanthrengruppe, einer Anthracengruppe, einer Triphenylengruppe, einer Pyrengruppe, einer Chrysengruppe, einer Pyridingruppe, einer Pyrazingruppe, einer Pyrimidingruppe, einer Triazingruppe, einer Chinolingruppe, einer Isochinolingruppe, einer Benzochinolingruppe, einer Benzoisochinolingruppe, einer 2,6-Naphthyridingruppe, einer 1,8-Naphthyridingruppe, einer 1,5-Naphthyridingruppe, einer 1,6-Naphthyridingruppe, einer 1,7-Naphthyridingruppe, einer 2,7-Naphthyridingruppe, einer Chinoxalingruppe, einer Chinazolingruppe, einer Phenanthridingruppe und einer Phenanthrolingruppe.

5. Organische lichtemittierende Vorrichtung nach einem der Ansprüche 1 bis 4, wobei
A₂₂ ausgewählt ist aus einer Benzolgruppe und einer Naphthalingruppe.

6. Organische lichtemittierende Vorrichtung nach einem der Ansprüche 1 bis 5, wobei
L₂₁ bis L₂₆ jeweils unabhängig aus der Gruppe ausgewählt sind, die besteht aus:
einer Phenylengruppe, einer Naphthylengruppe, einer Fluorenylengruppe, einer Phenanthrenylengruppe, einer Anthracenylengruppe, einer Triphenylenylengruppe, einer Pyrrolylengruppe, einer Thiophenylengruppe, einer Furanylengruppe, einer Pyridinylengruppe, einer Pyrazinylengruppe, einer Pyrimidinylengruppe, einer Indolylengruppe, einer Chinolinylengruppe, einer Isochinolinylengruppe, einer Benzochinolinylengruppe, einer Benzoisochinolinylengruppe, einer Naphthyridinylengruppe, einer Chinoxalinylengruppe, einer Chinazolinylengruppe, einer Cinnolinylengruppe, einer Phenanthridinylengruppe, einer Phenanthrolinylengruppe, einer Carbazolylengruppe, einer Benzimidazolylengruppe, einer Benzofuranylengruppe, einer Benzothiophenylengruppe, einer Triazinylengruppe, einer Dibenzofuranylengruppe und einer Dibenzothiophenylengruppe; und
einer Phenylengruppe, einer Naphthylengruppe, einer Fluorenylengruppe, einer Phenanthrenylengruppe, einer Anthracenylengruppe, einer Triphenylenylengruppe, einer Pyrrolylengruppe, einer Thiophenylengruppe, einer Furanylengruppe, einer Pyridinylengruppe, einer Pyrazinylengruppe, einer Pyrimidinylengruppe, einer Indolylengruppe, einer Chinolinylengruppe, einer Isochinolinylengruppe, einer Benzochinolinylengruppe, einer Benzoisochinolinylengruppe, einer Naphthyridinylengruppe, einer Chinoxalinylengruppe, einer Chinazolinylengruppe, einer Cinnolinylengruppe, einer Phenanthridinylengruppe, einer Phenanthrolinylengruppe, einer Carbazolylengruppe, einer Benzimidazolylengruppe, einer Benzofuranylengruppe, einer Benzothiophenylengruppe, einer Triazinylengruppe, einer Dibenzofuranylengruppe und einer Dibenzothiophenylengruppe, jeweils substituiert mit zumindest einem, ausgewählt aus Deuterium, -F, -Cl, -Br, -I, einer Cyanogruppe, einer C₁-C₂₀-Alkylgruppe, einer C₁-C₂₀-Alkoxygruppe, einer Cyclopropylgruppe, einer Cyclobutylgruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spiro-bifluorenyl-Gruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, -Si(Q₃₁)(Q₃₂)(Q₃₃),-N(Q₃₁)(Q₃₂), -B(Q₃₁)(Q₃₂), -C(=O)(Q₃₁), -S(=O)₂(Q₃₁) und -P(=O)(Q₃₁)(Q₃₂),
wobei Q₃₁ bis Q₃₃ jeweils unabhängig ausgewählt sind aus Wasserstoff, einer C₁-C₂₀-Alkylgruppe, einer Phenylgruppe, einer Naphthylgruppe, einer Biphenylgruppe und einer Terphenylgruppe.

7. Organische lichtemittierende Vorrichtung nach einem der Ansprüche 1 bis 6, wobei
R₂₁ bis R₂₄ jeweils unabhängig aus der Gruppe ausgewählt sind, die besteht aus:
einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spiro-bifluorenyl-Gruppe, einer Spiro-benzofluoren-fluorenyl-Gruppe, einer Spiro-cyclopentan-fluorenyl-Gruppe, einer Spiro-cyclohexan-fluorenyl-Gruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Tetraphenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Benzoisochinolinylgruppe, einer Carbazolylgruppe, einer Benzocarbazolylgruppe, einer Phthalazinylgruppe, einer Naphthyridinylgruppe, einer Chinoxalinylgruppe, einer Benzochinoxalinylgruppe, einer Chinazolinylgruppe, einer Benzochinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Benzonaphthofuranylgruppe, einer Dibenzothiophenylgruppe, einer Benzonaphthothiophenylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Benzofuropyridinylgruppe, einer Benzofuropyrimidinylgruppe, einer Benzothienopyridinylgruppe, einer Benzothienopyrimidinylgruppe, einer Indenopyridinylgruppe, einer Indenopyrimidinylgruppe, einer Indolopyridinylgruppe, einer Indolopyrimidinylgruppe und einer Diazafluorenylgruppe;
einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spiro-bifluorenyl-Gruppe, einer Spiro-benzofluoren-fluorenyl-Gruppe, einer Spiro-cyclopentan-fluorenyl-Gruppe, einer Spiro-cyclohexan-fluorenyl-Gruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Tetraphenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Benzoisochinolinylgruppe, einer Carbazolylgruppe, einer Benzocarbazolylgruppe, einer Phthalazinylgruppe, einer Naphthyridinylgruppe, einer Chinoxalinylgruppe, einer Benzochinoxalinylgruppe, einer Chinazolinylgruppe, einer Benzochinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Benzonaphthofuranylgruppe, einer Dibenzothiophenylgruppe, einer Benzonaphthothiophenylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Benzofuropyridinylgruppe, einer Benzofuropyrimidinylgruppe, einer Benzothienopyridinylgruppe, einer Benzothienopyrimidinylgruppe, einer Indenopyridinylgruppe, einer Indenopyrimidinylgruppe, einer Indolopyridinylgruppe, einer Indolopyrimidinylgruppe und einer Diazafluorenylgruppe, jeweils substituiert mit zumindest einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkylgruppe, substituiert mit Deuterium, einer C₁-C₂₀-Alkylgruppe, substituiert mit -F, einer C₁-C₂₀-Alkoxygruppe, einer C₃-C₁₀-Cycloalkylgruppe, einer Phenylgruppe, einer Phenylgruppe, substituiert mit Deuterium, einer Phenylgruppe, substituiert mit einer Methylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spiro-bifluorenyl-Gruppe, einer Spiro-benzofluoren-fluorenyl-Gruppe, einer Spiro-cyclopentan-fluorenyl-Gruppe, einer Spiro-cyclohexan-fluorenyl-Gruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Tetraphenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyridinylgruppe, substituiert mit Deuterium, einer Pyridinylgruppe, substituiert mit einer Methylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Benzoisochinolinylgruppe, einer Carbazolylgruppe, einer Benzocarbazolylgruppe, einer Phthalazinylgruppe, einer Naphthyridinylgruppe, einer Chinoxalinylgruppe, einer Benzochinoxalinylgruppe, einer Chinazolinylgruppe, einer Benzochinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Benzonaphthofuranylgruppe, einer Dibenzothiophenylgruppe, einer Benzonaphthothiophenylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Benzofuropyridinylgruppe, einer Benzofuropyrimidinylgruppe, einer Benzothienopyridinylgruppe, einer Benzothienopyrimidinylgruppe, einer Indenopyridinylgruppe, einer Indenopyrimidinylgruppe, einer Indolopyridinylgruppe, einer Indolopyrimidinylgruppe, einer Diazafluorenylgruppe, -N(Q₃₁)(Q₃₂) und-Si(Q₃₁)(Q₃₂)(Q₃₃); und
-N(Q₁)(Q₂) und -Si(Q₁)(Q₂)(Q₃),
wobei Q₁ bis Q₃ und Q₃₁ bis Q₃₃ jeweils unabhängig ausgewählt sind aus einer C₁-C₆₀-Alkylgruppe, einer C₆-C₆₀-Arylgruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, einer Biphenylgruppe und einer Terphenylgruppe.

8. Organische lichtemittierende Vorrichtung nach einem der Ansprüche 1 bis 7, wobei
R₂₁ bis R₂₄ jeweils unabhängig aus Gruppen ausgewählt sind, die durch Formeln 5-1 bis 5-128 dargestellt sind: 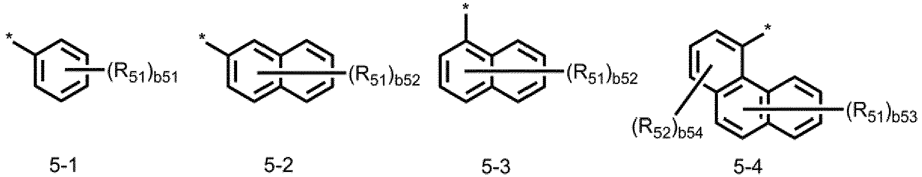 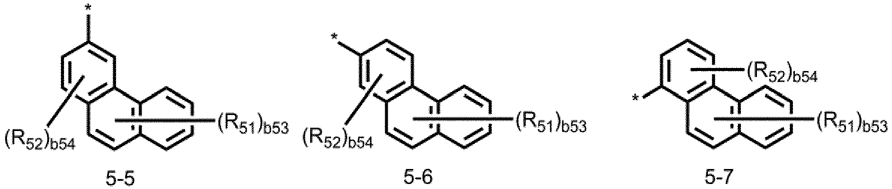 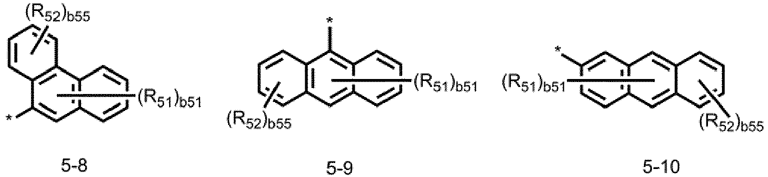 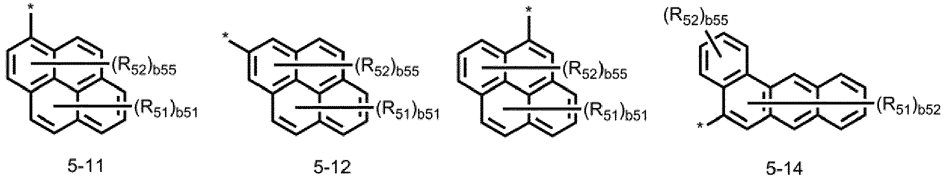 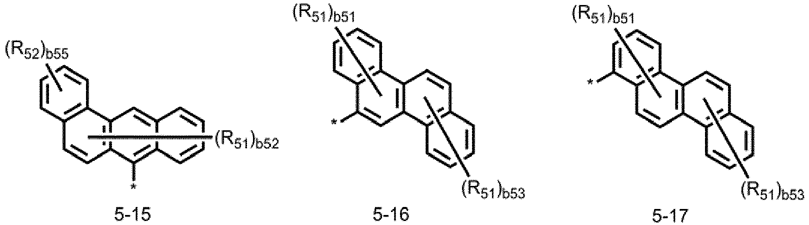 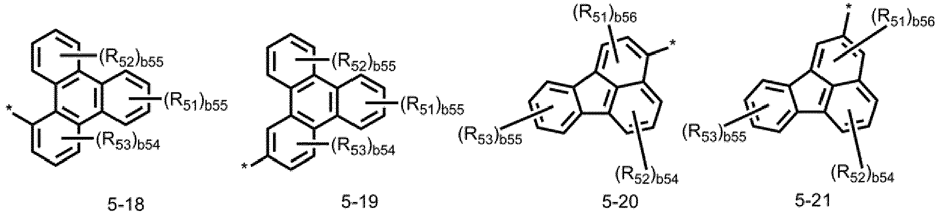 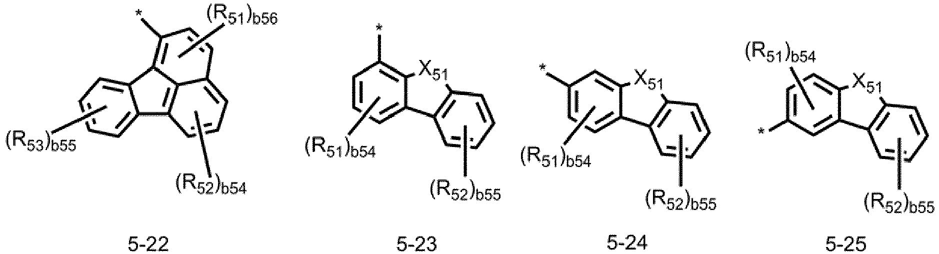 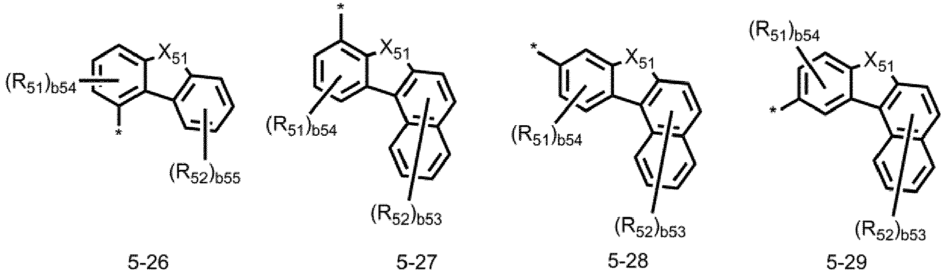 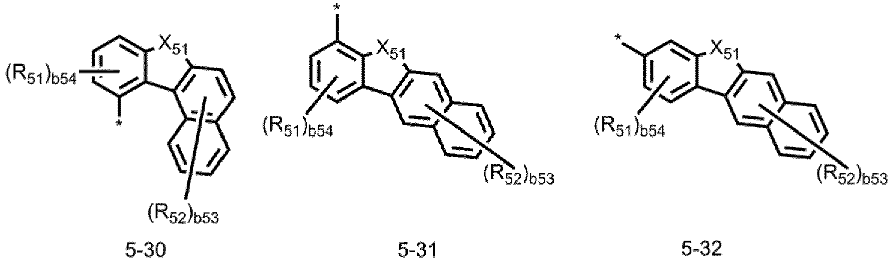 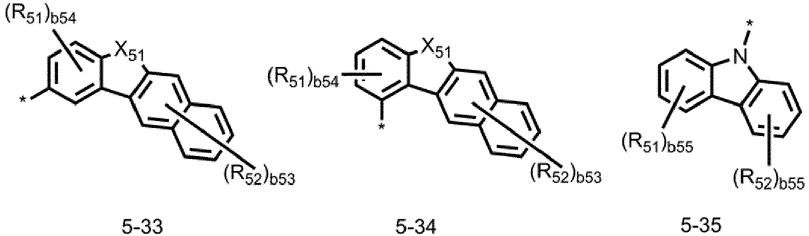 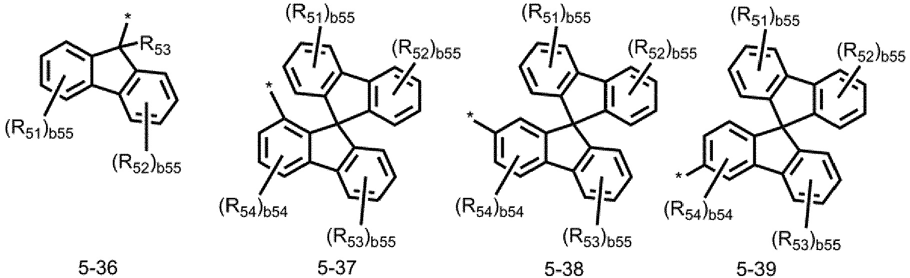 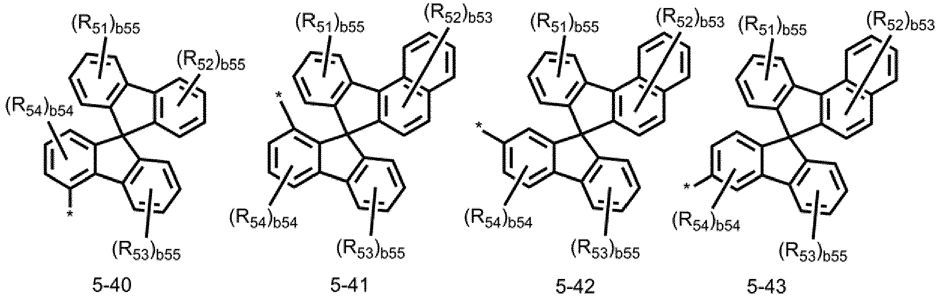 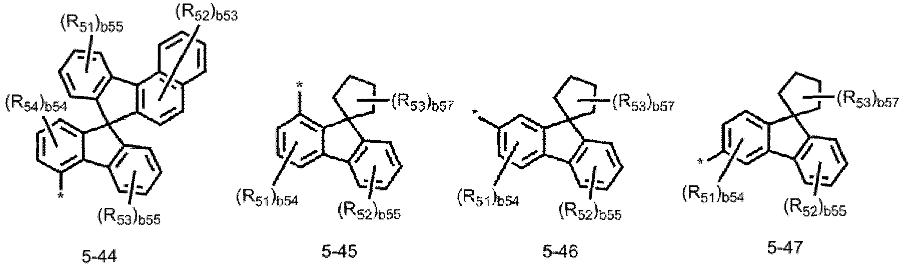 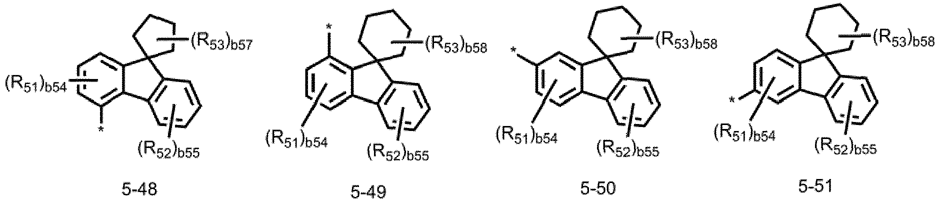 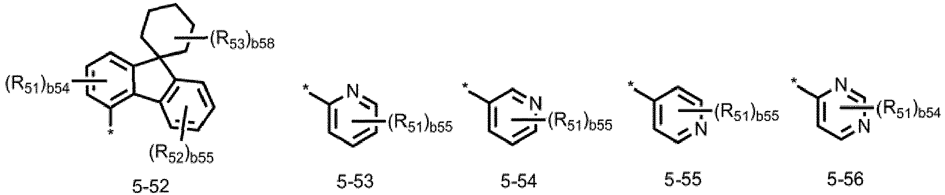 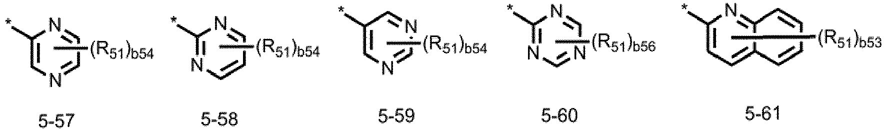 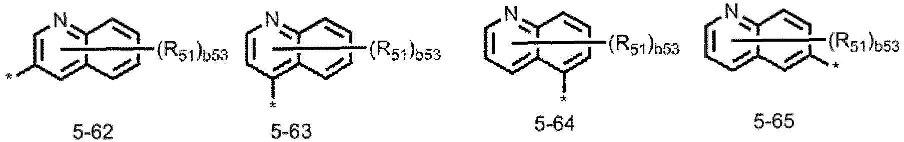 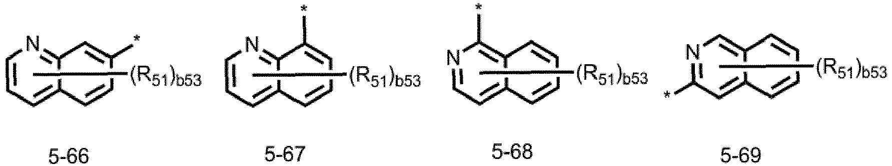 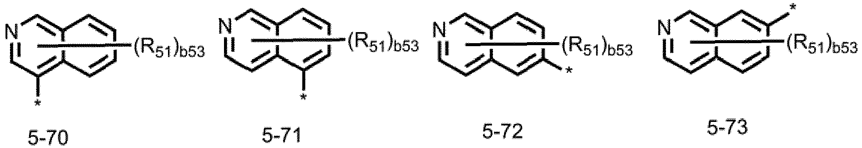 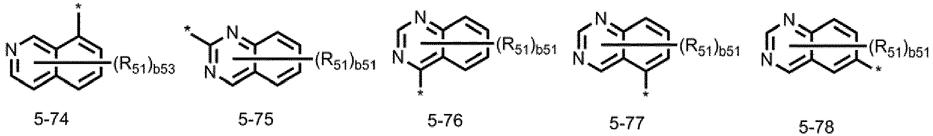 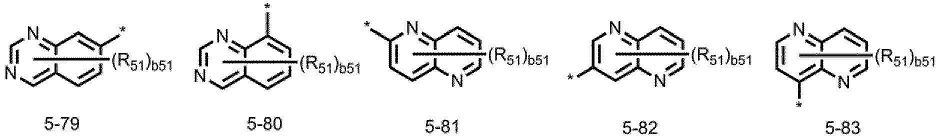 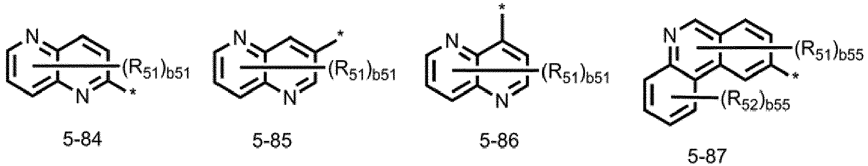 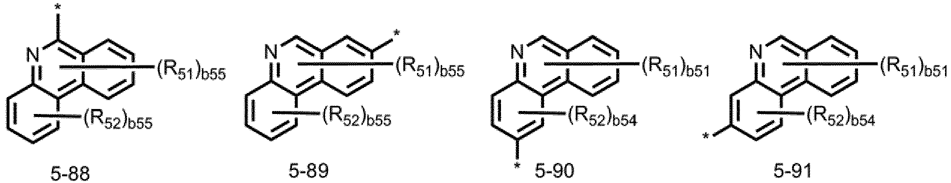 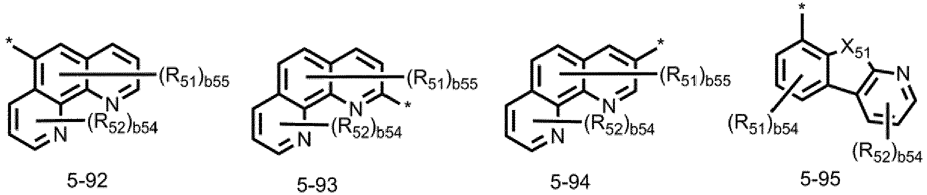 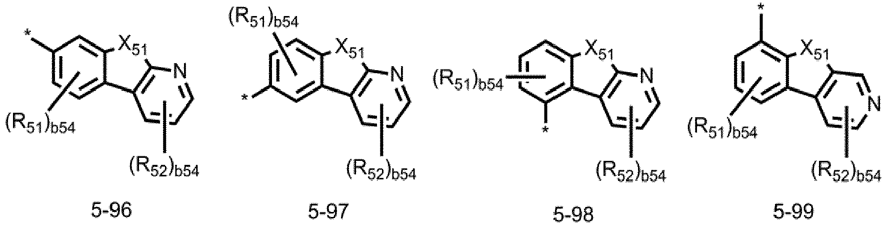 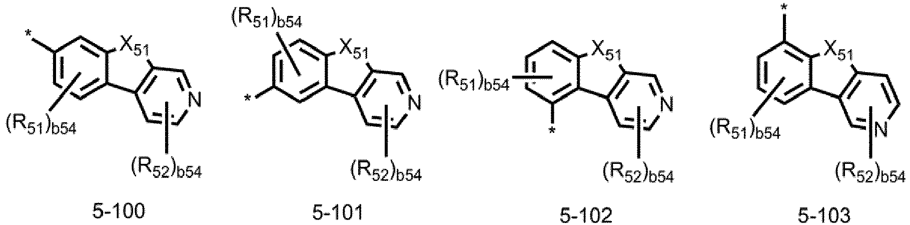 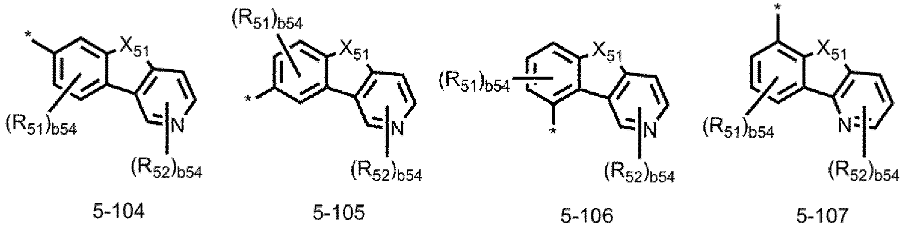 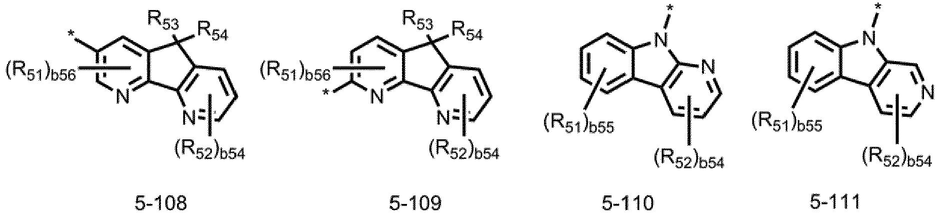 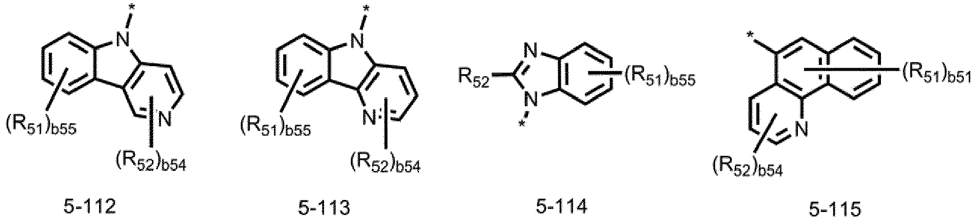 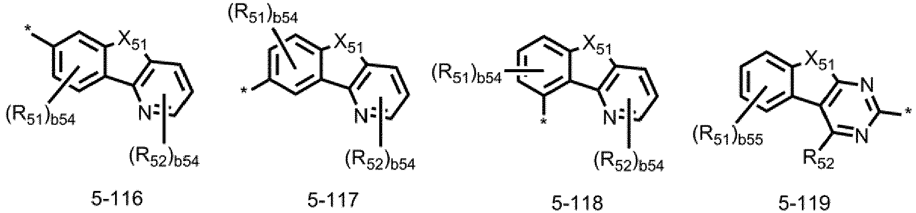 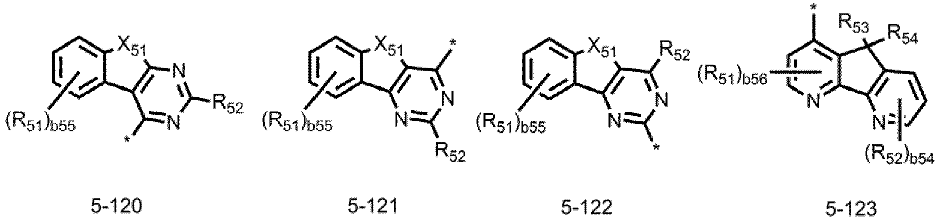 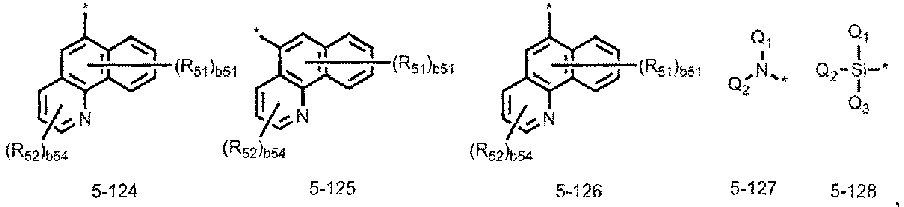 wobei, in Formeln 5-1 bis 5-128,
X₅₁ ausgewählt ist aus O, S, N(R₅₃) und C(R₅₃)(R₅₄);
R₅₁ bis R₅₄ jeweils unabhängig ausgewählt sind aus Wasserstoff, Deuterium, -F,-Cl, -Br, -I, einer Hydroxylgruppe, einer Cyanogruppe, einer Nitrogruppe, einer Amidinogruppe, einer Hydrazinogruppe, einer Hydrazonogruppe, einer Methylgruppe, einer Ethylgruppe, einer n-Propylgruppe, einer iso-Propylgruppe, einer n-Butylgruppe, einer iso-Butylgruppe, einer sec-Butylgruppe, einer tert-Butylgruppe, einer n-Pentylgruppe, einer iso-Pentylgruppe, einer sec-Pentylgruppe, einer tert-Pentylgruppe, einer neo-Pentylgruppe, -CDH₂, -CD₂H, -CD₃, -CFH₂, -CF₂H, -CF₃, einer Methoxygruppe, einer Ethoxygruppe, einer n-Propoxygruppe, einer iso-Propoxygruppe, einer n-Butoxygruppe, einer iso-Butoxygruppe, einer sec-Butoxygruppe, einer tert-Butoxygruppe, einer n-Pentoxygruppe, einer iso-Pentoxygruppe, einer sec-Pentoxygruppe, einer tert-Pentoxygruppe, einer neo-Pentoxygruppe, einer Cyclopropylgruppe, einer Cyclobutylgruppe, einer Cyclopentylgruppe, einer Cyclohexylgruppe, einer Phenylgruppe, Ds-Ph, 2-Me-Ph, 3-Me-Ph, 4-Me-Ph, einer Biphenylgruppe, einer Terphenylgruppe, einer Naphthylgruppe, einer Fluorenylgruppe, einer Spiro-bifluorenyl-Gruppe, einer Spiro-benzofluoren-fluorenyl-Gruppe, einer Benzofluorenylgruppe, einer Dibenzofluorenylgruppe, einer Phenanthrenylgruppe, einer Anthracenylgruppe, einer Fluoranthenylgruppe, einer Triphenylenylgruppe, einer Pyrenylgruppe, einer Tetraphenylgruppe, einer Chrysenylgruppe, einer Pyridinylgruppe, Ds-Py, 2-Me-1-Py, 3-Me-1-Py, 4-Me-1-Py, 5-Me-1-Py, 1-Me-2-Py, 3-Me-2-Py, 4-Me-2-Py, 5-Me-2-Py, 1-Me-3-Py, 2-Me-3-Py, 4-Me-3-Py, 5-Me-3-Py, einer Pyrimidinylgruppe, einer Chinolinylgruppe, einer Isochinolinylgruppe, einer Benzochinolinylgruppe, einer Benzoisochinolinylgruppe, einer Carbazolylgruppe, einer Benzocarbazolylgruppe, einer Naphthyridinylgruppe, einer Chinoxalinylgruppe, einer Chinazolinylgruppe, einer Phenanthridinylgruppe, einer Phenanthrolinylgruppe, einer Benzimidazolylgruppe, einer Triazinylgruppe, einer Dibenzofuranylgruppe, einer Benzonaphthofuranylgruppe, einer Dibenzothiophenylgruppe, einer Benzonaphthothiophenylgruppe, einer Benzofuropyridinylgruppe, einer Benzofuropyrimidinylgruppe, einer Benzothienopyridinylgruppe, einer Benzothienopyrimidinylgruppe, einer Indenopyridinylgruppe, einer Indenopyrimidinylgruppe, einer Indolopyridinylgruppe, einer Indolopyrimidinylgruppe, einer Diazafluorenylgruppe, -N(Q₃₁)(Q₃₂) und-Si(Q₃₁)(Q₃₂)(Q₃₃);
Q₁ bis Q₃ und Q₃₁ bis Q₃₃ jeweils unabhängig ausgewählt sind aus einer Methylgruppe, einer Ethylgruppe, einer n-Propylgruppe, einer iso-Propylgruppe, einer n-Butylgruppe, einer iso-Butylgruppe, einer sec-Butylgruppe, einer tert-Butylgruppe, einer n-Pentylgruppe, einer iso-Pentylgruppe, einer sec-Pentylgruppe, einer tert-Pentylgruppe, einer neo-Pentylgruppe, einer Phenylgruppe, einer Biphenylgruppe, einer Terphenylgruppe und einer Naphthylgruppe;
b51 ausgewählt ist aus 1, 2, 3, 4 und 5;
b52 ausgewählt ist aus 1, 2, 3, 4, 5, 6 und 7;
b53 ausgewählt ist aus 1, 2, 3, 4, 5 und 6;
b54 ausgewählt ist aus 1, 2 und 3;
b55 ausgewählt ist aus 1, 2, 3 und 4;
b56 ausgewählt ist aus 1 und 2;
b57 ausgewählt ist aus 1, 2, 3, 4, 5, 6, 7 und 8;
b58 ausgewählt ist aus 1, 2, 3, 4, 5, 6, 7, 8, 9 und 10; und
* eine Bindungsstelle an ein Nachbaratom anzeigt.

9. Organische lichtemittierende Vorrichtung nach einem der Ansprüche 1 bis 8, wobei
R₂₀₁ bis R₂₀₇ jeweils unabhängig ausgewählt sind aus Wasserstoff, Deuterium, -F, -Cl, -Br, -I, einer Cyanogruppe, einer substituierten oder unsubstituierten C₁-C₆₀-Alkylgruppe, einer substituierten oder unsubstituierten C₆-C₆₀-Arylgruppe, einer substituierten oder unsubstituierten C₁-C₆₀-Heteroarylgruppe, einer substituierten oder unsubstituierten einwertigen nichtaromatischen kondensierten polycyclischen Gruppe, einer substituierten oder unsubstituierten einwertigen nichtaromatischen kondensierten heteropolycyclischen Gruppe, -N(Q₁)(Q₂) und -Si(Q₁)(Q₂)(Q₃);
Q₁ bis Q₃ jeweils unabhängig ausgewählt sind aus einer C₁-C₆₀-Alkylgruppe, einer C₆-C₆₀-Arylgruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, einer Biphenylgruppe und einer Terphenylgruppe;
R₂₀₄ und R₂₀₅ gegebenenfalls miteinander verknüpft sind, um einen gesättigten Ring oder einen ungesättigten Ring zu bilden; und
R₂₀₆ und R₂₀₇ gegebenenfalls miteinander verknüpft sind, um einen gesättigten Ring oder einen ungesättigten Ring zu bilden.

10. Organische lichtemittierende Vorrichtung nach einem der Ansprüche 1 bis 9, wobei
R₂₀₁ bis R₂₀₇ jeweils unabhängig aus der Gruppe ausgewählt sind, die besteht aus:
Wasserstoff, Deuterium, -F, -Cl, -Br, -I, einer Cyanogruppe, einer Methylgruppe, einer Ethylgruppe, einer n-Propylgruppe, einer iso-Propylgruppe, einer n-Butylgruppe, einer sec-Butylgruppe, einer iso-Butylgruppe, einer tert-Butylgruppe, einer Phenylgruppe, einer Biphenylgruppe, einer Terphenylgruppe, einer Naphthylgruppe, einer Pyridinylgruppe, -N(Q₁)(Q₂) und -Si(Q₁)(Q₂)(Q₃); und
einer Phenylgruppe, einer Biphenylgruppe, einer Terphenylgruppe, einer Naphthylgruppe und einer Pyridinylgruppe, jeweils substituiert mit zumindest einem, ausgewählt aus einer Methylgruppe, einer Ethylgruppe, einer n-Propylgruppe, einer iso-Propylgruppe, einer n-Butylgruppe, einer sec-Butylgruppe, einer iso-Butylgruppe, einer tert-Butylgruppe, einer Phenylgruppe, einer Biphenylgruppe, einer Terphenylgruppe, einer Naphthylgruppe und einer Pyridinylgruppe;
Q₁ bis Q₃ jeweils unabhängig ausgewählt sind aus einer Methylgruppe, einer Ethylgruppe, einer n-Propylgruppe, einer iso-Propylgruppe und einer Phenylgruppe;
R₂₀₄ und R₂₀₅ gegebenenfalls miteinander verknüpft sind, um einen gesättigten Ring oder einen ungesättigten Ring zu bilden; und
R₂₀₆ und R₂₀₇ gegebenenfalls miteinander verknüpft sind, um einen gesättigten Ring oder einen ungesättigten Ring zu bilden.

11. Organische lichtemittierende Vorrichtung nach einem der Ansprüche 1 bis 10, wobei
die zweite Verbindung, dargestellt durch Formel 2, ausgewählt ist aus Verbindungen D1 bis D212:

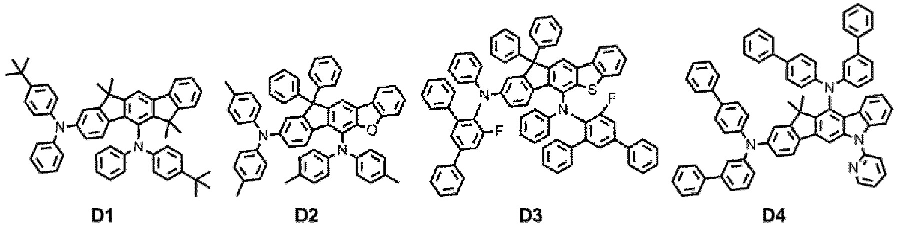

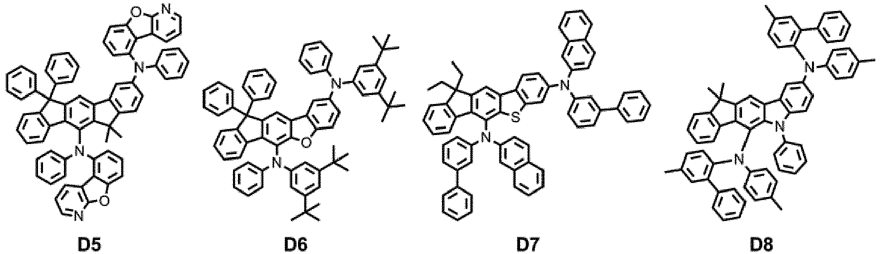

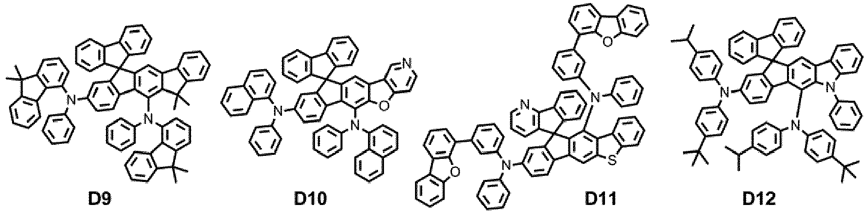

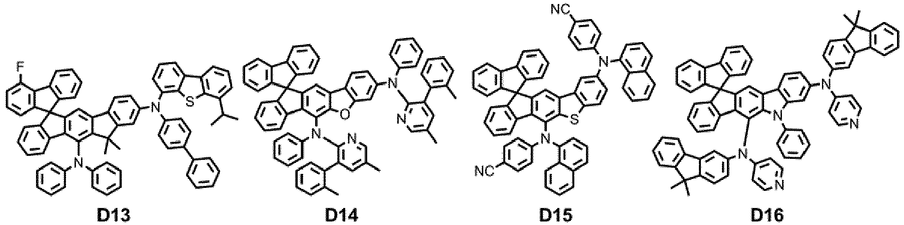

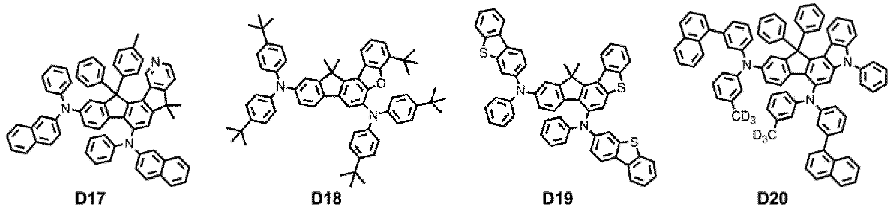

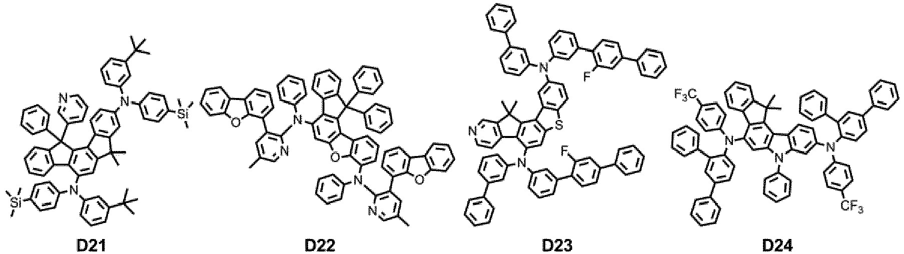

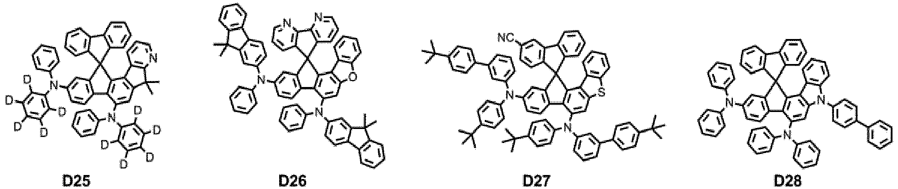

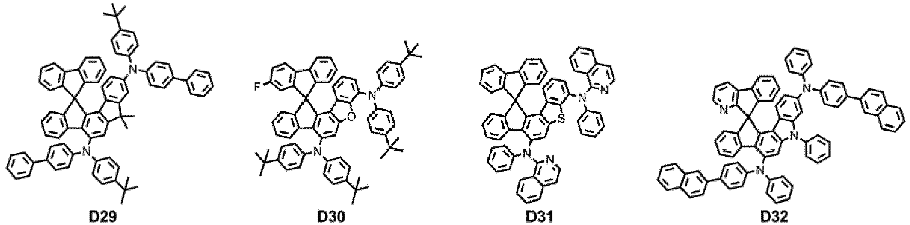

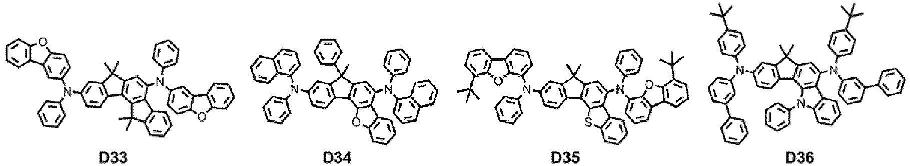

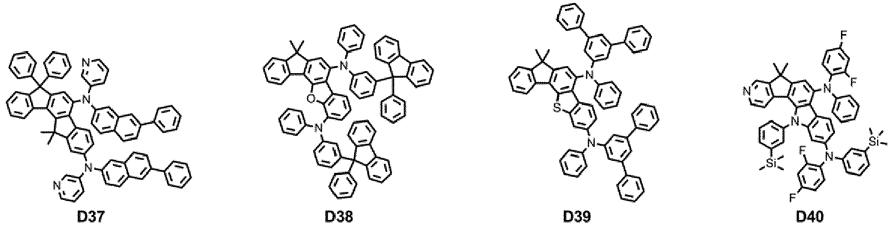

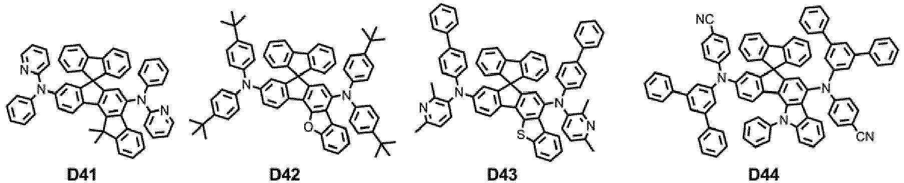

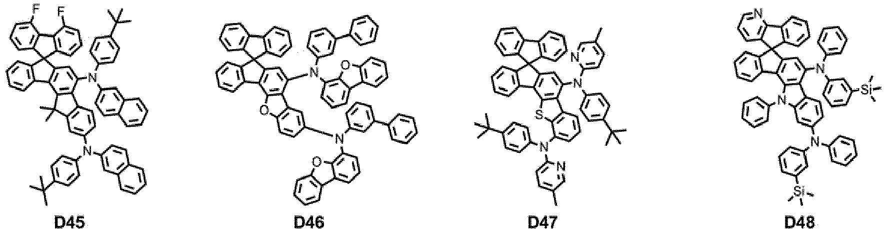

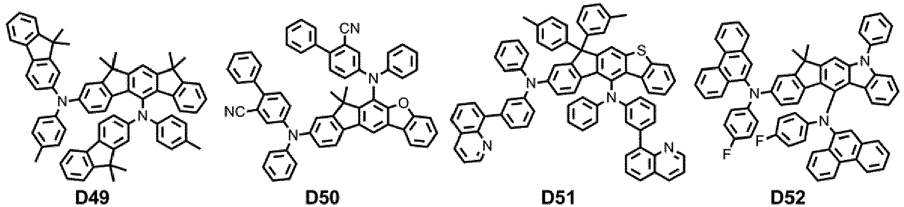

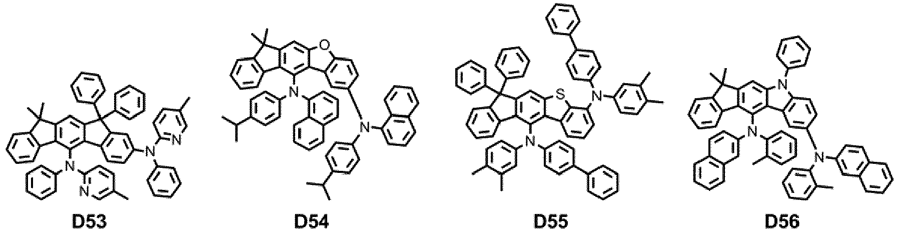

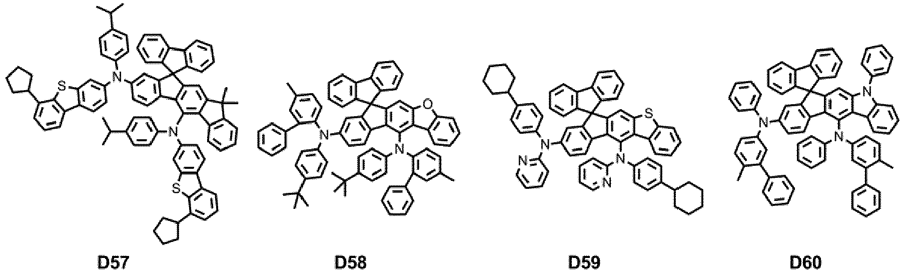

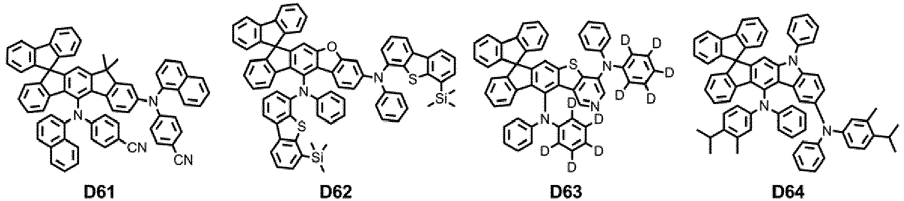

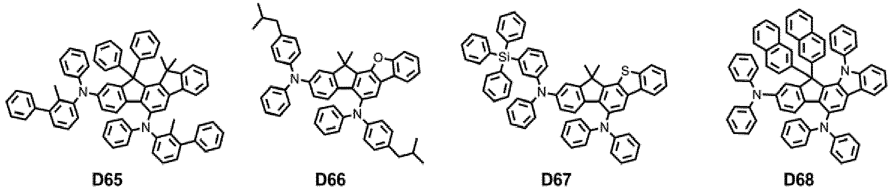

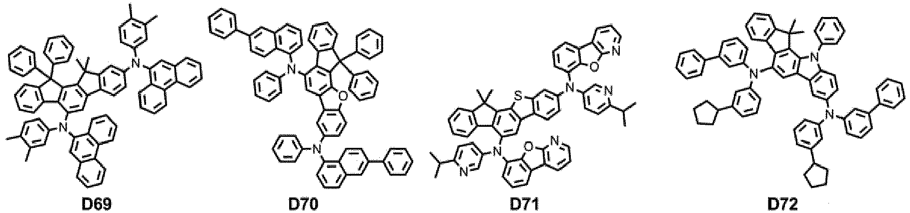

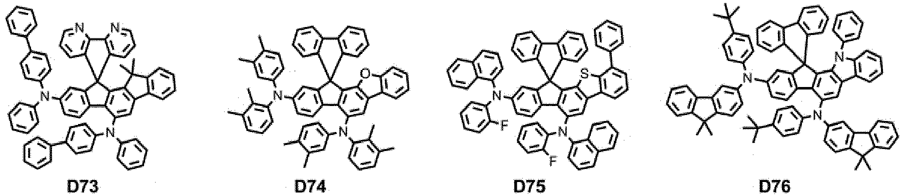

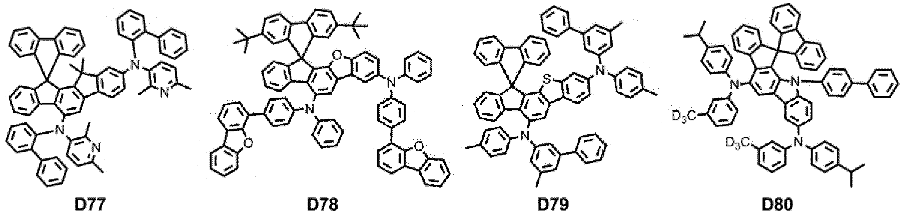

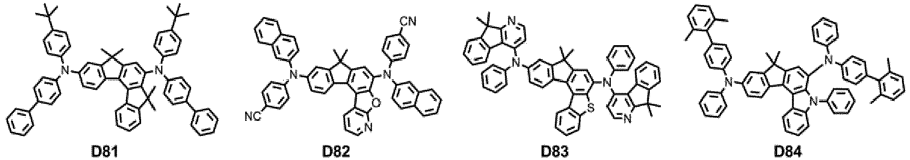

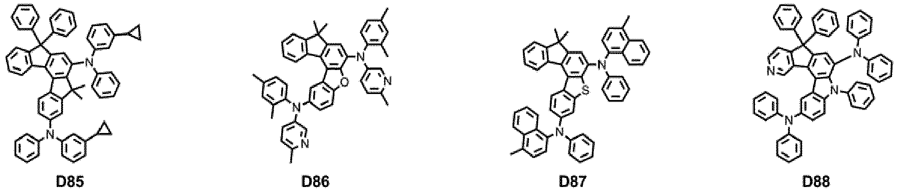

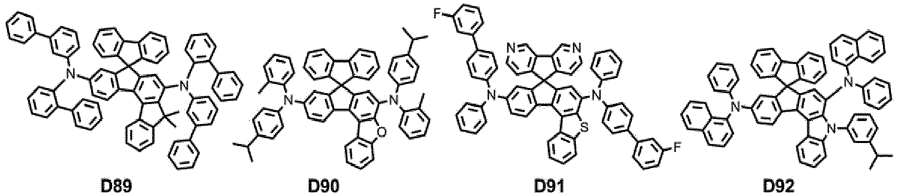

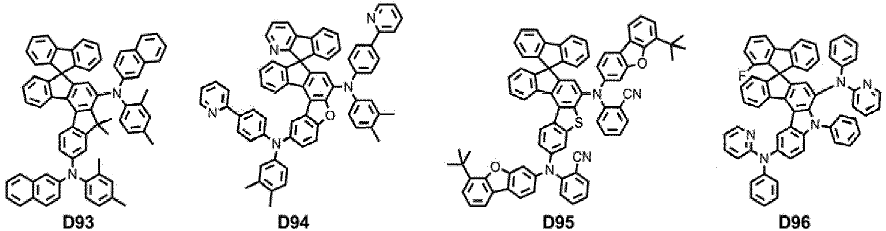

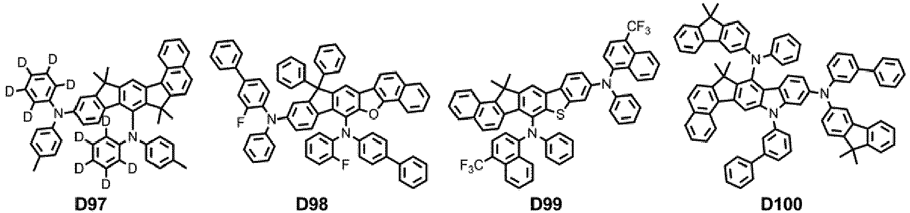

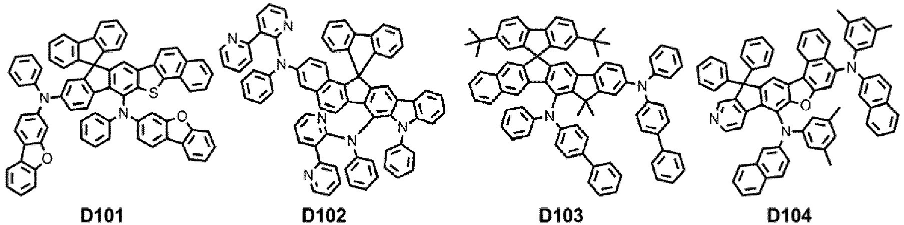

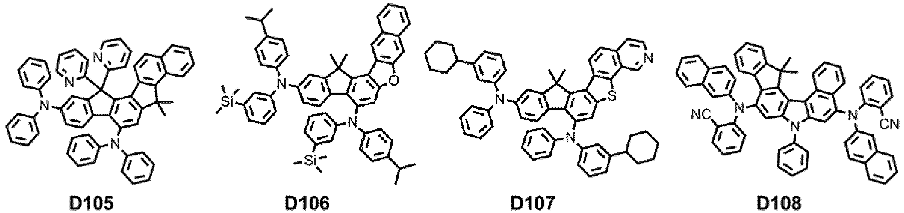

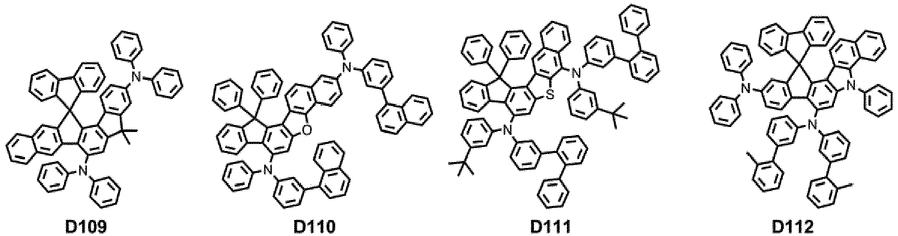

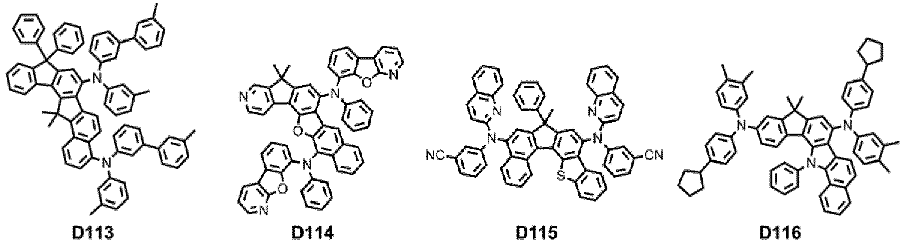

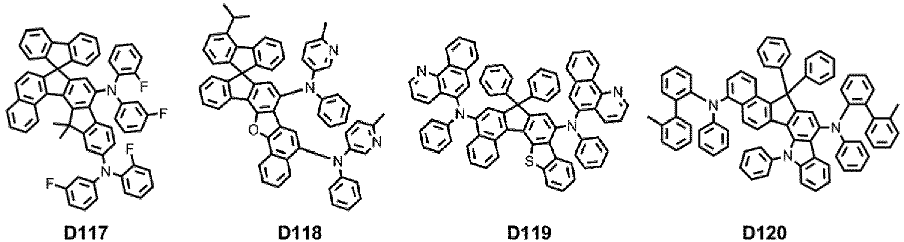

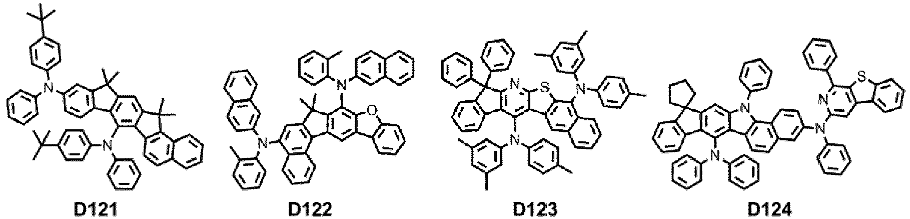

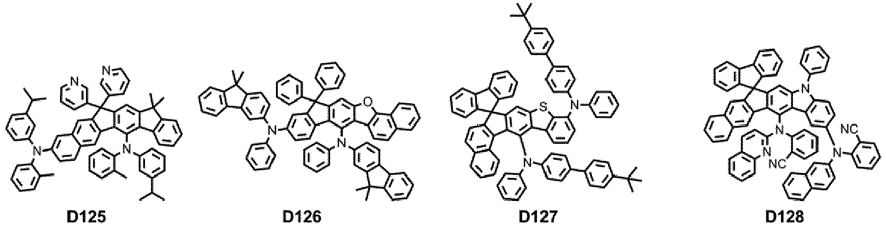

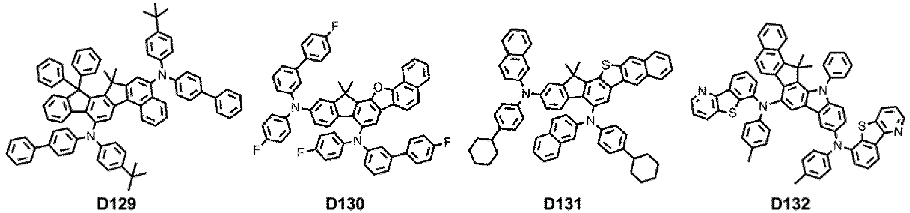

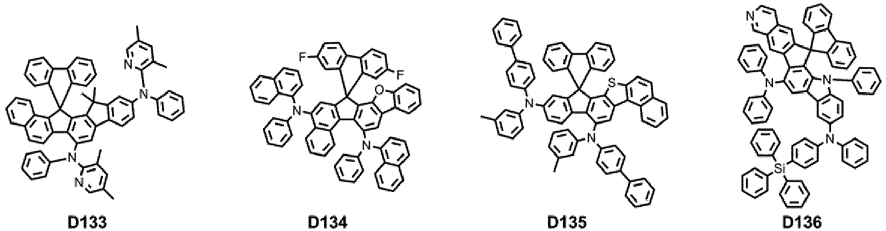

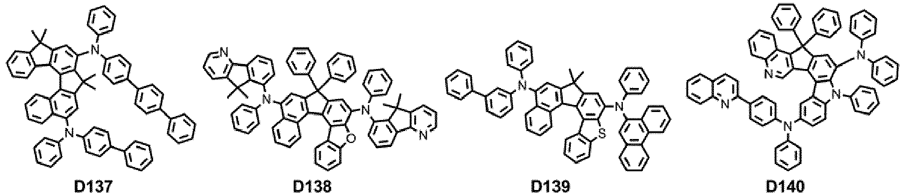

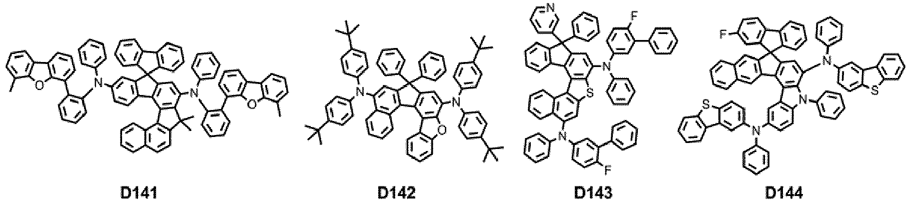

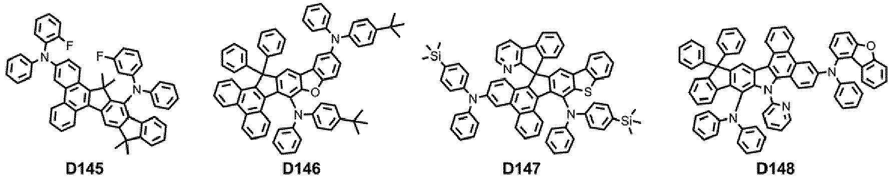

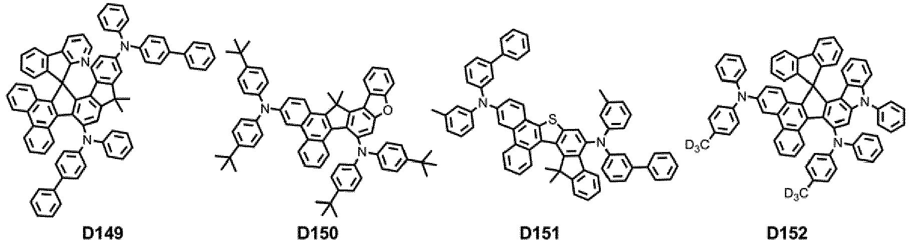

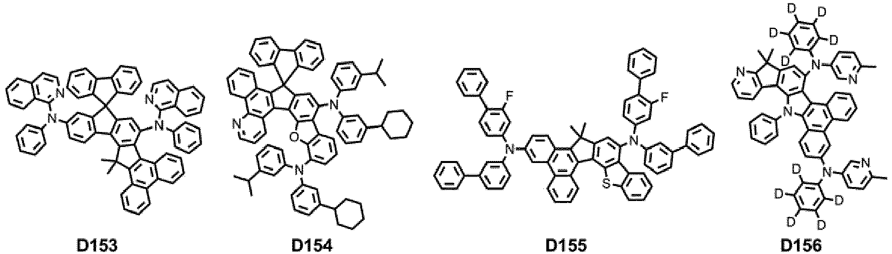

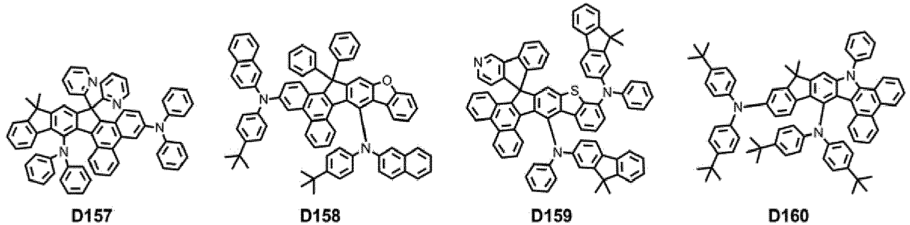

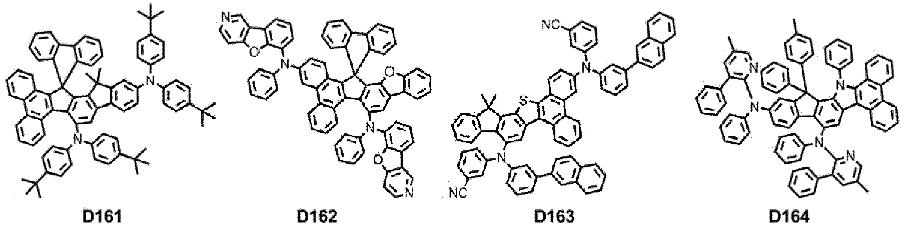

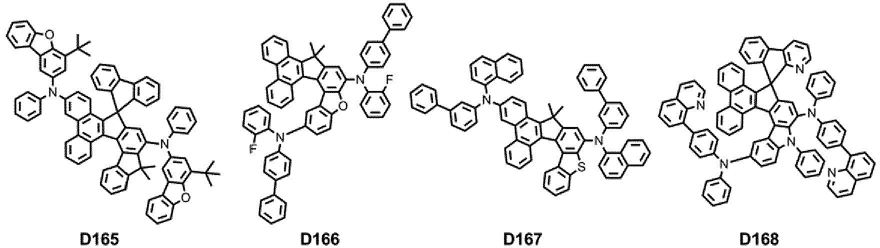

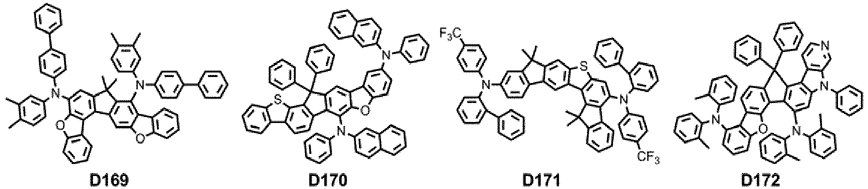

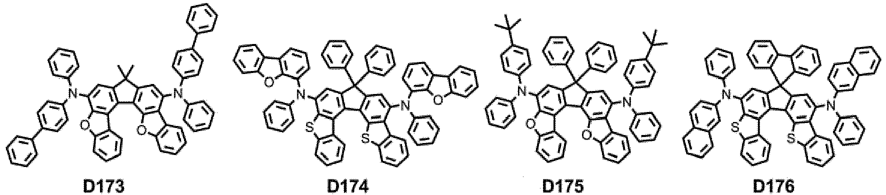

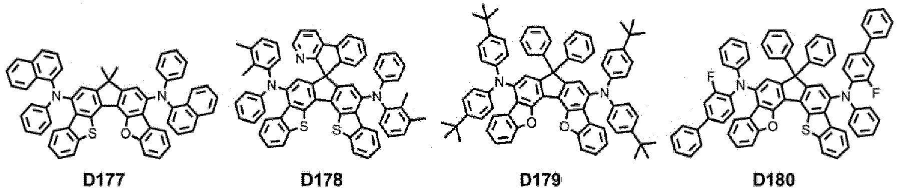

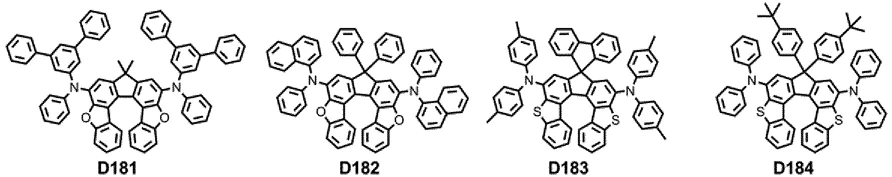

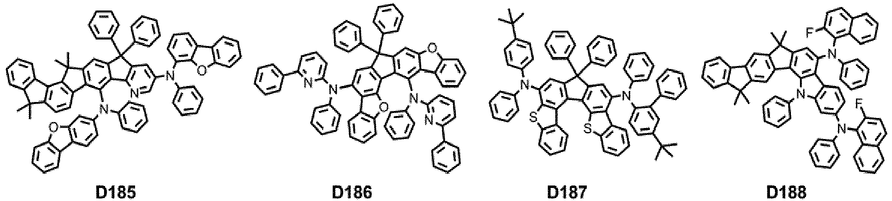

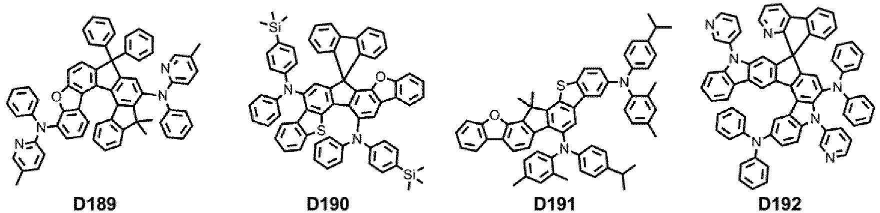

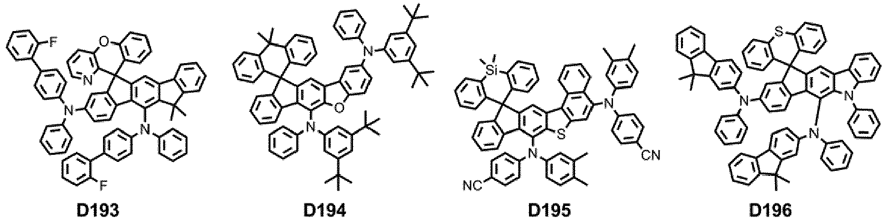

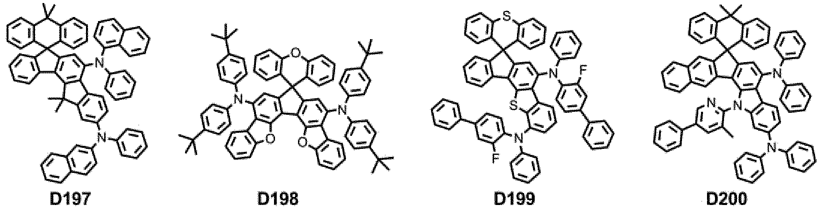

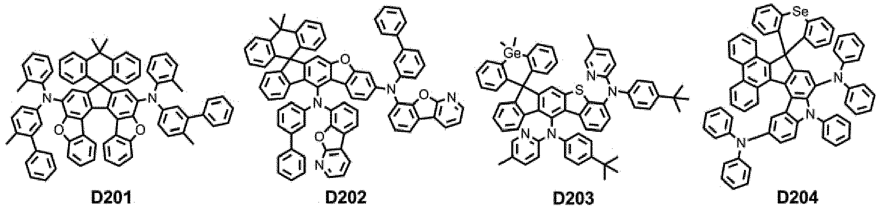

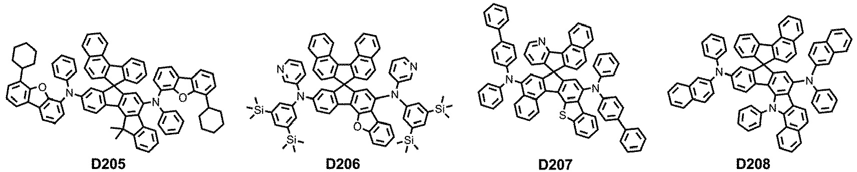

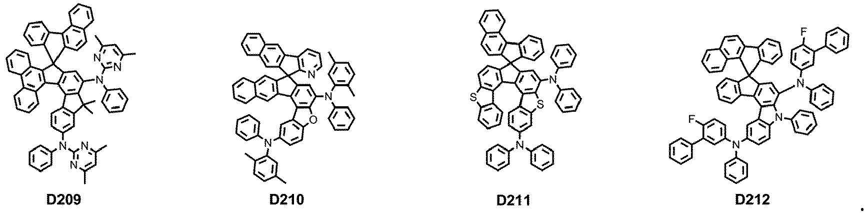

12. Organische lichtemittierende Vorrichtung nach einem der Ansprüche 1 bis 11, wobei
die organische Schicht weiterhin eine Elektronentransportregion zwischen der Emissionsschicht und der zweiten Elektrode umfasst,
wobei die Elektronentransportregion ein Alkalimetall, ein Erdalkalimetall, ein Seltenerdmetall, eine Alkalimetallverbindung, eine Erdalkalimetallverbindung, eine Seltenerdmetallverbindung, einen Alkalimetallkomplex, einen Erdalkalimetallkomplex, einen Seltenerdmetallkomplex oder eine beliebige Kombination davon umfasst.

13. Organische lichtemittierende Vorrichtung nach Anspruch 12,
wobei die Elektronentransportregion eine Elektronentransportschicht und eine Elektroneninjektionsschicht umfasst; und
zumindest eines, ausgewählt aus der Elektronentransportschicht und der Elektroneninjektionsschicht, ein Alkalimetall, ein Erdalkalimetall, ein Seltenerdmetall, eine Alkalimetallverbindung, eine Erdalkalimetallverbindung, eine Seltenerdmetallverbindung, einen Alkalimetallkomplex, einen Erdalkalimetallkomplex, einen Seltenerdmetallkomplex oder eine beliebige Kombination davon umfasst.

14. Organische lichtemittierende Vorrichtung nach einem der Ansprüche 1 bis 13, wobei
die organische Schicht weiterhin eine Lochtransportregion zwischen der Emissionsschicht und der ersten Elektrode umfasst,
wobei die Lochtransportregion einen p-Dotanden umfasst, und
ein LUMO- (niedrigstes unbesetztes Molekülorbital) Energieniveau des p-Dotanden -3,5 eV oder weniger beträgt.

15. Organische lichtemittierende Vorrichtung nach Anspruch 14, wobei
der p-Dotand eine Cyanogruppe-haltige Verbindung umfasst.

16. Organische lichtemittierende Vorrichtung nach einem der Ansprüche 1 bis 15, wobei
die Emissionsschicht eine Emissionsschicht ist, die Licht einer ersten Farbe emittiert;
die organische Schicht weiterhin umfasst: i) zumindest eine Emissionsschicht, die Licht einer zweiten Farbe emittiert, oder ii) zumindest eine Emissionsschicht, die Licht einer zweiten Farbe emittiert, und zumindest eine Emissionsschicht, die Licht einer dritten Farbe emittiert;
wobei ein Licht der ersten Farbe von der Emissionsschicht, die Licht der ersten Farbe emittiert, und ein Licht der zweiten Farbe von der Emissionsschicht, die Licht der zweiten Farbe emittiert, miteinander identisch oder voneinander verschieden sind; oder das Licht der ersten Farbe, das Licht der zweiten Farbe und ein Licht der dritten Farbe von der Emissionsschicht, die Licht der dritten Farbe emittiert, miteinander identisch oder voneinander verschieden sind; und
das Licht der ersten Farbe und das Licht der zweiten Farbe in einem Mischfarbenlicht emittiert werden; oder das Licht der ersten Farbe, das Licht der zweiten Farbe und das Licht der dritten Farbe in einem Mischfarbenlicht emittiert werden.

## Revendications

1. Dispositif émetteur de lumière organique comprenant:
une première électrode;
une deuxième électrode; et
une couche organique entre la première électrode et la deuxième électrode, la couche organique comprenant une couche d'émission,
dans lequel la couche d'émission comprend un premier composé choisi parmi les Composés H1 à H116 et un deuxième composé représenté par la Formule 2: 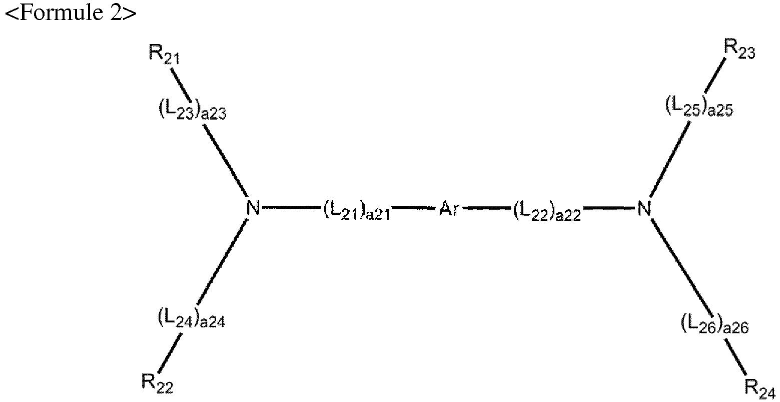 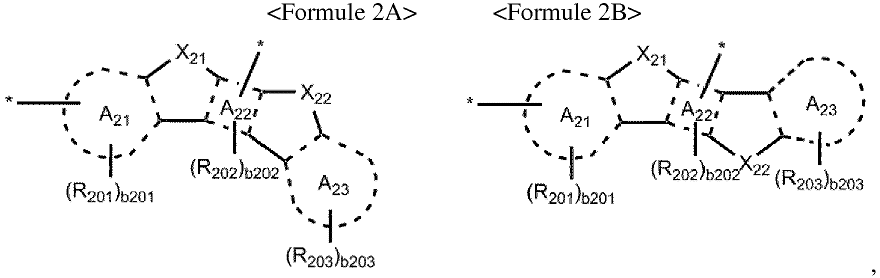
dans lequel, dans les Formules 2, 2A et 2B,
Ar est choisi parmi un groupe représenté par la Formule 2A et un groupe représenté par la Formule 2B;
X₂₁ est choisi parmi un oxygène, un soufre, N(R₂₀₄) et C(R₂₀₄)(R₂₀₅);
X₂₂ est choisi parmi un oxygène, un soufre, N(R₂₀₆) et C(R₂₀₆)(R₂₀₇);
A₂₁ est choisi parmi un groupe C₅-C₂₀ carbocyclique et un groupe C₁-C₂₀ hétérocyclique;
A₂₂ est choisi parmi un groupe C₆-C₂₀ arène et un groupe C₁-C₂₀ hétéroarène;
A₂₃ est choisi parmi un groupe C₅-C₂₀ carbocyclique et un groupe C₁-C₂₀ hétérocyclique;
L₂₁ à L₂₆ sont chacun indépendamment choisis parmi un groupe C₃-C₁₀ cycloalkylène substitué ou non substitué, un groupe C₁-C₁₀ hétérocycloalkylène substitué ou non substitué, un groupe C₃-C₁₀ cycloalcénylène substitué ou non substitué, un groupe C₁-C₁₀ hétérocycloalcénylène substitué ou non substitué, un groupe C₆-C₆₀ arylène substitué ou non substitué, un groupe C₁-C₆₀ hétéroarylène substitué ou non substitué, un groupe polycyclique condensé non aromatique divalent substitué ou non substitué et un groupe hétéropolycyclique condensé non aromatique divalent substitué ou non substitué;
a21 à a26 sont chacun indépendamment choisis parmi 0, 1, 2 et 3;
R₂₁ à R₂₄ sont chacun indépendamment choisis parmi un groupe C₁-C₆₀ alkyle substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalcényle substitué ou non substitué, un groupe C₁-C₁₀ hétérocycloalcényle substitué ou non substitué, un groupe C₆-C₆₀ aryle substitué ou non substitué, un groupe C₁-C₆₀ hétéroaryle substitué ou non substitué, un groupe polycyclique condensé non aromatique monovalent substitué ou non substitué et un groupe hétéropolycyclique condensé non aromatique monovalent substitué ou non substitué; dans lequel R₂₁ et R₂₂ sont optionnellement liés l'un à l'autre pour former un cycle saturé ou un cycle insaturé et R₂₃ et R₂₄ sont optionnellement liés l'un à l'autre pour former un cycle saturé ou un cycle insaturé;
R₂₀₁ à R₂₀₇ sont chacun indépendamment choisis parmi un hydrogène, un deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle substitué ou non substitué, un groupe C₂-C₆₀ alcényle substitué ou non substitué, un groupe C₂-C₆₀ alcynyle substitué ou non substitué, un groupe C₁-C₆₀ alcoxy substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalcényle substitué ou non substitué, un groupe C₁-C₁₀ hétérocycloalcényle substitué ou non substitué, un groupe C₆-C₆₀ aryle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe polycyclique condensé non aromatique monovalent substitué ou non substitué, un groupe hétéropolycyclique condensé non aromatique monovalent substitué ou non substitué, -Si(Q₁)(Q₂)(Q₃), -N(Q₁)(Q₂),-B(Q₁)(Q₂), -C(=O)(Q₁), -S(=O)₂(Q₁) et -P(=O)(Q₁)(Q₂); dans lequel R₂₀₄ et R₂₀₅ sont optionnellement liés l'un à l'autre pour former un cycle saturé ou un cycle insaturé et R₂₀₆ et R₂₀₇ sont optionnellement liés l'un à l'autre pour former un cycle saturé ou un cycle insaturé;
b201 à b203 sont chacun indépendamment choisis parmi 1, 2, 3, 4, 5, 6, 7, 8, 9 et 10;
Q₁ à Q₃ sont chacun indépendamment choisis parmi un hydrogène, un deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alcényle, un groupe C₂-C₆₀ alcynyle, un groupe C₁-C₆₀ alcoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₁-C₆₀ hétéroaryle, un groupe polycyclique condensé non aromatique monovalent, un groupe hétéropolycyclique condensé non aromatique monovalent, un groupe biphényle et un groupe terphényle; et
* indique un site de liaison à un atome avoisinant

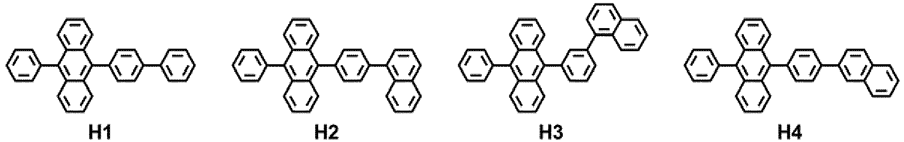

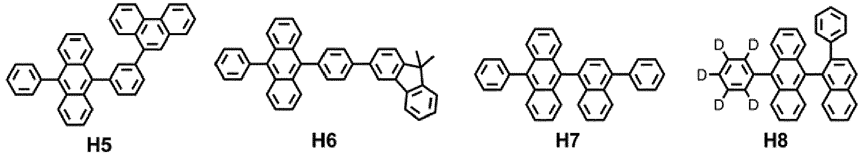

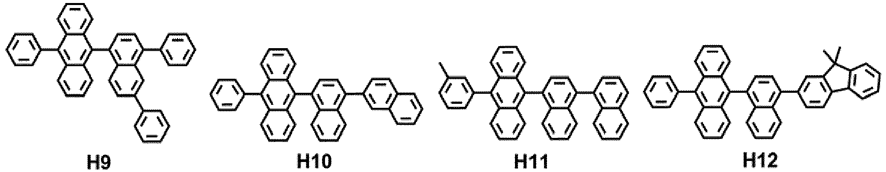

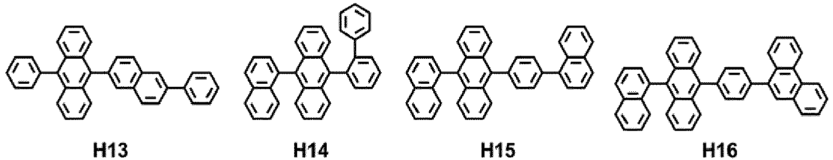

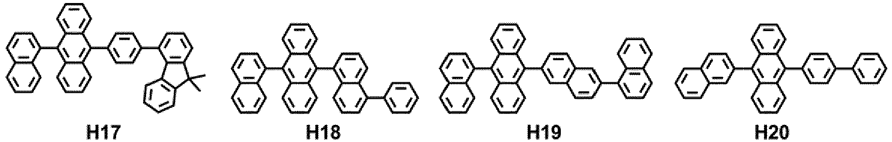

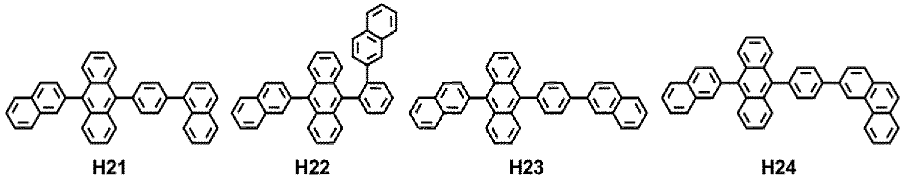

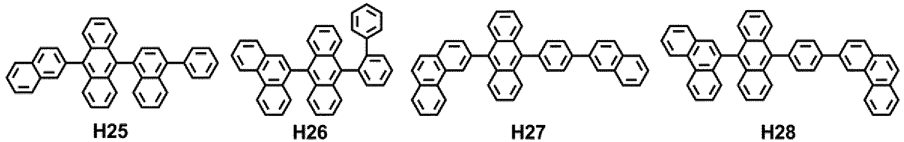

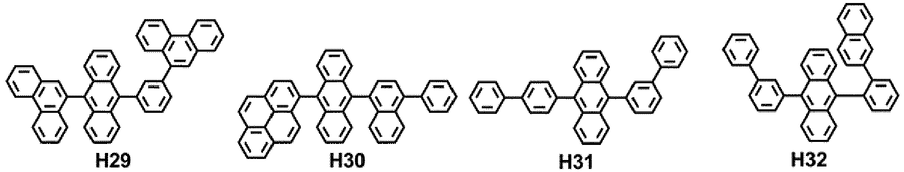

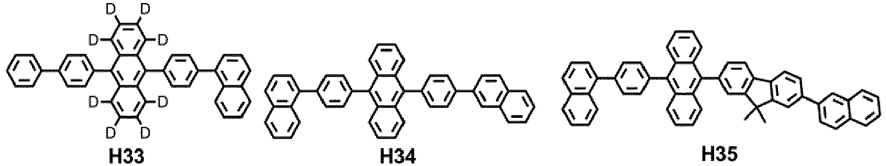

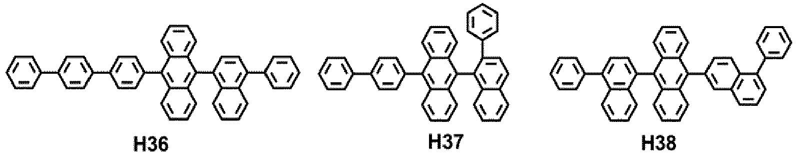

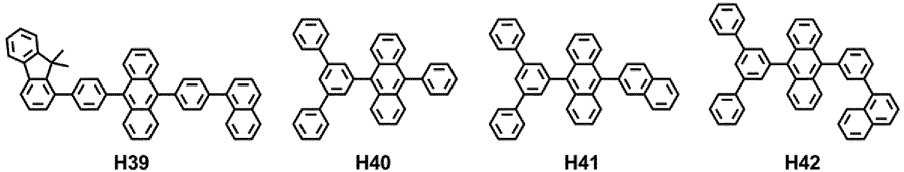

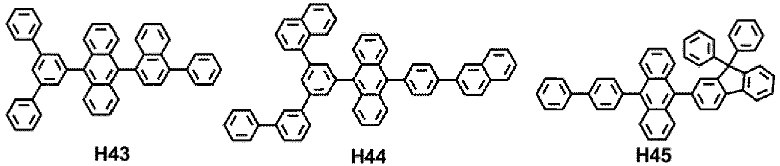

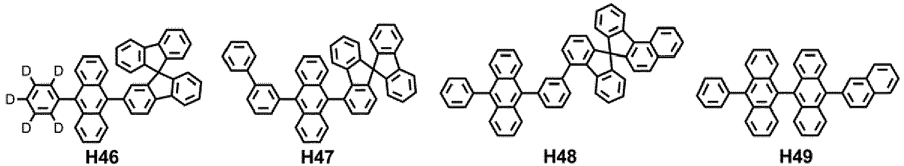

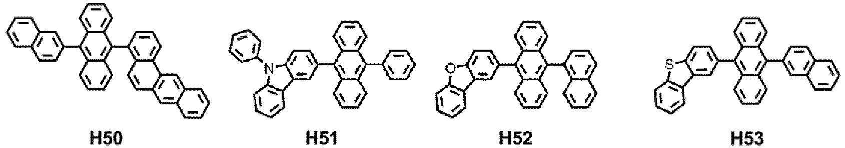

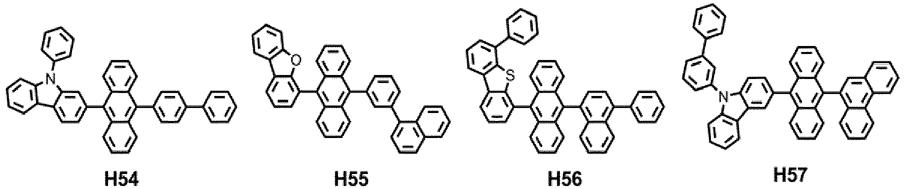

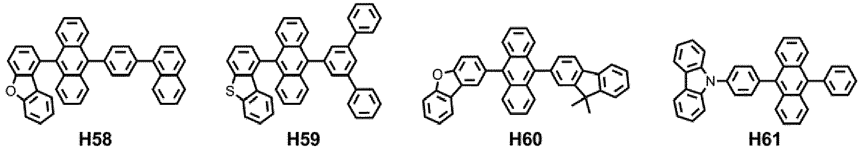

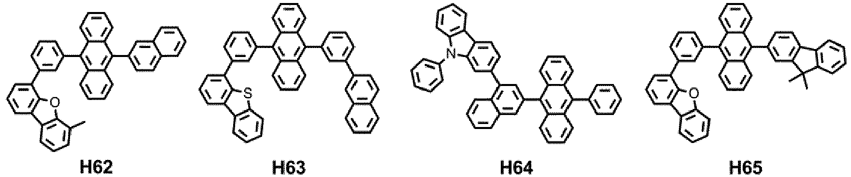

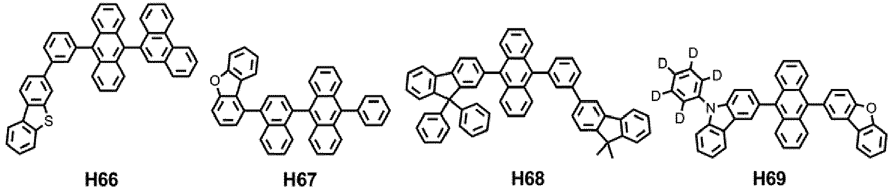

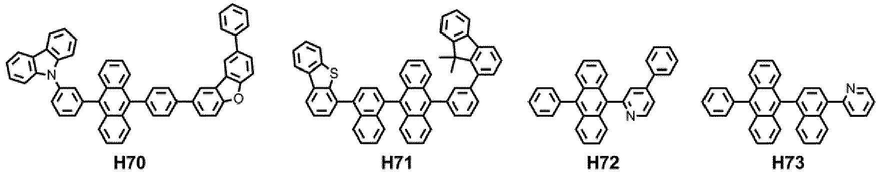

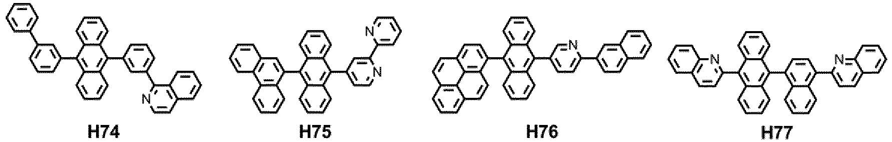

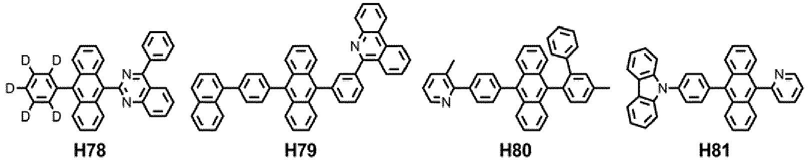

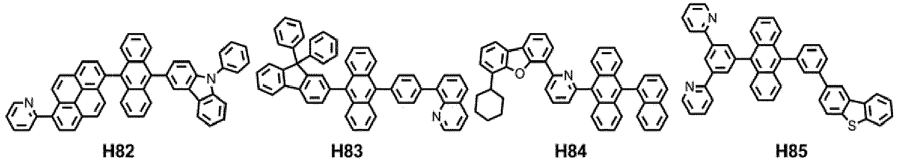

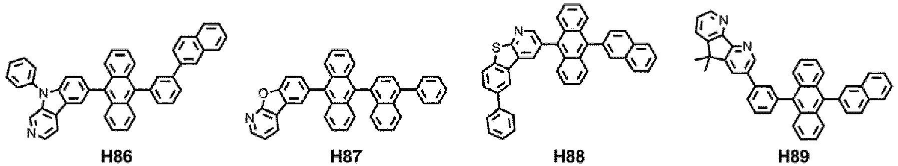

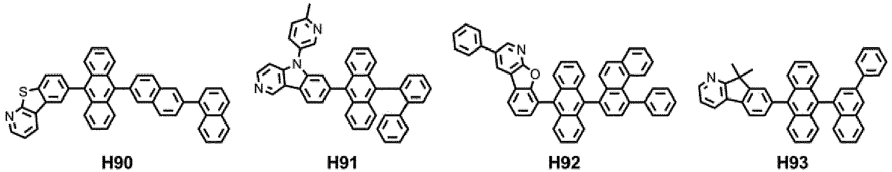

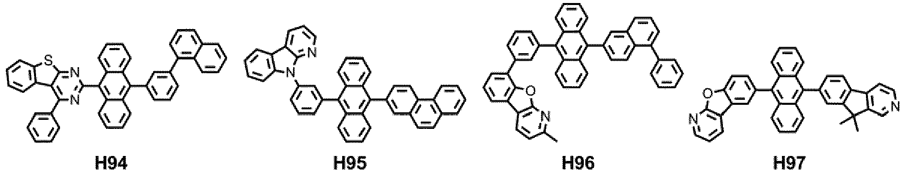

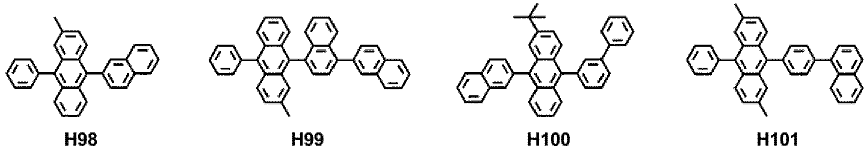

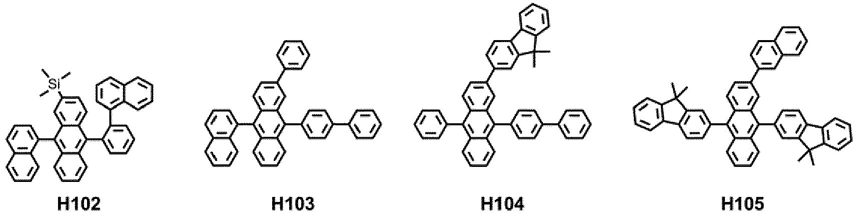

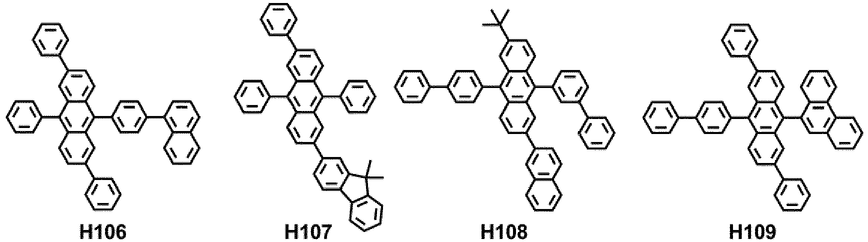

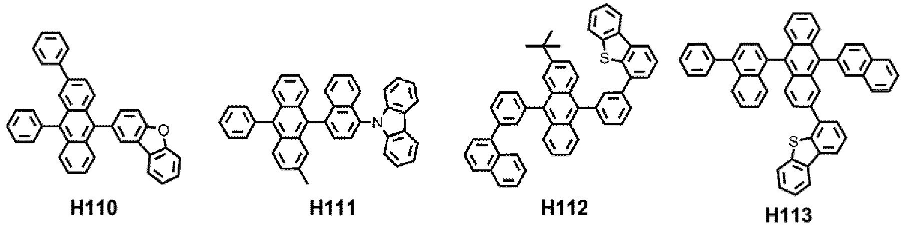

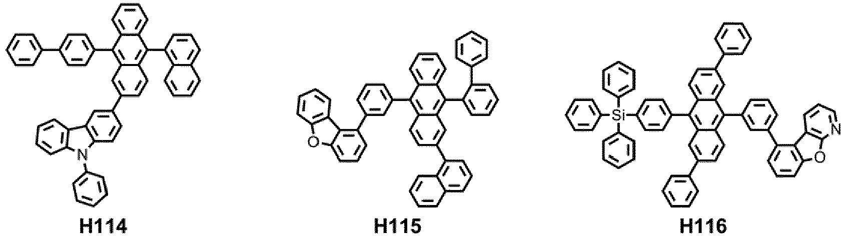

2. Dispositif émetteur de lumière organique selon la revendication 1, dans lequel:
A₂₁ et A₂₃ sont chacun indépendamment choisis parmi un groupe benzène, un groupe naphtalène, un groupe phénanthrène, un groupe anthracène, un groupe triphénylène, un groupe pyrène, un groupe chrysène, un groupe furane, un groupe thiophène, un groupe pyrrole, un groupe pyridine, un groupe pyrazine, un groupe pyrimidine, un groupe triazine, un groupe quinoléine, un groupe isoquinoléine, un groupe benzoquinoléine, un groupe benzoisoquinoléine, un groupe 2,6-naphtyridine, un groupe 1,8-naphtyridine, un groupe 1,5-naphtyridine, un groupe 1,6-naphtyridine, un groupe 1,7-naphtyridine, un groupe 2,7-naphtyridine, un groupe quinoxaline, un groupe quinazoline, un groupe phénanthridine, un groupe phénanthroline, un groupe benzofurane, un groupe benzothiophène, un groupe indène, un groupe indole, un groupe furopyridine, un groupe thiénopyridine, un groupe cyclopentapyridine, un groupe pyrrolopyridine, un groupe dibenzofurane, un groupe dibenzothiophène, un groupe fluorène, un groupe carbazole, un groupe benzofuropyrrole, un groupe benzothiénopyrrole, un groupe indénopyrrole, un groupe indolopyrrole, un groupe benzofurothiophène, un groupe benzothiénothiophène, un groupe indénothiophène, un groupe indolothiophène, un groupe benzofurofurane, un groupe benzothiénofurane, un groupe indénofurane, un groupe indolofurane, un groupe benzofurothiophène, un groupe benzothiénothiophène, un groupe indénothiophène, un groupe indolothiophène, un groupe benzofuropyridine, un groupe benzothiénopyridine, un groupe indénopyridine, un groupe indolopyridine, un groupe benzofuropyrimidine, un groupe benzothiénopyrimidine, un groupe indénopyrimidine, un groupe indolopyrimidine, un groupe benzofuroindole, un groupe benzothiénoindole, un groupe indénoindole, un groupe indoloindole, un groupe benzofurobenzofurane, un groupe benzothiénobenzofurane, un groupe indénobenzofurane, un groupe indolobenzofurane, un groupe benzofurobenzothiophène, un groupe benzothiénobenzothiophène, un groupe indénobenzothiophène, un groupe indolobenzothiophène, un groupe benzofuroquinoléine, un groupe benzothiénoquinoléine, un groupe indénoquinoléine, un groupe indoloquinoléine, un groupe benzonaphtofurane, un groupe benzonaphtothiophène, un groupe benzofluorène, un groupe benzocarbazole, un groupe dinaphtofurane, un groupe dinaphtothiophène, un groupe dibenzofluorène, un groupe dibenzocarbazole, un groupe benzoxazole, un groupe benzothiazole, un groupe benzimidazole, un naphtofurane, un naphtothiophène, un groupe cyclopentanaphtalène, un groupe spiro-bifluorène et un groupe spiro-fluorène-indène.

3. Dispositif émetteur de lumière organique selon la revendication 1 ou 2, dans lequel:
A₂₁ et A₂₃ sont chacun indépendamment choisis parmi un groupe benzène, un groupe naphtalène, un groupe phénanthrène, un groupe pyridine, un groupe quinoléine, un groupe isoquinoléine, un groupe benzoquinoléine, un groupe benzoisoquinoléine, un groupe dibenzofurane, un groupe dibenzothiophène, un groupe fluorène, un groupe carbazole et un groupe indolopyridine.

4. Dispositif émetteur de lumière organique selon l'une quelconque des revendications 1 à 3, dans lequel:
A₂₂ est choisi parmi un groupe benzène, un groupe naphtalène, un groupe phénanthrène, un groupe anthracène, un groupe triphénylène, un groupe pyrène, un groupe chrysène, un groupe pyridine, un groupe pyrazine, un groupe pyrimidine, un groupe triazine, un groupe quinoléine, un groupe isoquinoléine, un groupe benzoquinoléine, un groupe benzoisoquinoléine, un groupe 2,6-naphtyridine, un groupe 1,8-naphtyridine, un groupe 1,5-naphtyridine, un groupe 1,6-naphtyridine, un groupe 1,7-naphtyridine, un groupe 2,7-naphtyridine, un groupe quinoxaline, un groupe quinazoline, un groupe phénanthridine et un groupe phénanthroline.

5. Dispositif émetteur de lumière organique selon l'une quelconque des revendications 1 à 4, dans lequel:
A₂₂ est choisi parmi un groupe benzène et un groupe naphtalène.

6. Dispositif émetteur de lumière organique selon l'une quelconque des revendications 1 à 5, dans lequel:
L₂₁ à L₂₆ sont chacun indépendamment choisis dans le groupe constitué de:
un groupe phénylène, un groupe naphtylène, un groupe fluorénylène, un groupe phénanthrénylène, un groupe anthracénylène, un groupe triphénylénylène, un groupe pyrrolylène, un groupe thiophénylène, un groupe furanylène, un groupe pyridinylène, un groupe pyrazinylène, un groupe pyrimidinylène, un groupe indolylène, un groupe quinoléinylène, un groupe isoquinoléinylène, un groupe benzoquinoléinylène, un groupe benzoisoquinoléinylène, un groupe naphtyridinylène, un groupe quinoxalinylène, un groupe quinazolinylène, un groupe cinnolinylène, un groupe phénanthridinylène, un groupe phénanthrolinylène, un groupe carbazolylène, un groupe benzimidazolylène, un groupe benzofuranylène, un groupe benzothiophénylène, un groupe triazinylène, un groupe dibenzofuranylène et un groupe dibenzothiophénylène; et
un groupe phénylène, un groupe naphtylène, un groupe fluorénylène, un groupe phénanthrénylène, un groupe anthracénylène, un groupe triphénylénylène, un groupe pyrrolylène, un groupe thiophénylène, un groupe furanylène, un groupe pyridinylène, un groupe pyrazinylène, un groupe pyrimidinylène, un groupe indolylène, un groupe quinoléinylène, un groupe isoquinoléinylène, un groupe benzoquinoléinylène, un groupe benzoisoquinoléinylène, un groupe naphtyridinylène, un groupe quinoxalinylène, un groupe quinazolinylène, un groupe cinnolinylène, un groupe phénanthridinylène, un groupe phénanthrolinylène, un groupe carbazolylène, un groupe benzimidazolylène, un groupe benzofuranylène, un groupe benzothiophénylène, un groupe triazinylène, un groupe dibenzofuranylène et un groupe dibenzothiophénylène, chacun étant substitué avec au moins un choisi parmi un deutérium, -F, -Cl, -Br, -I, un groupe cyano, un groupe C₁-C₂₀ alkyle, un groupe C₁-C₂₀ alcoxy, un groupe cyclopropyle, un groupe cyclobutyle, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, -Si(Q₃₁)(Q₃₂)(Q₃₃), -N(Q₃₁)(Q₃₂), -B(Q₃₁)(Q₃₂), -C(=O)(Q₃₁),-S(=O)₂(Q₃₁) et -P(=O)(Q₃₁)(Q₃₂),
dans lequel Q₃₁ à Q₃₃ sont chacun indépendamment choisis parmi un hydrogène, un groupe C₁-C₂₀ alkyle, un groupe phényle, un groupe naphtyle, un groupe biphényle et un groupe terphényle.

7. Dispositif émetteur de lumière organique selon l'une quelconque des revendications 1 à 6, dans lequel:
R₂₁ à R₂₄ sont chacun indépendamment choisis dans le groupe constitué de:
un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe spiro-benzofluorène-fluorényle, un groupe spiro-cyclopentane-fluorényle, un groupe spiro-cyclohexane-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe tétraphényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe benzoisoquinoléinyle, un groupe carbazolyle, un groupe benzocarbazolyle, un groupe phtalazinyle, un groupe naphtyridinyle, un groupe quinoxalinyle, un groupe benzoquinoxalinyle, un groupe quinazolinyle, un groupe benzoquinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe benzonaphtofuranyle, un groupe dibenzothiophényle, un groupe benzonaphtothiophényle, un groupe benzocarbazolyle, un groupe dibenzocarbazolyle, un groupe thiadiazolyle, un groupe imidazopyridinyle, un groupe imidazopyrimidinyle, un groupe benzofuropyridinyle, un groupe benzofuropyrimidinyle, un groupe benzothiénopyridinyle, un groupe benzothiénopyrimidinyle, un groupe indénopyridinyle, un groupe indénopyrimidinyle, un groupe indolopyridinyle, un groupe indolopyrimidinyle et un groupe diazafluorényle;
un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe spiro-benzofluorène-fluorényle, un groupe spiro-cyclopentane-fluorényle, un groupe spiro-cyclohexane-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe tétraphényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe benzoisoquinoléinyle, un groupe carbazolyle, un groupe benzocarbazolyle, un groupe phtalazinyle, un groupe naphtyridinyle, un groupe quinoxalinyle, un groupe benzoquinoxalinyle, un groupe quinazolinyle, un groupe benzoquinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe benzonaphtofuranyle, un groupe dibenzothiophényle, un groupe benzonaphtothiophényle, un groupe benzocarbazolyle, un groupe dibenzocarbazolyle, un groupe thiadiazolyle, un groupe imidazopyridinyle, un groupe imidazopyrimidinyle, un groupe benzofuropyridinyle, un groupe benzofuropyrimidinyle, un groupe benzothiénopyridinyle, un groupe benzothiénopyrimidinyle, un groupe indénopyridinyle, un groupe indénopyrimidinyle, un groupe indolopyridinyle, un groupe indolopyrimidinyle et un groupe diazafluorényle, chacun étant substitué avec au moins un choisi parmi un deutérium, -F, -Cl, -Br, -I, un groupe hydroxyle, un groupe cyano, un groupe nitro, un groupe amidino, un groupe hydrazino, un groupe hydrazono, un groupe C₁-C₂₀ alkyle, un groupe C₁-C₂₀ alkyle substitué avec un deutérium, un groupe C₁-C₂₀ alkyle substitué avec -F, un groupe C₁-C₂₀ alcoxy, un groupe C₃-C₁₀ cycloalkyle, un groupe phényle, un groupe phényle substitué avec un deutérium, un groupe phényle substitué avec un groupe méthyle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe spiro-benzofluorène-fluorényle, un groupe spiro-cyclopentane-fluorényle, un groupe spiro-cyclohexane-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe tétraphényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyridinyle substitué avec un deutérium, un groupe pyridinyle substitué avec un groupe méthyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe benzoisoquinoléinyle, un groupe carbazolyle, un groupe benzocarbazolyle, un groupe phtalazinyle, un groupe naphtyridinyle, un groupe quinoxalinyle, un groupe benzoquinoxalinyle, un groupe quinazolinyle, un groupe benzoquinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe benzonaphtofuranyle, un groupe dibenzothiophényle, un groupe benzonaphtothiophényle, un groupe benzocarbazolyle, un groupe dibenzocarbazolyle, un groupe thiadiazolyle, un groupe imidazopyridinyle, un groupe imidazopyrimidinyle, un groupe benzofuropyridinyle, un groupe benzofuropyrimidinyle, un groupe benzothiénopyridinyle, un groupe benzothiénopyrimidinyle, un groupe indénopyridinyle, un groupe indénopyrimidinyle, un groupe indolopyridinyle, un groupe indolopyrimidinyle, un groupe diazafluorényle,-N(Q₃₁)(Q₃₂) et -Si(Q₃₁)(Q₃₂)(Q₃₃); et
-N(Q₁)(Q₂) et -Si(Q₁)(Q₂)(Q₃),
dans lequel Q₁ à Q₃ et Q₃₁ à Q₃₃ sont chacun indépendamment choisis parmi un groupe C₁-C₆₀ alkyle, un groupe C₆-C₆₀ aryle, un groupe C₁-C₆₀ hétéroaryle, un groupe polycyclique condensé non aromatique monovalent, un groupe hétéropolycyclique condensé non aromatique monovalent, un groupe biphényle et un groupe terphényle.

8. Dispositif émetteur de lumière organique selon l'une quelconque des revendications 1 à 7, dans lequel:
R₂₁ à R₂₄ sont chacun indépendamment choisis parmi des groupes représentés par les Formules 5-1 à 5-128: 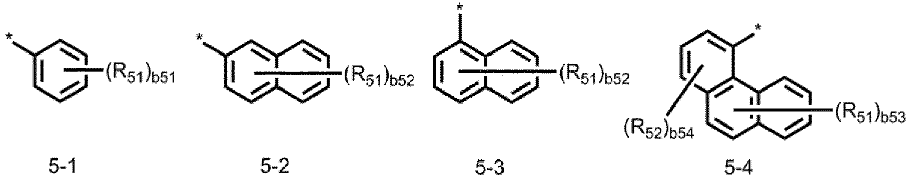 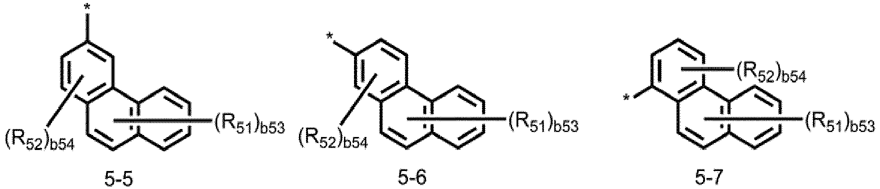 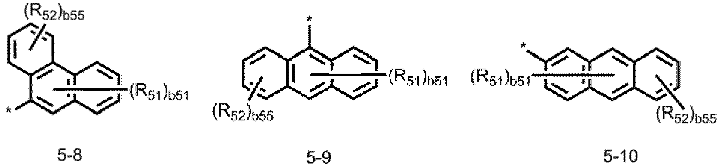 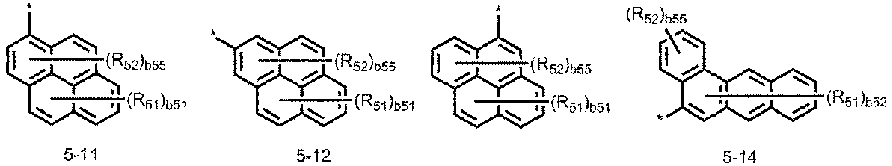 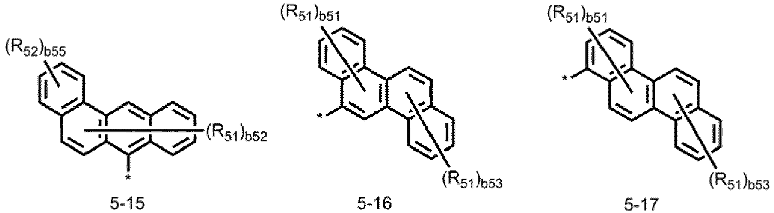 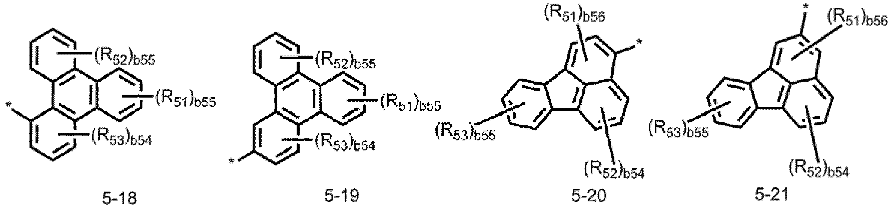 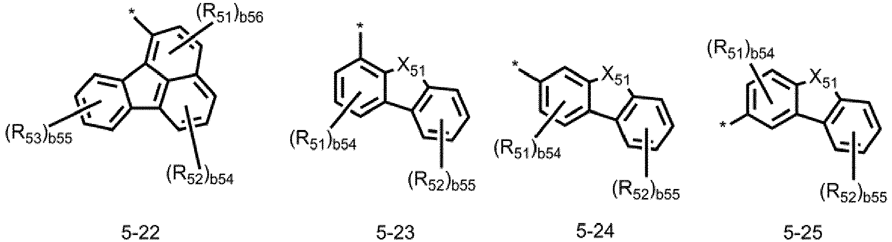 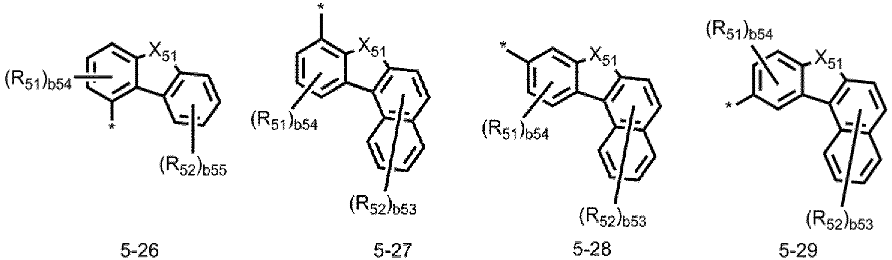 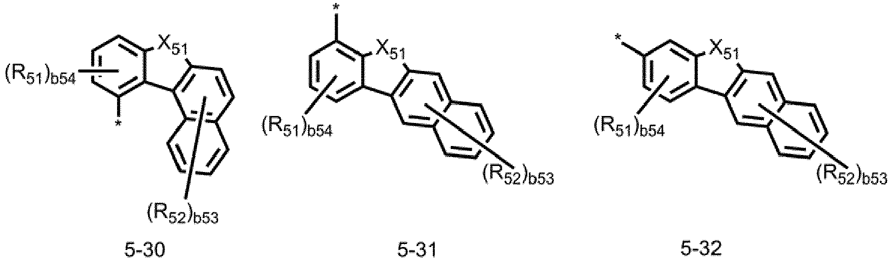 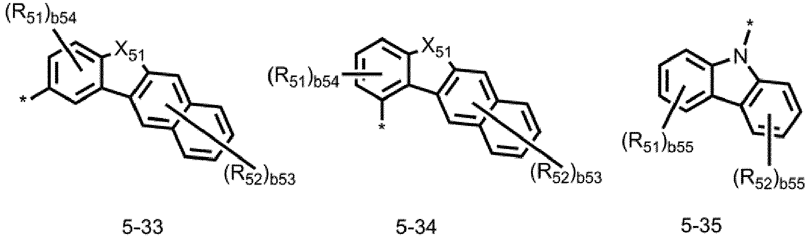 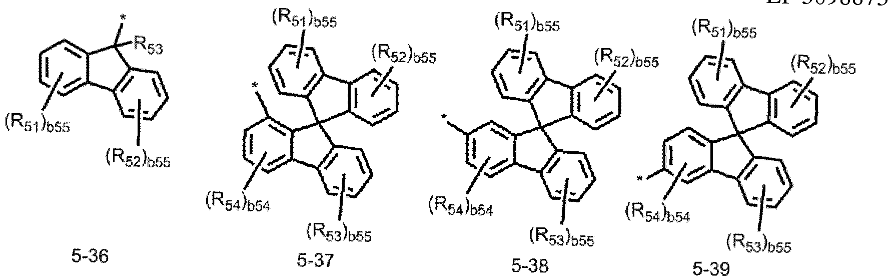 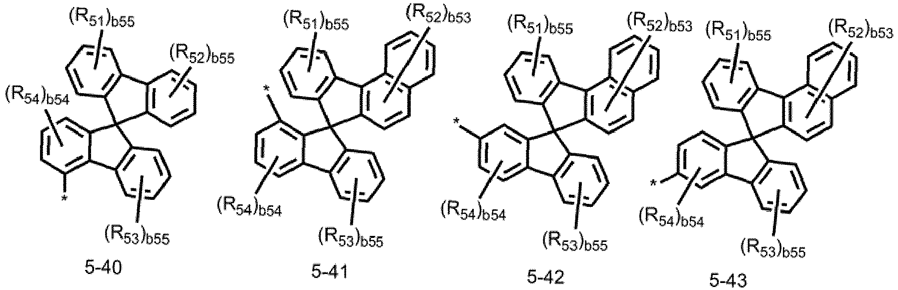 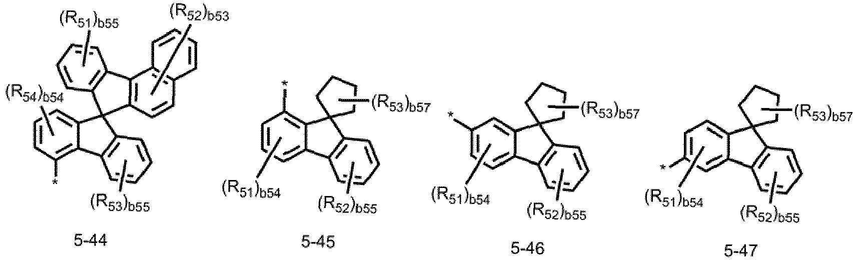 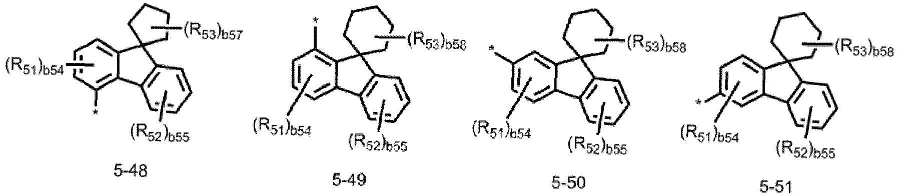 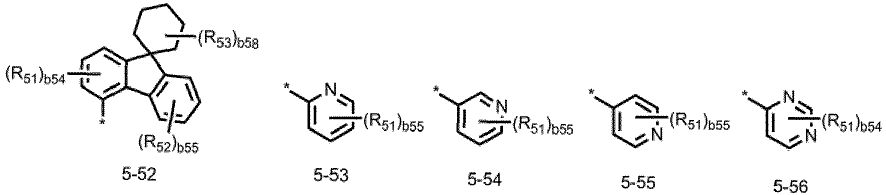 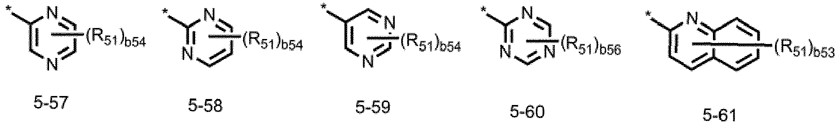 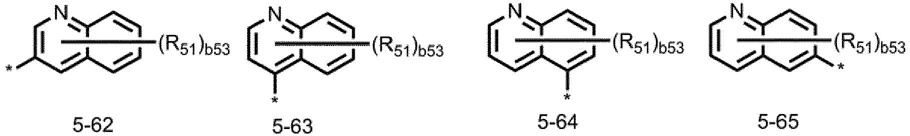 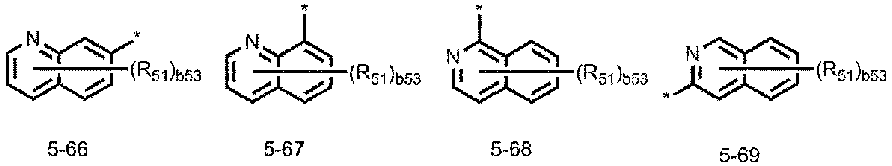 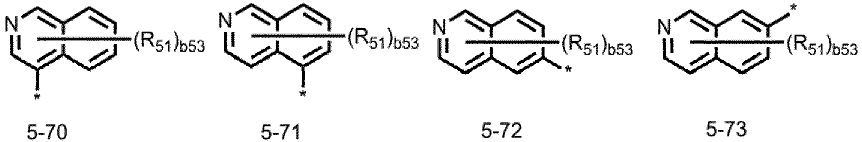 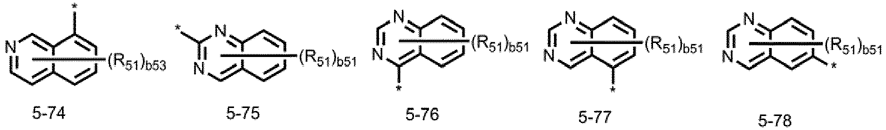 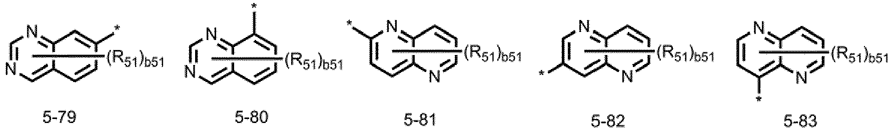 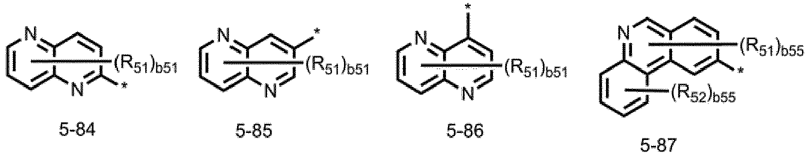 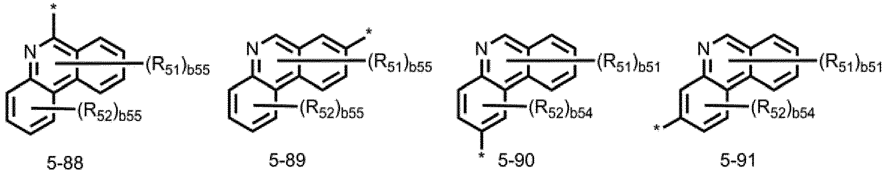 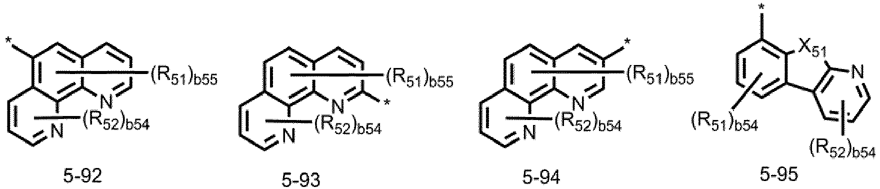 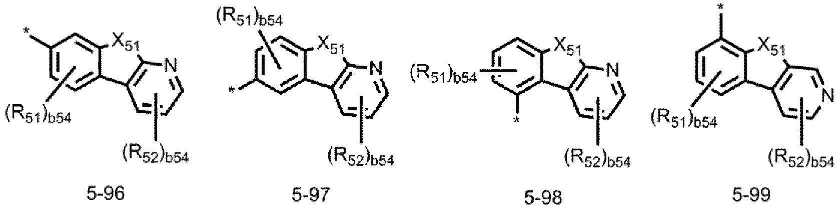 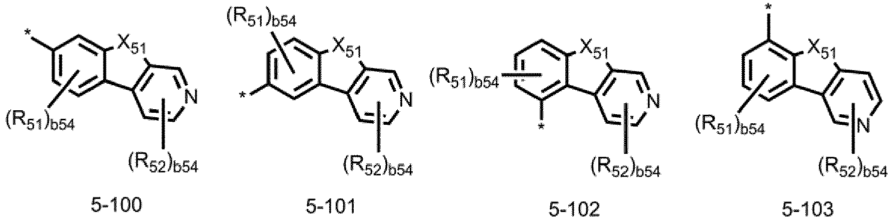 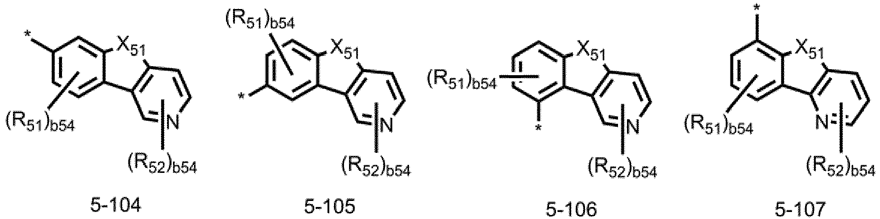 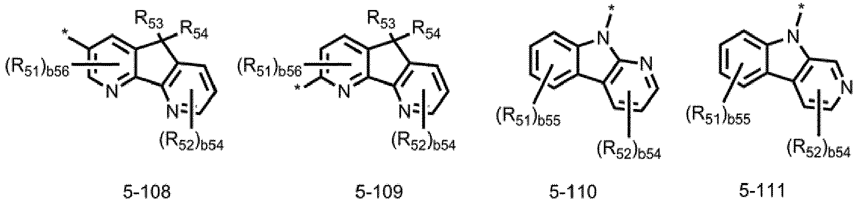 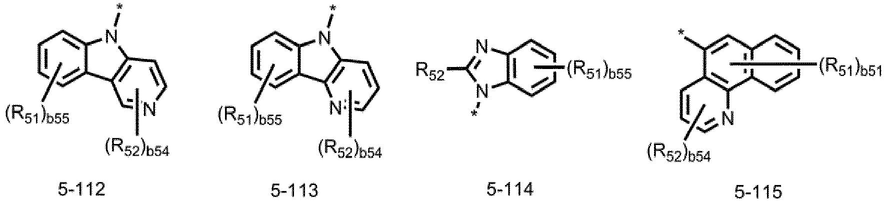 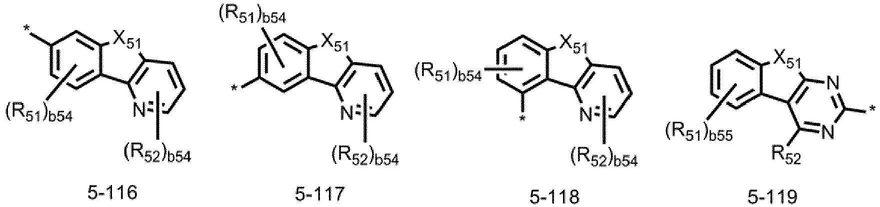 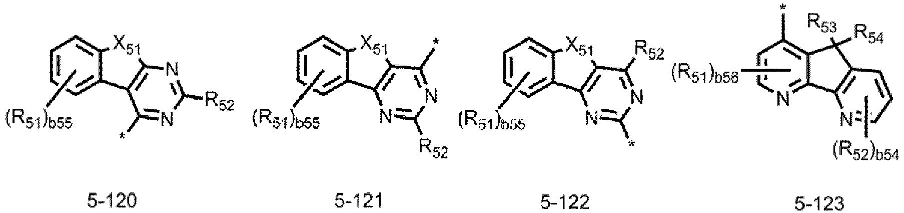 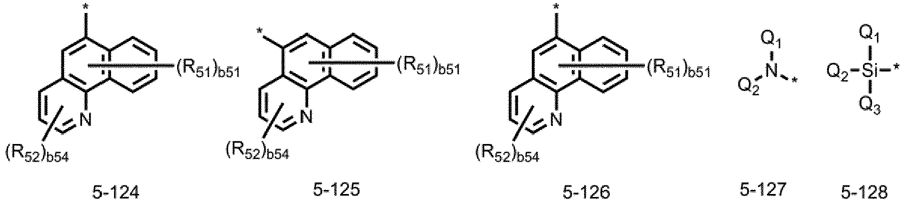 dans lequel, dans les Formules 5-1 à 5-128,
X₅₁ est choisi parmi O, S, N(R₅₃) et C(R₅₃)(R₅₄);
R₅₁ à R₅₄ sont chacun indépendamment choisis parmi un hydrogène, un deutérium, -F, -Cl, -Br, -I, un groupe hydroxyle, un groupe cyano, un groupe nitro, un groupe amidino, un groupe hydrazino, un groupe hydrazono, un groupe méthyle, un groupe éthyle, un groupe n-propyle, un groupe iso-propyle, un groupe n-butyle, un groupe iso-butyle, un groupe sec-butyle, un groupe tert-butyle, un groupe n-pentyle, un groupe iso-pentyle, un groupe sec-pentyle, un groupe tert-pentyle, un groupe néo-pentyle, -CDH₂,-CD₂H, -CD₃, -CFH₂, -CF₂H, -CF₃, un groupe méthoxy, un groupe éthoxy, un groupe n-propoxy, un groupe iso-propoxy, un groupe n-butoxy, un groupe iso-butoxy, un groupe sec-butoxy, un groupe tert-butoxy, un groupe n-pentoxy, un groupe iso-pentoxy, un groupe sec-pentoxy, un groupe tert-pentoxy, un groupe néo-pentoxy, un groupe cyclopropyle, un groupe cyclobutyle, un groupe cyclopentyle, un groupe cyclohexyle, un groupe phényle, Ds-Ph, 2-Me-Ph, 3-Me-Ph, 4-Me-Ph, un groupe biphényle, un groupe terphényle, un groupe naphtyle, un groupe fluorényle, un groupe spiro-bifluorényle, un groupe spiro-benzofluorène-fluorényle, un groupe benzofluorényle, un groupe dibenzofluorényle, un groupe phénanthrényle, un groupe anthracényle, un groupe fluoranthényle, un groupe triphénylényle, un groupe pyrényle, un groupe tétraphényle, un groupe chrysényle, un groupe pyridinyle, Ds-Py, 2-Me-1-Py, 3-Me-1-Py, 4-Me-1-Py, 5-Me-1-Py, 1-Me-2-Py, 3-Me-2-Py, 4-Me-2-Py, 5-Me-2-Py, 1-Me-3-Py, 2-Me-3-Py, 4-Me-3-Py, 5-Me-3-Py, un groupe pyrimidinyle, un groupe quinoléinyle, un groupe isoquinoléinyle, un groupe benzoquinoléinyle, un groupe benzoisoquinoléinyle, un groupe carbazolyle, un groupe benzocarbazolyle, un groupe naphtyridinyle, un groupe quinoxalinyle, un groupe quinazolinyle, un groupe phénanthridinyle, un groupe phénanthrolinyle, un groupe benzimidazolyle, un groupe triazinyle, un groupe dibenzofuranyle, un groupe benzonaphtofuranyle, un groupe dibenzothiophényle, un groupe benzonaphtothiophényle, un groupe benzofuropyridinyle, un groupe benzofuropyrimidinyle, un groupe benzothiénopyridinyle, un groupe benzothiénopyrimidinyle, un groupe indénopyridinyle, un groupe indénopyrimidinyle, un groupe indolopyridinyle, un groupe indolopyrimidinyle, un groupe diazafluorényle,-N(Q₃₁)(Q₃₂) et -Si(Q₃₁)(Q₃₂)(Q₃₃);
Q₁ à Q₃ et Q₃₁ à Q₃₃ sont chacun indépendamment choisis parmi un groupe méthyle, un groupe éthyle, un groupe n-propyle, un groupe iso-propyle, un groupe n-butyle, un groupe iso-butyle, un groupe sec-butyle, un groupe tert-butyle, un groupe n-pentyle, un groupe iso-pentyle, un groupe sec-pentyle, un groupe tert-pentyle, un groupe néo-pentyle, un groupe phényle, un groupe biphényle, un groupe terphényle et un groupe naphtyle;
b51 est choisi parmi 1, 2, 3, 4 et 5;
b52 est choisi parmi 1, 2, 3, 4, 5, 6 et 7;
b53 est choisi parmi 1, 2, 3, 4, 5 et 6;
b54 est choisi parmi 1, 2 et 3;
b55 est choisi parmi 1, 2, 3 et 4;
b56 est choisi parmi 1 et 2;
b57 est choisi parmi 1, 2, 3, 4, 5, 6, 7 et 8;
b58 est choisi parmi 1, 2, 3, 4, 5, 6, 7, 8, 9 et 10; et
* indique un site de liaison à un atome avoisinant.

9. Dispositif émetteur de lumière organique selon l'une quelconque des revendications 1 à 8, dans lequel:
R₂₀₁ à R₂₀₇ sont chacun indépendamment choisis parmi un hydrogène, un deutérium, -F, -Cl, -Br, -I, un groupe cyano, un groupe C₁-C₆₀ alkyle substitué ou non substitué, un groupe C₆-C₆₀ aryle substitué ou non substitué, un groupe C₁-C₆₀ hétéroaryle substitué ou non substitué, un groupe polycyclique condensé non aromatique monovalent substitué ou non substitué, un groupe hétéropolycyclique condensé non aromatique monovalent substitué ou non substitué, -N(Q₁)(Q₂) et -Si(Q₁)(Q₂)(Q₃);
Q₁ à Q₃ sont chacun indépendamment choisis parmi un groupe C₁-C₆₀ alkyle, un groupe C₆-C₆₀ aryle, un groupe C₁-C₆₀ hétéroaryle, un groupe polycyclique condensé non aromatique monovalent, un groupe hétéropolycyclique condensé non aromatique monovalent, un groupe biphényle et un groupe terphényle;
R₂₀₄ et R₂₀₅ sont optionnellement liés l'un à l'autre pour former un cycle saturé ou un cycle insaturé; et
R₂₀₆ et R₂₀₇ sont optionnellement liés l'un à l'autre pour former un cycle saturé ou un cycle insaturé.

10. Dispositif émetteur de lumière organique selon l'une quelconque des revendications 1 à 9, dans lequel:
R₂₀₁ à R₂₀₇ sont chacun indépendamment choisis dans le groupe constitué de:
un hydrogène, un deutérium, -F, -Cl, -Br, -I, un groupe cyano, un groupe méthyle, un groupe éthyle, un groupe n-propyle, un groupe iso-propyle, un groupe n-butyle, un groupe sec-butyle, un groupe iso-butyle, un groupe tert-butyle, un groupe phényle, un groupe biphényle, un groupe terphényle, un groupe naphtyle, un groupe pyridinyle, - N(Q₁)(Q₂) et -Si(Q₁)(Q₂)(Q₃); et
un groupe phényle, un groupe biphényle, un groupe terphényle, un groupe naphtyle et un groupe pyridinyle, chacun étant substitué avec au moins un choisi parmi un groupe méthyle, un groupe éthyle, un groupe n-propyle, un groupe iso-propyle, un groupe n-butyle, un groupe sec-butyle, un groupe iso-butyle, un groupe tert-butyle, un groupe phényle, un groupe biphényle, un groupe terphényle, un groupe naphtyle et un groupe pyridinyle;
Q₁ à Q₃ sont chacun indépendamment choisis parmi un groupe méthyle, un groupe éthyle, un groupe n-propyle, un groupe iso-propyle et un groupe phényle;
R₂₀₄ et R₂₀₅ sont optionnellement liés l'un à l'autre pour former un cycle saturé ou un cycle insaturé; et
R₂₀₆ et R₂₀₇ sont optionnellement liés l'un à l'autre pour former un cycle saturé ou un cycle insaturé.

11. Dispositif émetteur de lumière organique selon l'une quelconque des revendications 1 à 10, dans lequel:
le deuxième composé représenté par la Formule 2 est choisi parmi les Composés D1 à D212:

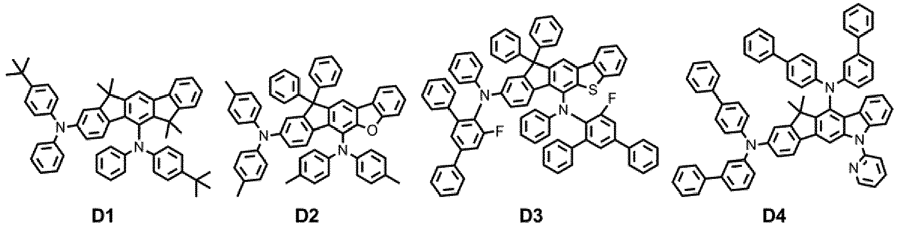

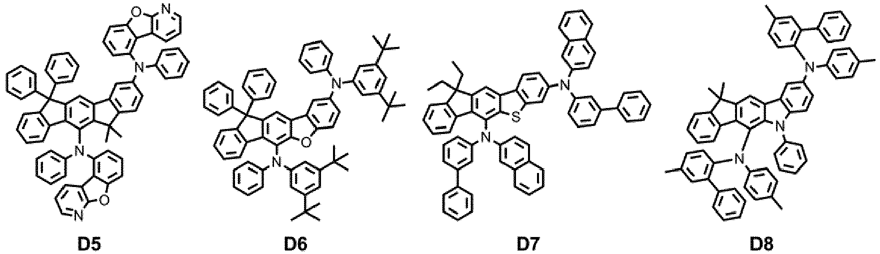

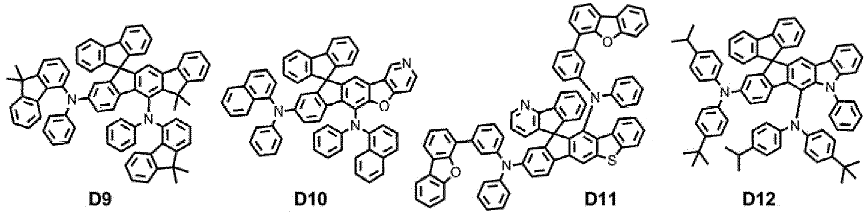

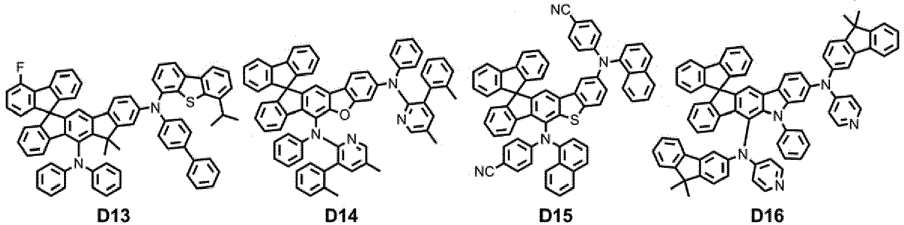

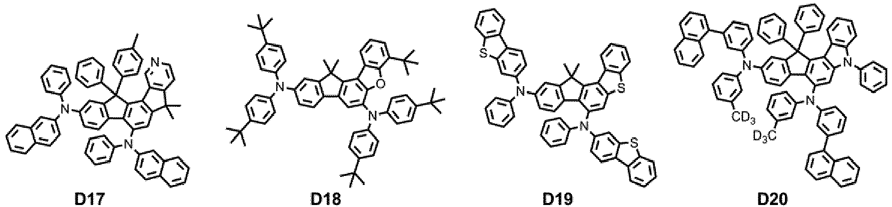

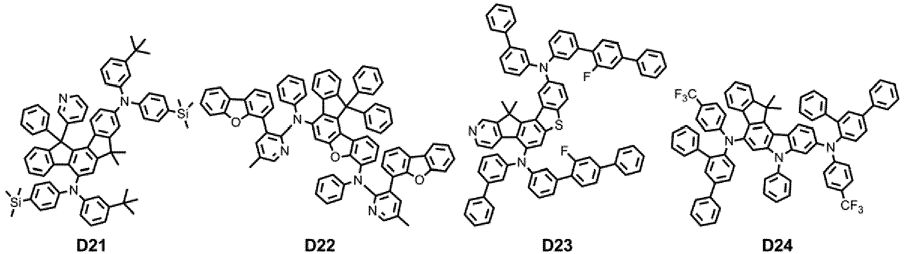

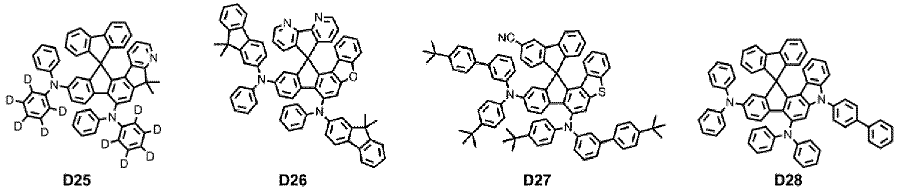

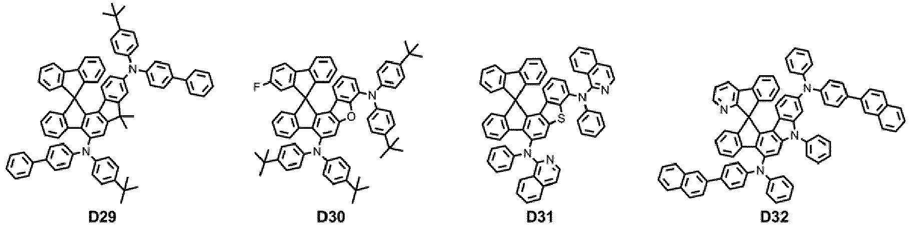

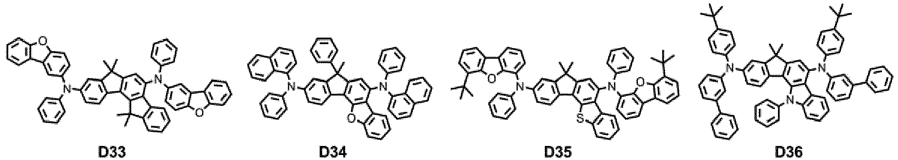

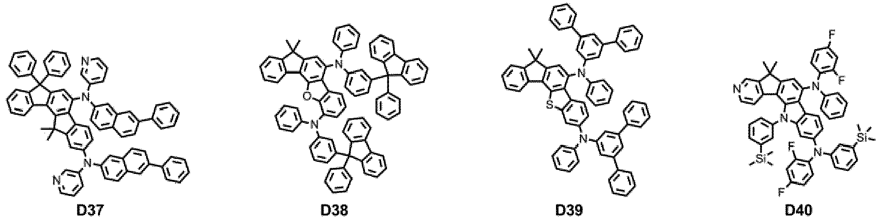

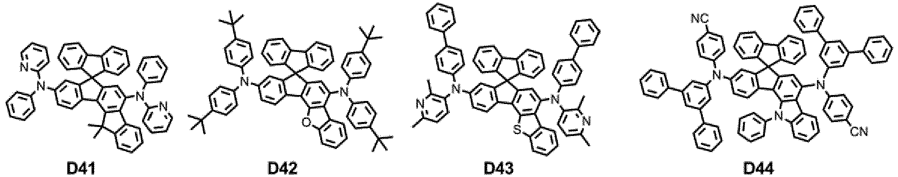

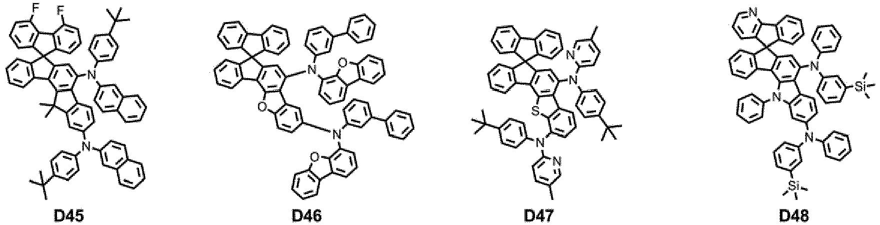

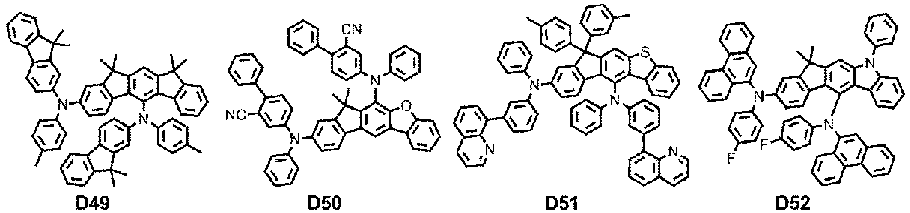

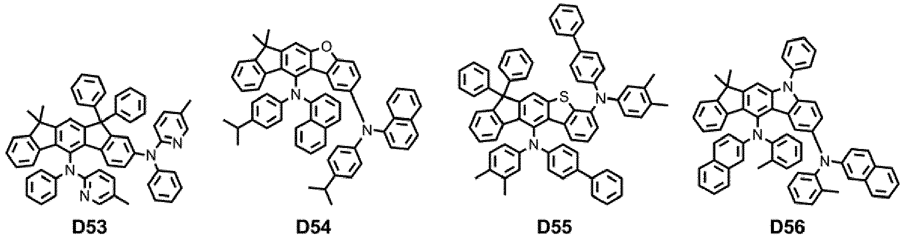

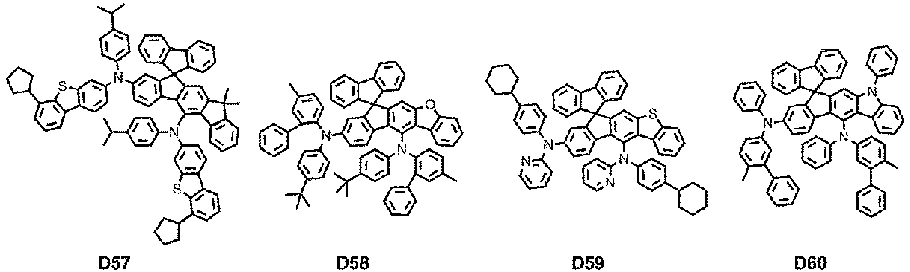

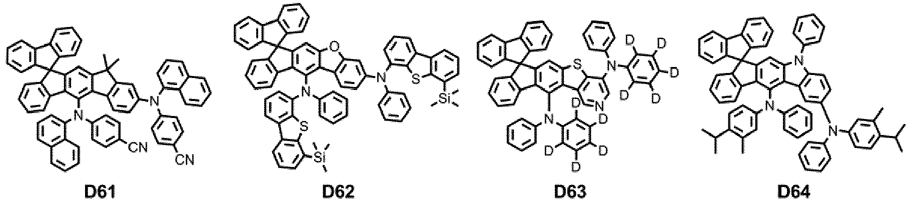

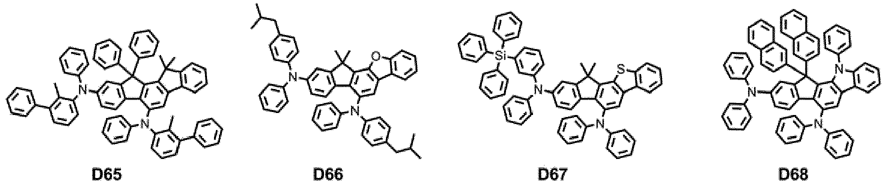

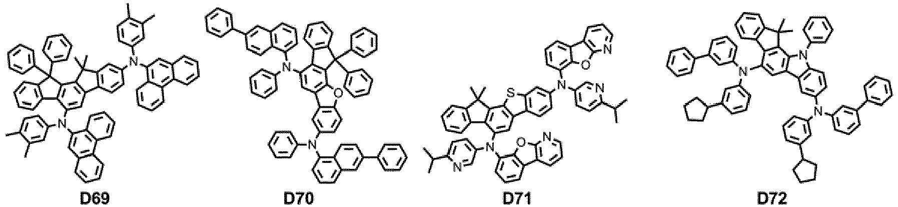

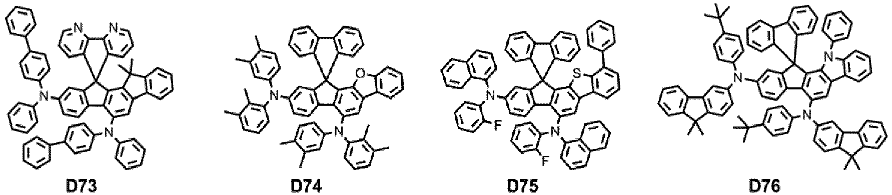

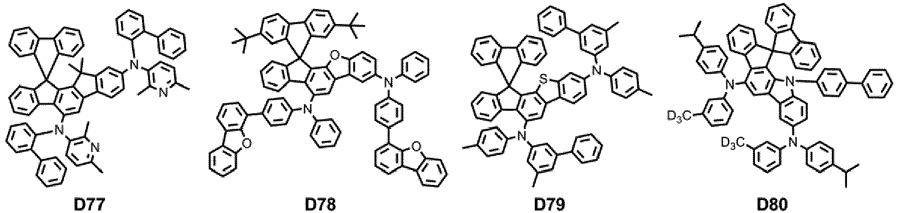

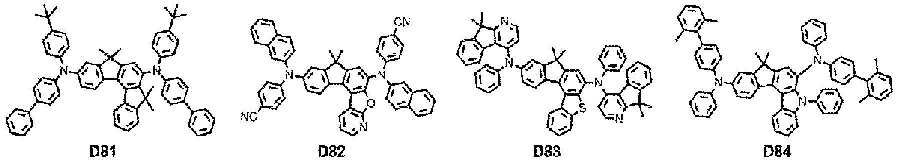

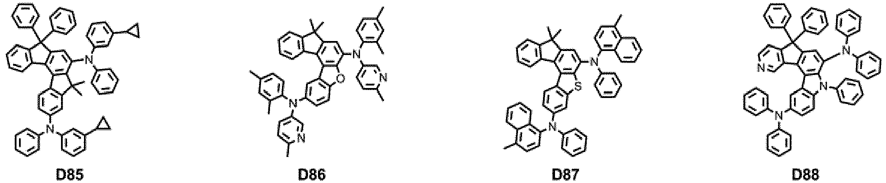

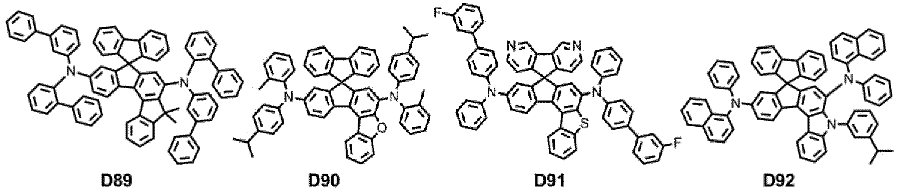

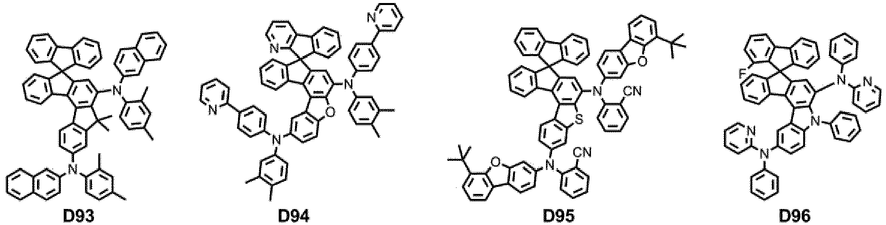

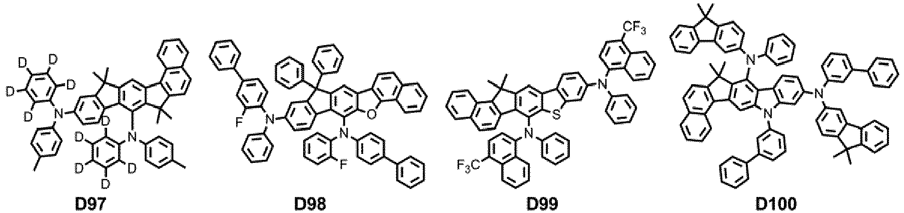

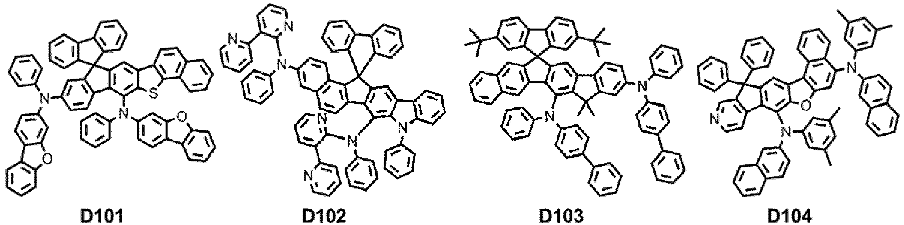

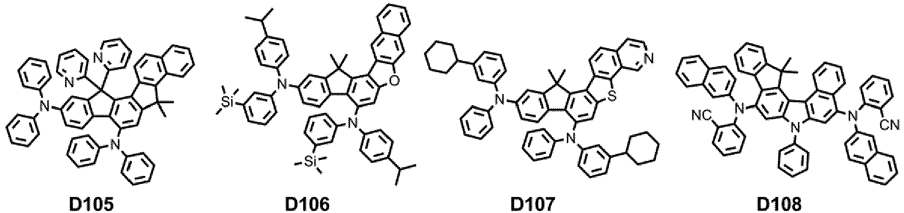

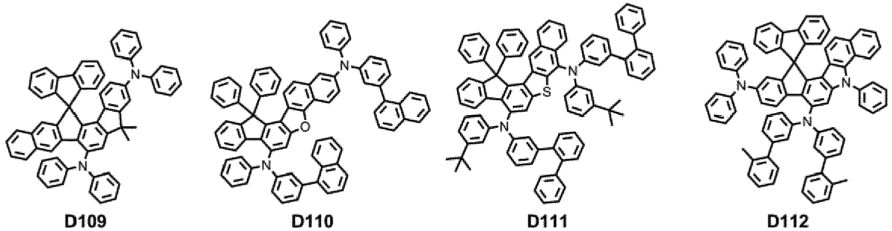

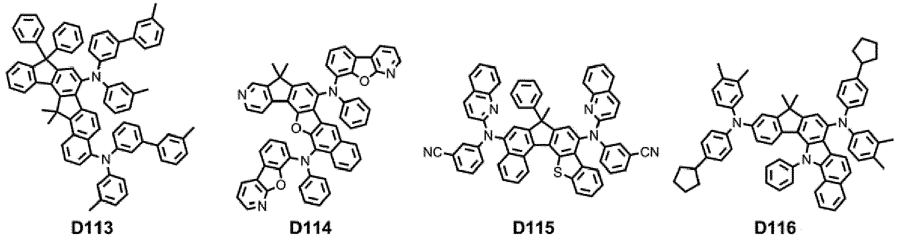

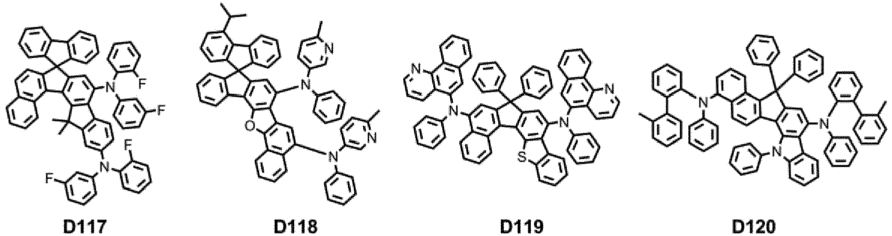

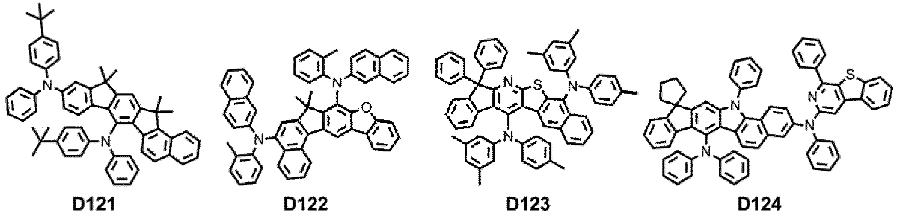

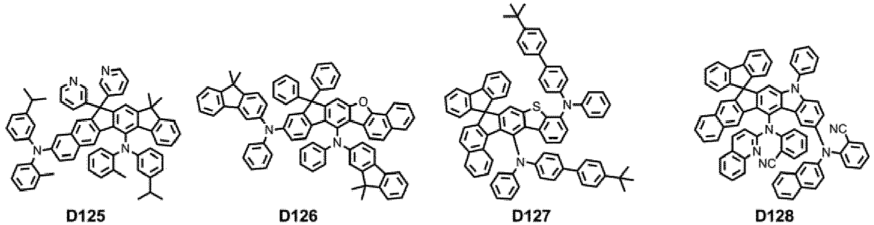

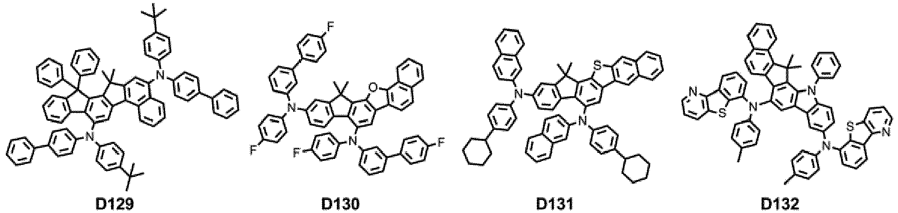

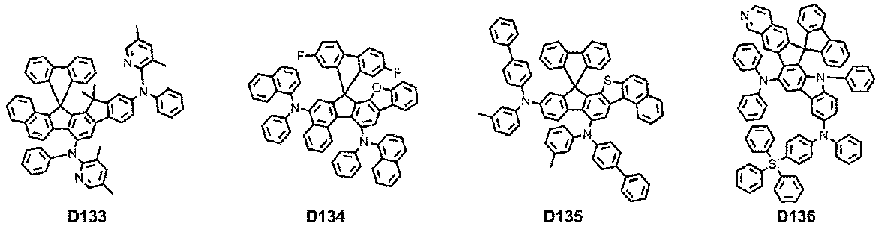

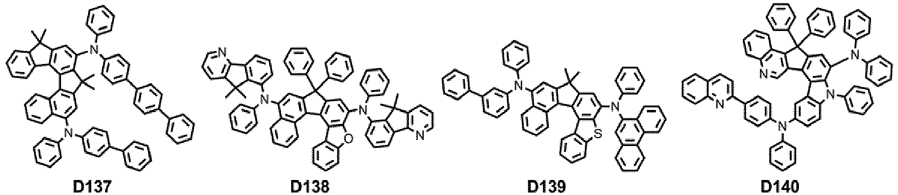

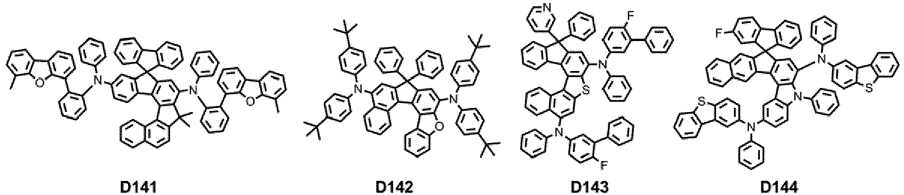

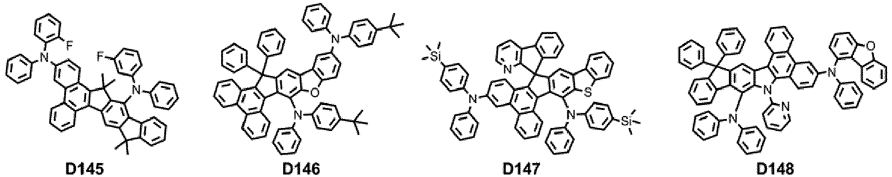

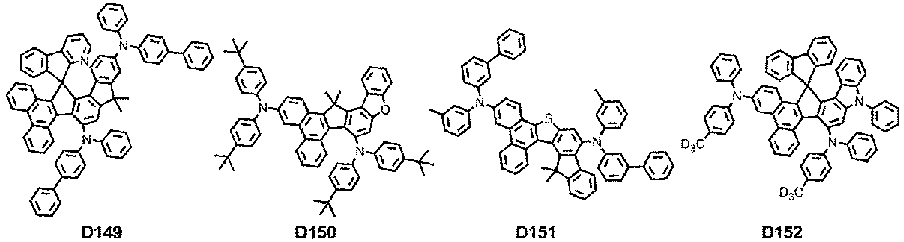

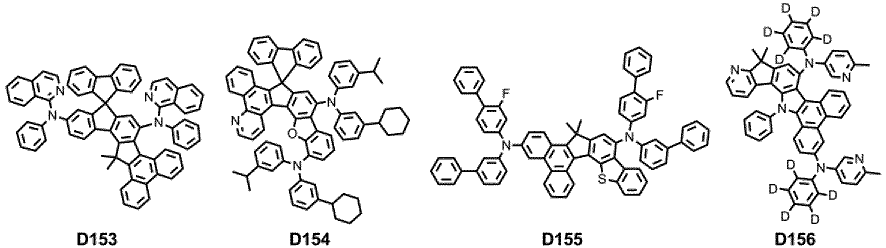

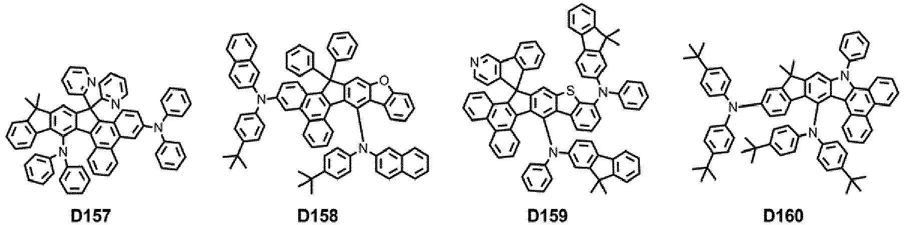

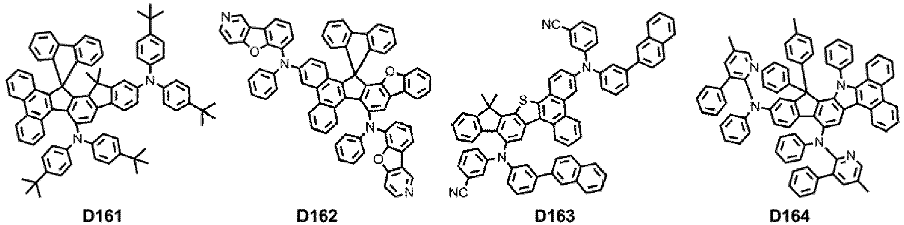

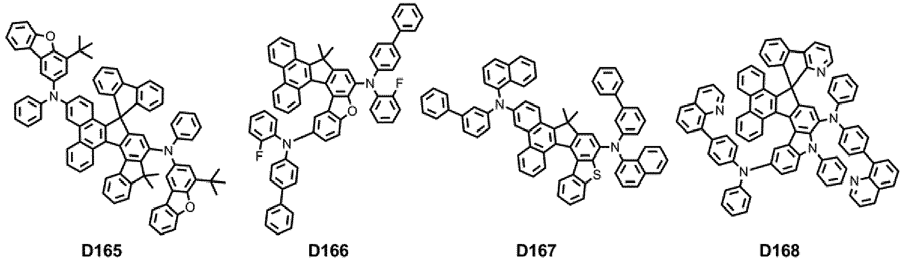

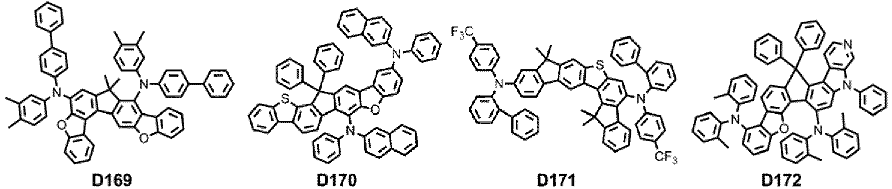

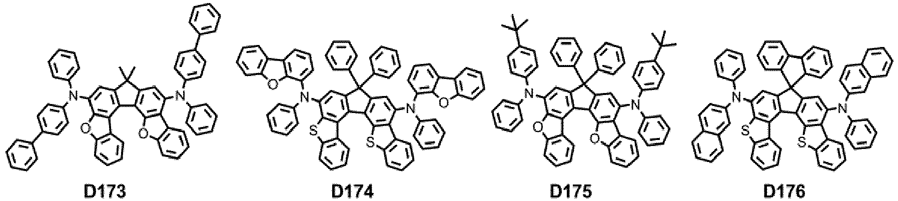

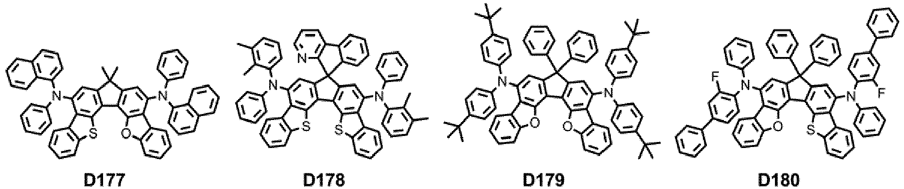

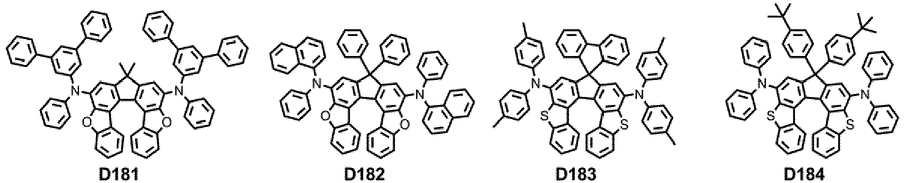

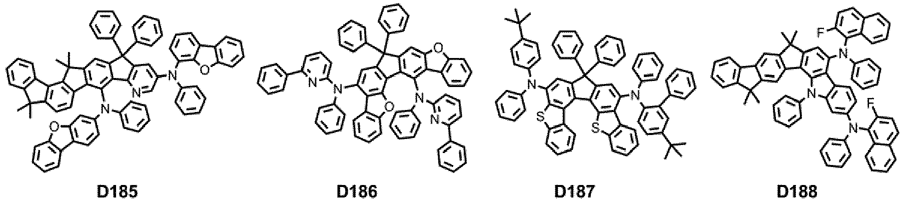

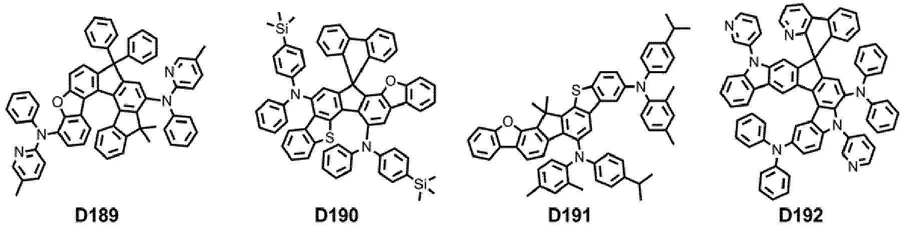

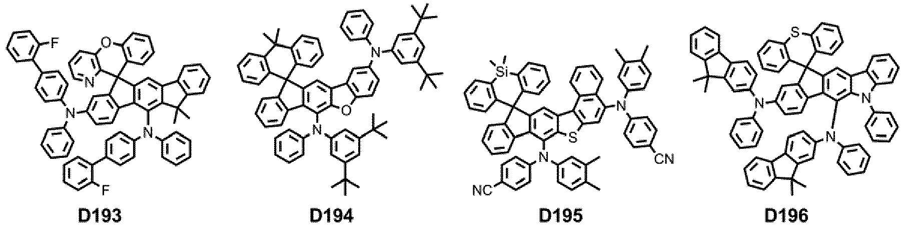

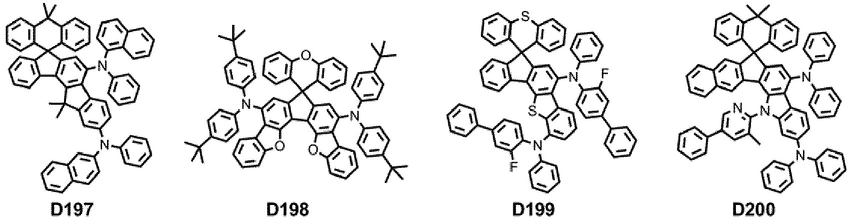

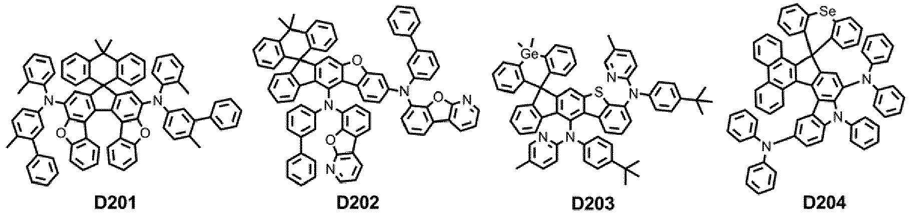

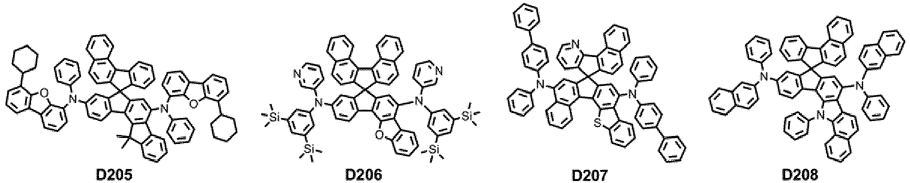

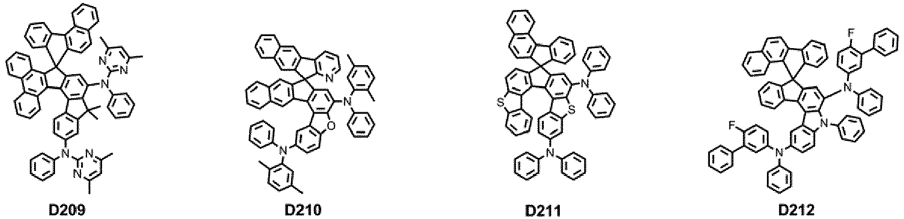

12. Dispositif émetteur de lumière organique selon l'une quelconque des revendications 1 à 11, dans lequel:
la couche organique comprend en outre une région de transport d'électrons entre la couche d'émission et la deuxième électrode,
la région de transport d'électrons comprenant un métal alcalin, un métal alcalino-terreux, un métal des terres rares, un composé de métal alcalin, un composé de métal alcalino-terreux, un composé de métal des terres rares, un complexe de métal alcalin, un complexe de métal alcalino-terreux, un complexe de métal des terres rares ou n'importe quelle combinaison de ceux-ci.

13. Dispositif émetteur de lumière organique selon la revendication 12,
dans lequel la région de transport d'électrons comprend une couche de transport d'électrons et une couche d'injection d'électrons; et
au moins une choisie parmi la couche de transport d'électrons et la couche d'injection d'électrons comprend un métal alcalin, un métal alcalino-terreux, un métal des terres rares, un composé de métal alcalin, un composé de métal alcalino-terreux, un composé de métal des terres rares, un complexe de métal alcalin, un complexe de métal alcalino-terreux, un complexe de métal des terres rares ou n'importe quelle combinaison de ceux-ci.

14. Dispositif émetteur de lumière organique selon l'une quelconque des revendications 1 à 13, dans lequel:
la couche organique comprend en outre une région de transport de trous entre la couche d'émission et la première électrode,
la région de transport de trous comprenant un p-dopant, et
le niveau d'énergie orbitale moléculaire non occupé le plus bas (LUMO) du p-dopant est de -3,5 eV ou moins.

15. Dispositif émetteur de lumière organique selon la revendication 14, dans lequel:
le p-dopant comprend un composé contenant un groupe cyano.

16. Dispositif émetteur de lumière organique selon l'une quelconque des revendications 1 à 15, dans lequel:
la couche d'émission est une couche d'émission émettant une lumière de première couleur;
la couche organique comprend en outre: i) au moins une couche d'émission émettant une lumière de deuxième couleur, ou ii) au moins une couche d'émission émettant une lumière de deuxième couleur et au moins une couche d'émission émettant une lumière de troisième couleur;
dans lequel une lumière de première couleur de la couche d'émission émettant une lumière de première couleur et une lumière de deuxième couleur de la couche d'émission émettant une lumière de deuxième couleur sont identiques ou différentes l'une de l'autre; ou la lumière de première couleur, la lumière de deuxième couleur et une lumière de troisième couleur de la couche d'émission émettant une lumière de troisième couleur sont identiques ou différentes l'une de l'autre; et
la lumière de première couleur et la lumière de deuxième couleur sont émises en une lumière de couleurs mélangées; ou la lumière de première couleur, la lumière de deuxième couleur et la lumière de troisième couleur sont émises en une lumière de couleurs mélangées.
